(19) Europäisches Patentamt
European Patent Office
Office européen des brevets

(11) EP 4 395 521 A1

(12) EUROPEAN PATENT APPLICATION

(43) Date of publication:
03.07.2024 Bulletin 2024/27

(21) Application number: 23210701.1

(22) Date of filing: 17.11.2023

(51) International Patent Classification (IPC):
*H10K 85/60* (2023.01) *H10K 101/00* (2023.01)
*H10K 101/20* (2023.01)

(52) Cooperative Patent Classification (CPC):
**H10K 85/658; H10K 85/6572; H10K 85/6574;**
H10K 50/11; H10K 50/121; H10K 2101/00;
H10K 2101/20; H10K 2101/90

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **30.12.2022 KR 20220191075**

(71) Applicant: **Samsung Display Co., Ltd.**
**Yongin-si, Gyeonggi-do 17113 (KR)**

(72) Inventors:
- **Sim, Munki**
  **17113 Yongin-si (KR)**
- **Pak, Sunyoung**
  **17113 Yongin-si (KR)**
- **Park, Junha**
  **17113 Yongin-si (KR)**
- **Sunwoo, Kyoung**
  **17113 Yongin-si (KR)**
- **Oh, Chanseok**
  **17113 Yongin-si (KR)**
- **Chu, Changwoong**
  **17113 Yongin-si (KR)**

(74) Representative: **Crow, Martin et al**
**Venner Shipley LLP**
**200 Aldersgate**
**London EC1A 4HD (GB)**

(54) **CONDENSED CYCLIC COMPOUND, LIGHT-EMITTING DEVICE COMPRISING THE CONDENSED CYCLIC COMPOUND, AND ELECTRONIC APPARATUS COMPRISING THE LIGHT-EMITTING DEVICE**

(57) A condensed cyclic compound satisfying Expression 1, a light-emitting device comprising a first electrode, a second electrode facing the first electrode, and an interlayer between the first electrode and the second electrode and comprising the condensed cyclic compound, and an electronic apparatus and electronic equipment that comprise the light-emitting device are provided. Expression 1 is:

$$SA_1/V_1 \leq 0.89\ Å^{-1}$$

wherein, in Expression 1,
$SA_1$ indicates a surface area of the condensed cyclic compound, and $V_1$ indicates a volume of the condensed cyclic compound.

EP 4 395 521 A1

## Description

### CROSS-REFERENCE TO RELATED APPLICATION

This application claims priority to and the benefit of Korean Patent Application No. 10-2022-0191075, filed on December 30, 2022, in the Korean Intellectual Property Office, the content of which is incorporated by reference herein in its entirety.

### BACKGROUND

#### 1. Field

One or more embodiments of the present disclosure relate to a condensed cyclic compound, a light-emitting device comprising the condensed cyclic compound, and an electronic apparatus comprising the light-emitting device.

#### 2. Description of the Related Art

Self-emissive devices (for example, organic light-emitting devices) are light-emitting devices that have relatively wide viewing angles, high contrast ratios, short response times, and excellent or suitable characteristics in terms of luminance, driving voltage, and response speed.

In a light-emitting device, a first electrode is arranged on a substrate, and a hole transport region, an emission layer, an electron transport region, and a second electrode are sequentially arranged on the first electrode. Holes provided from the first electrode move toward the emission layer through the hole transport region, and electrons provided from the second electrode move toward the emission layer through the electron transport region. Carriers, such as holes and electrons, recombine in the emission layer to produce excitons. These excitons transition and decay from an excited state to a ground state to thus generate light.

### SUMMARY

According to one or more embodiments of the present disclosure, provided is a condensed cyclic compound satisfying Expression 1:

**Expression 1**

$$SA_1/V_1 \leq 0.89\ \text{Å}^{-1},$$

wherein, in Expression 1,
$SA_1$ indicates a surface area of the condensed cyclic compound, and $V_1$ indicates a volume of the condensed cyclic compound.

According to one or more embodiments of the present disclosure, a light-emitting device comprises a first electrode,

a second electrode facing the first electrode,
an interlayer between the first electrode and the second electrode and comprising an emission layer, and
at least one of the condensed cyclic compound satisfying Expression 1.

According to one or more embodiments of the present disclosure, an electronic apparatus comprises the light-emitting device.

According to one or more embodiments of the present disclosure, electronic equipment comprises the light-emitting device.

Additional aspects will be set forth in part in the description which follows and, in part, will be apparent from the description, or may be learned by practice of the presented embodiments of the disclosure.

### BRIEF DESCRIPTION OF THE DRAWINGS

The accompanying drawings are included to provide a further understanding of the present disclosure and are incorporated in and constitute a part of the present disclosure. The drawings illustrate embodiments of the present

disclosure and, together with the description, serve to explain principles of the present disclosure. The above and other aspects, features, and advantages of certain embodiments of the disclosure will be more apparent from the following description taken in conjunction with the accompanying drawings, in which:

FIG. 1 is a schematic view of a light-emitting device according to one or more embodiments of the present disclosure;
FIG. 2 is a schematic view of an electronic apparatus according to one or more embodiments of the present disclosure;
FIG. 3 is a schematic view of an electronic apparatus according to one or more embodiments of the present disclosure;
FIG. 4 is a schematic perspective view of electronic equipment comprising a light-emitting device according to one or more embodiments of the present disclosure;
FIG. 5 is a schematic view of an exterior of a vehicle as electronic equipment comprising a light-emitting device according to one or more embodiments of the present disclosure;
FIGs. 6A to 6C are each a schematic view of an interior of a vehicle according to one or more embodiments of the present disclosure;
FIGs. 7 and 8A-8C are each a diagram for illustrating and explaining a Connolly surface; and
FIG. 9 is a graph showing surface area to volume ratios of Examples 1 to 15 and Comparative Examples 1 to 13 of the present disclosure.

## DETAILED DESCRIPTION

Reference will now be made in more detail to embodiments, examples of which are illustrated in the accompanying drawings, wherein like reference numerals refer to like elements throughout the present disclosure, and duplicative descriptions thereof may not be provided for conciseness. In this regard, the embodiments of the present disclosure may have different forms and should not be construed as being limited to the descriptions set forth herein. Accordingly, the embodiments of the present disclosure are merely described, by referring to the drawings, to explain aspects of the present disclosure. As utilized herein, the term "and/or" or "or" may include any and all combinations of one or more of the associated listed items. Throughout the disclosure, the expressions such as "at least one of," "one of," and "selected from," when preceding a list of elements, modify the entire list of elements and do not modify the individual elements of the list. For example, "at least one of a, b or c", "at least one selected from a, b, and c", "at least one selected from among a to c", etc., may indicate only a, only b, only c, both (e.g., simultaneously) a and b, both (e.g., simultaneously) a and c, both (e.g., simultaneously) b and c, all of a, b, and c, or variations thereof. The "j" utilized herein may be interpreted as "and" or as "or" depending on the situation.

As the disclosure allows for one or more suitable changes and numerous embodiments, some embodiments will be illustrated in the drawings and described in more detail in the written description. Effects and features of the disclosure, and methods of achieving the same will be clarified by referring to embodiments described in more detail later with reference to the drawings. The present disclosure may, however, be embodied in many different forms and should not be construed as limited to the embodiments set forth herein.

Hereinafter, embodiments of the disclosure will be described in more detail with reference to the accompanying drawings. The same or corresponding components will be denoted by the same reference numerals, and thus redundant description thereof will not be provided for conciseness.

An expression utilized in the singular encompasses the expression of the plural, unless it has a clearly different meaning in the context.

It will be further understood that the terms "comprise(s)/include(s)," "comprising/including," "have/has," and/or "having" utilized herein specify the presence of stated features or components, but do not preclude the presence or addition of one or more other features or components.

It will be understood that when a layer, region, or component is referred to as being "on" or "onto" another layer, region, or component, it may be directly or indirectly formed on the other layer, region, or component. For example, for example, intervening layers, regions, or components may be present. In some embodiments, "directly on" may refer to that there are no additional layers, films, regions, plates, etc., between a layer, a film, a region, a plate, etc. and the other part. For example, "directly on" may refer to two layers or two members are disposed without utilizing an additional member such as an adhesive member therebetween.

Sizes of components in the drawings may be exaggerated for convenience of explanation. In other words, because sizes and thicknesses of components in the drawings are arbitrarily illustrated for convenience of explanation, the following embodiments are not limited thereto.

The term "interlayer" as utilized herein refers to a single layer and/or all layers between a first electrode and a second electrode of a light-emitting device.

The term "surface area" of a compound as utilized herein refers to an area of a three-dimensional surface of a compound, and may be understood as an area of a surface (Connolly surface) formed by a solvent molecule, referred to as "probe," rolling over the surface of a compound, that is, the surface area measured by Connolly surface analysis.

The term "Connolly surface" refers to, as illustrated in FIG. 7, a track on which a solvent molecule of an appropriate or suitable size is injected to roll over the surface of a target compound molecule of which the surface area is to be measured, and on which the concave inner surface of the solvent molecule passes.

In particular, as illustrated in FIG. 8A to 8C , i) when the solvent molecule is in contact with one atom of the target compound, the surface shown in FIG. 8A is referred as a convex sphere, ii) when the solvent molecule is in contact with two atoms of the target compound, the bow-shaped surface shown in FIG. 8B connecting portions of the two atoms in contact with the solvent molecule is referred to as a saddle sphere, and iii) when the solvent molecule is in contact with three atoms of the target compound, the triangular-shaped region shown in FIG. 8C formed by connecting portions of the three atoms in contact with the solvent molecule is referred to as a concave sphere. The sum of the convex sphere, the saddle sphere, and the concave sphere of the target compound may correspond to the Connolly surface of the target compound, and the area thereof may be the surface area of the target compound.

The term "volume" of a compound as utilized herein refers to the size of a space occupied by the three-dimensional structure of a compound, and may be understood as the size of an intersurface space formed by a solvent molecule rolling over the surface of a compound, that is, the volume measured by Connolly surface analysis.

In one or more embodiments of the present disclosure, the size of a space surrounded (e.g., enclosed) by the convex sphere, the saddle sphere, and the concave sphere of the target compound described above may correspond to the volume of the target compound. Further, the additional description of the Connolly surface analysis may refer to the disclosures of Michael L. Connolly, J. Appl. Cryst. (1983), 16, 548-558, and Chunmiao Ma, et. al., 2020 5th International Symposium on Biomedical Science, Biotechnology and Healthcare (ISBSBH 2020), 120-125, both of which are incorporated herein by reference in their entireties.

In one or more embodiments of the present disclosure, calculation of the Connolly surface may be performed utilizing Material Studio 2018, which is a commercial program, under conditions of a grid interval of about 0.15 Å, a Van Der Waals scale factor of about 1.0 Å, and a solvent radius (probe) of about 1.4 Å. In the present disclosure, the term "Å" may refer to Ångström, equal to $10^{-10}$ meter or 0.1 nanometers.

One or more aspects of embodiments of the present disclosure are directed toward a condensed cyclic compound satisfying Expression 1:

## Expression 1

$$SA_1/V_1 \leq 0.89\ Å^{-1},$$

wherein, in Expression 1,

$SA_1$ indicates a surface area of the condensed cyclic compound, and $V_1$ indicates a volume of the condensed cyclic compound.

In one or more embodiments, $SA_1/V_1$ may be less than or equal to about 0.89 $Å^{-1}$, for example, less than or equal to about 0.8900 $Å^{-1}$, less than or equal to about 0.8890 $Å^{-1}$, or less than or equal to about 0.8880 $Å^{-1}$, but embodiments of the present disclosure are not limited thereto.

In one or more embodiments, $SA_1$, which is the surface area of the condensed cyclic compound, may be greater than or equal to about 500 $Å^2$ and less than or equal to about 2,000 $Å^2$, for example, greater than or equal to about 500 $Å^2$ and less than or equal to about 2,000 $Å^2$, greater than or equal to about 500 $Å^2$ and less than or equal to about 1,500 $Å^2$, greater than or equal to about 800 $Å^2$ and less than or equal to about 1,500 $Å^2$, greater than or equal to about 830 $Å^2$ and less than or equal to about 1,450 $Å^2$, or greater than or equal to about 850 $Å^2$ and less than or equal to about 1,400 $Å^2$, but embodiments of the present disclosure are not limited thereto.

In one or more embodiments, $V_1$, which is the volume of the condensed cyclic compound, may be greater than or equal to about 500 $Å^3$ and less than or equal to about 2,000 $Å^3$, for example, greater than or equal to about 500 $Å^3$ and less than or equal to about 2,000 $Å^3$, greater than or equal to about 800 $Å^3$ and less than or equal to about 2,000 $Å^3$, or greater than or equal to about 900 $Å^3$ and less than or equal to about 2,000 $Å^3$, but embodiments of the present disclosure are not limited thereto.

As the ratio between the surface area and the volume of the condensed cyclic compound of the present disclosure satisfies the relationship of Expression 1, bulky substituents of the condensed cyclic compound may have a molecular shape around (e.g., surrounding) the multi-resonance core of the condensed cyclic compound, and the substituents having such a molecular shape may provide steric protection to the empty p orbital (e.g., vacant p orbital) of boron in the multi-resonance core. As a result, boron atoms, which may be chemically vulnerable (e.g., susceptible to a base species), may be protected, and the condensed cyclic compound molecule may have a round molecular shape as a whole, so that interaction with a surrounding matrix (such as a host, a sensitizer, and/or another boron emitter molecule) may be suppressed or reduced.

In some embodiments, because emission transition occurs in the multi-resonance core, multi-resonance molecules require core protection to suppress or reduce Dexter energy transfer (DET). In embodiments of general boron-based, DABNA-based molecules, due to the plate-like structure of the multi-resonance core, emission side effects caused by intermolecular interactions, such as aggregation, excimers, and exciplexes, may appear, and exciton quenching such as DET, triplet-triplet annihilation (TTA), and triplet-polaron quenching (TPQ) may easily occur in an organic light-emitting device, thus negatively affecting the efficiency and lifespan thereof. In contrast, in embodiments of molecules satisfying the relational expression of the present disclosure, intramolecularly, the p orbital (e.g., vacant p orbital) of boron may be protected, and extramolecularly, intermolecular interaction may be reduced by increasing the intermolecular distance.

In one or more embodiments, the condensed cyclic compound may be a boron-containing compound. For example, in one or more embodiments, the condensed cyclic compound may be a compound comprising at least one boron atom.

Because the condensed cyclic compound according to one or more embodiments comprises boron and satisfies the relationship of Expression 1, the empty p orbital (e.g., vacant p orbital) of the boron included in the compound may be protected, and thus, the structural stability of the condensed cyclic compound may be improved.

In one or more embodiments, the condensed cyclic compound may be a nitrogen-containing compound. For example, in one or more embodiments, the condensed cyclic compound may be a compound comprising at least one nitrogen atom.

In one or more embodiments, the condensed cyclic compound may be a metal-free compound. For example, in some embodiments, the condensed cyclic compound may not comprise (e.g., may exclude) a metal atom as a constituent atom.

In one or more embodiments, the condensed cyclic compound may be a thermally activated delayed fluorescence (TADF) compound.

In one or more embodiments, the condensed cyclic compound may satisfy Expression 2:

**Expression 2**

$$\Delta E_{ST} = E(S_1) - E(T_1) < 0.2 \text{ eV},$$

wherein, in Expression 2,

$E(S_1)$ indicates a singlet energy level (eV) of the condensed cyclic compound, and
$E(T_1)$ indicates a triplet energy level (eV) of the condensed cyclic compound.

In one or more embodiments, the surface area and the volume of the condensed cyclic compound may each be calculated by Connolly surface analysis.

In one or more embodiments, the Connolly surface analysis may be performed under conditions of a grid interval of about 0.15 Å, a Van Der Waals scale factor of about 1.0 Å, and a solvent radius (probe) of about 1.4 Å.

In one or more embodiments, the condensed cyclic compound may satisfy Expression 3:

**Expression 3**

$$SA_1/V_1 < SA_D/V_D * 0.90,$$

wherein, in Expression 3,

$SA_1$ indicates a surface area of the condensed cyclic compound, and $V_1$ indicates a volume of the condensed cyclic compound, and
$SA_D$ indicates a surface area of DABNA-1, and $V_D$ indicates a volume of DABNA-1.

DABNA-1 is a compound having the following structure:

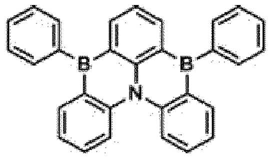

DABNA-1

In one or more embodiments, the condensed cyclic compound may be represented by Formula 1:

Formula 1

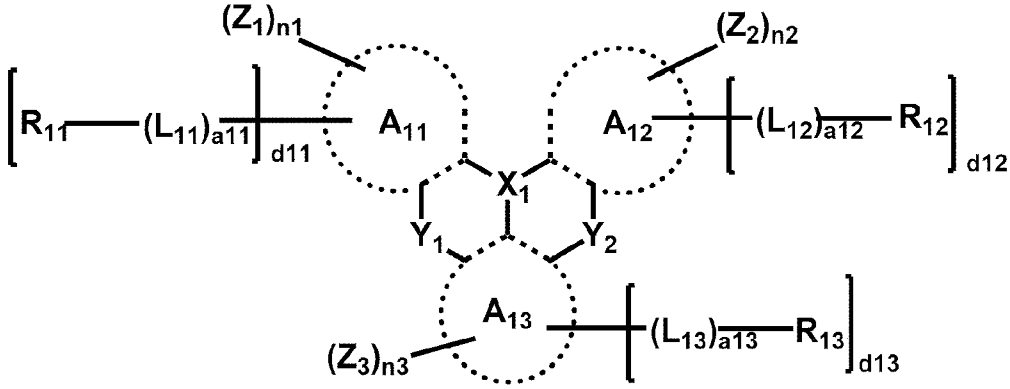

,

wherein, in Formula 1,

$A_{11}$ to $A_{13}$ may each independently be a $C_3$-$C_{30}$ carbocyclic group or a $C_2$-$C_{30}$ heterocyclic group.
$X_1$ may be B, P(=O), or P(=S),
$Y_1$ may be O, S, Se, or N($E_1$), and
$Y_2$ may be O, S, Se, or N($E_2$).
For example, in some embodiments, $Y_1$ may be N($E_1$), and $Y_2$ may be N($E_2$).
$E_1$ may be *-$(L_{14})_{a14}$-$R_{14}$, and $E_2$ may be *-$(L_{15})_{a15}$-$R_{15}$.
$L_{11}$ to $L_{15}$ may each independently be a single bond, a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$.

In Formula 1, a11 to a15 indicate the number of $L_{11}$ to the number of $L_{15}$, respectively, and a11 to a15 may each independently be an integer from 1 to 5. When a11 is 2 or more, two or more of $L_{11}$(s) may be identical to or different from each other, when a12 is 2 or more, two or more of $L_{12}$(s) may be identical to or different from each other, when a13 is 2 or more, two or more of $L_{13}$(s) may be identical to or different from each other, when a14 is 2 or more, two or more of $L_{14}$(s) may be identical to or different from each other, and when a15 is 2 or more, two or more of $L_{15}$(s) may be identical to or different from each other.

$R_{11}$ to $R_{15}$ may each independently be hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_1$-$C_{60}$ alkylthio group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, -C($Q_1$)($Q_2$)($Q_3$),-Si($Q_1$)($Q_2$)($Q_3$), -N($Q_1$)($Q_2$), -B($Q_1$)($Q_2$), -C(=O)($Q_1$), -S(=O)$_2$($Q_1$), or -P(=O)($Q_1$)($Q_2$).

In one or more embodiments, $R_{11}$ to $R_{15}$ may each independently be: hydrogen, deuterium, -F, -Cl, -Br, -I, a hydroxyl group, a cyano group, a nitro group, an amidino group, a hydrazine group, a hydrazone group, a $C_1$-$C_{20}$ alkyl group, or a $C_1$-$C_{20}$ alkoxy group;

a $C_1$-$C_{20}$ alkyl group or a $C_1$-$C_{20}$ alkoxy group, each substituted with deuterium, -F,-Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a $C_1$-$C_{10}$ alkyl group, a cyclopentyl group, a cyclohexyl group, a cycloheptyl group, a cyclooctyl

group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a ($C_1$-$C_{10}$ alkyl)phenyl group, a naphthyl group, a tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a benzoisoquinolinyl group, a phthalazinyl group, a naphthylidinyl group, a quinoxalinyl group, a benzoquinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a thiadiazolyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium, -F, -Cl, -Br, -I, $-CD_3$, $-CD_2H$, $-CDH_2$, $-CF_3$, $-CF_2H$, - $CFH_2$, a hydroxyl group, a cyano group, a nitro group, an amidino group, a hydrazine group, a hydrazone group, a $C_1$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a ($C_1$-$C_{10}$ alkyl)phenyl group, a naphthyl group, a tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a benzoisoquinolinyl group, a phthalazinyl group, a naphthylidinyl group, a quinoxalinyl group, a benzoquinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a thiadiazolyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, $-Si(Q_{31})(Q_{32})(Q_{33})$, $-B(Q_{31})(Q_{32})$, $-P(Q_{31})(Q_{32})$, $-C(=O)(Q_{31})$,$-S(=O)_2(Q_{31})$, $-P(=O)(Q_{31})(Q_{32})$, or any combination thereof; or

$-C(Q_1)(Q_2)(Q_3)$, $-Si(Q_1)(Q_2)(Q_3)$, $-N(Q_1)(Q_2)$, $-B(Q_1)(Q_2)$, $-C(=O)(Q_1)$, $-S(=O)_2(Q_1)$, or $-P(=O)(Q_1)(Q_2)$.

In one or more embodiments, $R_{11}$ to $R_{15}$ may each independently be:

hydrogen, deuterium, -F, -Cl, -Br, -I, $-CD_3$, $-CD_2H$, $-CDH_2$, $-CF_3$, $-CF_2H$, $-CFH_2$, a cyano group, a nitro group, a $C_1$-$C_{60}$ alkyl group, a $C_2$-$C_{60}$ alkenyl group, a $C_2$-$C_{60}$ alkynyl group, or a $C_1$-$C_{60}$ alkoxy group;

a group represented by one selected from among Formulae 9-1 to 9-61 or a group represented by one selected from among Formulae 10-1 to 10-348; or

$-C(Q_1)(Q_2)(Q_3)$, $-Si(Q_1)(Q_2)(Q_3)$, $-N(Q_1)(Q_2)$, $-B(Q_1)(Q_2)$, $-C(=O)(Q_1)$, $-S(=O)_2(Q_1)$, or $-P(=O)(Q_1)(Q_2)$:

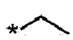
9-1
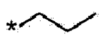
9-2
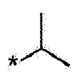
9-3
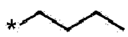
9-4
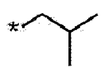
9-5
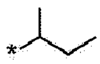
9-6
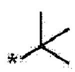
9-7
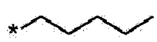
9-8

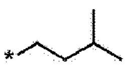
9-9
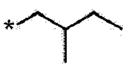
9-10
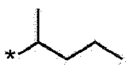
9-11
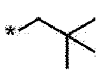
9-12
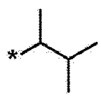
9-13
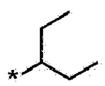
9-14
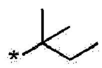
9-15

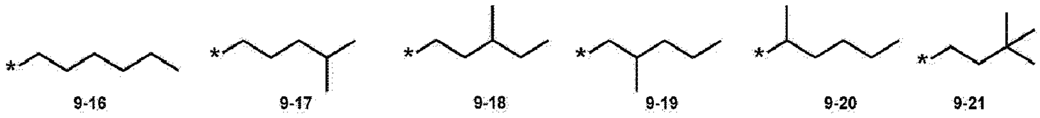

9-16 9-17 9-18 9-19 9-20 9-21

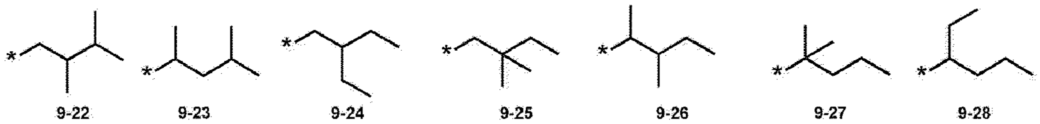

9-22 9-23 9-24 9-25 9-26 9-27 9-28

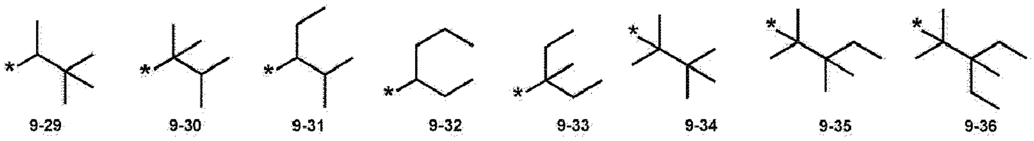

9-29 9-30 9-31 9-32 9-33 9-34 9-35 9-36

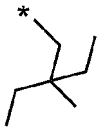
9-37

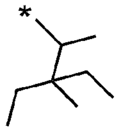
9-38

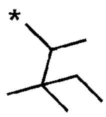
9-39

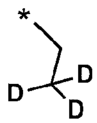
9-40

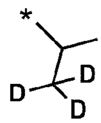
9-41

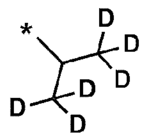
9-42

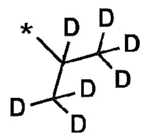
9-43

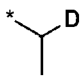
9-44

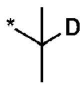
9-45

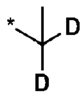
9-46

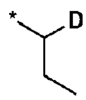
9-47

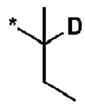
9-48

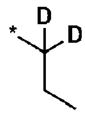
9-49

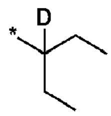
9-50

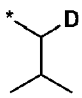
9-51

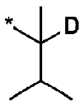
9-52

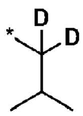
9-53

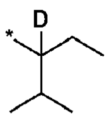
9-54

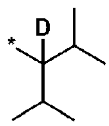
9-55

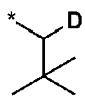
9-56

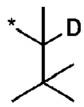
9-57

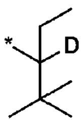
9-58

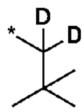
9-59

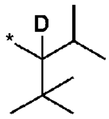
9-60

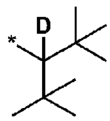
9-61

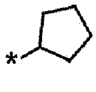
10-1

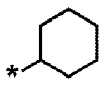
10-2

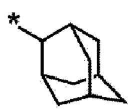
10-3

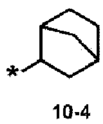
10-4

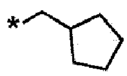
10-5

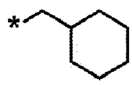
10-6

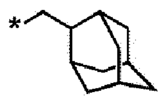
10-7

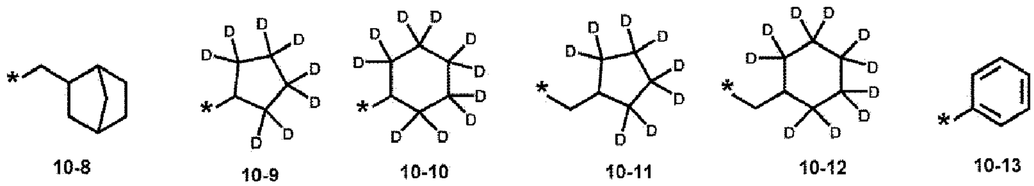

10-8 10-9 10-10 10-11 10-12 10-13

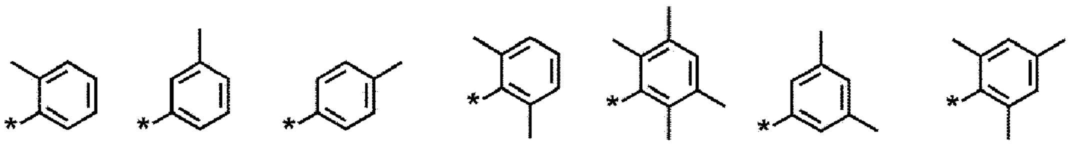

10-14 10-15 10-16 10-17 10-18 10-19 10-20

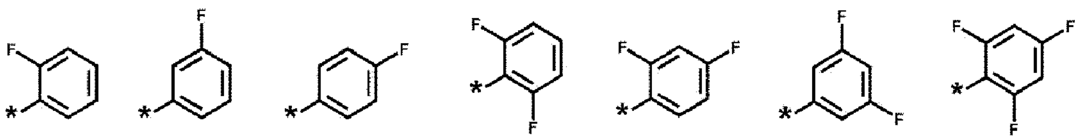

10-21 10-22 10-23 10-24 10-25 10-26 10-27

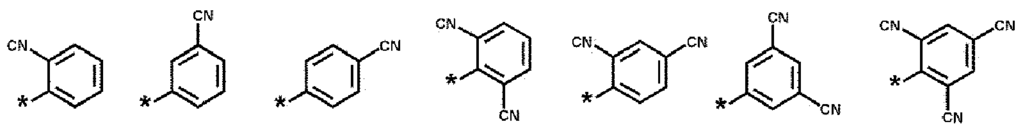

10-28 10-29 10-30 10-31 10-32 10-33 10-34

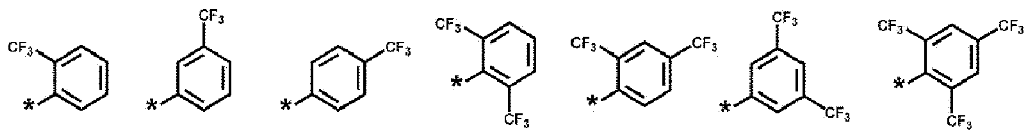

10-35 10-36 10-37 10-38 10-39 10-40 10-41

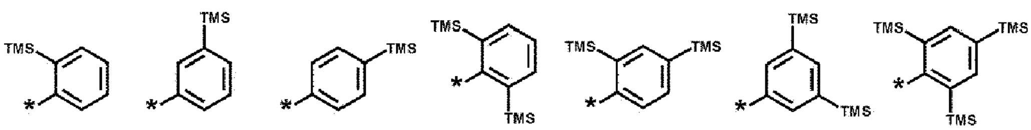

10-42 10-43 10-44 10-45 10-46 10-47 10-48

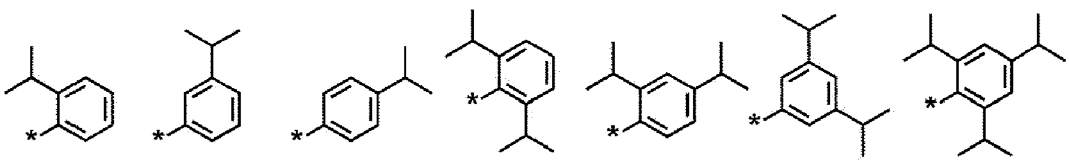

10-49 10-50 10-51 10-52 10-53 10-54 10-55

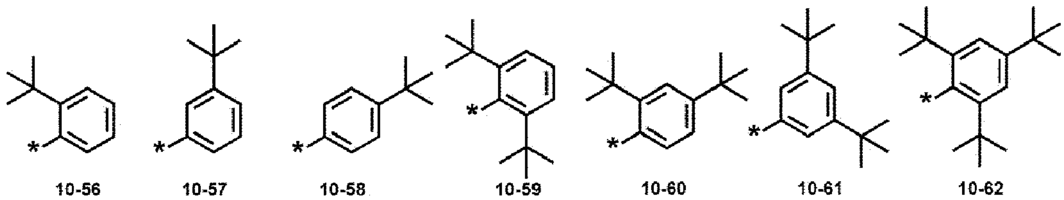

10-56 10-57 10-58 10-59 10-60 10-61 10-62

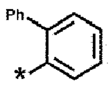
10-63
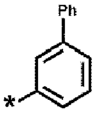
10-64
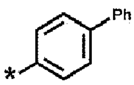
10-65
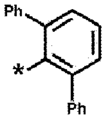
10-66
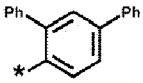
10-67
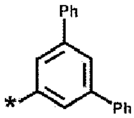
10-68
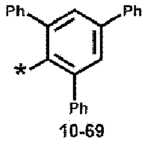
10-69

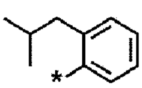
10-70
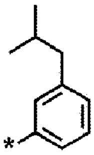
10-71
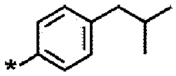
10-72
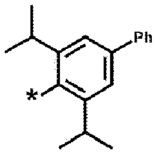
10-73
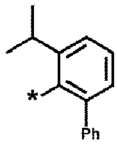
10-74
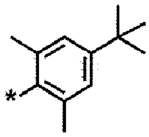
10-75

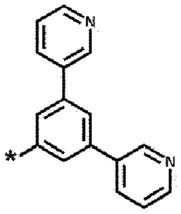
10-76
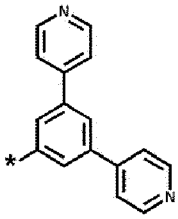
10-77
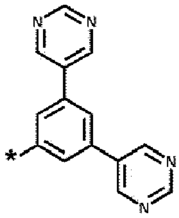
10-78
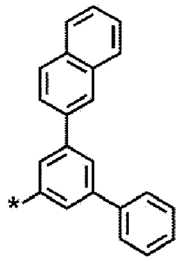
10-79
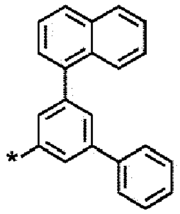
10-80

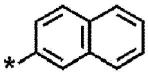
10-81
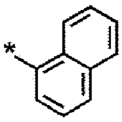
10-82
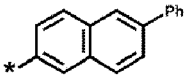
10-83
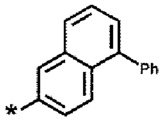
10-84
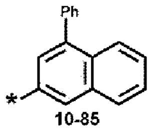
10-85

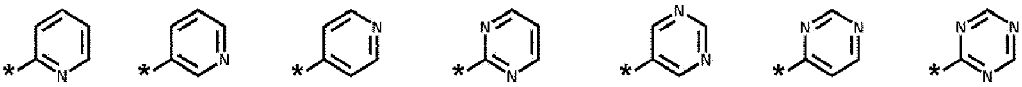
10-86 10-87 10-88 10-89 10-90 10-91 10-92

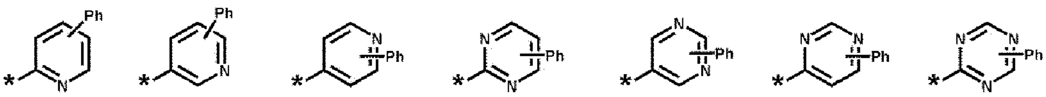
10-93 10-94 10-95 10-96 10-97 10-98 10-99

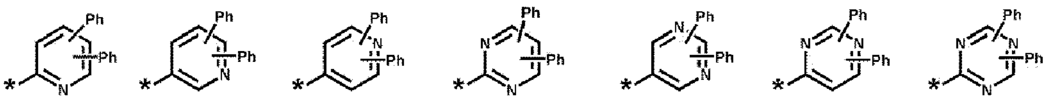
10-100 10-101 10-102 10-103 10-104 10-105 10-106

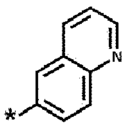
10-107
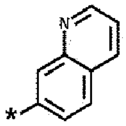
10-108
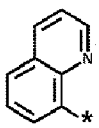
10-109
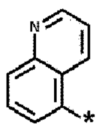
10-110
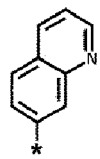
10-111
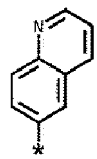
10-112

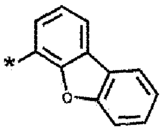
10-113
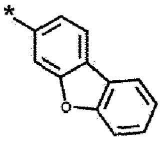
10-114
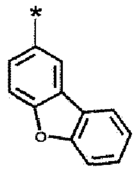
10-115
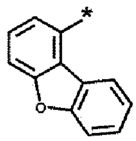
10-116
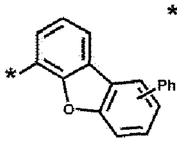
10-117
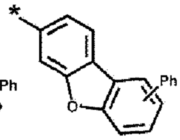
10-118

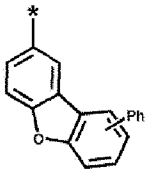
10-119
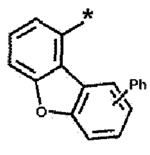
10-120
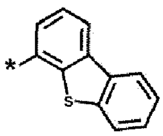
10-121
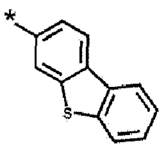
10-122
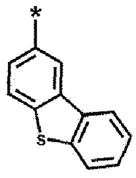
10-123
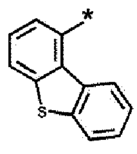
10-124

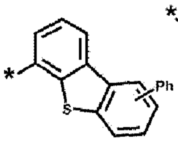
10-125
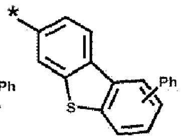
10-126
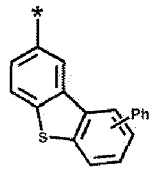
10-127
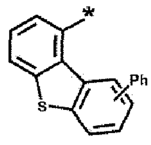
10-128
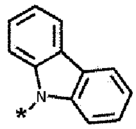
10-129
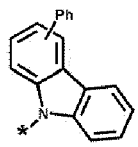
10-130

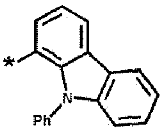
10-131
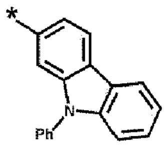
10-132
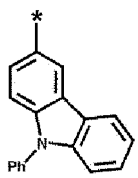
10-133
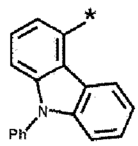
10-134
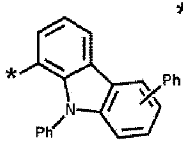
10-135
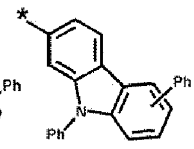
10-136

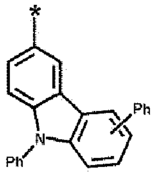
10-137
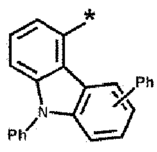
10-138
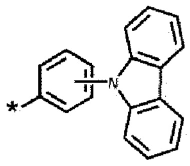
10-139
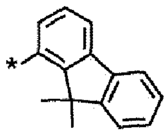
10-140
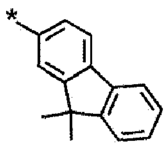
10-141
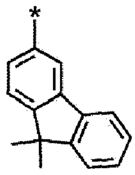
10-142

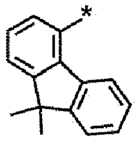
10-143
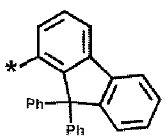
10-144
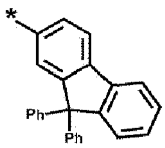
10-145
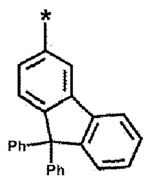
10-146
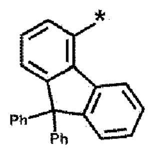
10-147

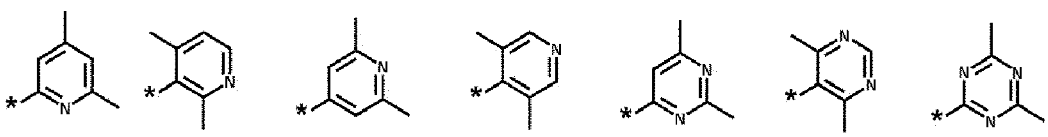
10-148
10-149
10-150
10-151
10-152
10-153
10-154

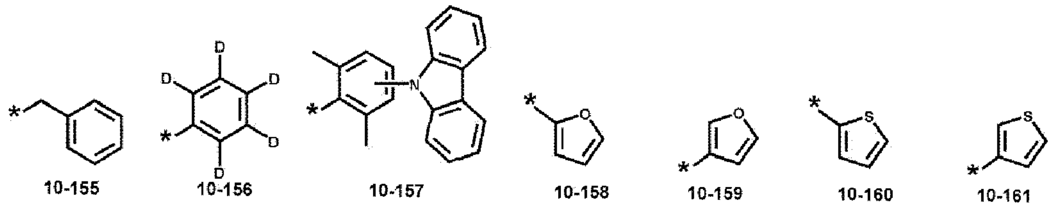

10-155 10-156 10-157 10-158 10-159 10-160 10-161

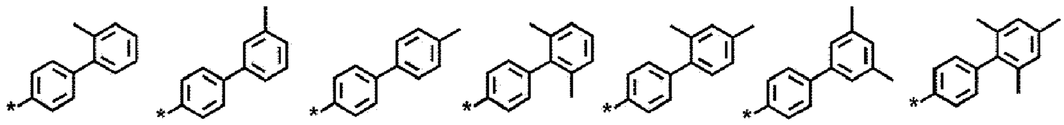

10-162 10-163 10-164 10-165 10-166 10-167 10-168

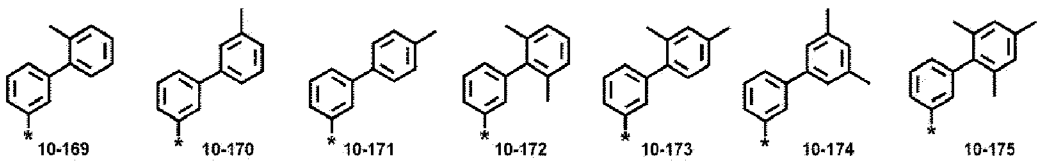

10-169 10-170 10-171 10-172 10-173 10-174 10-175

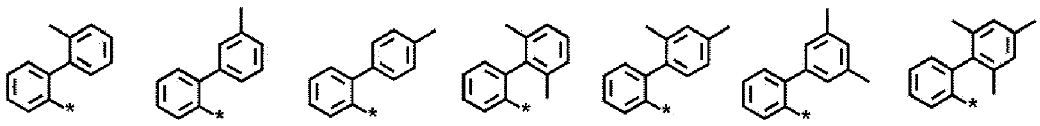

10-176 10-177 10-178 10-179 10-180 10-181 10-182

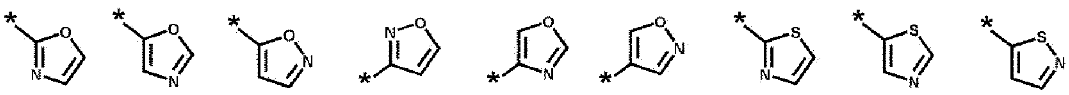

10-183 10-184 10-185 10-186 10-187 10-188 10-189 10-190 10-191

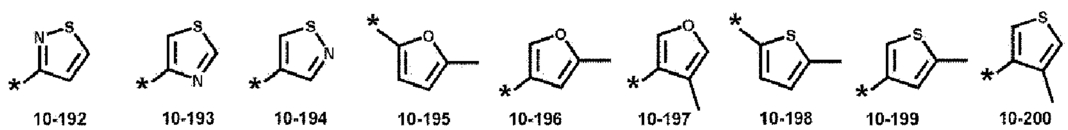

10-192 10-193 10-194 10-195 10-196 10-197 10-198 10-199 10-200

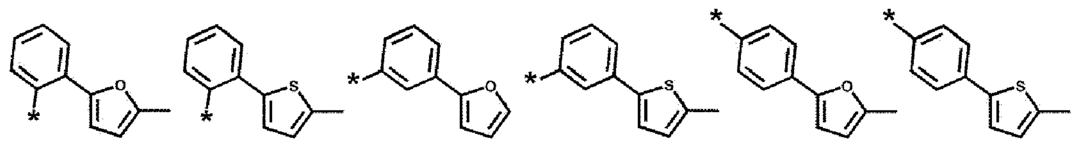

10-201 10-202 10-203 10-204 10-205 10-206

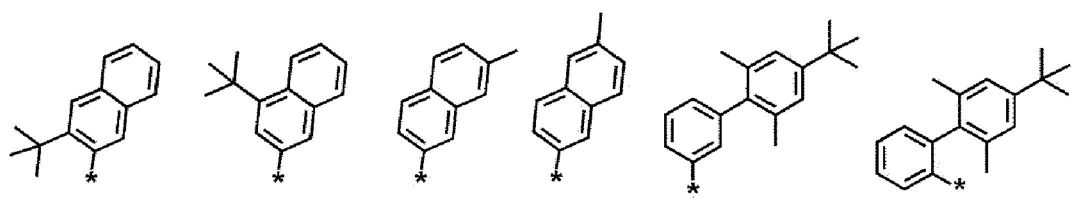

10-207 10-208 10-209 10-210 10-211 10-212

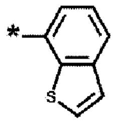
10-213

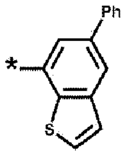
10-214

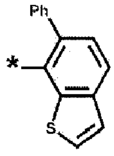
10-215

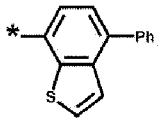
10-216

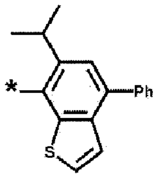
10-217

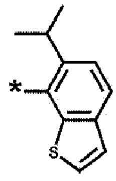
10-218

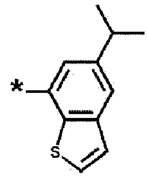
10-219

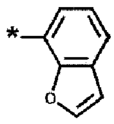
10-220

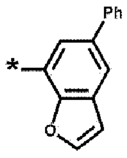
10-221

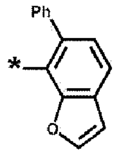
10-222

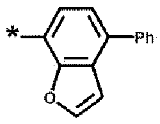
10-223

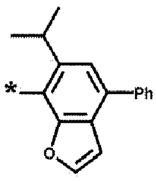
10-224

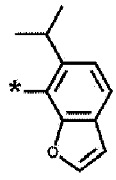
10-225

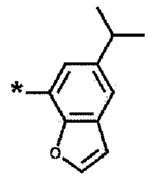
10-226

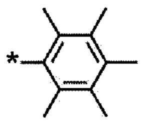
10-227

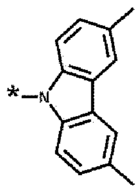
10-228

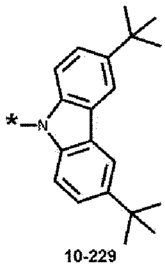
10-229

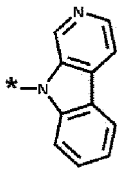
10-230

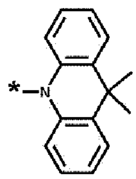
10-231

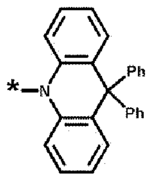
10-232

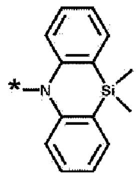
10-233

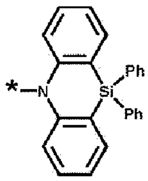
10-234

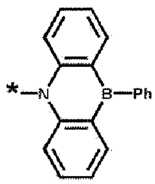
10-235

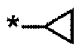
10-236

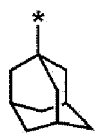
10-237

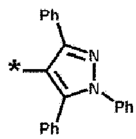
10-238

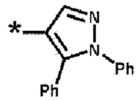
10-239

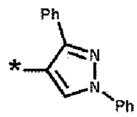
10-240

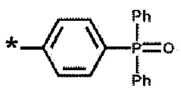
10-241

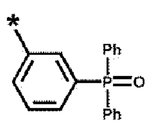
10-242

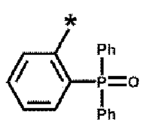
10-243

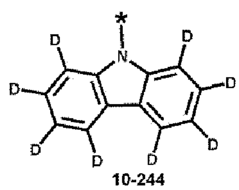
10-244

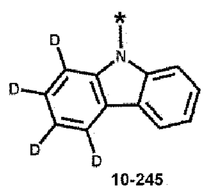
10-245

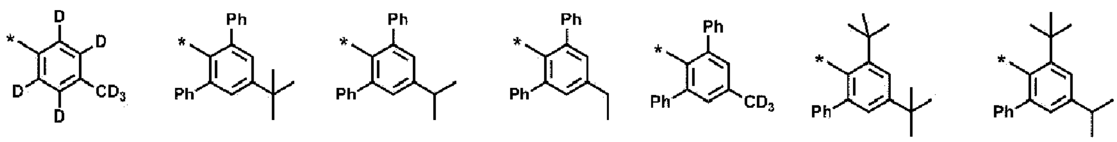
10-246 10-247 10-248 10-249 10-250 10-251 10-252

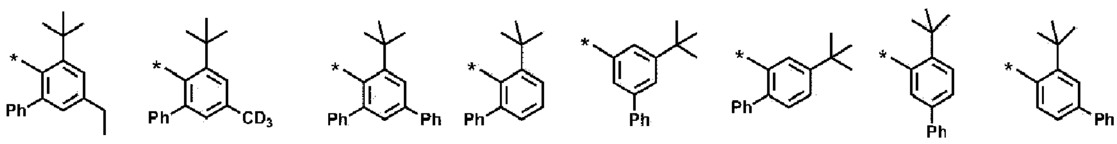
10-253 10-254 10-255 10-256 10-257 10-258 10-259 10-260

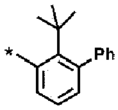 10-261 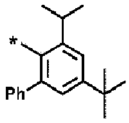 10-262 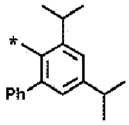 10-263 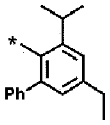 10-264 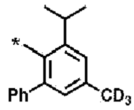 10-265 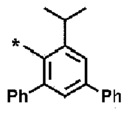 10-266 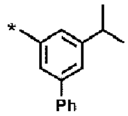 10-267

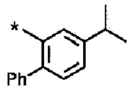 10-268 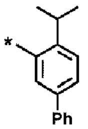 10-269 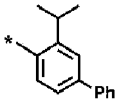 10-270 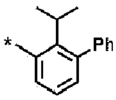 10-271 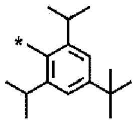 10-272 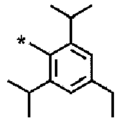 10-273 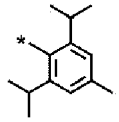 10-274

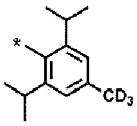 10-275 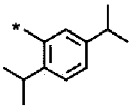 10-276 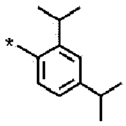 10-277 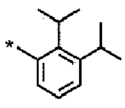 10-278 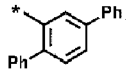 10-279 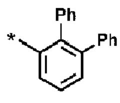 10-280

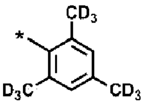 10-281 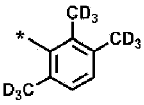 10-282 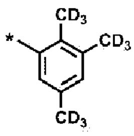 10-283 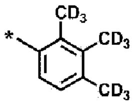 10-284 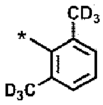 10-285 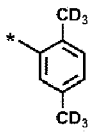 10-286 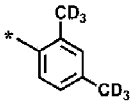 10-287

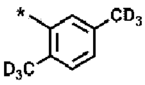 10-288 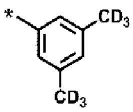 10-289 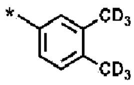 10-290 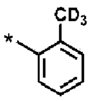 10-291 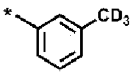 10-292 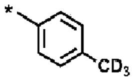 10-293

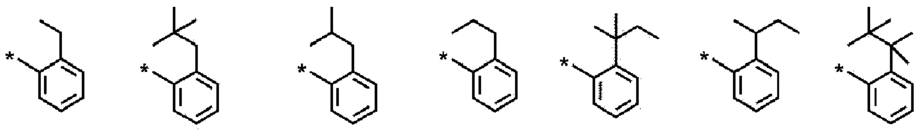

10-294 10-295 10-296 10-297 10-298 10-299 10-300

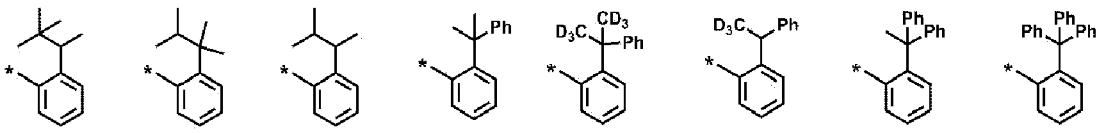

10-301 10-302 10-303 10-304 10-305 10-306 10-307 10-308

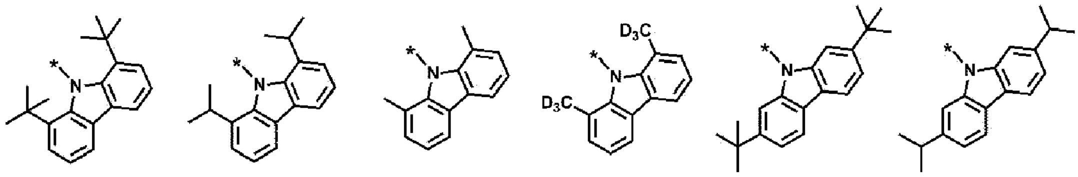

10-309 10-310 10-311 10-312 10-313 10-314

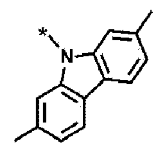
10-315
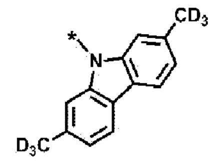
10-316
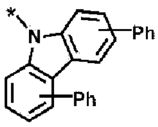
10-317
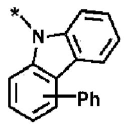
10-318
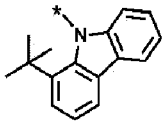
10-319
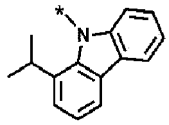
10-320

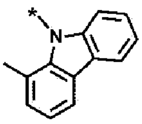
10-321
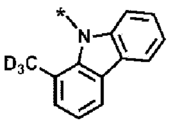
10-322
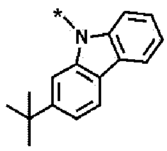
10-323
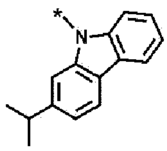
10-324
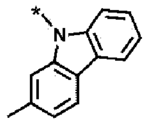
10-325
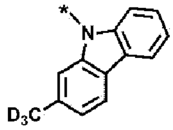
10-326

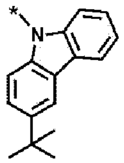
10-327
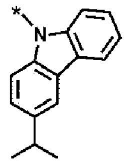
10-328
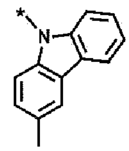
10-329
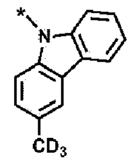
10-330
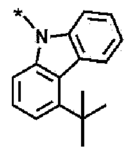
10-331
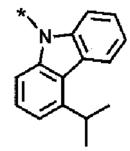
10-332

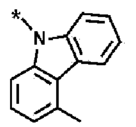
10-333
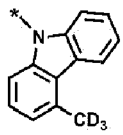
10-334
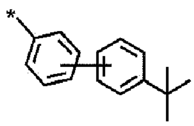
10-335
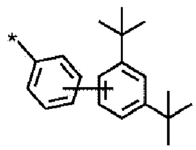
10-336
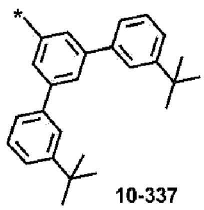
10-337

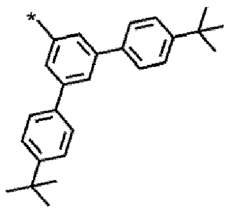
10-338
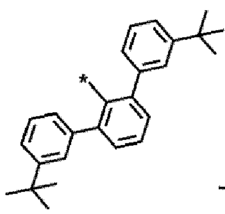
10-339
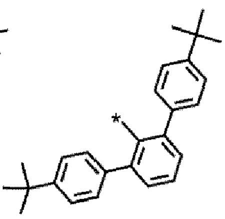
10-340
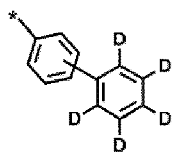
10-341
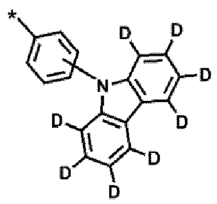
10-342

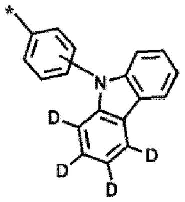
10-343
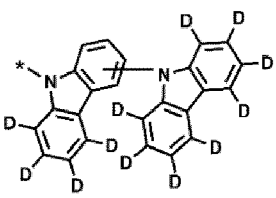
10-344
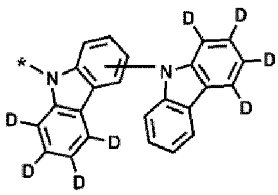
10-345
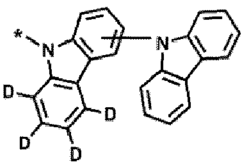
10-346

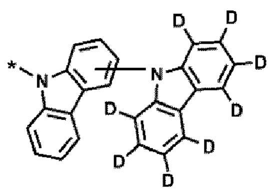

10-347

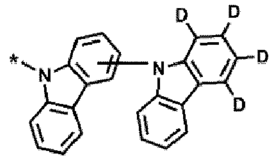

10-348

wherein, in Formulae 9-1 to 9-61 and 10-1 to 10-348, * indicates a binding site to a neighboring atom, Ph indicates a phenyl group, TMS indicates a trimethylsilyl group, D indicates deuterium, and $Q_1$ to $Q_3$ may each be as defined herein.

In Formula 1, d11 to d13 indicate the number of $R_{11}$ to the number of $R_{13}$, respectively, and d11 to d13 may each independently be an integer from 0 to 20. When d11 is 2 or more, two or more of $R_{11}$(s) may be identical to or different from each other, when d12 is 2 or more, two or more of $R_{12}$(s) may be identical to or different from each other, and when d13 is 2 or more, two or more of $R_{13}$(s) may be identical to or different from each other.

$Z_1$ to $Z_3$ may each independently be deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_1$-$C_{60}$ alkylthio group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, $-C(Q_1)(Q_2)(Q_3)$, $-Si(Q_1)(Q_2)(Q_3)$, $-N(Q_1)(Q_2)$, $-B(Q_1)(Q_2)$,$-C(=O)(Q_1)$, $-S(=O)_2(Q_1)$, or $-P(=O)(Q_1)(Q_2)$.

In one or more embodiments, $Z_1$ to $Z_3$ may each independently be a substituent other than hydrogen.

In Formula 1, n1 to n3 indicate the number of $Z_1$ to the number of $Z_3$, respectively, and n1 to n3 may each independently be an integer from 0 to 3. When n1 is 2 or more, two or more of $Z_1$(s) may be identical to or different from each other, when n2 is 2 or more, two or more of $Z_2$(s) may be identical to or different from each other, and when n3 is 2 or more, two or more of $Z_3$(s) may be identical to or different from each other.

Two or more neighboring groups of $R_{11}$ in the number of d11, $R_{12}$ in the number of d12, $R_{13}$ in the number of d13, $R_{14}$, $R_{15}$, and $Z_1$ to $Z_3$ may optionally be bonded to each other to form a $C_5$-$C_{60}$ carbocyclic group unsubstituted or substituted with at least one $R_{10a}$ or a $C_2$-$C_{60}$ heterocyclic group unsubstituted or substituted with at least one $R_{10a}$.

For example, in one or more embodiments, in Formula 1, i) two or more of $R_{11}$ in the number of d11, $R_{14}$, and $Z_1$ may optionally be bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$, ii) two or more of $R_{12}$ in the number of d12, $R_{15}$, and $Z_2$ may optionally be bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$, iii) two or more of $R_{13}$ in the number of d13, $R_{14}$, $R_{15}$, $Z_1$, and $Z_2$ may optionally be bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$, iv) two or more of $R_{11}$ in the number of d11 and $R_{12}$ in the number of d12 may optionally be bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$, and v) $Z_1$ and $Z_2$ may optionally be bonded to each other to form a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$, wherein $R_{10a}$ may be as defined herein.

* indicates a binding site to a neighboring atom.

"$R_{10a}$" utilized herein may be:

deuterium, -F, -Cl, -Br, -I, a hydroxyl group, a cyano group, or a nitro group;

a $C_1$-$C_{60}$ alkyl group, a $C_2$-$C_{60}$ alkenyl group, a $C_2$-$C_{60}$ alkynyl group, or a $C_1$-$C_{60}$ alkoxy group, each unsubstituted or substituted with deuterium, -F, -Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ arylalkyl group, a $C_2$-$C_{60}$ heteroarylalkyl group, $-Si(Q_{11})(Q_{12})(Q_{13})$, $-N(Q_{11})(Q_{12})$, $-B(Q_{11})(Q_{12})$, $-C(=O)(Q_{11})$, $-S(=O)_2(Q_{11})$,$-P(=O)(Q_{11})(Q_{12})$, or any combination thereof;

a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ arylalkyl group, or a $C_2$-$C_{60}$ heteroarylalkyl group, each unsubstituted or substituted with deuterium, -F, -Cl, -Br, -I,

a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ arylalkyl group, a $C_2$-$C_{60}$ heteroarylalkyl group,-Si($Q_{21}$)($Q_{22}$)($Q_{23}$), -N($Q_{21}$)($Q_{22}$), -B($Q_{21}$)($Q_{22}$), -C(=O)($Q_{21}$), -S(=O)$_2$($Q_{21}$), -P(=O)($Q_{21}$)($Q_{22}$), or any combination thereof; or
-Si($Q_{31}$)($Q_{32}$)($Q_{33}$), -N($Q_{31}$)($Q_{32}$), -B($Q_{31}$)($Q_{32}$), -C(=O)($Q_{31}$), -S(=O)$_2$($Q_{31}$), or-P(=O)($Q_{31}$)($Q_{32}$).

"$Q_1$ to $Q_3$, $Q_{11}$ to $Q_{13}$, $Q_{21}$ to $Q_{23}$, and $Q_{31}$ to $Q_{33}$" utilized herein may each independently be: hydrogen; deuterium; -F; -Cl; -Br; -I; a hydroxyl group; a cyano group; a nitro group; a $C_1$-$C_{60}$ alkyl group; a $C_2$-$C_{60}$ alkenyl group; a $C_2$-$C_{60}$ alkynyl group; a $C_1$-$C_{60}$ alkoxy group; a $C_3$-$C_{60}$ carbocyclic group or a $C_1$-$C_{60}$ heterocyclic group, each unsubstituted or substituted with deuterium, -F, a cyano group, a $C_1$-$C_{60}$ alkyl group, a $C_1$-$C_{60}$ alkoxy group, a phenyl group, a biphenyl group, or any combination thereof; a $C_7$-$C_{60}$ arylalkyl group; or a $C_2$-$C_{60}$ heteroarylalkyl group.

In one or more embodiments, the condensed cyclic compound represented by Formula 1 may satisfy at least one selected from among Conditions 1 to 5:

**Condition 1**
$Y_1$ is N($E_1$), and $E_1$ is a group represented by Formula 2;

**Condition 2**
$Y_2$ is N($E_2$), and $E_2$ is a group represented by Formula 2;

**Condition 3**
n1 is an integer of 1 or more;

**Condition 4**
n2 is an integer of 1 or more; and

**Condition 5**
n3 is an integer of 1 or more:

**Formula 2**

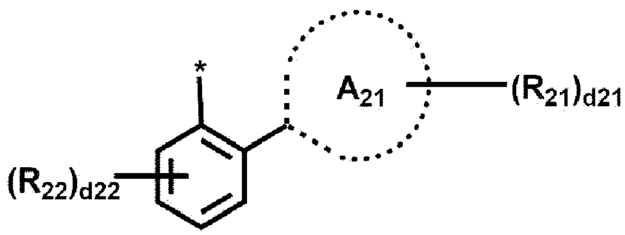

,

wherein, in Formula 2,

$A_{21}$ may be a $C_3$-$C_{30}$ carbocyclic group or a $C_2$-$C_{30}$ heterocyclic group,
$R_{21}$ and $R_{22}$ may each independently be the same as defined herein with respect to $R_{11}$,
d21 may be an integer from 0 to 20,
d22 may be an integer from 0 to 4, and
* indicates a binding site to a neighboring atom.

In one or more embodiments, the sum of n1, n2, and n3 may be an integer of 1 or more (for example, 1, 2, 3, 4, 5, etc.).

In one or more embodiments, the sum of n1 and n2 may be an integer of 2 or more (for example, 2, 3, 4, 5, etc.).

In one or more embodiments, the group represented by Formula 2 may be a group represented by Formula 2-1:

**Formula 2-1**

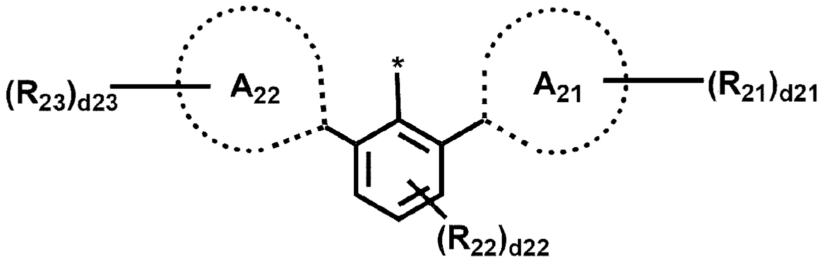

,

wherein, in Formula 2-1,

$A_{21}$ and $A_{22}$ may each independently be a $C_3$-$C_{30}$ carbocyclic group or a $C_2$-$C_{30}$ heterocyclic group,
$R_{21}$ to $R_{23}$ may each independently be the same as defined herein with respect to $R_{11}$,
d21 and d23 may each independently be an integer from 0 to 20,
d22 may be an integer from 0 to 3, and
* indicates a binding site to a neighboring atom.

In one or more embodiments, in Formula 1, $Y_1$ may be $N(E_1)$, and $E_1$ may be a group represented by Formula 2-1.
In one or more embodiments, in Formula 1, $Y_2$ may be $N(E_2)$, and $E_2$ may be a group represented by Formula 2-1.
In one or more embodiments, in Formula 1,
**[0061]** $Z_1$ and $Z_2$ may each independently be a group represented by Formula 4:

**Formula 4**

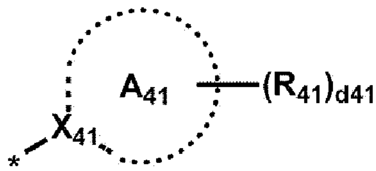

,

wherein, in Formula 4,

$X_{41}$ may be C or N,
$A_{41}$ may be a $C_3$-$C_{30}$ carbocyclic group or a $C_2$-$C_{30}$ heterocyclic group,
$R_{41}$ may be the same as defined herein with respect to $R_{11}$, and
d41 may be an integer from 0 to 20.

In one or more embodiments, the condensed cyclic compound represented by Formula 1 may satisfy Condition 3, and
$Z_1$ may not be a $C_1$-$C_{60}$ alkyl group unsubstituted or substituted with at least one $R_{10a}$, and $R_{10a}$ may be as defined herein.
In one or more embodiments, the condensed cyclic compound represented by Formula 1 may satisfy Condition 4, and
$Z_2$ may not be a $C_1$-$C_{60}$ alkyl group unsubstituted or substituted with at least one $R_{10a}$, and $R_{10a}$ may be as defined herein.
In one or more embodiments, in Formula 1, a moiety represented by

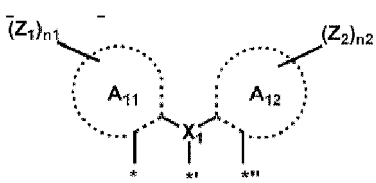

may be represented by one selected from groups represented by Formulae 3-1 to 3-16:

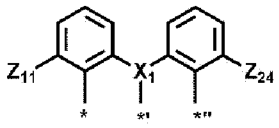

3-1

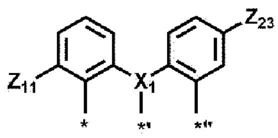

3-2

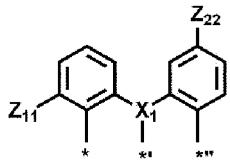

3-3

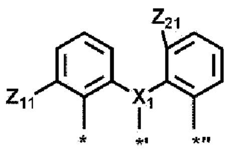

3-4

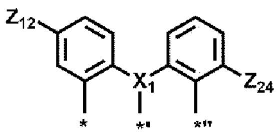

3-5

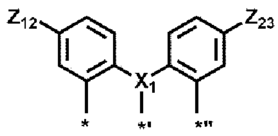

3-6

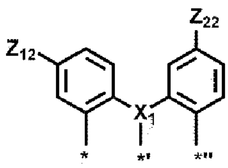

3-7

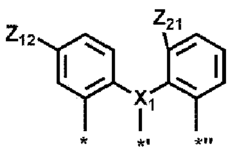

3-8

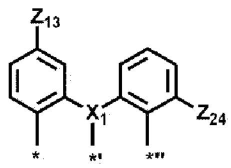

3-9

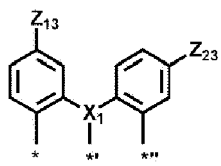

3-10

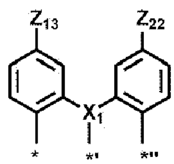

3-11

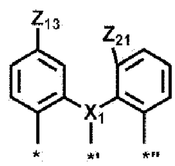

3-12

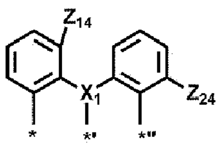

3-13

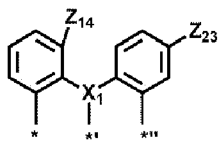

3-14

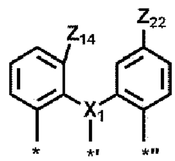

3-15

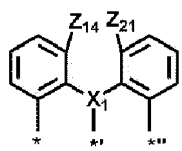

3-16

wherein, in Formulae 3-1 to 3-16,

$Z_{11}$ to $Z_{14}$ may each independently be the same as defined herein with respect to $Z_1$,
$Z_{21}$ to $Z_{24}$ may each independently be the same as defined herein with respect to $Z_2$,

$X_1$ may be as defined herein, and

*, *', and *" each indicate a binding site to a neighboring atom.

In one or more embodiments, in Formula 1, a moiety represented by

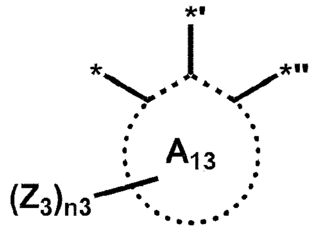

may be one selected from groups represented by Formulae 5-1 to 5-8:

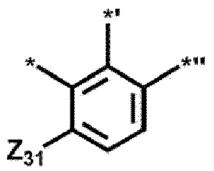

5-1

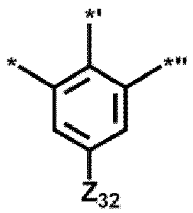

5-2

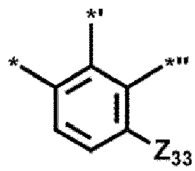

5-3

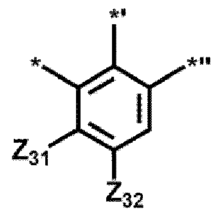

5-4

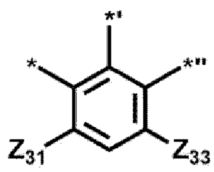

5-5

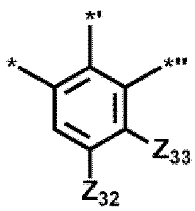

5-6

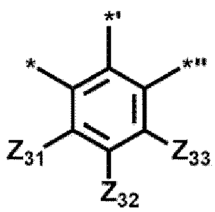

5-7

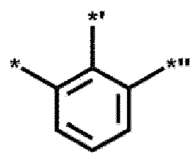

5-8

,

wherein, in Formulae 5-1 to 5-8,

$Z_{31}$ to $Z_{33}$ may each independently be the same as defined herein with respect to $Z_3$, and

*, *', and *" each indicate a binding site to a neighboring atom.

In one or more embodiments, in Formula 1, $Z_3$ may be a $C_1$-$C_{60}$alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$, and

$R_{10a}$ may be as defined herein.

In one or more embodiments, the condensed cyclic compound satisfying Expression 1 may be represented by one selected from Formulae 1-1 to 1-3:

Formula 1-1

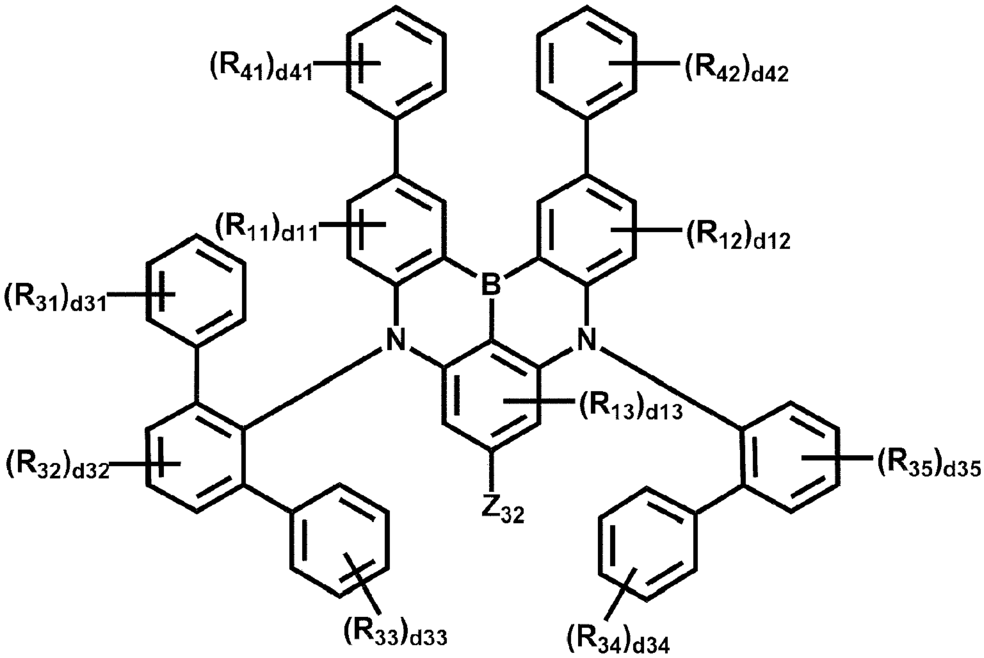

Formula 1-2

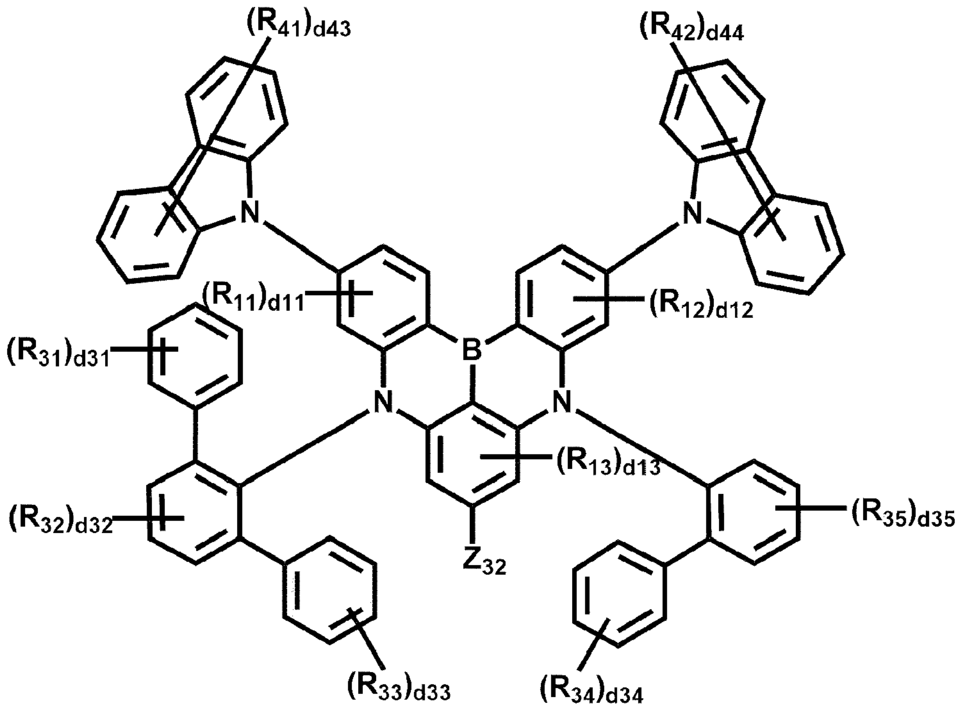

Formula 1-3

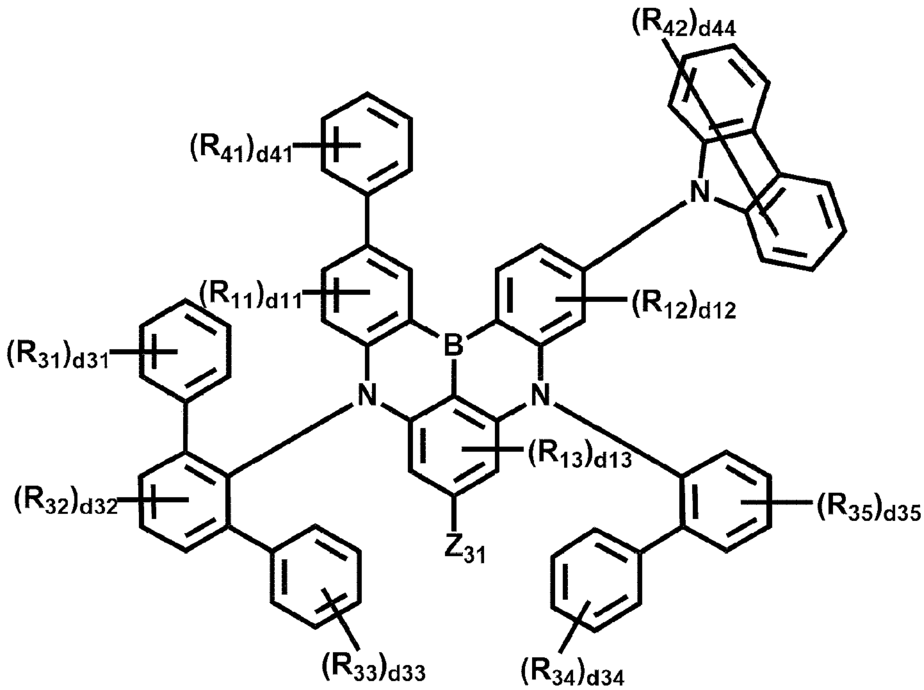

,

wherein, in Formulae 1-1 to 1-3,

$R_{11}$ to $R_{13}$ may each be as defined herein,
$Z_{31}$ may be the same as defined herein with respect to $Z_3$,
$R_{31}$ to $R_{35}$ and $R_{41}$ to $R_{42}$ may each independently be the same as defined herein with respect to $R_{11}$,
d11 and d12 may each independently be an integer from 0 to 3,
d13 may be an integer from 0 to 2,
d31, d33, d34, d41, and d42 may each independently be an integer from 0 to 5,
d32 may be an integer from 0 to 3,
d35 may be an integer from 0 to 4, and
d43 and d44 may each independently be an integer from 0 to 8.

In one or more embodiments, the condensed cyclic compound satisfying Expression 1 may be one selected from Compounds 1 to 21, but embodiments of the present disclosure are not limited thereto:

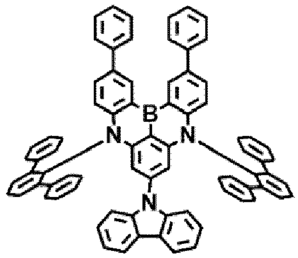

1

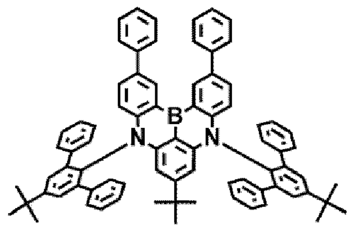

2

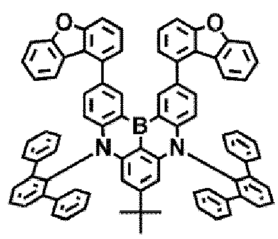

3

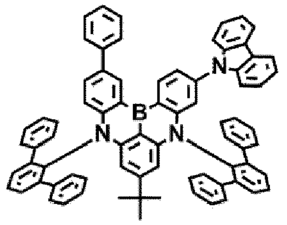

**4**

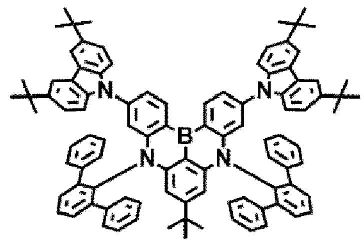

**5**

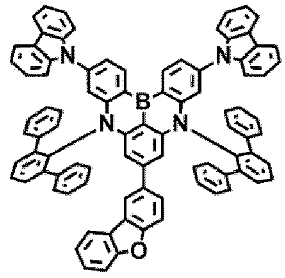

**6**

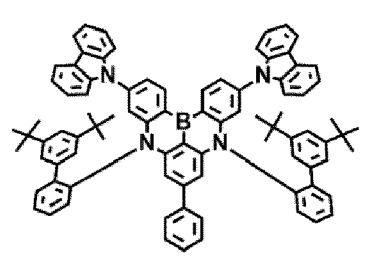

**7**

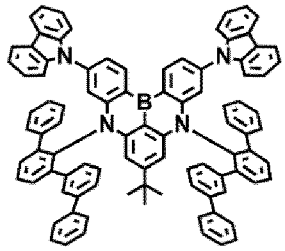

**8**

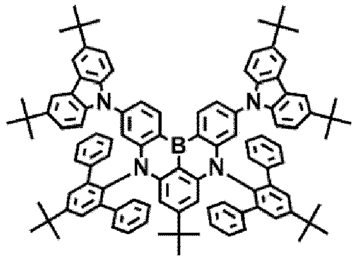

**9**

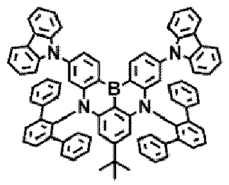

**10**

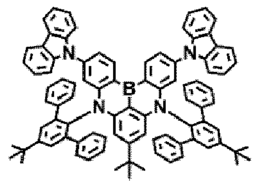

**11**

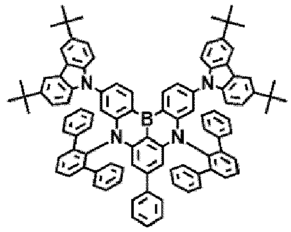

**12**

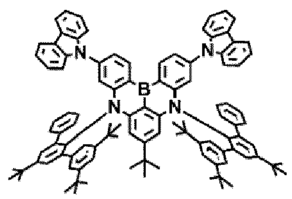

**13**

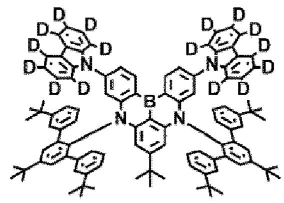

**14**

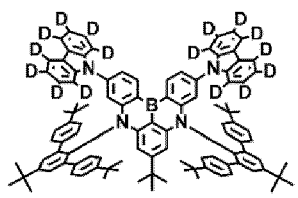

**15**

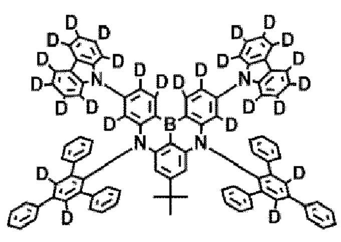

**16**

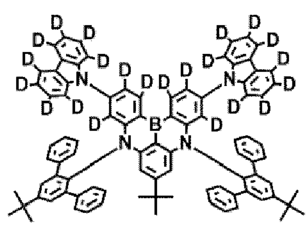

**17**

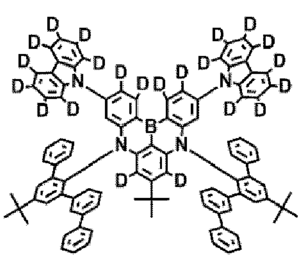

**18**

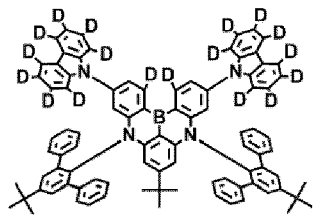

19

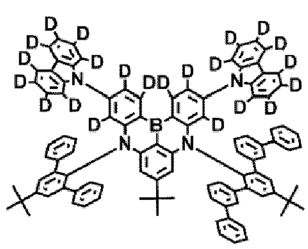

20

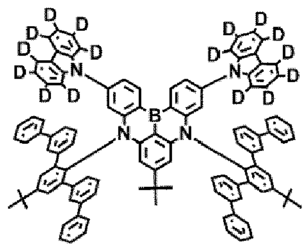

21

Synthesis methods of the condensed cyclic compound may be recognizable by one of ordinary skill in the art by referring to Synthesis Examples and/or Examples provided in the present disclosure.

At least one of the condensed cyclic compounds satisfying Expression 1 may be utilized in a light-emitting device (for example, an organic light-emitting device).

One or more aspects of embodiments of the present disclosure are directed toward a light-emitting device comprising: a first electrode; a second electrode facing the first electrode; an interlayer between the first electrode and the second electrode and comprising an emission layer; and at least one of the condensed cyclic compounds satisfying Expression 1.

In one or more embodiments, the first electrode may be an anode,

the second electrode may be a cathode,

the interlayer may further comprise a hole transport region between the emission layer and the first electrode and an electron transport region between the emission layer and the second electrode,

the hole transport region may comprise a hole injection layer, a hole transport layer, an emission auxiliary layer, an electron blocking layer, or any combination thereof, and

the electron transport region may comprise a buffer layer, a hole blocking layer, an electron control layer, an electron transport layer, an electron injection layer, or any combination thereof.

In one or more embodiments, the emission layer may comprise the condensed cyclic compound.

In one or more embodiments, an amount of the condensed cyclic compound may be greater than 0 parts by weight and less than about 50 parts by weight based on the total weight of 100 parts by weight of the emission layer. For example, in some embodiments, the amount of the condensed cyclic compound may be greater than or equal to about 0.01 parts by weight and less than or equal to about 49.99 parts by weight, greater than or equal to about 0.01 parts by weight and less than or equal to about 33.33 parts by weight, or greater than 0 parts by weight and less than about 1 parts by weight, based on the total weight of 100 parts by weight of the emission layer.

In one or more embodiments, the emission layer may comprise a dopant, and

the dopant may comprise the condensed cyclic compound.

In one or more embodiments, the hole transport region may comprise the condensed cyclic compound.

In one or more embodiments, the electron transport region may comprise the condensed cyclic compound.

In one or more embodiments, the emission layer may be to emit light having a maximum emission wavelength in a range of about 400 nm to about 500 nm.

In one or more embodiments, the emission layer may be to emit blue or blue-green light.

In one or more embodiments, the condensed cyclic compound may be to emit light.

In one or more embodiments, the condensed cyclic compound may be to emit light having a maximum emission wavelength in a range of about 400 nm to about 500 nm.

In one or more embodiments, the condensed cyclic compound may be to emit blue or blue-green light.

In one or more embodiments, the emission layer may further comprise a first compound, a second compound, or any combination thereof.

In one or more embodiments, the first compound may be a hole transporting compound comprising at least one electron donating group, and the second compound may be an electron transporting compound comprising at least one electron withdrawing group.

The term "electron donating group" refers to any moiety capable of donating electrons. For example, the electron donating group may be a $\pi$ electron-rich $C_3$-$C_{60}$ cyclic group or an amine group, but embodiments of the present disclosure are not limited thereto. In one or more embodiments, the electron donating group may refer to a cyclic group that is not a $\pi$ electron-deficient nitrogen-containing $C_1$-$C_{60}$ cyclic group.

The term "electron withdrawing group" refers to any moiety capable of withdrawing electrons. For example, the

electron withdrawing group may be -F, $-CFH_2$, $-CF_2H$, $-CF_3$, -CN,$-NO_2$, a $\pi$ electron-deficient nitrogen-containing $C_1$-$C_{60}$ cyclic group, or any combination thereof, but embodiments of the present disclosure are not limited thereto.

In one or more embodiments, the emission layer may further comprise a third compound, and the third compound may be a metal-containing compound.

In one or more embodiments, the emission layer may further comprise a host.

In one or more embodiments, the host may comprise the first compound, the second compound, or any combination thereof.

In one or more embodiments, the host may comprise the first compound and the second compound, and the first compound and the second compound may act as an exciplex host.

In one or more embodiments, the third compound may act as a sensitizer, for example, a phosphorescent sensitizer.

In one or more embodiments, the third compound may not emit light.

The light emission path (or energy transfer path) of the light-emitting device according to one or more embodiments may be as follows: the first compound and the second compound form an exciton (first step), the energy of the exciton is transferred to the third compound (second step), and then energy is transferred from the third compound to the condensed cyclic compound satisfying Expression 1 of the present disclosure (third step).

In one or more embodiments, an amount of the third compound may be greater than 0 parts by weight and less than about 50 parts by weight based on the total weight of 100 parts by weight of the emission layer.

In one or more embodiments, the first compound may be represented by Formula 301-1A or 301-2A:

**Formula 301-1A**

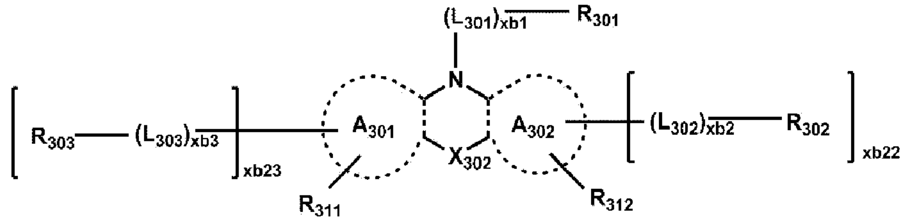

**Formula 301-2A**

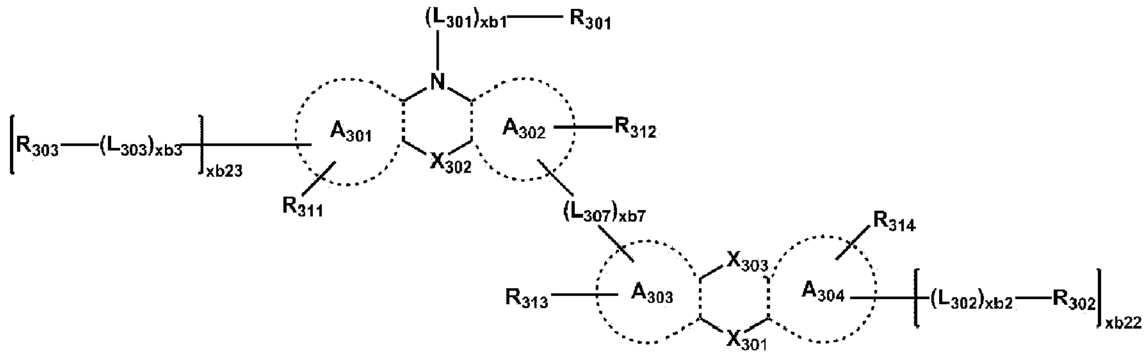

,

wherein, in Formulae 301-1A and 301-2A,

ring $A_{301}$ to ring $A_{304}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
$X_{301}$ may be O, S, N-[$(L_{304})_{xb4}$-$R_{304}$], C($R_{304a}$)($R_{304a}$), or Si($R_{304a}$)($R_{305}$),
$X_{302}$ may be a single bond, O, S, N-[$(L_{305})_{xb5}$-$R_{305a}$], C($R_{305a}$)($R_{305b}$), or Si($R_{305a}$)($R_{305b}$),
$X_{303}$ may be a single bond, O, S, N-[$(L_{306})_{xb6}$-$R_{306a}$], C($R_{306a}$)($R_{306b}$), or Si($R_{306a}$)($R_{306b}$),
xb22 and xb23 may each independently be an integer from 0 to 10,
$L_{301}$ to $L_{307}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
xb1 to xb7 may each independently be an integer from 0 to 5,
$R_{301}$ to $R_{303}$, $R_{304a}$ to $R_{306a}$, $R_{304b}$ to $R_{306b}$, and $R_{311}$ to $R_{314}$ may each independently be hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group

unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$,-Si($Q_{301}$)($Q_{302}$)($Q_{303}$), -N($Q_{301}$)($Q_{302}$), -B($Q_{301}$)($Q_{302}$), -C(=O)($Q_{301}$), -S(=O)$_2$($Q_{301}$), or-P(=O)($Q_{301}$)($Q_{302}$), and
$Q_{301}$ to $Q_{303}$ may each dependently be the same as defined herein with respect to Q1.

In one or more embodiments, the first compound may be at least one selected from Compounds HTH1 to HTH56, but embodiments of the present disclosure are not limited thereto:

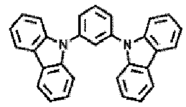
HTH1

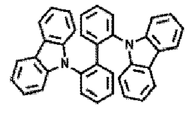
HTH2

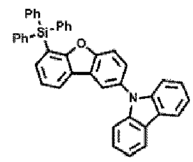
HTH3

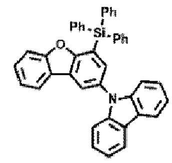
HTH4

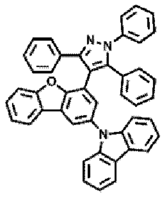
HTH5

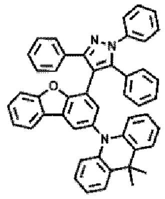
HTH6

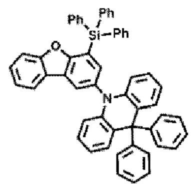
HTH7

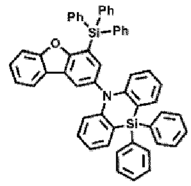
HTH8

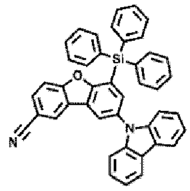
HTH9

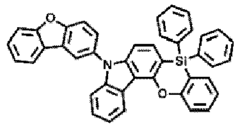
HTH10

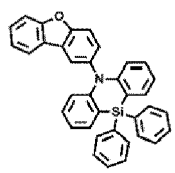
HTH11

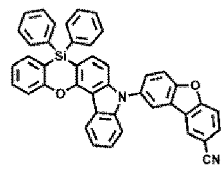
HTH12

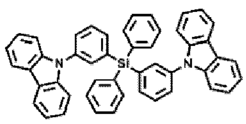
HTH13

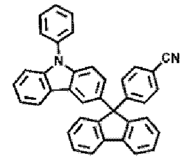
HTH14

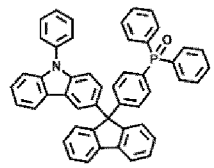
HTH15

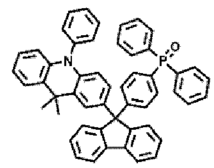
HTH16

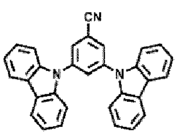
HTH17

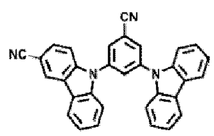
HTH18

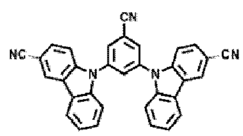
HTH19

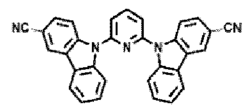
HTH20

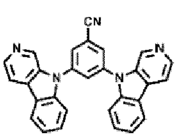
HTH21

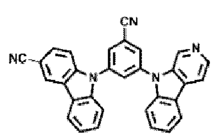
HTH22

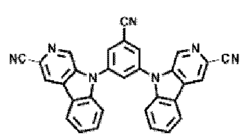
HTH23

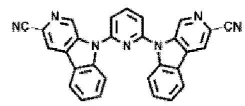
HTH24

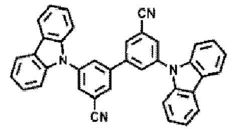
HTH25

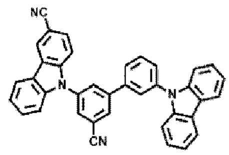
HTH26

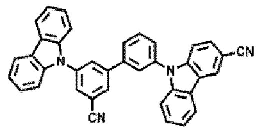
HTH27

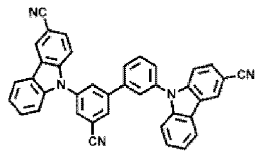
HTH28

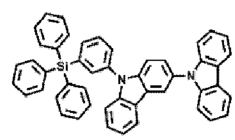
HTH29

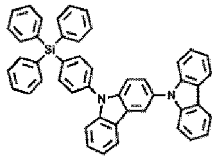
HTH30

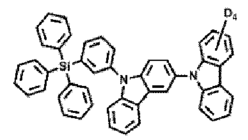
HTH31

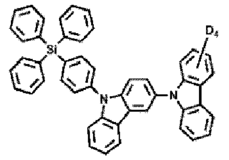
HTH32

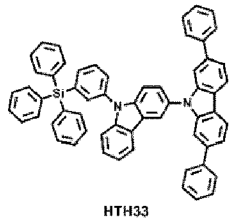
HTH33

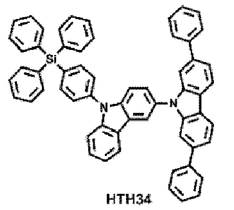
HTH34

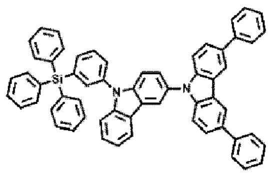
HTH35

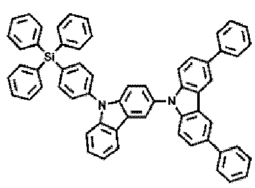
HTH36

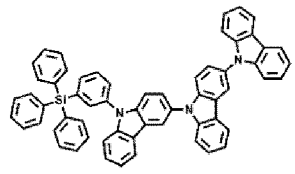
HTH37

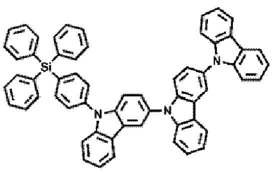
HTH38

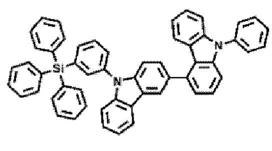
HTH39

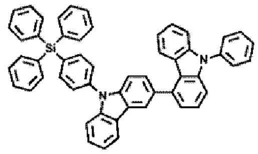
HTH40

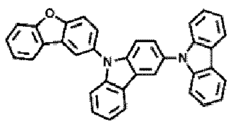
HTH41

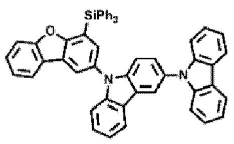
HTH42

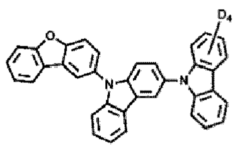
HTH43

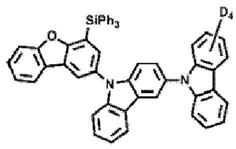
HTH44

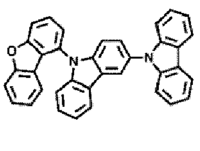
HTH45

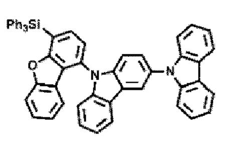
HTH46

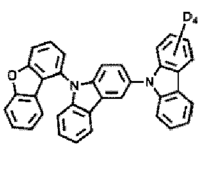
HTH47

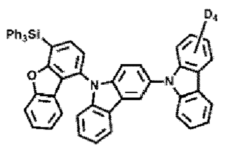
HTH48

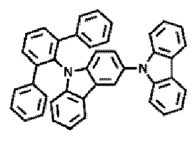
HTH49

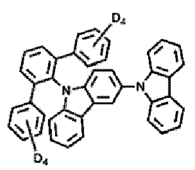
HTH50

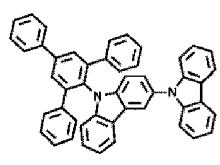
HTH51

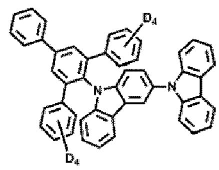
HTH52

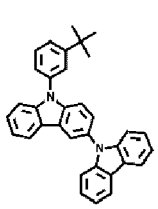

HTH53

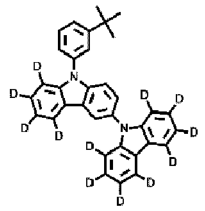

HTH54

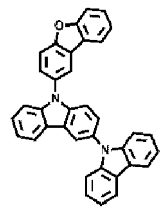

HTH55

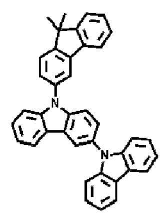

HTH56 .

In one or more embodiments, the second compound may be represented by Formula 302:

## Formula 302

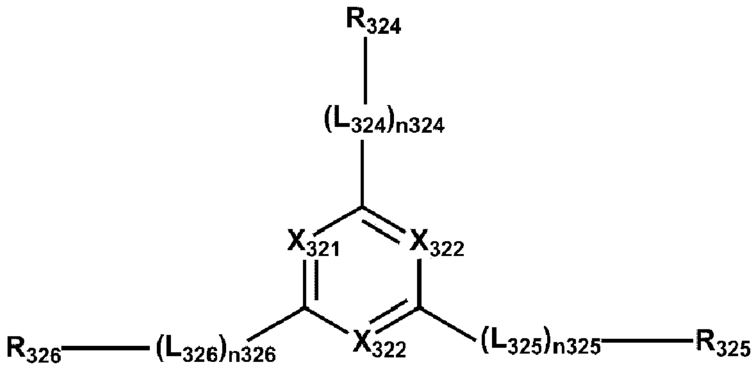

,

wherein, in Formula 302,

$X_{321}$ may be $C(R_{321})$ or N,
$X_{322}$ may be $C(R_{322})$ or N,
$X_{323}$ may be $C(R_{323})$ or N,
at least one selected from among $X_{321}$ to $X_{323}$ may be N,
$L_{324}$ to $L_{326}$ may each independently be a single bond, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, *-C(Q321)(Q322)-*', *-Si(Q321)(Q322)-*', *-B(Q321)-*', or *-N(Q321)-*'
n324 to n326 may each independently be an integer from 1 to 5,
$R_{321}$ to $R_{326}$ may each independently be hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, -Si(Q323)(Q324)(Q325), -N(Q323)(Q324), -B(Q323)(Q324),-C(=O)($Q_{323}$), -S(=O)$_2$($Q_{323}$), or -P(=O)($Q_{323}$)($Q_{324}$),
two or more neighboring groups of $Q_{321}$ to $Q_{325}$ and $R_{321}$ to $R_{326}$ may optionally be bonded to each other to form a $C_5$-$C_{30}$ carbocyclic group unsubstituted or substituted with at least one $R_{10a}$ or a $C_2$-$C_{30}$ heterocyclic group unsubstituted or substituted with at least one $R_{10a}$,
* and *' each indicate a binding site to a neighboring atom,
$R_{10a}$ may be as defined herein, and
$Q_{321}$ to $Q_{325}$ may each independently be the same as defined herein with respect to Q1.

In one or more embodiments, the second compound may be at least one selected from Compounds ETH1 to ETH86, but embodiments of the present disclosure are not limited thereto:

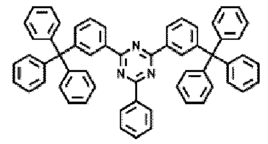
ETH1

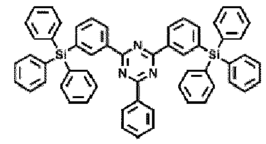
ETH2

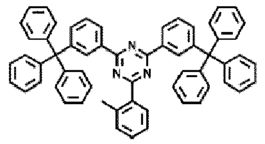
ETH3

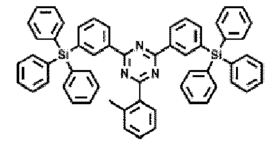
ETH4

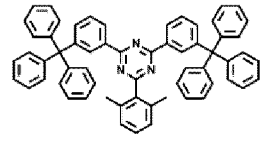
ETH5

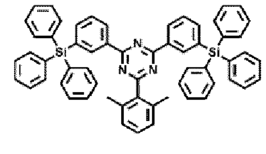
ETH6

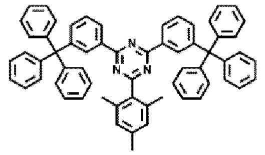
ETH7

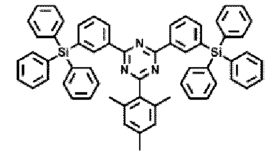
ETH8

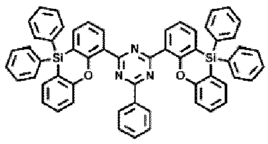
ETH9

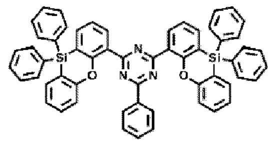
ETH10

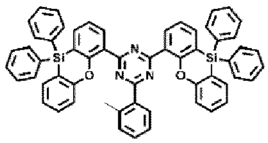
ETH11

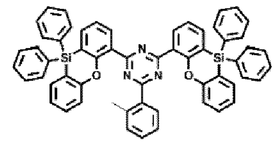
ETH12

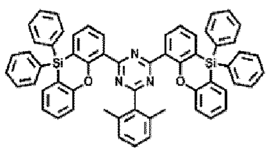
ETH13

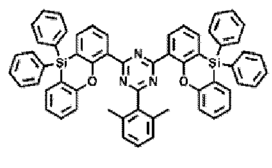
ETH14

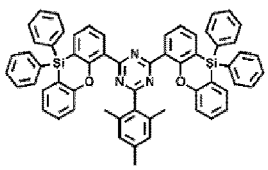
ETH15

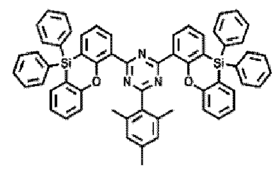
ETH16

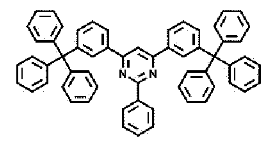
ETH17

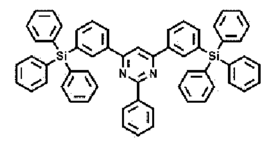
ETH18

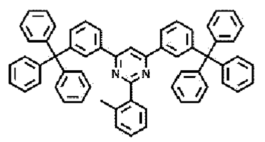
ETH19

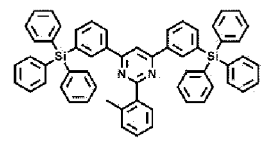
ETH20

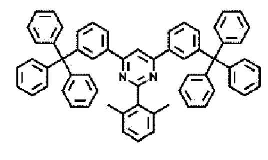
ETH21

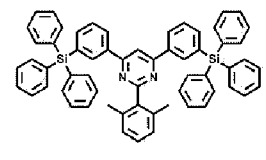
ETH22

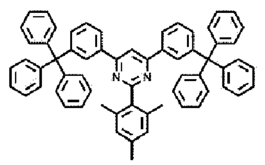
ETH23

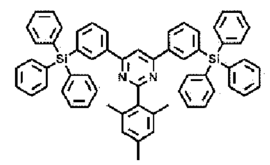
ETH24

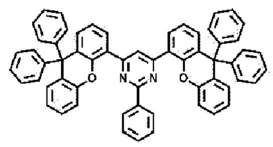
ETH25

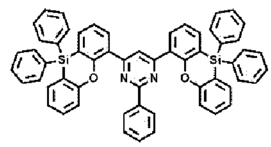
ETH26

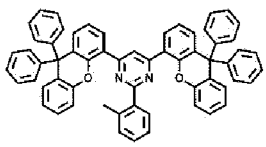
ETH27

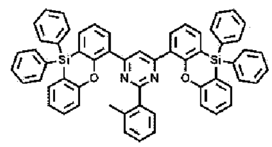
ETH28

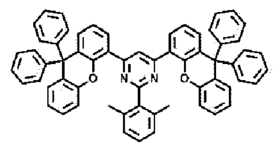

ETH29

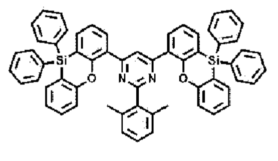

ETH30

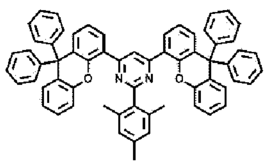

ETH31

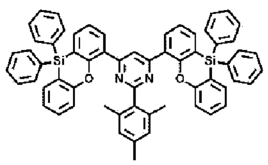

ETH32

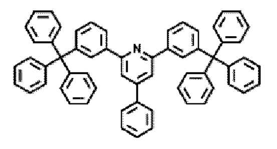

ETH33

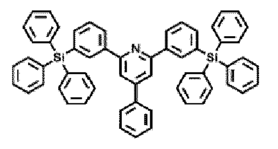

ETH34

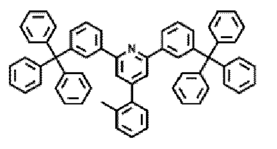

ETH35

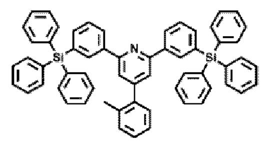

ETH36

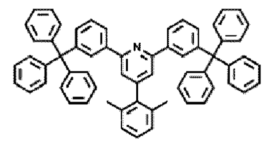

ETH37

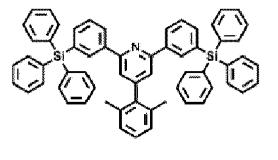

ETH38

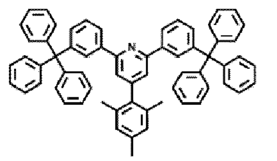

ETH39

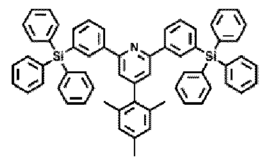

ETH40

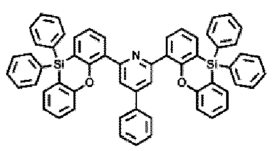

ETH41

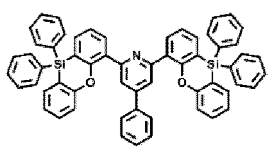

ETH42

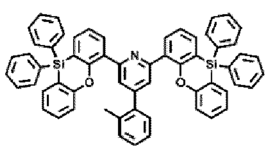

ETH43

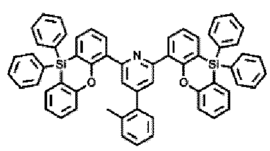

ETH44

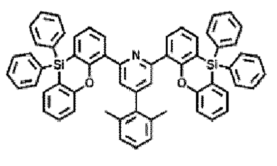

ETH45

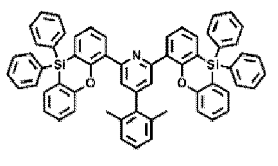

ETH46

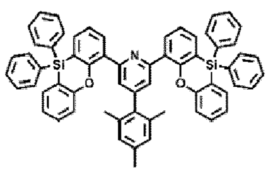

ETH47

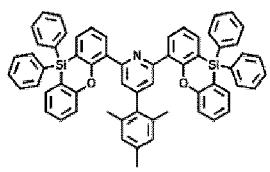

ETH48

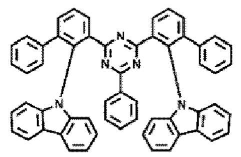

ETH49

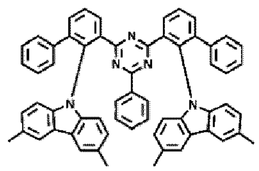

ETH50

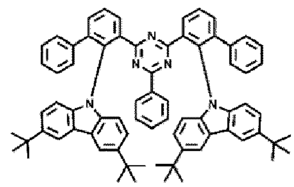

ETH51

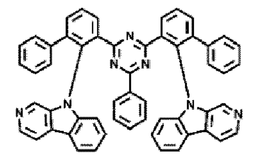

ETH52

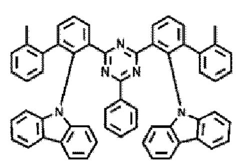

ETH53

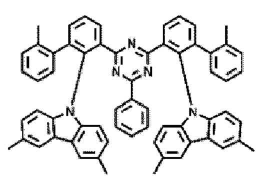

ETH54

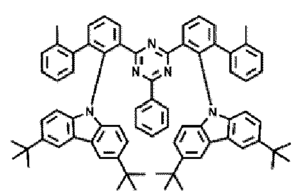

ETH55

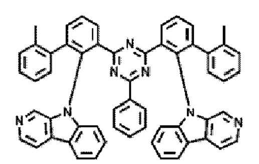

ETH56

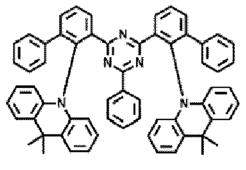
ETH57

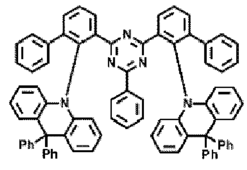
ETH58

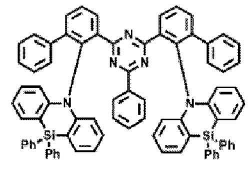
ETH59

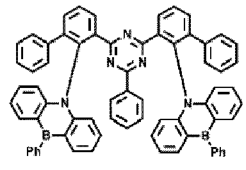
ETH60

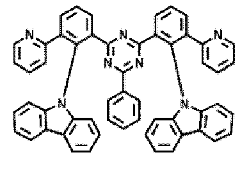
ETH61

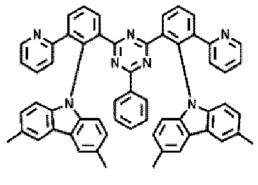
ETH62

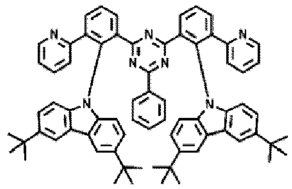
ETH63

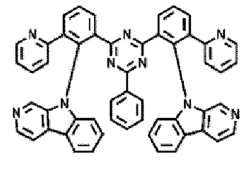
ETH64

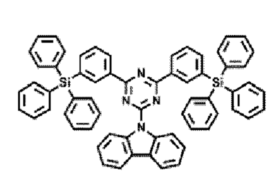
ETH65

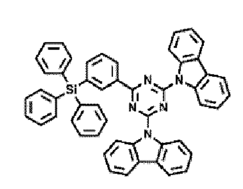
ETH66

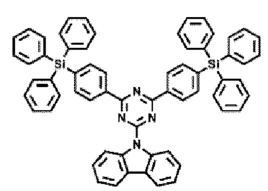
ETH67

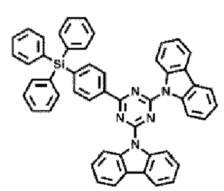
ETH68

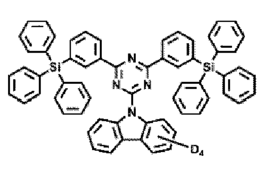
ETH69

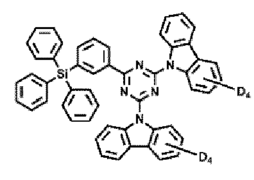
ETH70

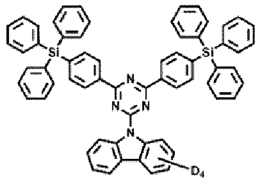
ETH71

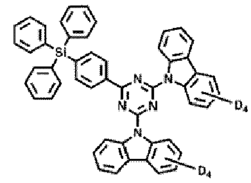
ETH72

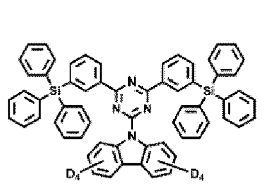
ETH73

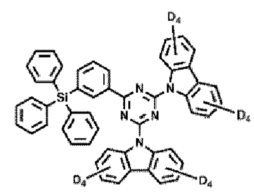
ETH74

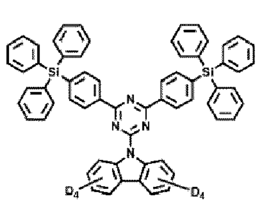
ETH75

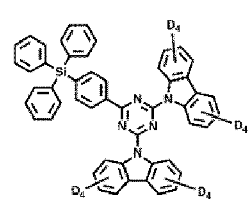
ETH76

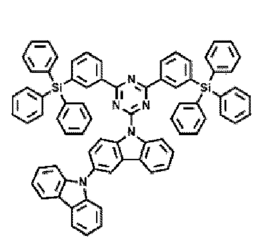
ETH77

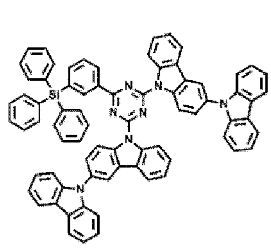
ETH78

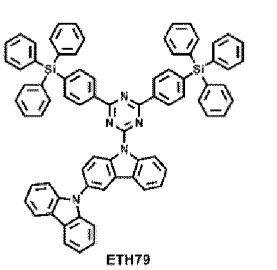
ETH79

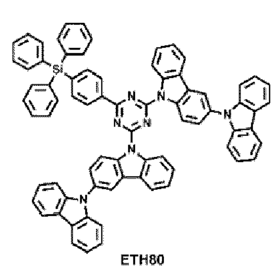
ETH80

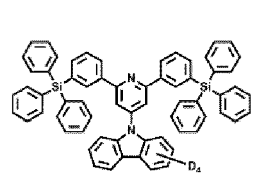
ETH81

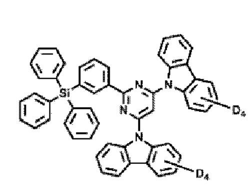
ETH82

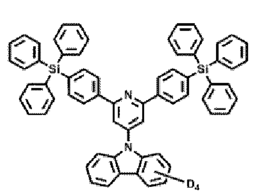
ETH83

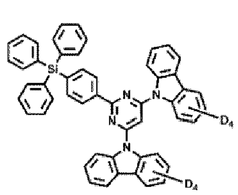
ETH84

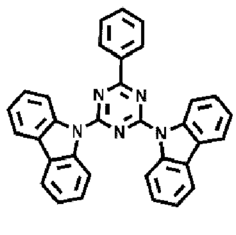

ETH85

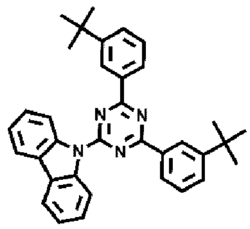

ETH86

.

In one or more embodiments, the third compound may be represented by Formula 401A:

**Formula 401A** $M_{401}(L_{401})_{xc1}(L_{402})_{xc2}$

**Formula 402A**

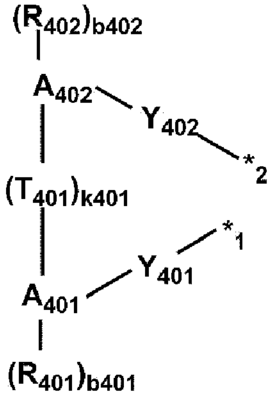

**Formula 402B**

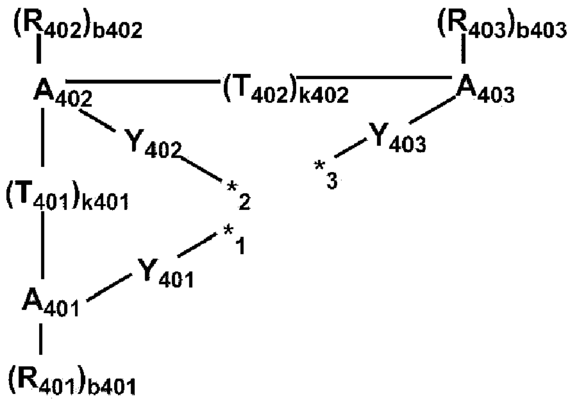

**Formula 402C**

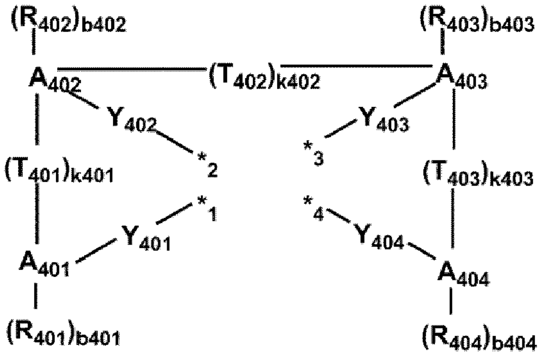

**Formula 402D**

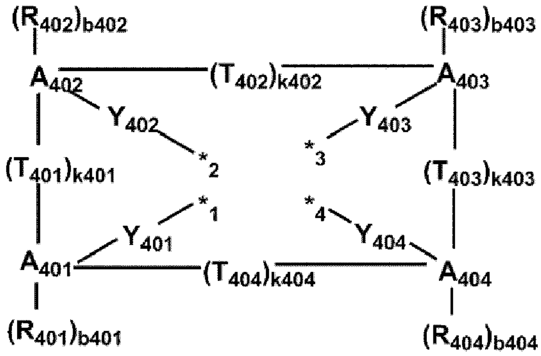

,

wherein, in Formulae 401A and 402A to 402D,

$M_{401}$ may be a first-row transition metal of the Periodic Table of Elements, a second-row transition metal of the Periodic Table of Elements, or a third-row transition metal of the Periodic Table of Elements,
$L_{401}$ may be a ligand represented by one selected from among Formulae 402A to 402D,
$L_{402}$ may be a monodentate ligand, a bidentate ligand, or a tridentate ligand,
xc1 may be 1 or 2,
xc2 may be an integer from 0 to 4,
$A_{401}$ to $A_{404}$ may each independently be a $C_5$-$C_{30}$ carbocyclic group or a $C_1$-$C_{30}$ heterocyclic group,
$T_{401}$ to $T_{404}$ may each independently be a single bond, a double bond, *-O-*', *-S-*', *-C(=O)-*', *-S(=O)-*', *-$C(R_{405})(R_{406})$-*', *-$C(R_{405})=C(R_{406})$-*', *-$C(R_{405})$=*', *-$Si(R_{405})(R_{406})$-*', *-$B(R_{405})$-*', *-$N(R_{405})$-*', or *-$P(R_{405})$-*',

k401 to k404 may each independently be 1, 2, or 3,

$Y_{401}$ to $Y_{404}$ may each independently be a single bond, *-O-*', *-S-*', *-C($R_{407}$)($R_{408}$)-*', *-Si($R_{407}$)($R_{408}$)-*', *-B($R_{407}$)-*', *-N($R_{407}$)-*', or *-P($R_{407}$)-*',

$*_1$, $*_2$, $*_3$, and $*_4$ each indicate a binding site to $M_{401}$,

$R_{401}$ to $R_{408}$ may each independently be hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$,-Si($Q_1$)($Q_2$)($Q_3$), -N($Q_1$)($Q_2$), -B($Q_1$)($Q_2$), -C(=O)($Q_1$), -S(=O)$_2$($Q_1$), or-P(=O)($Q_1$)($Q_2$),

$R_{401}$ to $R_{408}$ may optionally be bonded to each other to form a $C_5$-$C_{60}$ carbocyclic group unsubstituted or substituted with at least one $R_{10a}$ or a $C_1$-$C_{60}$ heterocyclic group unsubstituted or substituted with at least one $R_{10a}$,

b401 to b404 may each independently be an integer from 0 to 10,

* and *' each indicate a binding site to a neighboring atom, and

$Q_1$ to $Q_3$ and $R_{10a}$ may each be as defined herein.

In one or more embodiments, the third compound may be at least one selected from Compounds PD1 to PD41, but embodiments of the present disclosure are not limited thereto:

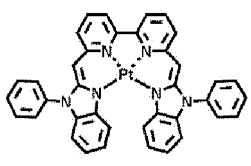
PD1

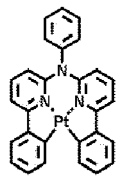
PD2

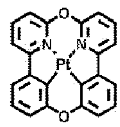
PD3

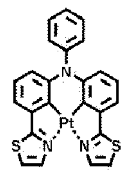
PD4

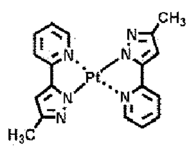
PD5

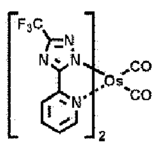
PD6

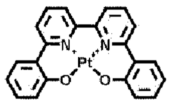
PD7

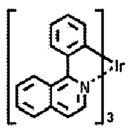
PD8

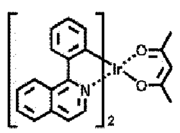
PD9

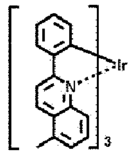
PD10

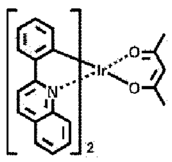
PD11

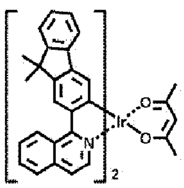
PD12

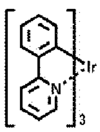
PD13

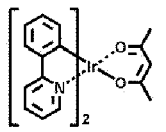
PD14

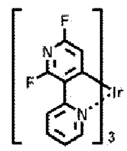
PD15

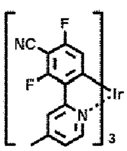
PD16

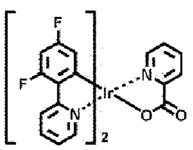
PD17

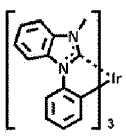
PD18

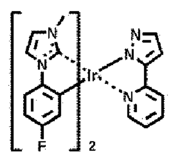
PD19

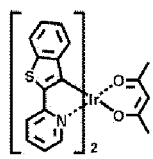
PD20

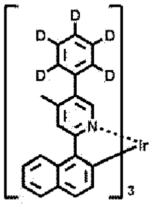
PD21

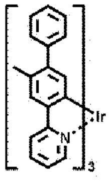
PD22

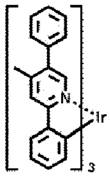
PD23

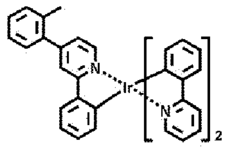
PD24

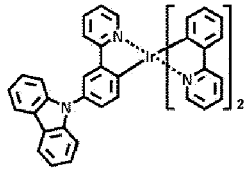
PD25

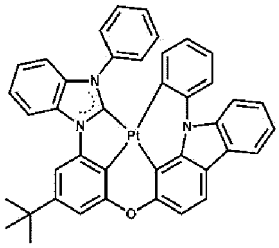
PD26

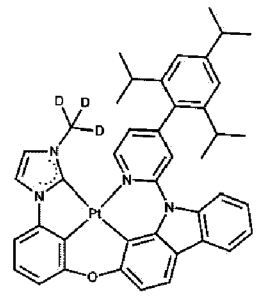
PD27

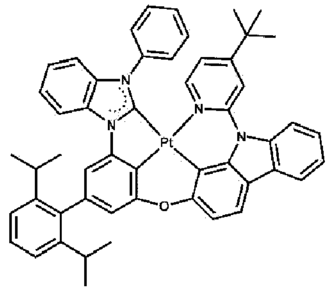
PD28

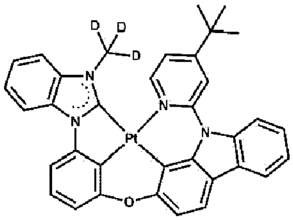
PD29

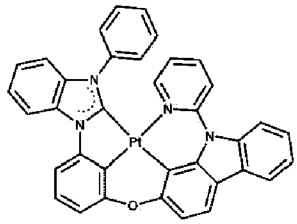
PD30

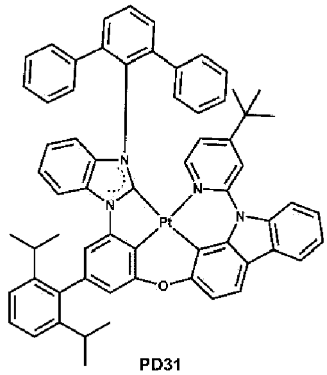
PD31

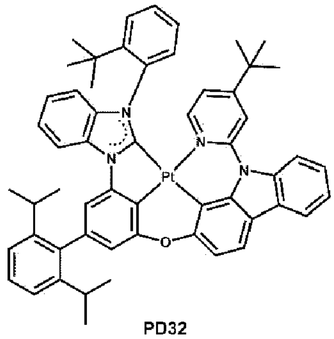
PD32

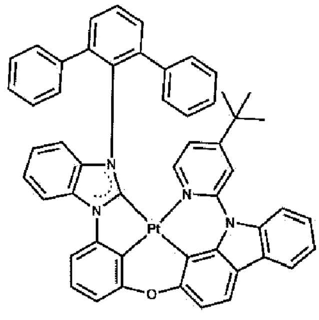
PD33

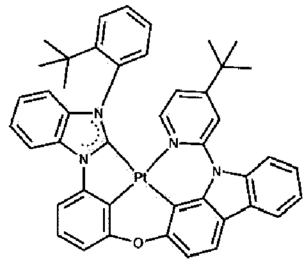
PD34

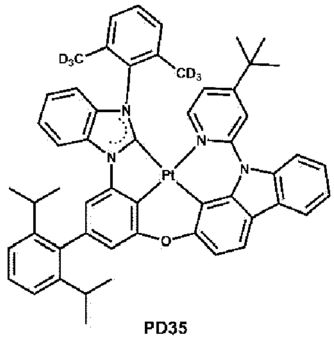
PD35

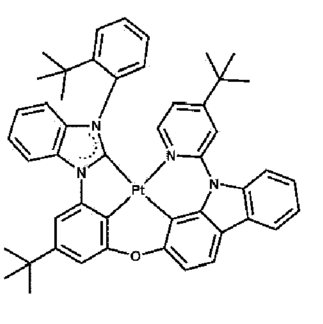
PD36

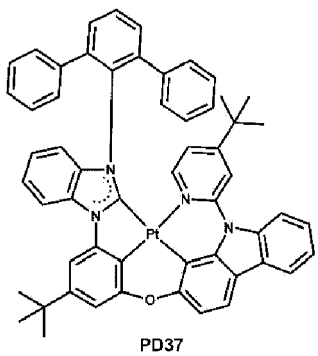
PD37

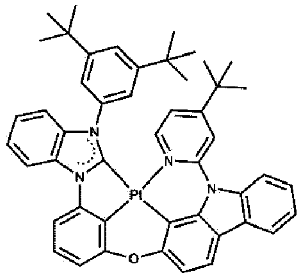
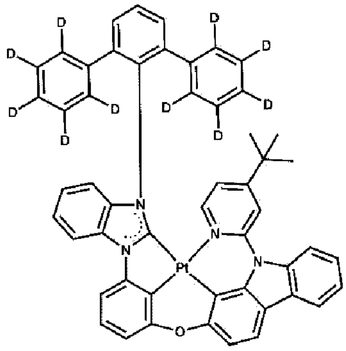

PD38 PD39

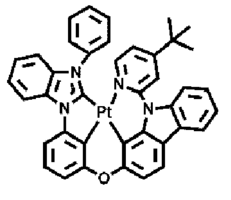
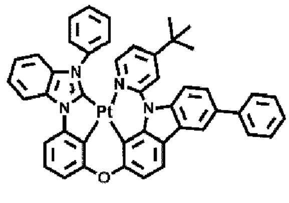

**PD40** **PD41**

In one or more embodiments, $R_{301}$ to $R_{303}$, $R_{304a}$ to $R_{306a}$, $R_{304b}$ to $R_{306b}$, and $R_{311}$ to $R_{314}$ in Formulae 301-1A and 301-2A, $R_{321}$ to $R_{326}$ in Formula 302, and $R_{401}$ to $R_{408}$ in Formulae 401A and 402A to 402D may each independently be: hydrogen, deuterium, -F, -Cl, -Br, -I, a hydroxyl group, a cyano group, a nitro group, an amidino group, a hydrazine group, a hydrazone group, a $C_1$-$C_{20}$ alkyl group, or a $C_1$-$C_{20}$ alkoxy group;

a $C_1$-$C_{20}$ alkyl group or a $C_1$-$C_{20}$ alkoxy group, each substituted with deuterium, -F,-Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a ($C_1$-$C_{10}$ alkyl)phenyl group, a naphthyl group, a tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a benzoisoquinolinyl group, a phthalazinyl group, a naphthylidinyl group, a quinoxalinyl group, a benzoquinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a thiadiazolyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium, -F, -Cl, -Br, -I, $-CD_3$, $-CD_2H$, $-CDH_2$, $-CF_3$, $-CF_2H$,$-CFH_2$, a hydroxyl group, a cyano group, a nitro group, an amidino group, a hydrazine group, a hydrazone group, a $C_1$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a ($C_1$-$C_{10}$ alkyl)phenyl group, a naphthyl group, a tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl

group, a pyridazinyl group, an isoindolyl group, an indolyl group, an indazolyl group, a purinyl group, a quinolinyl group, an isoquinolinyl group, a benzoquinolinyl group, a benzoisoquinolinyl group, a phthalazinyl group, a naphthylidinyl group, a quinoxalinyl group, a benzoquinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a thiadiazolyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, $-Si(Q_{31})(Q_{32})(Q_{33})$, $-B(Q_{31})(Q_{32})$, $-P(Q_{31})(Q_{32})$, $-C(=O)(Q_{31})$,$-S(=O)_2(Q_{31})$, $-P(=O)(Q_{31})(Q_{32})$, or any combination thereof; or

$-C(Q_1)(Q_2)(Q_3)$, $-Si(Q_1)(Q_2)(Q_3)$, $-N(Q_1)(Q_2)$, $-B(Q_1)(Q_2)$, $-C(=O)(Q_1)$, $-S(=O)_2(Q_1)$, or $-P(=O)(Q_1)(Q_2)$, and $Q_1$ to $Q_3$ and $Q_{31}$ to $Q_{33}$ may each be as defined herein.

In one or more embodiments, $R_{301}$ to $R_{303}$, $R_{304a}$ to $R_{306a}$, $R_{304b}$ to $R_{306b}$, and $R_{311}$ to $R_{314}$ in Formulae 301-1A and 301-2A, $R_{321}$ to $R_{326}$ in Formula 302, and $R_{401}$ to $R_{408}$ in Formulae 401A and 402A to 402D may each independently be:

hydrogen, deuterium, -F, -Cl, -Br, -I, $-CD_3$, $-CD_2H$, $-CDH_2$, $-CF_3$, $-CF_2H$, $-CFH_2$, a cyano group, a nitro group, a $C_1$-$C_{60}$ alkyl group, a $C_2$-$C_{60}$ alkenyl group, a $C_2$-$C_{60}$ alkynyl group, or a $C_1$-$C_{60}$ alkoxy group;

a group represented by one selected from Formulae 9-1 to 9-61 or a group represented by one selected from Formulae 10-1 to 10-348; or

$-C(Q_1)(Q_2)(Q_3)$, $-Si(Q_1)(Q_2)(Q_3)$, $-N(Q_1)(Q_2)$, $-B(Q_1)(Q_2)$, $-C(=O)(Q_1)$, $-S(=O)_2(Q_1)$, or $-P(=O)(Q_1)(Q_2)$:

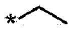
9-1
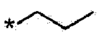
9-2
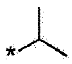
9-3
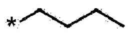
9-4
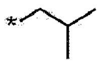
9-5
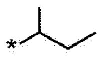
9-6
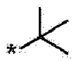
9-7
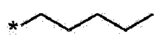
9-8

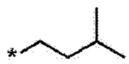
9-9
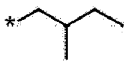
9-10
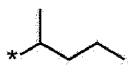
9-11
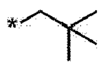
9-12
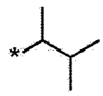
9-13
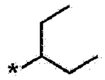
9-14
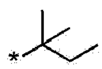
9-15

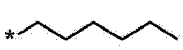
9-16
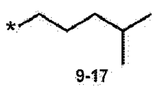
9-17
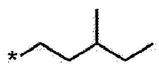
9-18
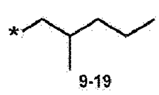
9-19
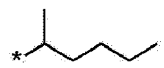
9-20
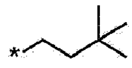
9-21

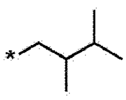
9-22
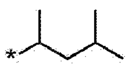
9-23
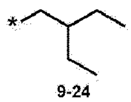
9-24
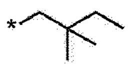
9-25
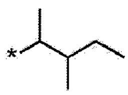
9-26
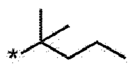
9-27
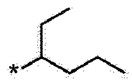
9-28

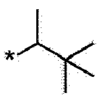
9-29
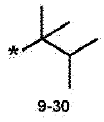
9-30
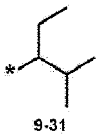
9-31
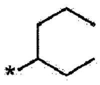
9-32
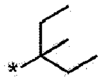
9-33
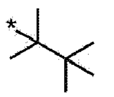
9-34
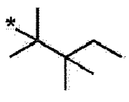
9-35
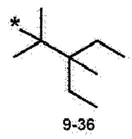
9-36

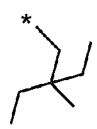
9-37
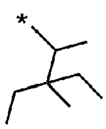
9-38
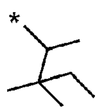
9-39
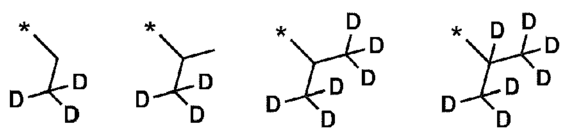
9-40
9-41
9-42
9-43

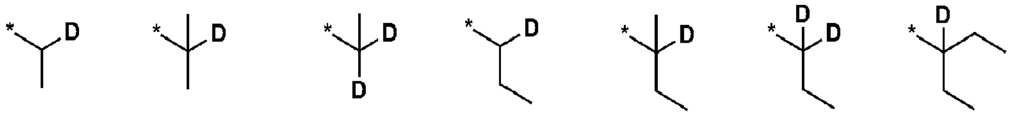

9-44 9-45 9-46 9-47 9-48 9-49 9-50

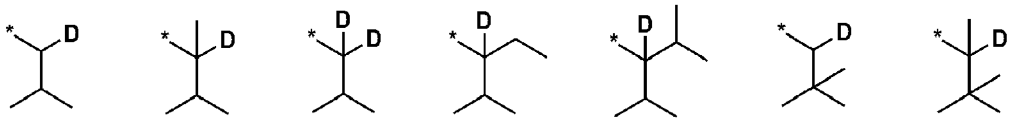

9-51 9-52 9-53 9-54 9-55 9-56 9-57

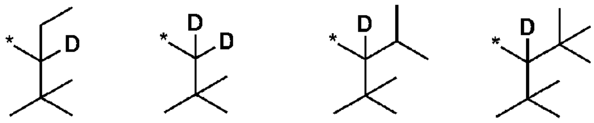

9-58 9-59 9-60 9-61

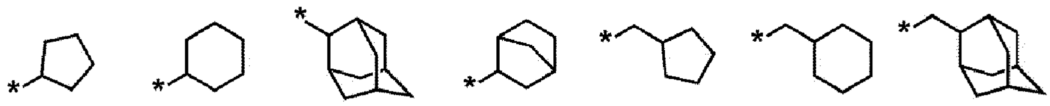

10-1 10-2 10-3 10-4 10-5 10-6 10-7

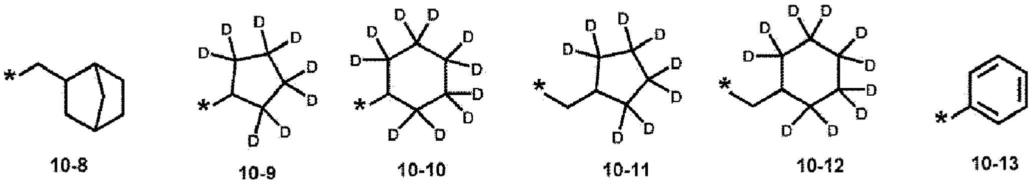

10-8 10-9 10-10 10-11 10-12 10-13

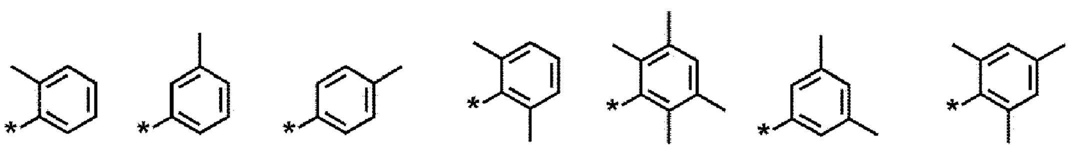

10-14 10-15 10-16 10-17 10-18 10-19 10-20

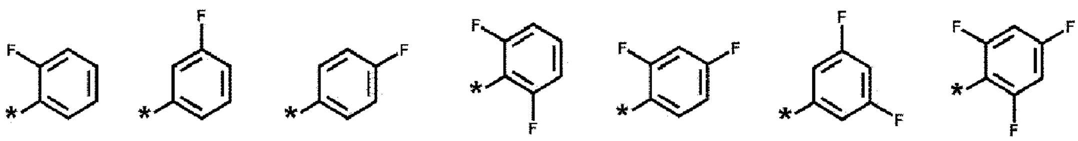

10-21 10-22 10-23 10-24 10-25 10-26 10-27

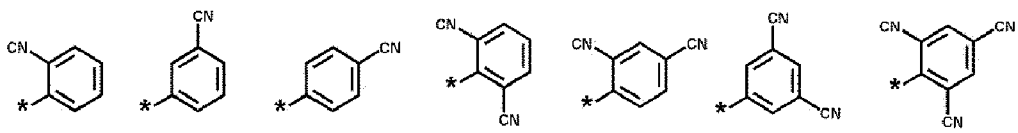

10-28 10-29 10-30 10-31 10-32 10-33 10-34

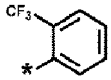 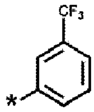 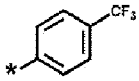 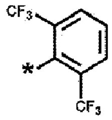 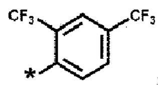 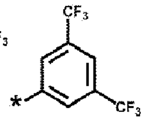 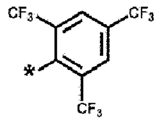

10-35 10-36 10-37 10-38 10-39 10-40 10-41

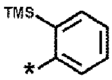 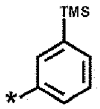 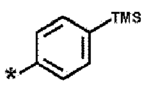 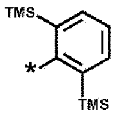 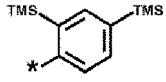 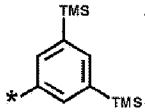 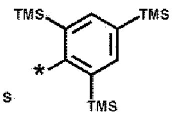

10-42 10-43 10-44 10-45 10-46 10-47 10-48

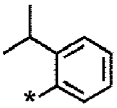 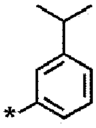 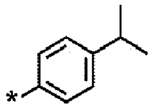 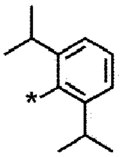 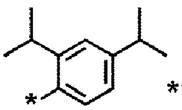 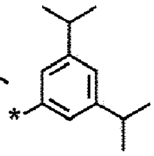 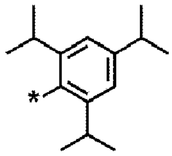

10-49 10-50 10-51 10-52 10-53 10-54 10-55

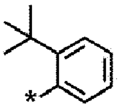 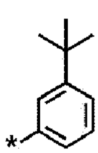 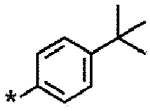 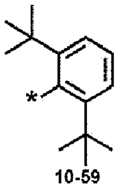 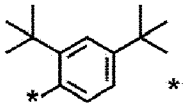 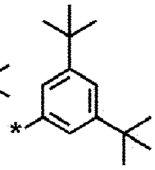 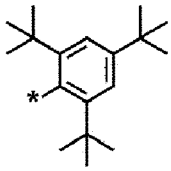

10-56 10-57 10-58 10-59 10-60 10-61 10-62

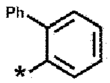 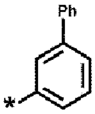 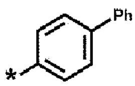 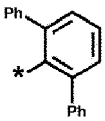 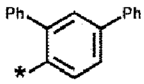 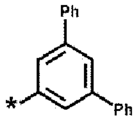 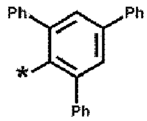

10-63 10-64 10-65 10-66 10-67 10-68 10-69

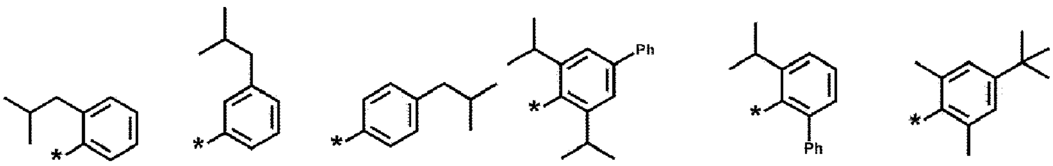

10-70 10-71 10-72 10-73 10-74 10-75

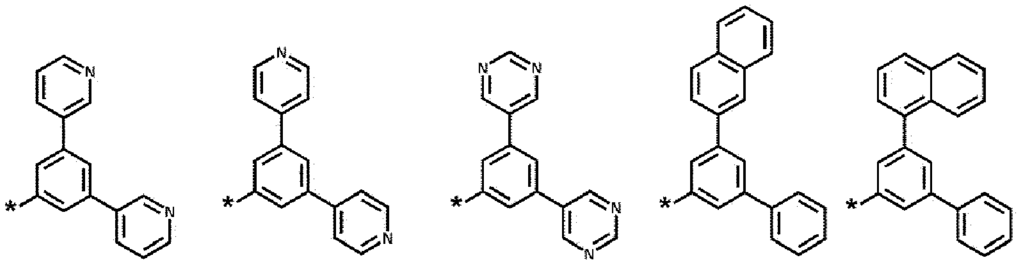

10-76 10-77 10-78 10-79 10-80

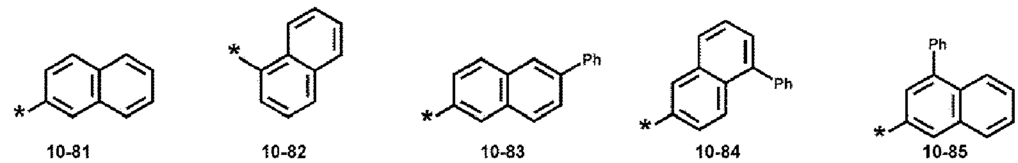

10-81 10-82 10-83 10-84 10-85

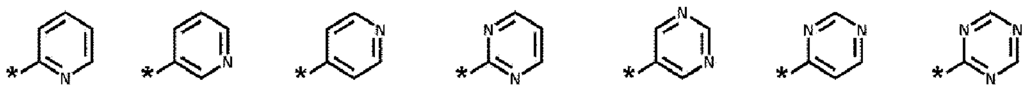

10-86 10-87 10-88 10-89 10-90 10-91 10-92

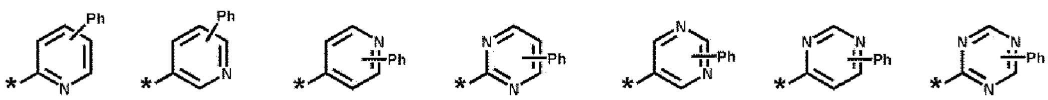

10-93 10-94 10-95 10-96 10-97 10-98 10-99

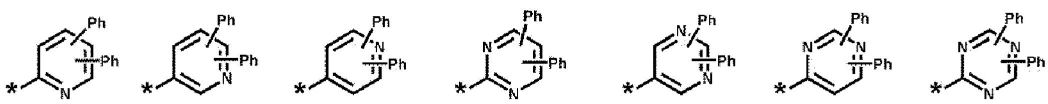

10-100 10-101 10-102 10-103 10-104 10-105 10-106

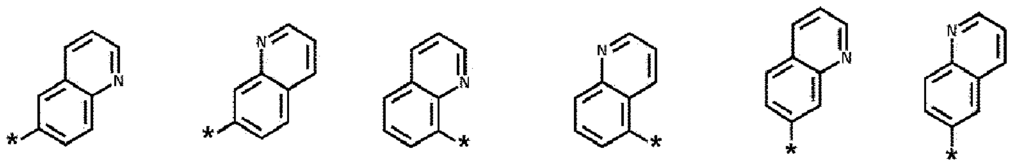

10-107 10-108 10-109 10-110 10-111 10-112

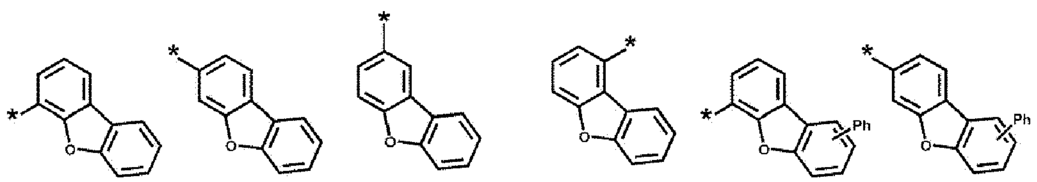

10-113 10-114 10-115 10-116 10-117 10-118

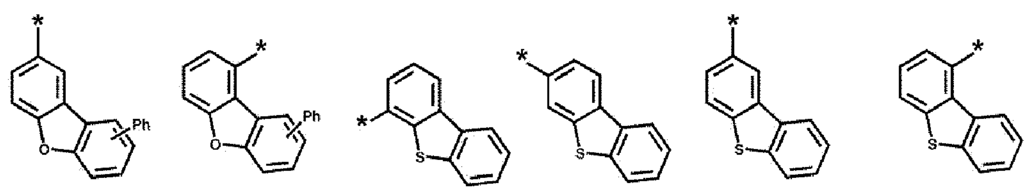

10-119 10-120 10-121 10-122 10-123 10-124

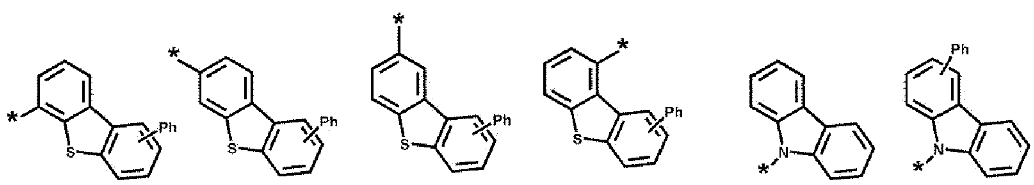

10-125 10-126 10-127 10-128 10-129 10-130

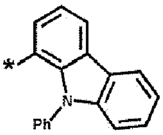
10-131
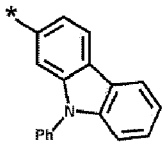
10-132
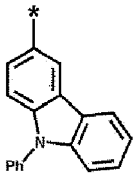
10-133
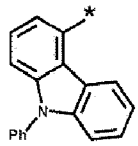
10-134
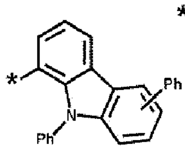
10-135
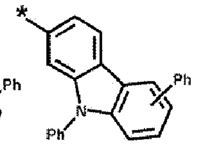
10-136

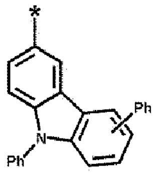
10-137
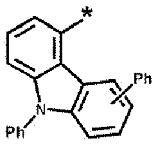
10-138
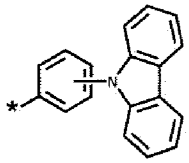
10-139
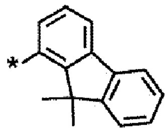
10-140
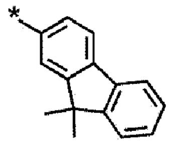
10-141
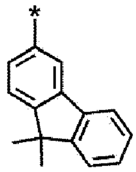
10-142

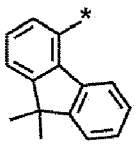
10-143
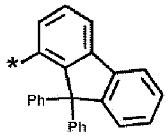
10-144
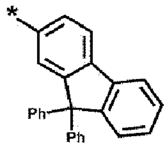
10-145
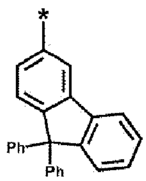
10-146
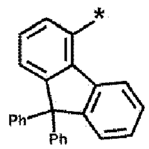
10-147

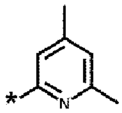
10-148
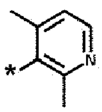
10-149
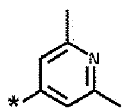
10-150
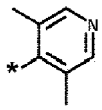
10-151
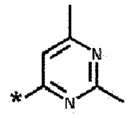
10-152
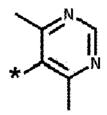
10-153
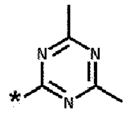
10-154

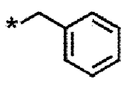
10-155
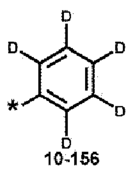
10-156
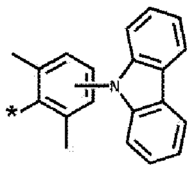
10-157
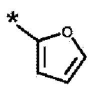
10-158
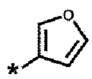
10-159
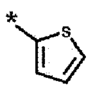
10-160
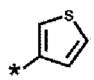
10-161

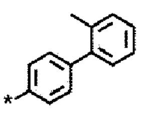
10-162
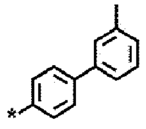
10-163
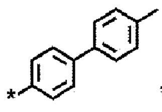
10-164
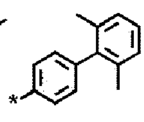
10-165
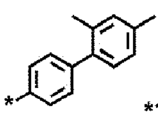
10-166
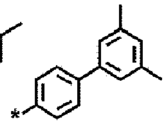
10-167
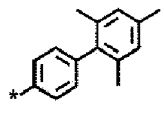
10-168

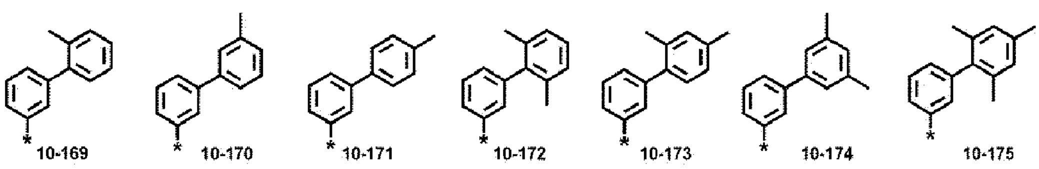
10-169
10-170
10-171
10-172
10-173
10-174
10-175

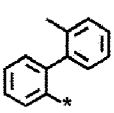
10-176

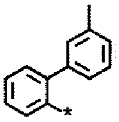
10-177

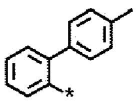
10-178

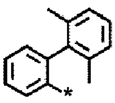
10-179

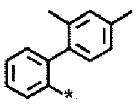
10-180

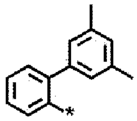
10-181

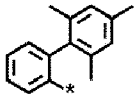
10-182

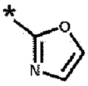
10-183

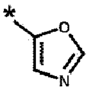
10-184

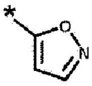
10-185

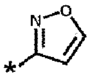
10-186

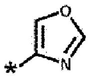
10-187

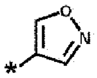
10-188

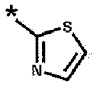
10-189

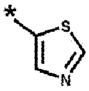
10-190

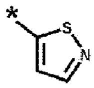
10-191

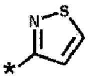
10-192

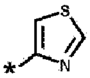
10-193

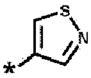
10-194

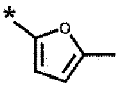
10-195

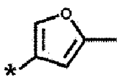
10-196

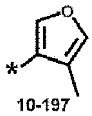
10-197

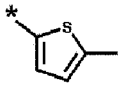
10-198

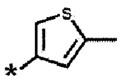
10-199

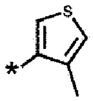
10-200

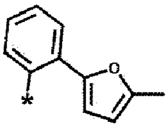
10-201

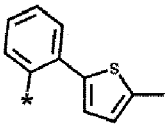
10-202

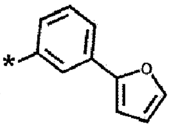
10-203

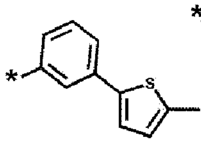
10-204

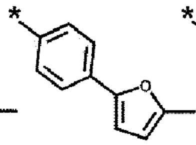
10-205

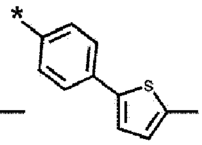
10-206

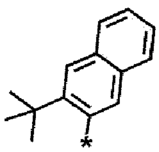
10-207

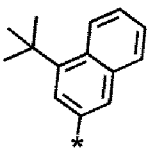
10-208

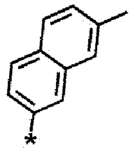
10-209

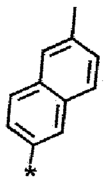
10-210

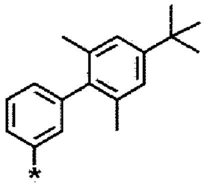
10-211

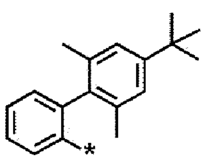
10-212

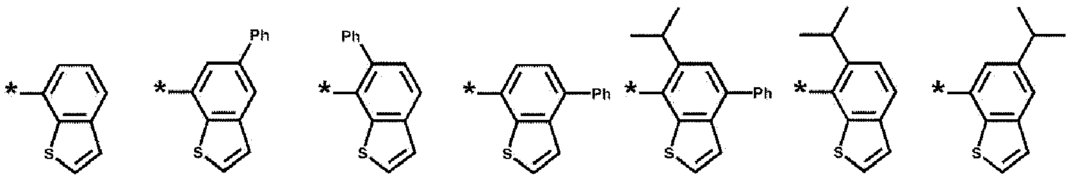
10-213 10-214 10-215 10-216 10-217 10-218 10-219

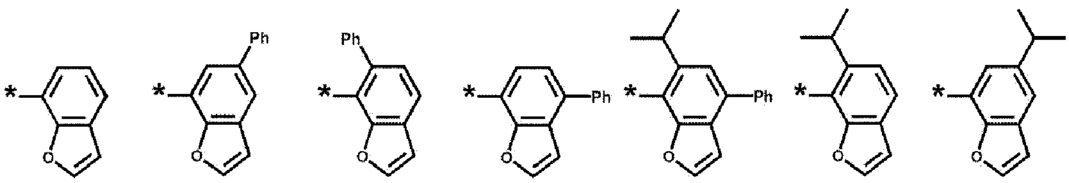
10-220 10-221 10-222 10-223 10-224 10-225 10-226

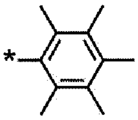 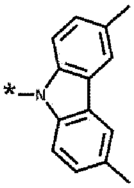 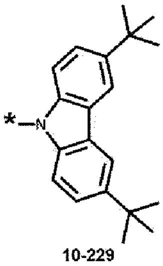 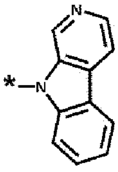 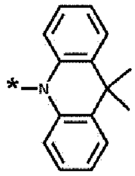 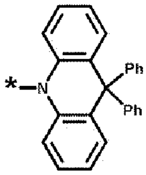 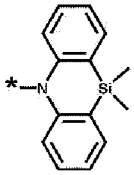

10-227 10-228 10-229 10-230 10-231 10-232 10-233

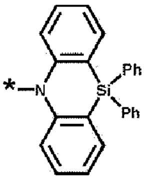 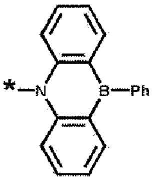 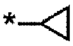 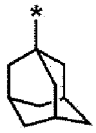 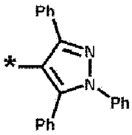 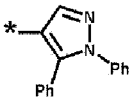 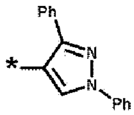

10-234 10-235 10-236 10-237 10-238 10-239 10-240

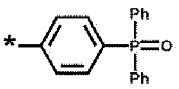 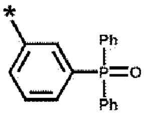 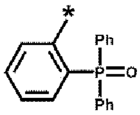 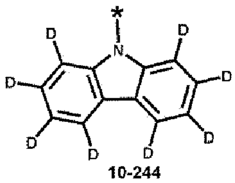 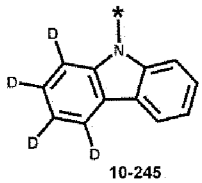

10-241 10-242 10-243 10-244 10-245

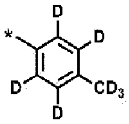 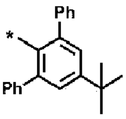 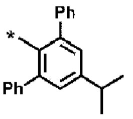 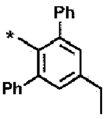 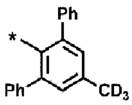 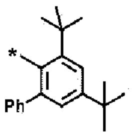 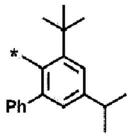

10-246 10-247 10-248 10-249 10-250 10-251 10-252

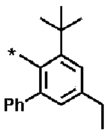 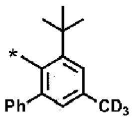 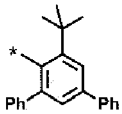 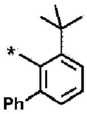 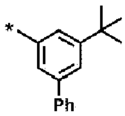 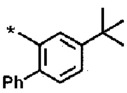 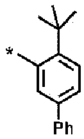 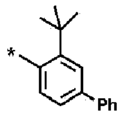

10-253 10-254 10-255 10-256 10-257 10-258 10-259 10-260

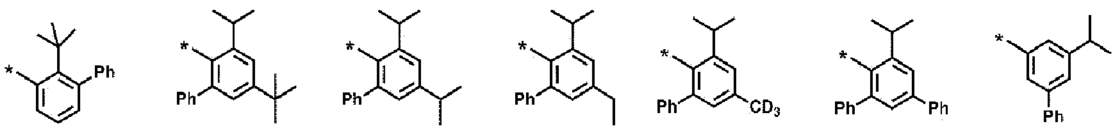

10-261 10-262 10-263 10-264 10-265 10-266 10-267

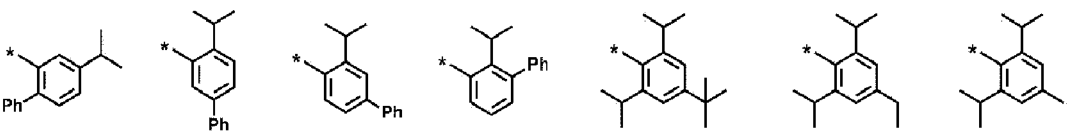

10-268 10-269 10-270 10-271 10-272 10-273 10-274

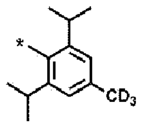
10-275
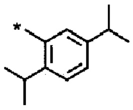
10-276
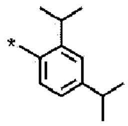
10-277
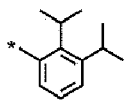
10-278
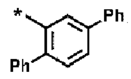
10-279
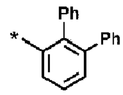
10-280

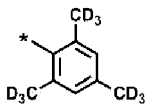
10-281
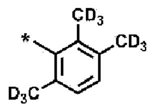
10-282
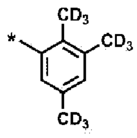
10-283
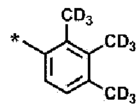
10-284
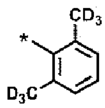
10-285
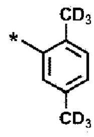
10-286
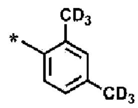
10-287

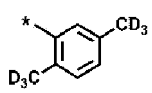
10-288
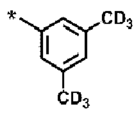
10-289
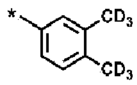
10-290
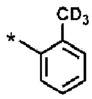
10-291
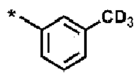
10-292
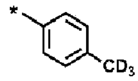
10-293

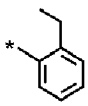
10-294
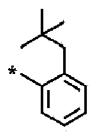
10-295
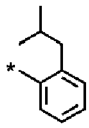
10-296
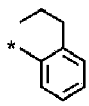
10-297
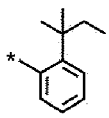
10-298
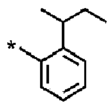
10-299
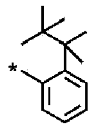
10-300

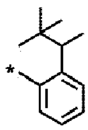
10-301
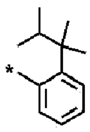
10-302
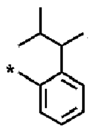
10-303
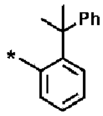
10-304
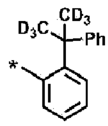
10-305
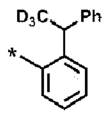
10-306
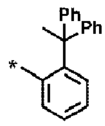
10-307
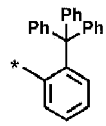
10-308

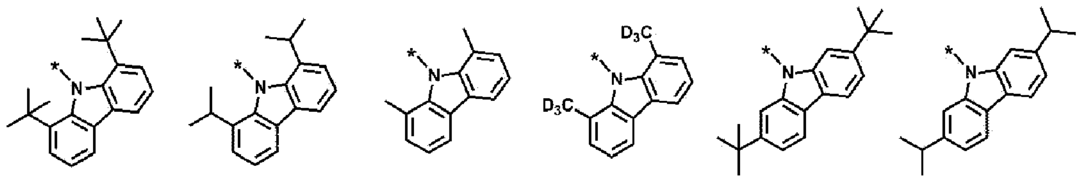
10-309 10-310 10-311 10-312 10-313 10-314

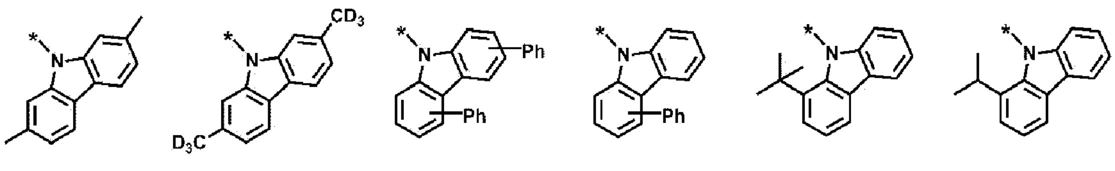
10-315 10-316 10-317 10-318 10-319 10-320

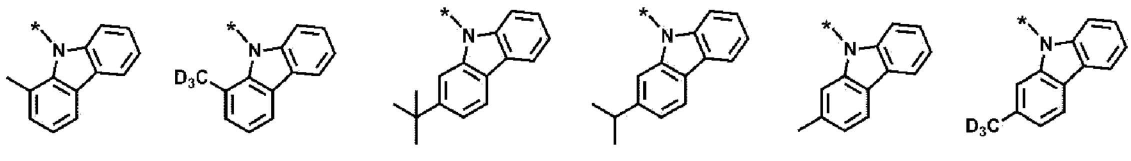
10-321 10-322 10-323 10-324 10-325 10-326

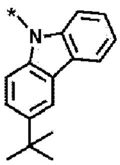 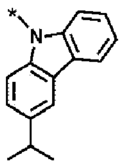 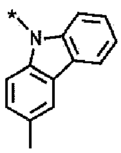 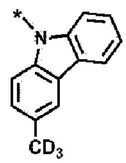 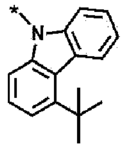 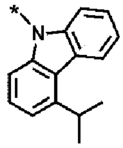

10-327 10-328 10-329 10-330 10-331 10-332

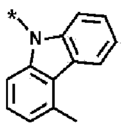 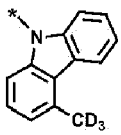 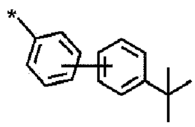 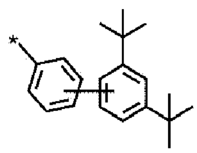 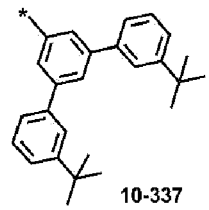

10-333 10-334 10-335 10-336 10-337

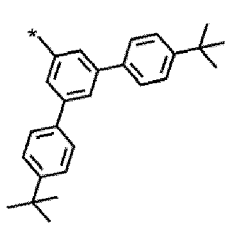 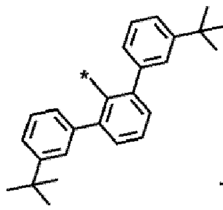 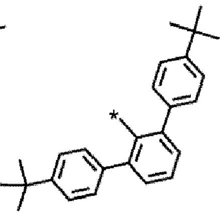 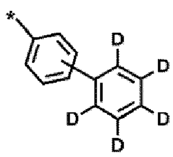 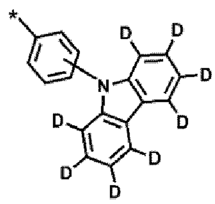

10-338 10-339 10-340 10-341 10-342

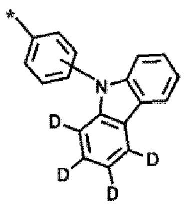 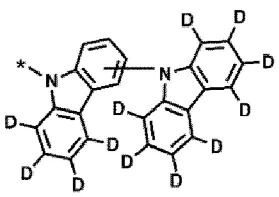 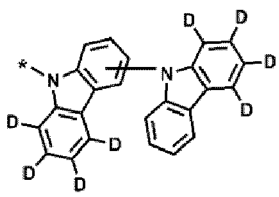 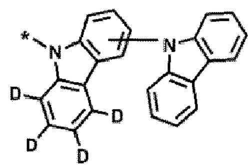

10-343 10-344 10-345 10-346

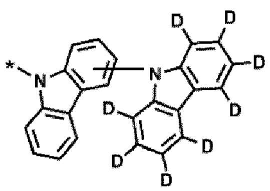 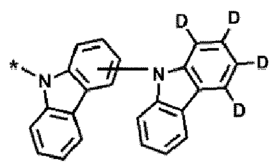

10-347 10-348

wherein, in Formulae 9-1 to 9-61 and 10-1 to 10-348, * indicates a binding site to a neighboring atom, Ph indicates a phenyl group, and TMS indicates a trimethylsilyl group, D represents deuterium, and

$Q_1$ to $Q_3$ may each be as defined herein.

The expression "(interlayer and/or capping layer) comprises a condensed cyclic compound" as utilized herein may be understood as "(interlayer and/or capping layer) may comprise one kind of condensed cyclic compound satisfying Expression 1 or two or more different kinds of condensed cyclic compounds, each satisfying Expression 1."

In one or more embodiments, the interlayer and/or the capping layer may comprise Compound 1 only as the condensed cyclic compound. In this regard, Compound 1 may be present in the emission layer of the light-emitting device. In one or more embodiments, the interlayer may comprise, as the condensed cyclic compound, Compound 1 and Compound 2. In this regard, Compound 1 and Compound 2 may be present in substantially the same layer (for example, both (e.g., simultaneously) Compound 1 and Compound 2 may be present in the emission layer), or may be

present in different layers (for example, Compound 1 may be present in the emission layer, and Compound 2 may be present in the electron transport region).

One or more aspects of embodiments of the present disclosure are directed toward an electronic apparatus comprising the light-emitting device. The electronic apparatus may further comprise a thin-film transistor. For example, in one or more embodiments, the electronic apparatus may further comprise a thin-film transistor comprising a source electrode and a drain electrode, wherein the first electrode of the light-emitting device may be electrically connected to the source electrode or the drain electrode. In one or more embodiments, the electronic apparatus may further comprise a color filter, a color conversion layer, a touch screen layer, a polarizing layer, or any combination thereof. More details of the electronic apparatus may be referred to the descriptions provided herein.

One or more aspects of embodiments of the present disclosure are directed toward electronic equipment comprising the light-emitting device.

For example, the electronic equipment may be at least one selected from a flat panel display, a curved display, a computer monitor, a medical monitor, a television, an advertisement board, an indoor or outdoor lighting and/or signaling light, a head-up display, a fully or partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a microdisplay, a 3D display, a virtual or augmented reality display, a vehicle, a video wall comprising multiple displays tiled together, a theater or stadium screen, a phototherapy device, and a sign.

**Description of FIG. 1**

FIG. 1 is a schematic cross-sectional view of a light-emitting device 10 according to one or more embodiments of the present. The light-emitting device 10 may comprise a first electrode 110, an interlayer 130, and a second electrode 150.

Hereinafter, the structure of the light-emitting device 10 according to one or more embodiments and a method of manufacturing the light-emitting device 10 will be described in more detail with reference to FIG. 1.

**First electrode 110**

In FIG. 1, in some embodiments, a substrate may be additionally provided and arranged under the first electrode 110 and/or on the second electrode 150. In one or more embodiments, as the substrate, a glass substrate or a plastic substrate may be utilized. In one or more embodiments, the substrate may be a flexible substrate, and may comprise plastics with excellent or suitable heat resistance and durability, such as polyimide, polyethylene terephthalate (PET), polycarbonate, polyethylene naphthalate, polyarylate (PAR), polyetherimide, or any combination thereof.

The first electrode 110 may be formed by, for example, depositing or sputtering a material for forming the first electrode 110 on the substrate. When the first electrode 110 is an anode, a material for forming the first electrode 110 may be a high-work function material that facilitates injection of holes.

The first electrode 110 may be a reflective electrode, a semi-transmissive electrode, or a transmissive electrode. In one or more embodiments, when the first electrode 110 is a transmissive electrode, a material for forming the first electrode 110 may comprise indium tin oxide (ITO), indium zinc oxide (IZO), tin oxide ($SnO_2$), zinc oxide (ZnO), or any combination thereof. In one or more embodiments, when the first electrode 110 is a semi-transmissive electrode or a reflective electrode, a material for forming the first electrode 110 may comprise magnesium (Mg), silver (Ag), aluminum (Al), aluminum-lithium (Al-Li), calcium (Ca), magnesium-indium (Mg-In), magnesium-silver (Mg-Ag), or any combination thereof.

The first electrode 110 may have a single-layer structure comprising (e.g., consisting of) a single layer or a multi-layer structure comprising multiple layers. For example, in some embodiments, the first electrode 110 may have a three-layer structure of ITO/Ag/ITO.

**Interlayer 130**

The interlayer 130 is arranged on the first electrode 110. The interlayer 130 may comprise an emission layer.

In one or more embodiments, the interlayer 130 may further comprise a hole transport region arranged between the first electrode 110 and the emission layer, and an electron transport region arranged between the emission layer and the second electrode 150.

In one or more embodiments, the interlayer 130 may further comprise, in addition to one or more suitable organic materials, a metal-containing compound such as an organometallic compound, an inorganic material such as a quantum dot, and/or the like.

In one or more embodiments, the interlayer 130 may comprise, i) two or more emitting units sequentially stacked

between the first electrode 110 and the second electrode 150, and ii) a charge generation layer between the two or more emitting units. When the interlayer 130 comprises the two or more emitting units and the charge generation layer, the light-emitting device 10 may be a tandem light-emitting device.

**Hole transport region in interlayer 130**

The hole transport region may have: i) a single-layer structure comprising (e.g., consisting of) a single layer comprising (e.g., consisting of) a single material, ii) a single-layer structure comprising (e.g., consisting of) a single layer comprising (e.g., consisting of) multiple materials that are different from each other, or iii) a multi-layer structure comprising multiple materials comprising multiple materials that are different from each other.

The hole transport region may comprise a hole injection layer, a hole transport layer, an emission auxiliary layer, an electron blocking layer, or any combination thereof.

For example, in some embodiments, the hole transport region may have a multi-layer structure comprising a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, wherein constituent layers of each structure are stacked sequentially from the first electrode 110 in the stated order.

The hole transport region may comprise a compound represented by Formula 201, a compound represented by Formula 202, or any combination thereof:

Formula 201

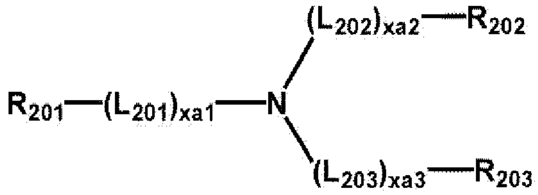

Formula 202

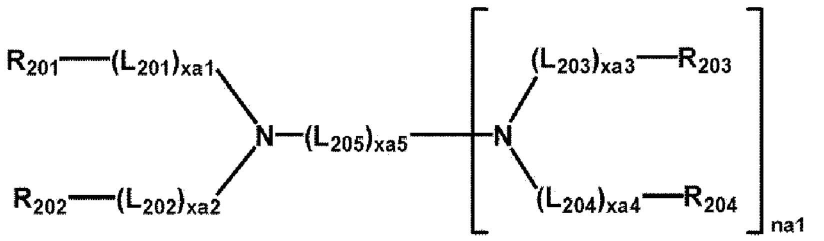

wherein, in Formulae 201 and 202,

$L_{201}$ to $L_{204}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,

$L_{205}$ may be *-O-*', *-S-*', *-N($Q_{201}$)-*', a $C_1$-$C_{20}$ alkylene group unsubstituted or substituted with at least one $R_{10a}$, a $C_2$-$C_{20}$ alkenylene group unsubstituted or substituted with at least one $R_{10a}$, a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,

xa1 to xa4 may each independently be an integer from 0 to 5,

xa5 may be an integer from 1 to 10,

$R_{201}$ to $R_{204}$ and $Q_{201}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,

$R_{201}$ and $R_{202}$ may optionally be bonded to each other via a single bond, a $C_1$-$C_5$ alkylene group unsubstituted or substituted with at least one $R_{10a}$, or a $C_2$-$C_5$ alkenylene group unsubstituted or substituted with at least one $R_{10a}$, to form a $C_8$-$C_{60}$ polycyclic group (for example, a carbazole group, etc.) unsubstituted or substituted with at least one $R_{10a}$ (for example, Compound HT16, etc.),

$R_{203}$ and $R_{204}$ may optionally be bonded to each other via a single bond, a $C_1$-$C_5$ alkylene group unsubstituted or substituted with at least one $R_{10a}$, or a $C_2$-$C_5$ alkenylene group unsubstituted or substituted with at least one $R_{10a}$,

to form a $C_8$-$C_{60}$ polycyclic group unsubstituted or substituted with at least one $R_{10a}$, and na1 may be an integer from 1 to 4.

For example, in some embodiments, each of Formulae 201 and 202 may comprise at least one selected from groups represented by Formulae CY201 to CY217:

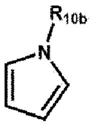
CY201
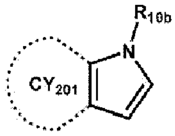
CY202
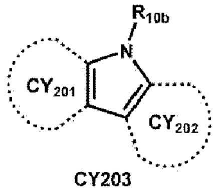
CY203
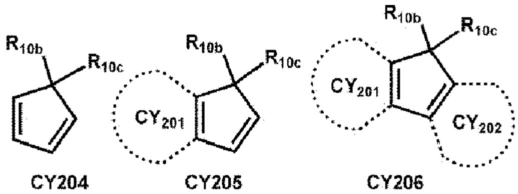
CY204 CY205 CY206

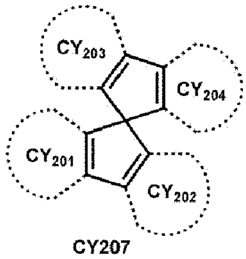
CY207
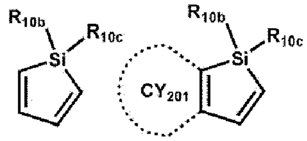
CY208 CY209
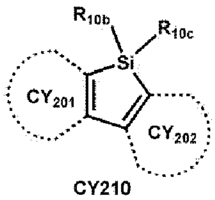
CY210
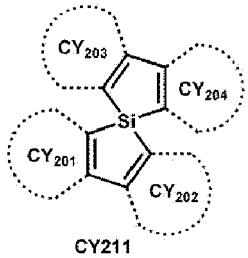
CY211

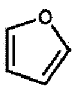
CY212
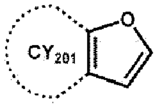
CY213
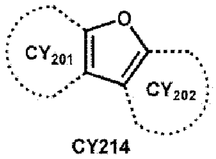
CY214
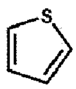
CY215
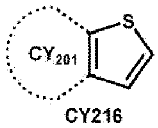
CY216
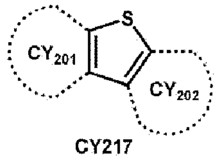
CY217 ,

wherein, in Formulae CY201 to CY217, $R_{10b}$ and $R_{10c}$ may each independently be the same as defined herein with respect to $R_{10a}$, ring $CY_{201}$ to ring $CY_{204}$ may each independently be a $C_3$-$C_{20}$ carbocyclic group or a $C_1$-$C_{20}$ heterocyclic group, and at least one hydrogen in Formulae CY201 to CY217 may be unsubstituted or substituted with $R_{10a}$.

In one or more embodiments, in Formulae CY201 to CY217, ring $CY_{201}$ to ring $CY_{204}$ may each independently be a benzene group, a naphthalene group, a phenanthrene group, or an anthracene group.

In one or more embodiments, each of Formulae 201 and 202 may comprise at least one selected from the groups represented by Formulae CY201 to CY203.

In one or more embodiments, Formula 201 may comprise at least one selected from the groups represented by Formulae CY201 to CY203 and at least one selected from the groups represented by Formulae CY204 to CY217.

In one or more embodiments, in Formula 201, xa1 may be 1, $R_{201}$ may be one selected from the groups represented by Formulae CY201 to CY203, xa2 may be 0, and $R_{202}$ may be one selected from the groups represented by Formulae CY204 to CY207.

In one or more embodiments, each of Formulae 201 and 202 may not comprise(e.g., may exclude) any groups represented by Formulae CY201 to CY203.

In one or more embodiments, each of Formulae 201 and 202 may not comprise (e.g., may exclude) any groups represented by Formulae CY201 to CY203, and may comprise at least one selected from the groups represented by Formulae CY204 to CY217.

In one or more embodiments, each of Formulae 201 and 202 may not comprise (e.g., may exclude) any groups represented by Formulae CY201 to CY217.

In one or more embodiments, the hole transport region may comprise at least one selected from Compounds HT1 to HT46, 4,4',4"-[tris(3-methylphenyl)phenylamino] triphenylamine (m-MTDATA), 4,4',4"-tris(N,N-diphenylamino)triphenylamine (TDATA), 4,4',4"-tris[N(2-naphthyl)-N-phenylamino]-triphenylamine (2-TNATA), N,N'-di(1-naphthalen-1-yl)-N,N'-diphenyl-benzidine (NPB(NPD)), β-NPB, N,N'-bis(3-methylphenyl)-N,N'-diphenyl-[1,1'-biphenyl]-4,4'-diamine (TPD), Spiro-TPD, Spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), or any

combination thereof:

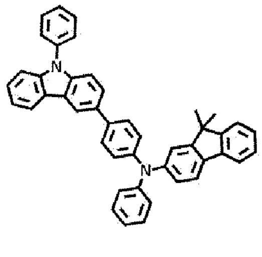
HT1

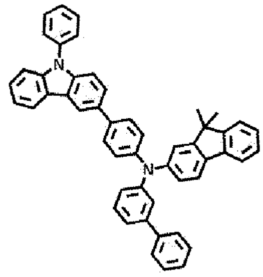
HT2

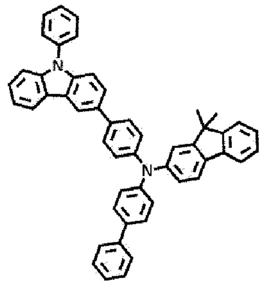
HT3

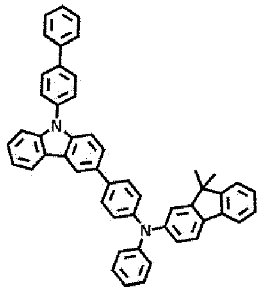
HT4

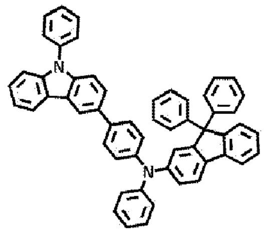
HT5

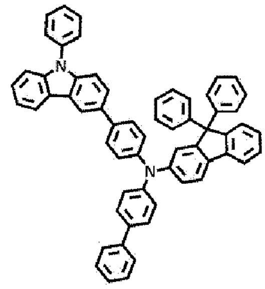
HT6

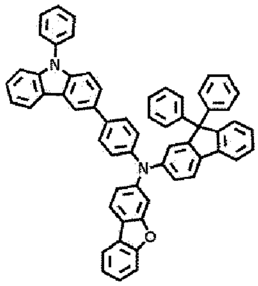
HT7

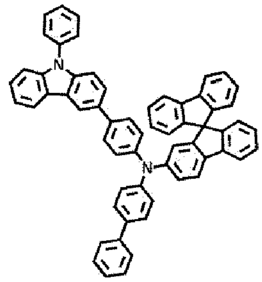
HT8

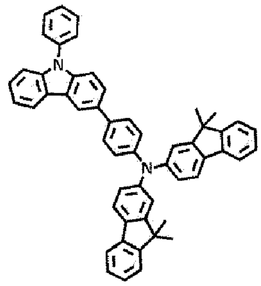
HT9

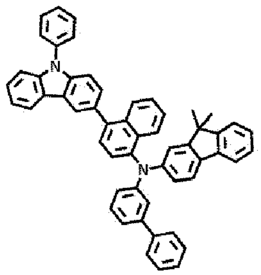
HT10

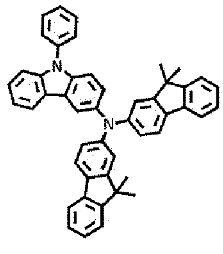
HT11

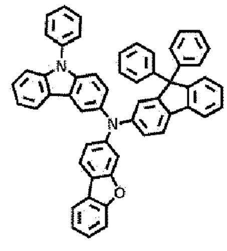
HT12

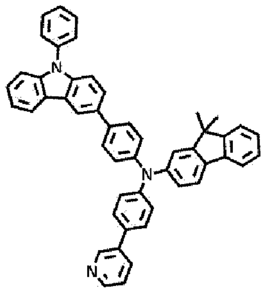

HT13

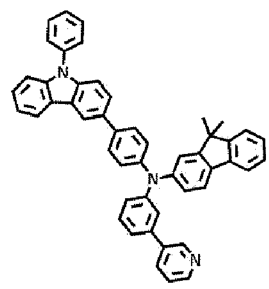

HT14

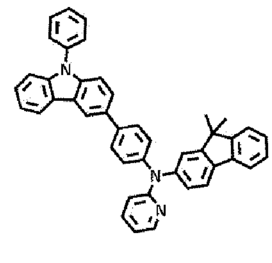

HT15

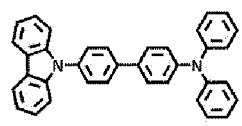

HT16

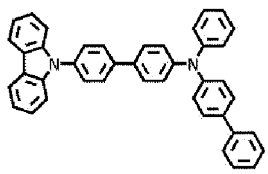

HT17

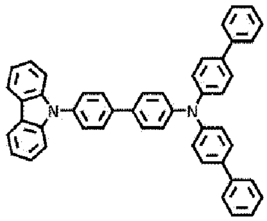

HT18

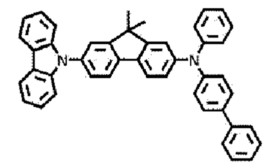

HT19

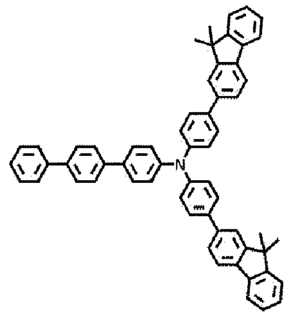

HT20

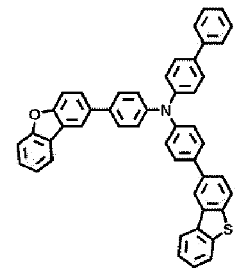

HT21

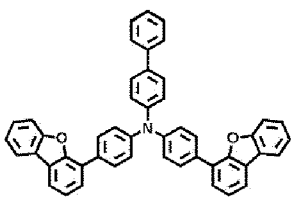

HT22

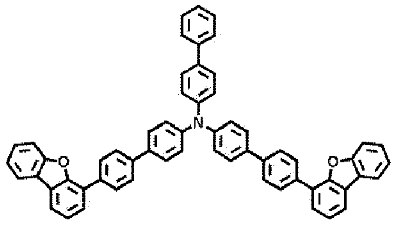

HT23

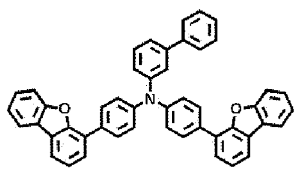

HT24

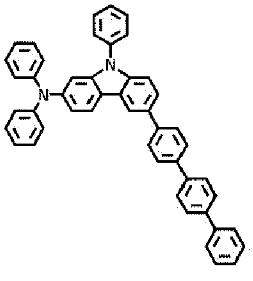

HT25

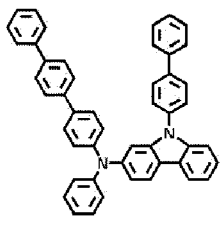

HT26

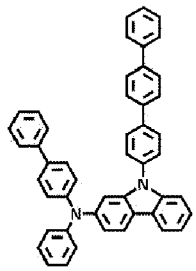

HT27

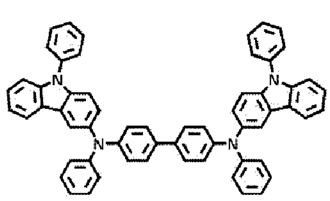
HT28

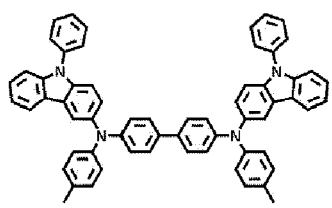
HT29

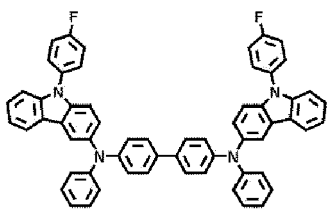
HT30

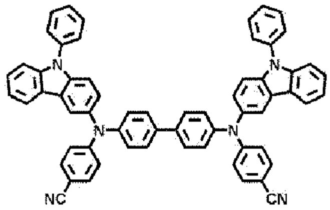
HT31

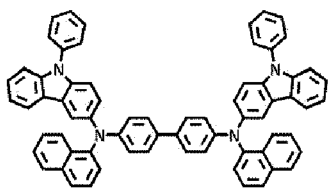
HT32

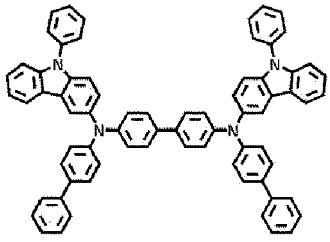
HT33

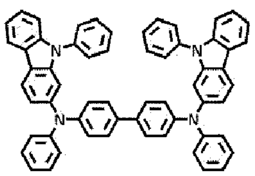
HT34

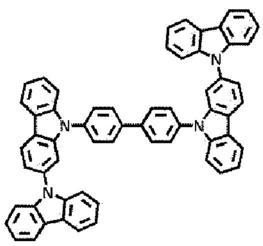
HT35

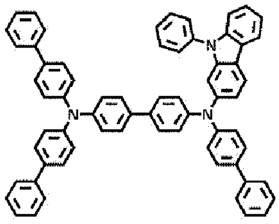
HT36

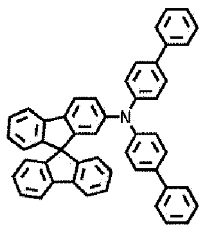
HT37

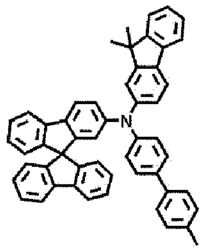
HT38

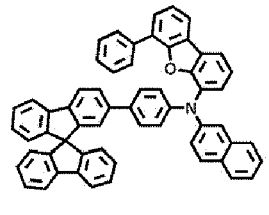
HT39

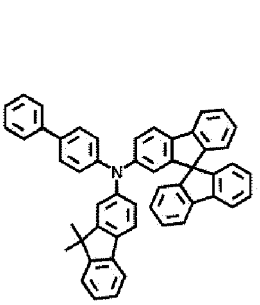
HT40

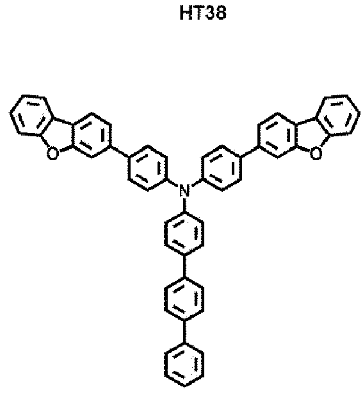
HT41

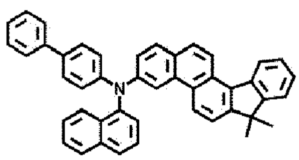
HT42

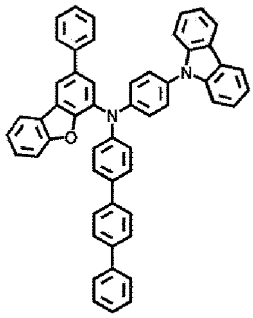

HT43

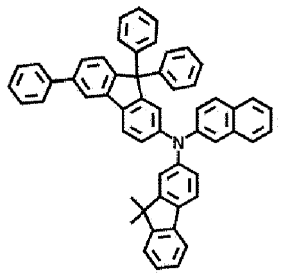

HT44

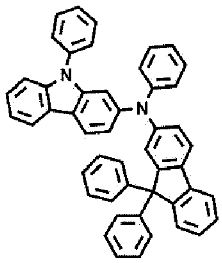

HT45

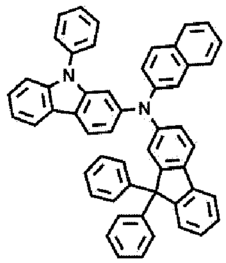

HT46

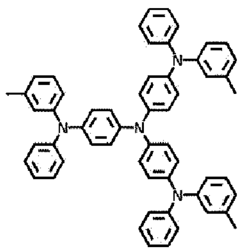

m-MTDATA

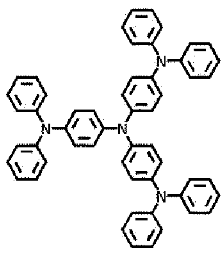

TDATA

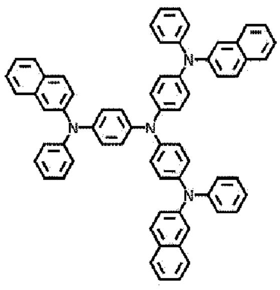

2-TNATA

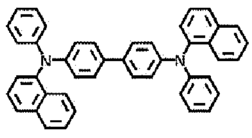

NPB

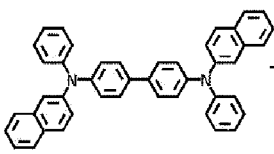

β-NPB

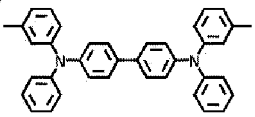

TPD

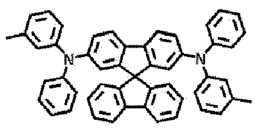

Spiro-TPD

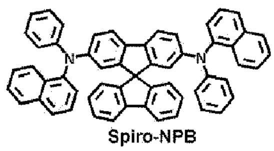

Spiro-NPB

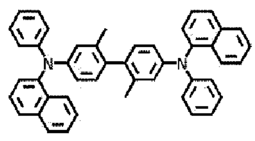

methylated-NPB

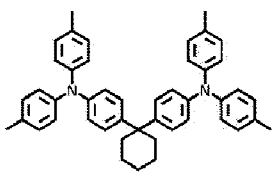

TAPC

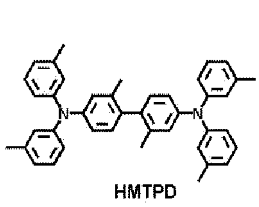

HMTPD

A thickness of the hole transport region may be in a range of about 50 Å to about 10,000 Å, for example, about 100 Å to about 4,000 Å. When the hole transport region comprises a hole injection layer, a hole transport layer, or any combination thereof, a thickness of the hole injection layer may be in a range of about 100 Å to about 9,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within these ranges, satisfactory hole transporting characteristics may

be obtained without a substantial increase in driving voltage.

The emission auxiliary layer may increase light-emission efficiency by compensating for an optical resonance distance according to the wavelength of light emitted by the emission layer, and the electron blocking layer may block or reduce the leakage of electrons from the emission layer to the hole transport region. Materials that may be included in the hole transport region may be included in the emission auxiliary layer and the electron blocking layer.

**p-dopant**

In one or more embodiments, the hole transport region may further comprise, in addition to these materials, a charge-generation material for the improvement of conductive properties. The charge-generation material may be substantially uniformly or non-uniformly dispersed in the hole transport region (for example, in the form of a single layer comprising (e.g., consisting of) a charge-generation material).

The charge-generation material may be, for example, a p-dopant.

For example, in some embodiments, the p-dopant may have a lowest unoccupied molecular orbital (LUMO) energy level of less than or equal to about -3.5 eV.

In one or more embodiments, the p-dopant may comprise a quinone derivative, a cyano group-containing compound, a compound comprising element EL1 and element EL2, or any combination thereof.

Non-limiting examples of the quinone derivative may be tetracyanoquinodimethane (TCNQ), 2,3,5,6-tetrafluoro-7,7,8,8-tetracyanoquinodimethane (F4-TCNQ), and/or the like.

Non-limiting examples of the cyano group-containing compound may be dipyrazino[2,3-f: 2',3'-h] quinoxaline-2,3,6,7,10,11-hexacarbonitrile (HAT-CN), a compound represented by Formula 221, and/or the like:

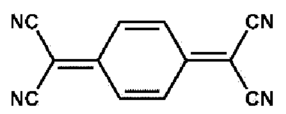

TCNQ

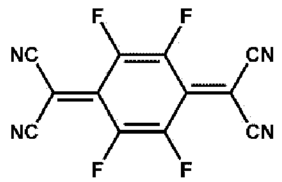

F4-TCNQ

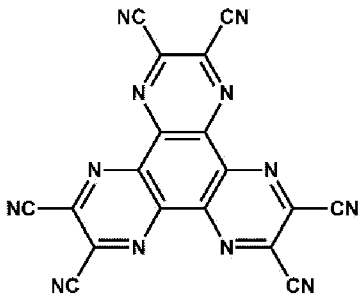

HAT-CN

**Formula 221**

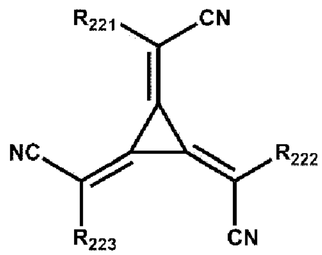

,

wherein, in Formula 221,

$R_{221}$ to $R_{223}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$, and

at least one selected from among $R_{221}$ to $R_{223}$ may each independently be a $C_3$-$C_{60}$ carbocyclic group or a $C_1$-$C_{60}$ heterocyclic group, each substituted with: a cyano group; -F; -Cl; -Br; -I; a $C_1$-$C_{20}$ alkyl group substituted with a cyano group, -F, -Cl, -Br, -I, or any combination thereof; or any combination thereof.

In the compound comprising element EL1 and element EL2, element EL1 may be metal, metalloid, or any combination thereof, and element EL2 may be non-metal, metalloid, or any combination thereof.

Non-limiting examples of the metal may be: an alkali metal (for example, lithium (Li), sodium (Na), potassium (K), rubidium (Rb), cesium (Cs), etc.); an alkaline earth metal (for example, beryllium (Be), magnesium (Mg), calcium (Ca), strontium (Sr), barium (Ba), etc.); a transition metal (for example, titanium (Ti), zirconium (Zr), hafnium (Hf), vanadium

(V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); a post-transition metal (for example, zinc (Zn), indium (In), tin (Sn), etc.); a lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.); and/or the like.

Non-limiting examples of the metalloid may be silicon (Si), antimony (Sb), tellurium (Te), and/or the like.

Non-limiting examples of the non-metal may be oxygen (O), halogen (for example, F, Cl, Br, I, etc.), and/or the like.

Non-limiting examples of the compound comprising element EL1 and element EL2 may be metal oxide, metal halide (for example, metal fluoride, metal chloride, metal bromide, metal iodide, etc.), metalloid halide (for example, metalloid fluoride, metalloid chloride, metalloid bromide, metalloid iodide, etc.), metal telluride, or any combination thereof.

Non-limiting examples of the metal oxide may be tungsten oxide (for example, WO, $W_2O_3$, $WO_2$, $WO_3$, $W_2O_5$, etc.), vanadium oxide (for example, VO, $V_2O_3$, $VO_2$, $V_2O_5$, etc.), molybdenum oxide (MoO, $Mo_2O_3$, $MoO_2$, MoOs, $Mo_2O_5$, etc.), rhenium oxide (for example, ReOs, etc.), and/or the like.

Non-limiting examples of the metal halide may be alkali metal halide, alkaline earth metal halide, transition metal halide, post-transition metal halide, lanthanide metal halide, and/or the like.

Non-limiting examples of the alkali metal halide may be LiF, NaF, KF, RbF, CsF, LiCl, NaCl, KCl, RbCl, CsCl, LiBr, NaBr, KBr, RbBr, CsBr, LiI, NaI, KI, RbI, CsI, and/or the like.

Non-limiting examples of the alkaline earth metal halide may be $BeF_2$, $MgF_2$, $CaF_2$, $SrF_2$, $BaF_2$, $BeCl_2$, $MgCl_2$, $CaCl_2$, $SrCl_2$, $BaCl_2$, $BeBr_2$, $MgBr_2$, $CaBr_2$, $SrBr_2$, $BaBr_2$, $BeI_2$, $MgI_2$, $CaI_2$, $SrI_2$, $BaI_2$, and/or the like.

Non-limiting examples of the transition metal halide may be titanium halide (for example, $TiF_4$, $TiCl_4$, $TiBr_4$, $TiI_4$, etc.), zirconium halide (for example, $ZrF_4$, $ZrCl_4$, $ZrBr_4$, $ZrI_4$, etc.), hafnium halide (for example, $HfF_4$, $HfCl_4$, $HfBr_4$, $HfI_4$, etc.), vanadium halide (for example, $VF_3$, $VCl_3$, $VBr_3$, $VI_3$, etc.), niobium halide (for example, $NbF_3$, $NbCl_3$, $NbBr_3$, $NbI_3$, etc.), tantalum halide (for example, $TaF_3$, $TaCl_3$, $TaBr_3$, $TaI_3$, etc.), chromium halide (for example, $CrF_3$, $CrCl_3$, $CrBr_3$, $CrI_3$, etc.), molybdenum halide (for example, $MoF_3$, $MoCl_3$, $MoBr_3$, $MoI_3$, etc.), tungsten halide (for example, $WF_3$, $WCl_3$, $WBr_3$, $WI_3$, etc.), manganese halide (for example, $MnF_2$, $MnCl_2$, $MnBr_2$, $MnI_2$, etc.), technetium halide (for example, $TcF_2$, $TcCl_2$, $TcBr_2$, $TcI_2$, etc.), rhenium halide (for example, $ReF_2$, $ReCl_2$, $ReBr_2$, $ReI_2$, etc.), iron halide (for example, $FeF_2$, $FeCl_2$, $FeBr_2$, $FeI_2$, etc.), ruthenium halide (for example, $RuF_2$, $RuCl_2$, $RuBr_2$, $RuI_2$, etc.), osmium halide (for example, $OsF_2$, $OsCl_2$, $OsBr_2$, $OsI_2$, etc.), cobalt halide (for example, $CoF_2$, $CoCl_2$, $CoBr_2$, $CoI_2$, etc.), rhodium halide (for example, $RhF_2$, $RhCl_2$, $RhBr_2$, $RhI_2$, etc.), iridium halide (for example, $IrF_2$, $IrCl_2$, $IrBr_2$, $IrI_2$, etc.), nickel halide (for example, $NiF_2$, $NiCl_2$, $NiBr_2$, $NH_2$, etc.), palladium halide (for example, $PdF_2$, $PdCl_2$, $PdBr_2$, $PdI_2$, etc.), platinum halide (for example, $PtF_2$, $PtCl_2$, $PtBr_2$, $PtI_2$, etc.), copper halide (for example, CuF, CuCl, CuBr, CuI, etc.), silver halide (for example, AgF, AgCl, AgBr, AgI, etc.), gold halide (for example, AuF, AuCl, AuBr, AuI, etc.), and/or the like.

Non-limiting examples of the post-transition metal halide may be zinc halide (for example, $ZnF_2$, $ZnCl_2$, $ZnBr_2$, $ZnI_2$, etc.), indium halide (for example, $InI_3$, etc.), tin halide (for example, $SnI_2$, etc.), and/or the like.

Non-limiting examples of the lanthanide metal halide may be YbF, $YbF_2$, $YbF_3$, $SmF_3$, YbCl, $YbCl_2$, $YbCl_3$, $SmCl_3$, YbBr, $YbBr_2$, $YbBr_3$ $SmBr_3$, YbI, $YbI_2$, $YbI_3$, $SmI_3$, and/or the like.

Non-limiting examples of the metalloid halide may be antimony halide (for example, $SbCl_5$, etc.) and/or the like.

Non-limiting examples of the metal telluride may be alkali metal telluride (for example, $Li_2Te$, $Na_2Te$, $K_2Te$, $Rb_2Te$, $Cs_2Te$, etc.), alkaline earth metal telluride (for example, BeTe, MgTe, CaTe, SrTe, BaTe, etc.), transition metal telluride (for example, $TiTe_2$, $ZrTe_2$, $HfTe_2$, $V_2Te_3$, $Nb_2Te_3$, $Ta_2Te_3$, $Cr_2Te_3$, $Mo_2Te_3$, $W_2Te_3$, MnTe, TcTe, ReTe, FeTe, RuTe, OsTe, CoTe, RhTe, IrTe, NiTe, PdTe, PtTe, $Cu_2Te$, CuTe, $Ag_2Te$, AgTe, $Au_2Te$, etc.), post-transition metal telluride (for example, ZnTe, etc.), lanthanide metal telluride (for example, LaTe, CeTe, PrTe, NdTe, PmTe, EuTe, GdTe, TbTe, DyTe, HoTe, ErTe, TmTe, YbTe, LuTe, etc.), and/or the like.

### Emission layer in interlayer 130

When the light-emitting device 10 is a full-color light-emitting device, the emission layer may be patterned into a red emission layer, a green emission layer, and/or a blue emission layer, according to a sub-pixel. In one or more embodiments, the emission layer may have a stacked structure of two or more layers selected from a red emission layer, a green emission layer, and a blue emission layer, in which the two or more layers contact each other or are separated from each other, to emit white light (e.g., combined white light). In one or more embodiments, the emission layer may comprise two or more materials selected from a red light-emitting material, a green light-emitting material, and a blue light-emitting material, in which the two or more materials are mixed with each other in a single layer, to emit white light (e.g., combined white light).

In one or more embodiments, the emission layer may comprise a host and a dopant. The dopant may comprise a phosphorescent dopant, a fluorescent dopant, or any combination thereof.

An amount of the dopant in the emission layer may be in a range of about 0.01 parts by weight to about 15 parts by weight based on 100 parts by weight of the host.

In one or more embodiments, the emission layer may comprise a quantum dot.

In one or more embodiments, the emission layer may comprise a delayed fluorescence material. The delayed fluorescence material may act as a host or a dopant in the emission layer.

A thickness of the emission layer may be in a range of about 100 Å to about 1,000 Å, for example, about 200 Å to about 600 Å. When the thickness of the emission layer is within these ranges, excellent or suitable luminescence characteristics may be obtained without a substantial increase in driving voltage.

Host

In one or more embodiments, the host may comprise a compound represented by Formula 301:

**Formula 301** $[Ar_{301}]_{xb11}-[(L_{301})_{xb1}-R_{301}]_{xb21}$,

wherein, in Formula 301,

$Ar_{301}$ and $L_{301}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
xb11 may be 1, 2, or 3,
xb1 may be an integer from 0 to 5,
$R_{301}$ may be hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, $-Si(Q_{301})(Q_{302})(Q_{303})$, $-N(Q_{301})(Q_{302})$, $-B(Q_{301})(Q_{302})$, $-C(=O)(Q_{301})$, $-S(=O)_2(Q_{3d})$, or $-P(=O)(Q_{301})(Q_{302})$,
xb21 may be an integer from 1 to 5, and
$Q_{301}$ to $Q_{303}$ may each independently be the same as defined herein with respect to Q1.

For example, in some embodiments, when xb11 in Formula 301 is 2 or more, two or more of $Ar_{301}$(s) may be linked to each other via a single bond.

In one or more embodiments, the host may comprise the first compound represented by Formula 301-1A or 301-2A, the second compound represented by Formula 302, or any combination thereof.

In one or more embodiments, the host may comprise a compound represented by Formula 301-1, a compound represented by Formula 301-2, or any combination thereof:

**Formula 301-1**

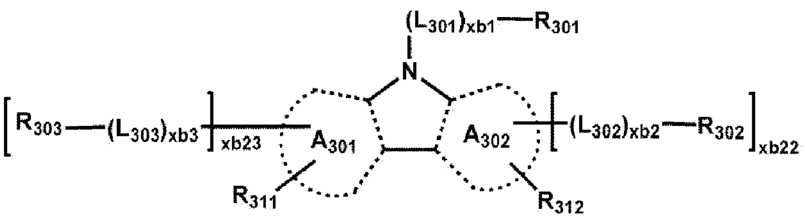

**Formula 301-2**

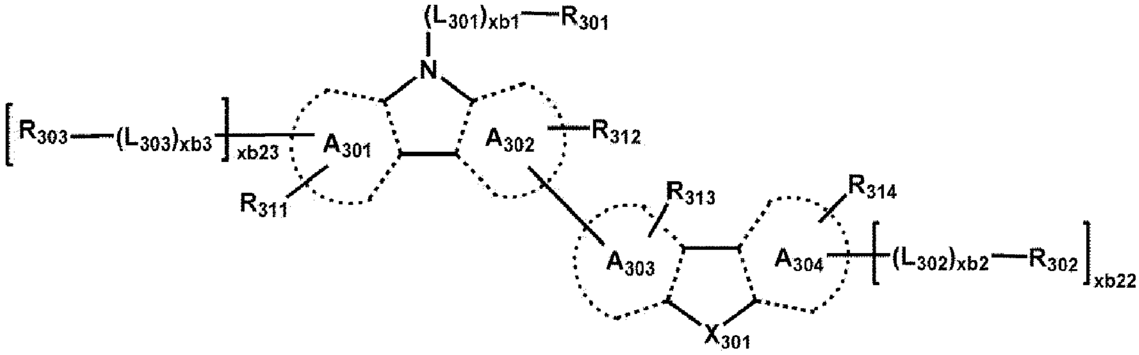

wherein, in Formulae 301-1 and 301-2,

ring $A_{301}$ to ring $A_{304}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
$X_{301}$ may be O, S, N-[$(L_{304})_{xb4}$-$R_{304}$], C($R_{304}$)($R_{305}$), or Si($R_{304}$)($R_{305}$),
xb22 and xb23 may each independently be 0, 1, or 2,
$L_{301}$, xb1, and $R_{301}$ may each be as defined herein,
$L_{302}$ to $L_{304}$ may each independently be the same as defined herein with respect to L301,
xb2 to xb4 may each independently be the same as defined herein with respect to xb1, and
$R_{302}$ to $R_{305}$ and $R_{311}$ to $R_{314}$ may each independently be the same as defined herein with respect to $R_{301}$.

In one or more embodiments, the host may comprise an alkaline earth metal complex, a post-transition metal complex, or any combination thereof. In one or more embodiments, the host may comprise a Be complex (for example, Compound H55), an Mg complex, a Zn complex, or any combination thereof.

In one or more embodiments, the host may comprise at least one selected from among Compounds H1 to H124, at least one selected from among Compounds HTH1 to HTH55, at least one selected from among Compounds ETH1 to ETH86, 9,10-di(2-naphthyl)anthracene (ADN), 2-methyl-9,10-bis(naphthalen-2-yl)anthracene (MADN), 9,10-di-(2-naphthyl)-2-t-butyl-anthracene (TBADN), 4,4'-bis(N-carbazolyl)-1,1'-biphenyl (CBP), 1,3-di(carbazol-9-yl)benzene (mCP), 1,3,5-tri(carbazol-9-yl)benzene (TCP), or any combination thereof:

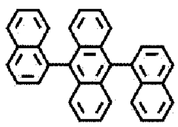
H1

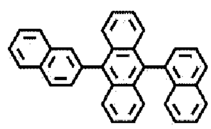
H2

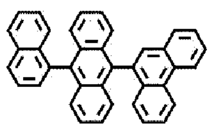
H3

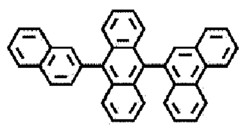
H4

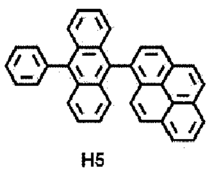
H5

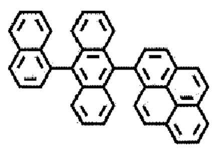
H6

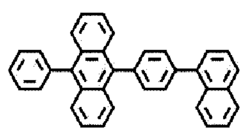
H7

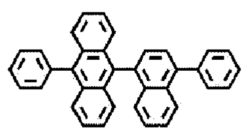
H8

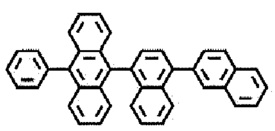
H9

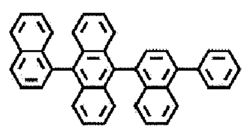
H10

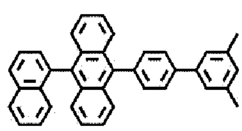
H11

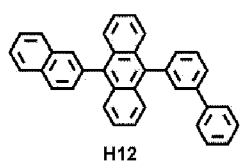
H12

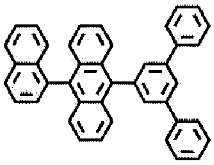
H13

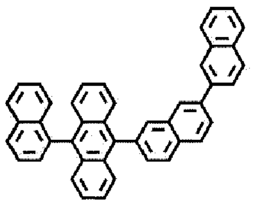
H14

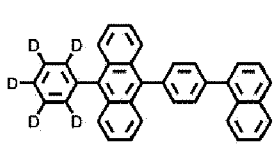
H15

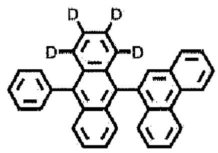
H16

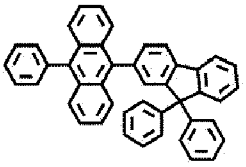
H17

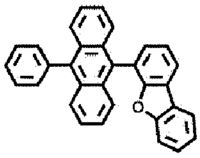
H18

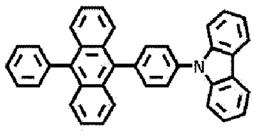
H19

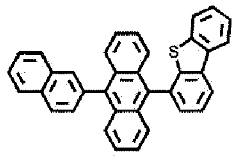
H20

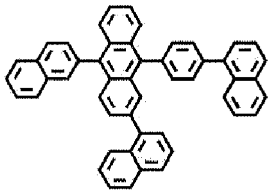
H21

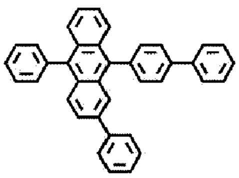
H22

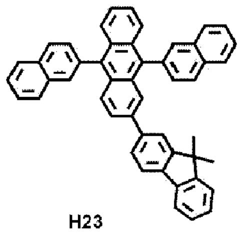
H23

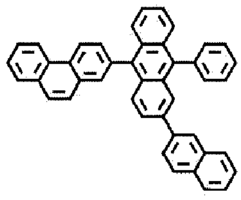
H24

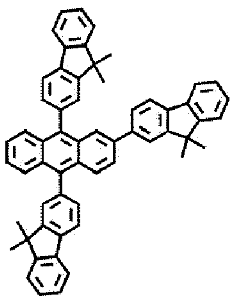
H25

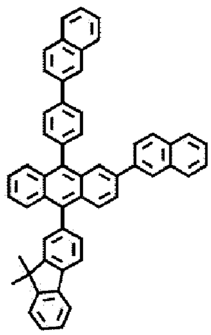
H26

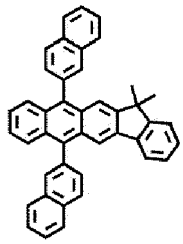
H27

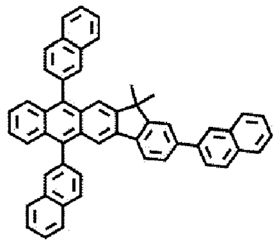
H28

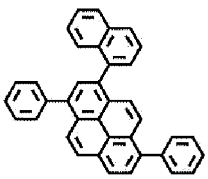
H29

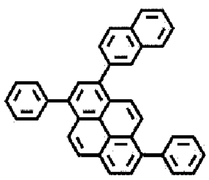
H30

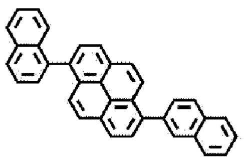
H31

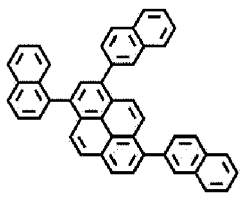
H32

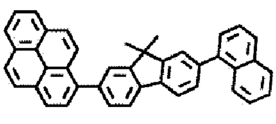
H33

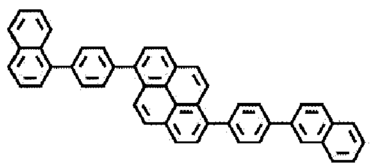
H34

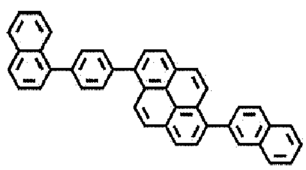
H35

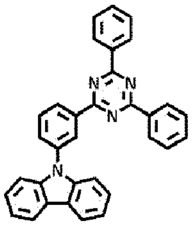
H36

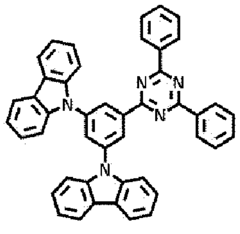
H37

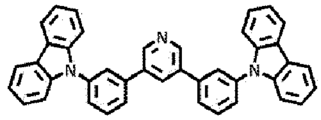
H38

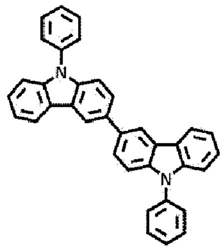
H39

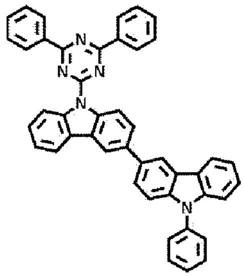
H40

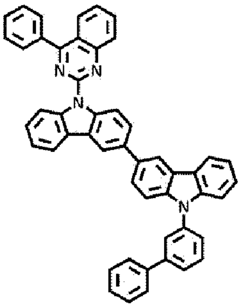
H41

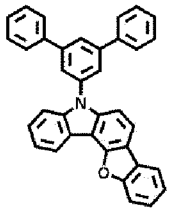
H42

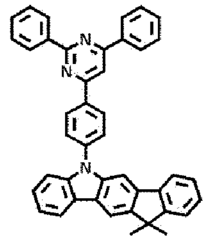
H43

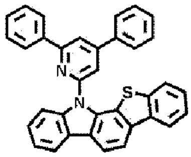
H44

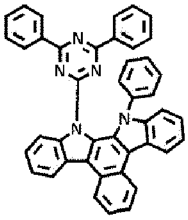
H45

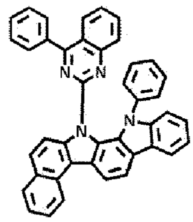
H46

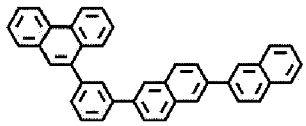
H47

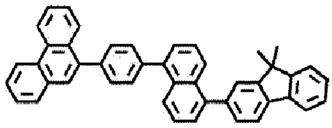
H48

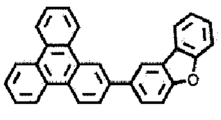
H49

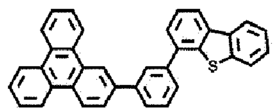
H50

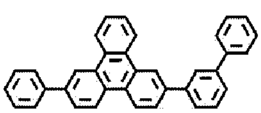
H51

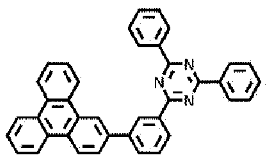
H52

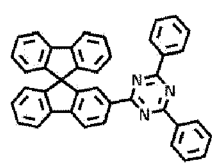
H53

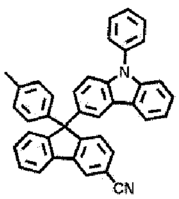
H54

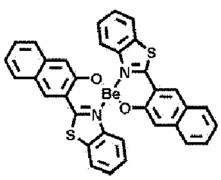
H55

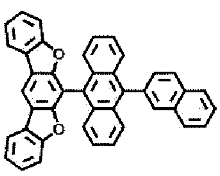
H56

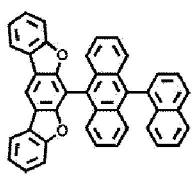
H57

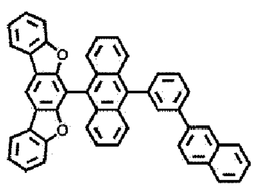
H58

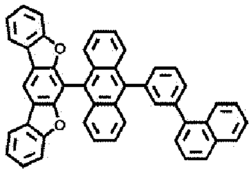
H59

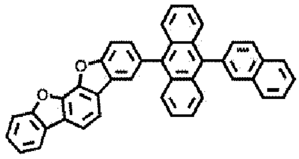
H60

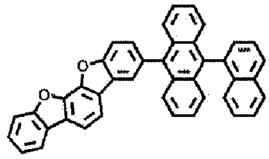
H61

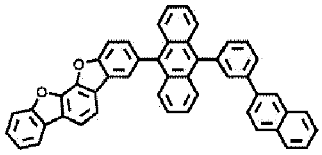
H62

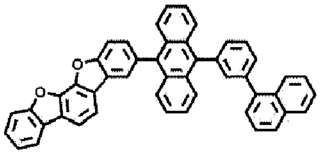
H63

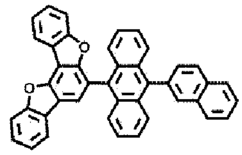
H64

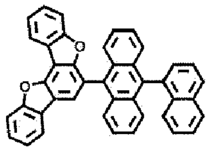
H65

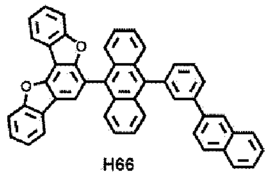
H66

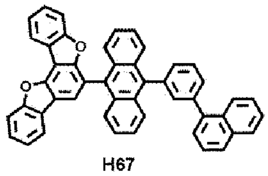
H67

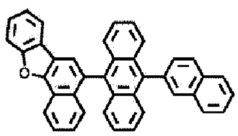
H68

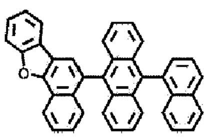
H69

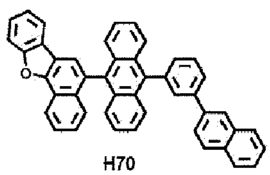
H70

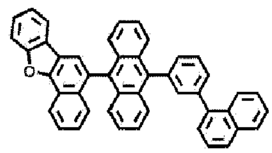
H71

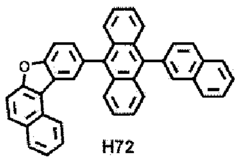
H72

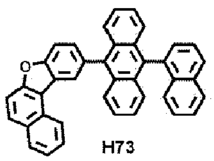
H73

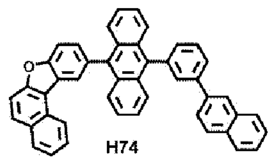
H74

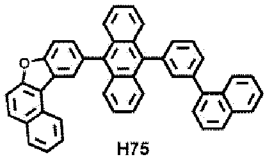
H75

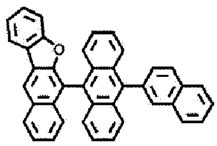
H76

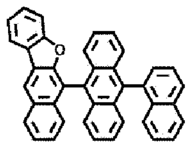
H77

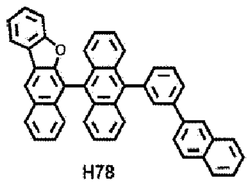
H78

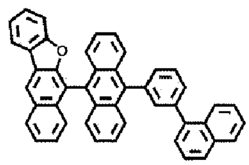
H79

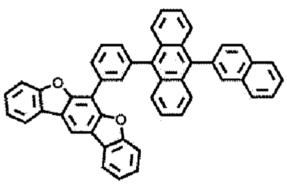
H80

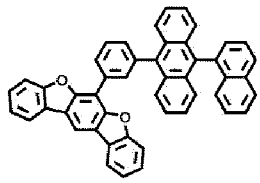
H81

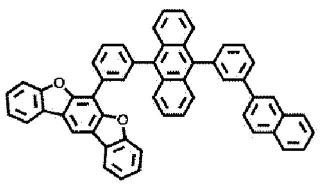
H82

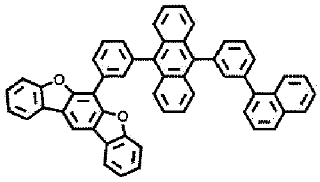
H83

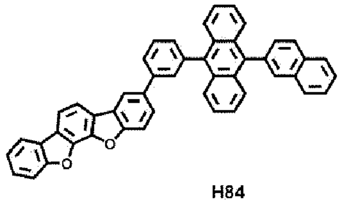
H84

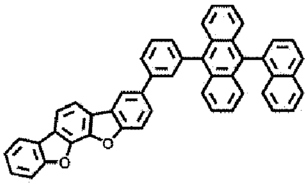
H85

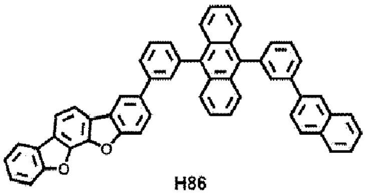
H86

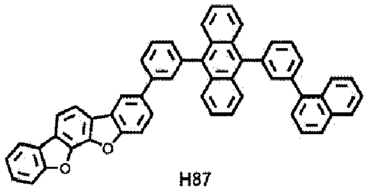
H87

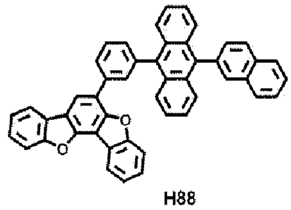
H88

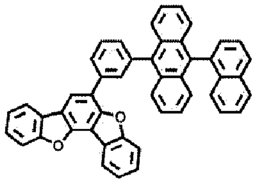
H89

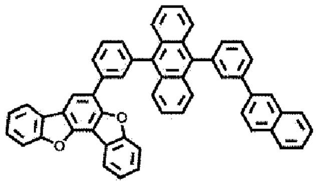
H90

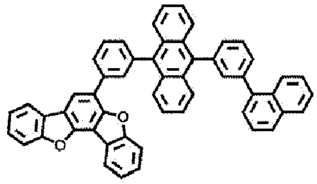
H91

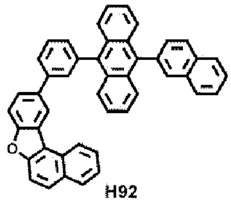
H92

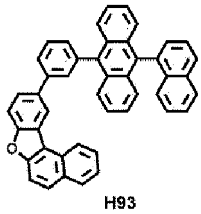
H93

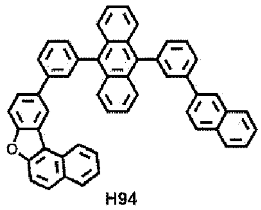
H94

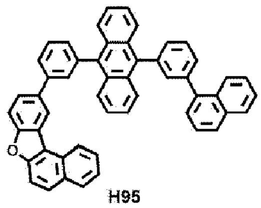
H95

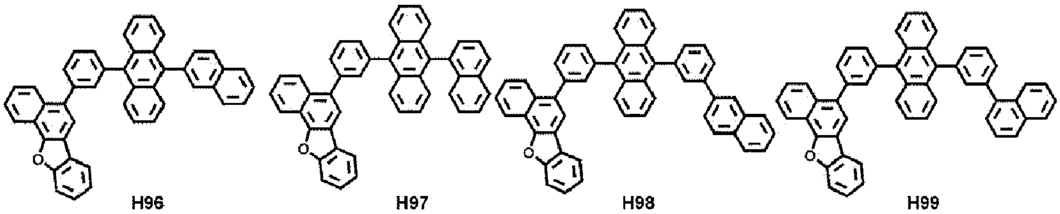
H96 H97 H98 H99

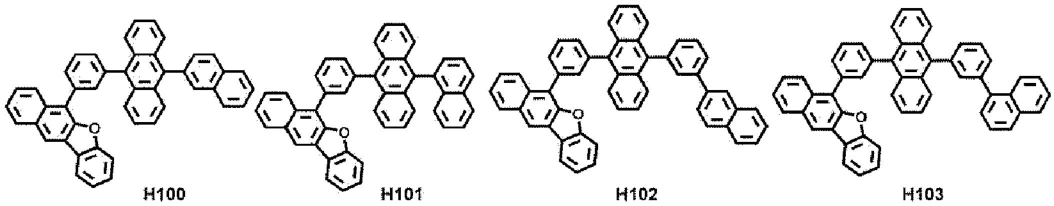
H100 H101 H102 H103

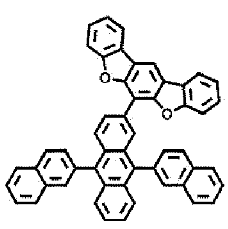
H104

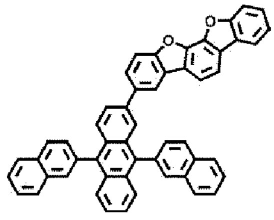
H105

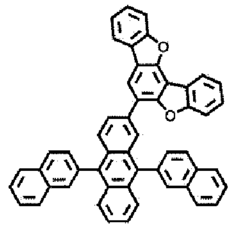
H106

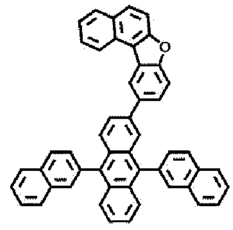
H107

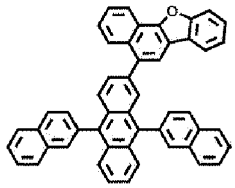
H108

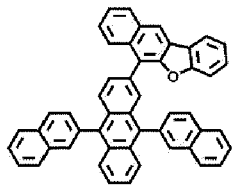
H109

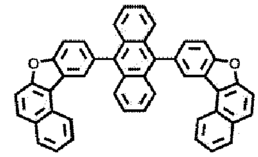
H110

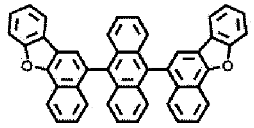
H111

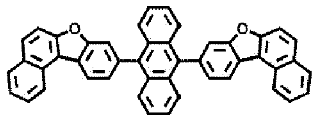
H112

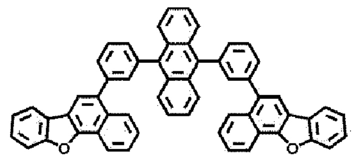
H113

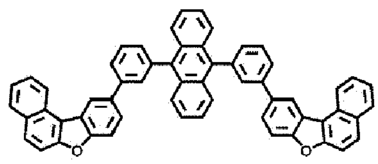
H114

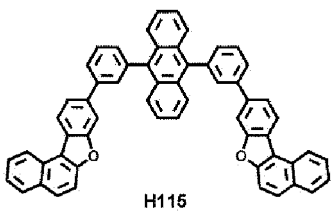
H115

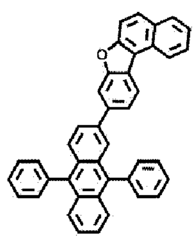
H116

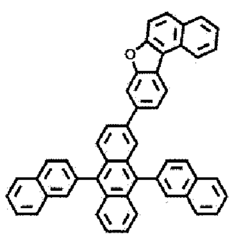
H117

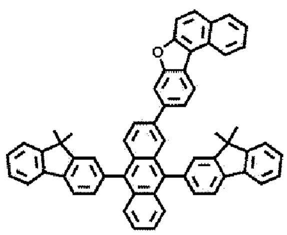
H118

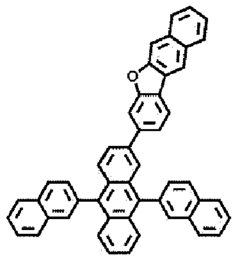
H119

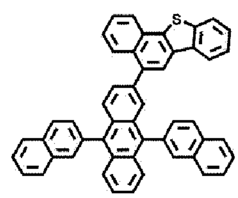
H120

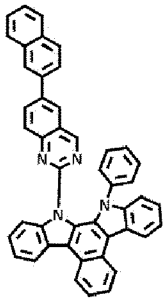
H121

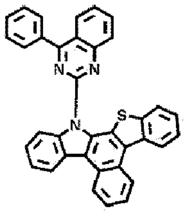
H122

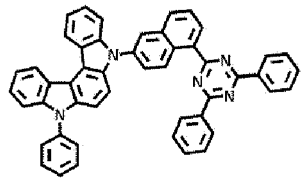
H123

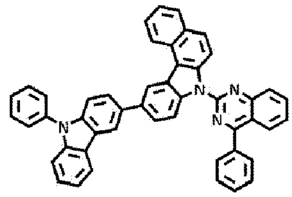
H124

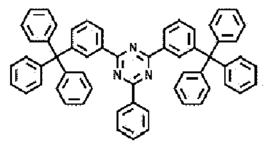
ETH1

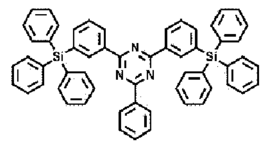
ETH2

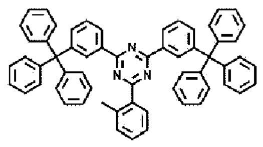
ETH3

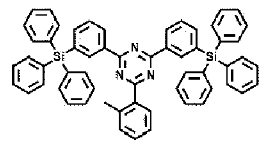
ETH4

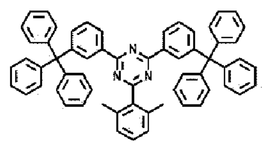
ETH5

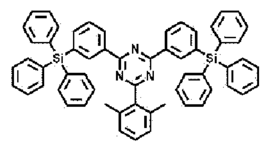
ETH6

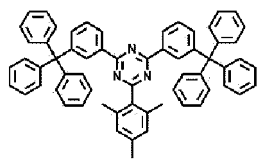
ETH7

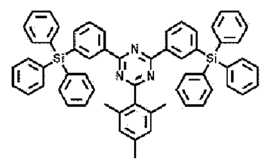
ETH8

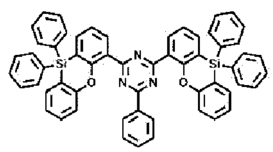
ETH9

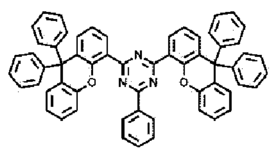
ETH10

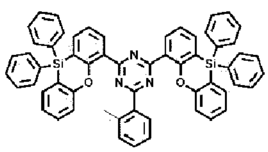
ETH11

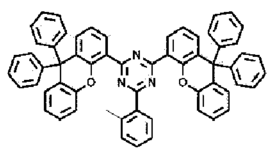
ETH12

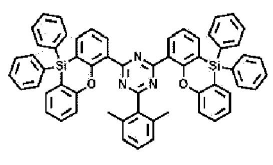
ETH13

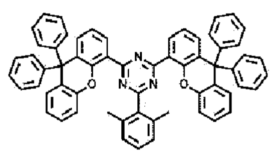
ETH14

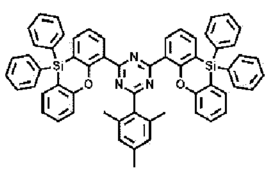
ETH15

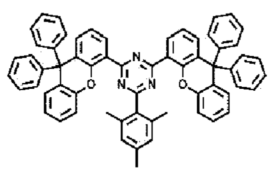
ETH16

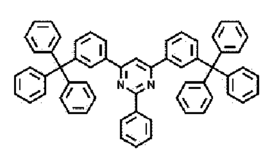
ETH17

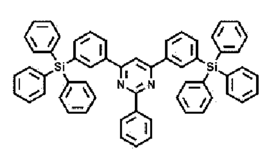
ETH18

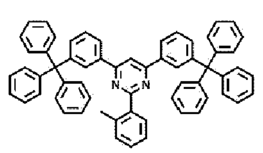
ETH19

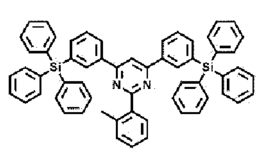
ETH20

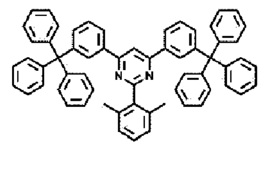
ETH21

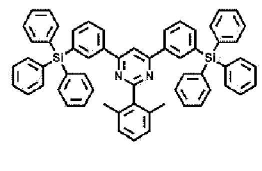
ETH22

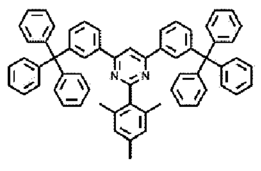
ETH23

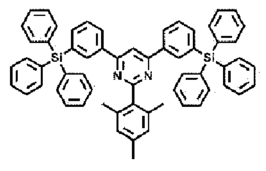
ETH24

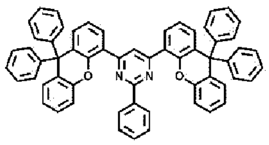
ETH25

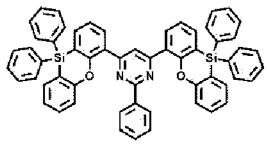
ETH26

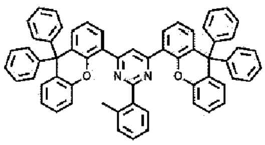
ETH27

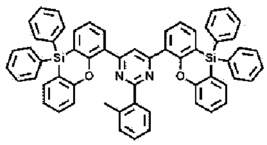
ETH28

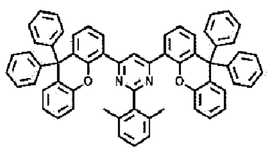
ETH29

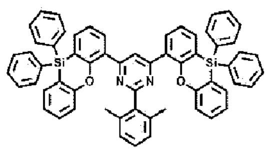
ETH30

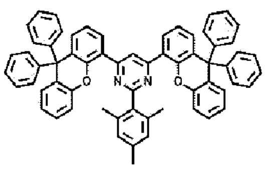
ETH31

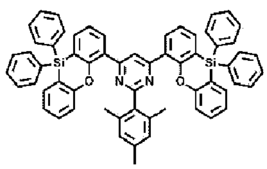
ETH32

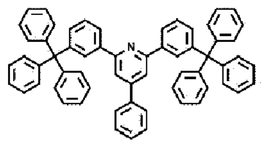
ETH33

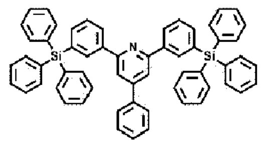
ETH34

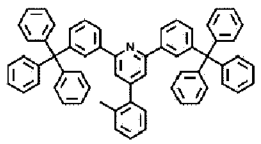
ETH35

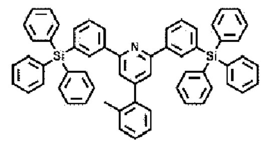
ETH36

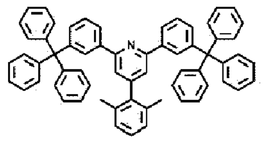
ETH37

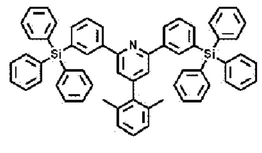
ETH38

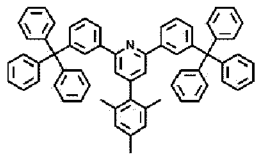
ETH39

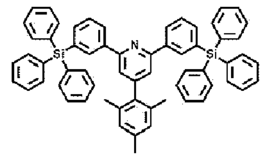
ETH40

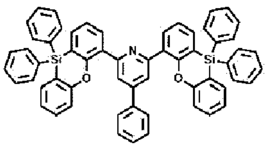
ETH41

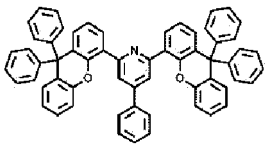
ETH42

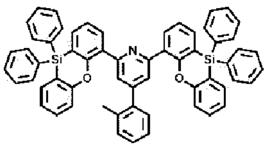
ETH43

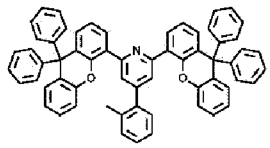
ETH44

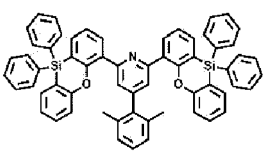
ETH45

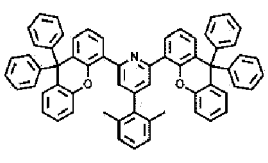
ETH46

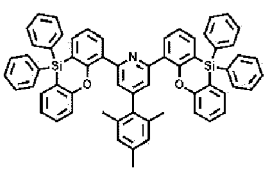
ETH47

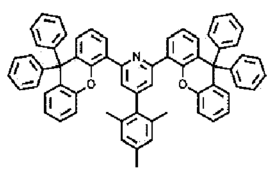
ETH48

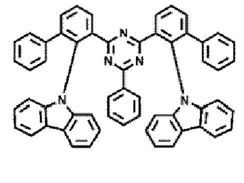
ETH49

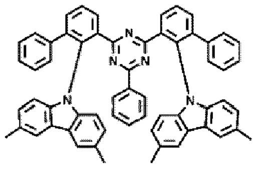
ETH50

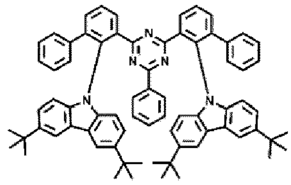
ETH51

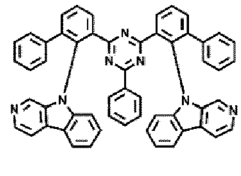
ETH52

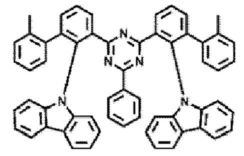
ETH53

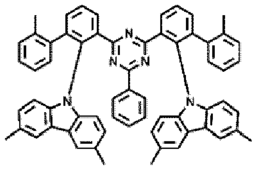
ETH54

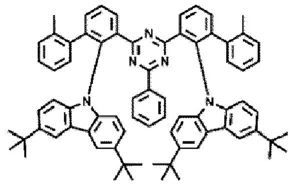
ETH55

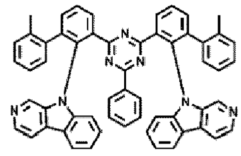
ETH56

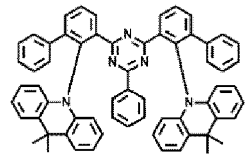
ETH57

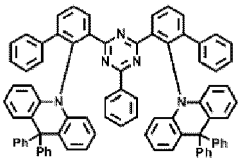
ETH58

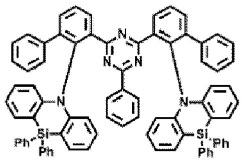
ETH59

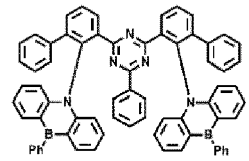
ETH60

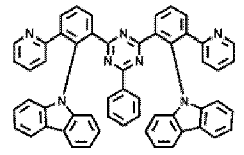
ETH61

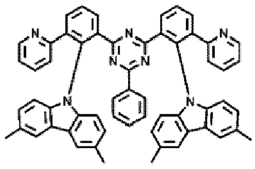
ETH62

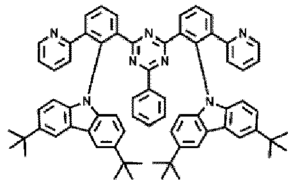
ETH63

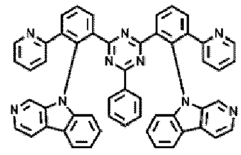
ETH64

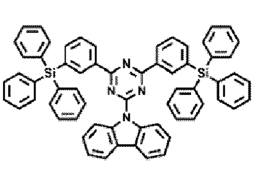
ETH65

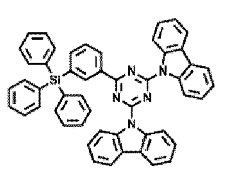
ETH66

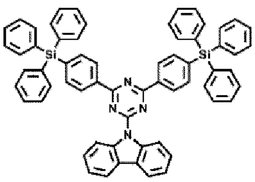
ETH67

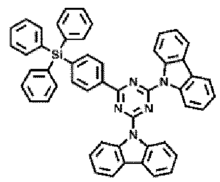
ETH68

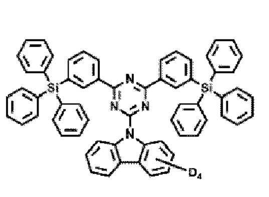
ETH69

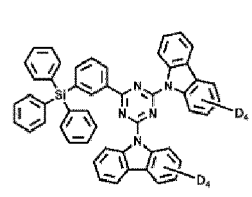
ETH70

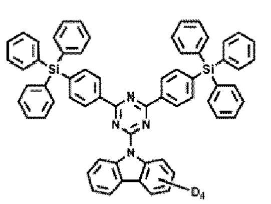
ETH71

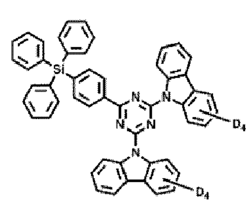
ETH72

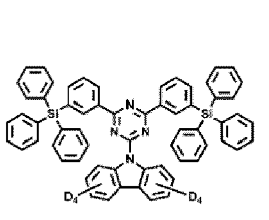
ETH73

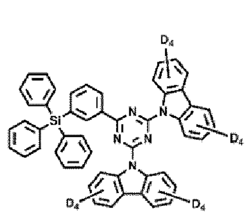
ETH74

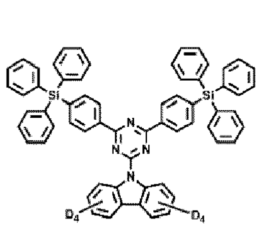
ETH75

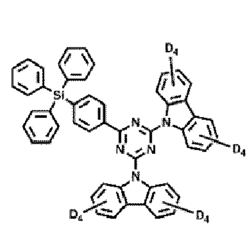
ETH76

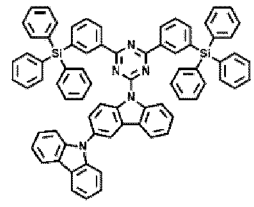
ETH77

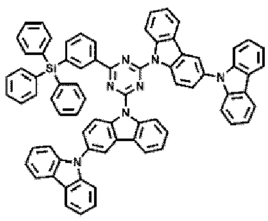
ETH78

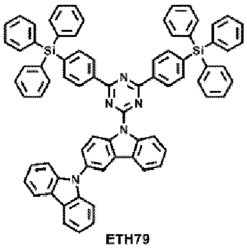
ETH79

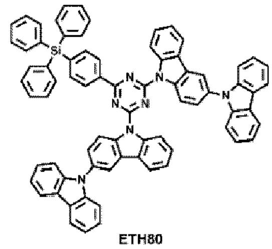
ETH80

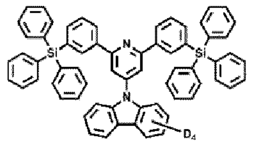
ETH81

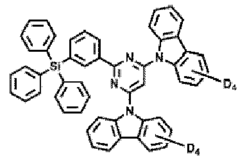
ETH82

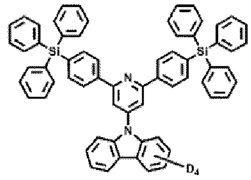
ETH83

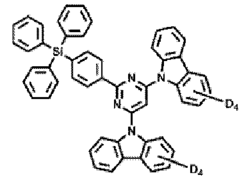
ETH84

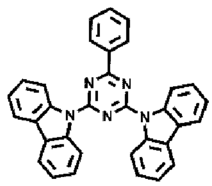
ETH85

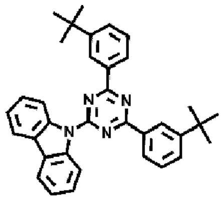
ETH86

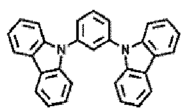
HTH1

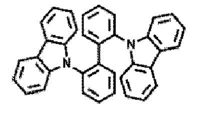
HTH2

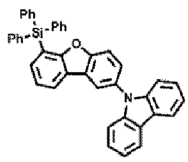
HTH3

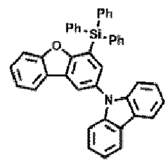
HTH4

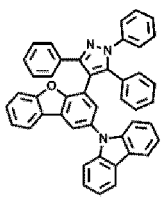
HTH5

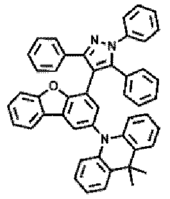
HTH6

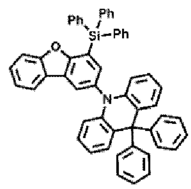
HTH7

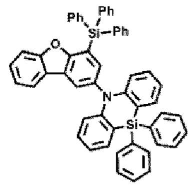
HTH8

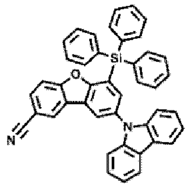
HTH9

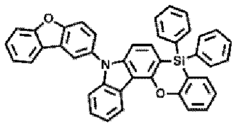
HTH10

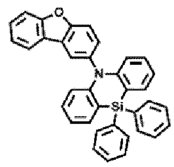
HTH11

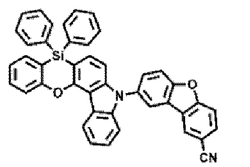
HTH12

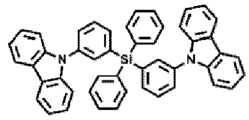
HTH13

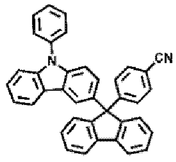
HTH14

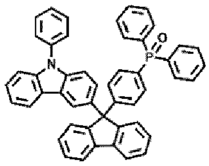
HTH15

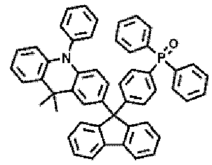
HTH16

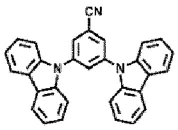
HTH17

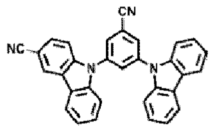
HTH18

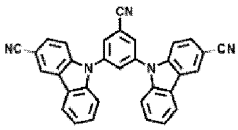
HTH19

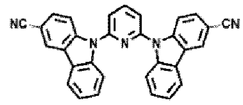
HTH20

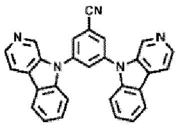
HTH21

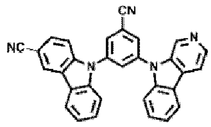
HTH22

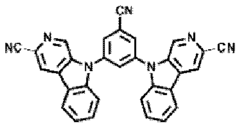
HTH23

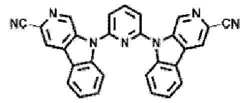
HTH24

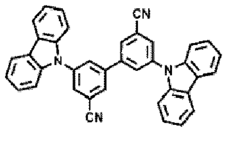
HTH25

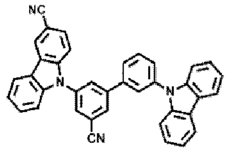
HTH26

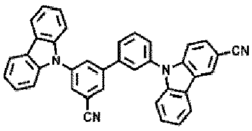
HTH27

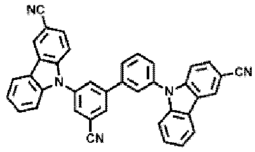
HTH28

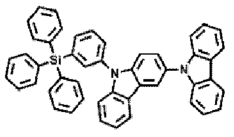
HTH29

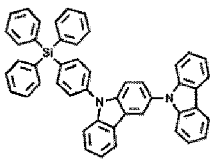
HTH30

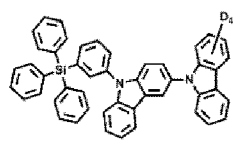
HTH31

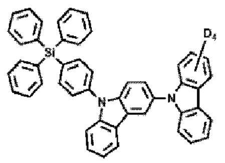
HTH32

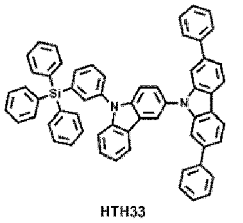
HTH33

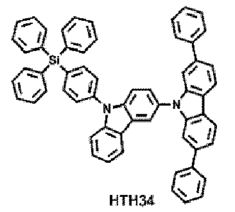
HTH34

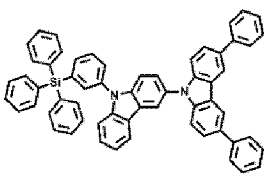
HTH35

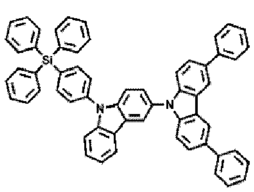
HTH36

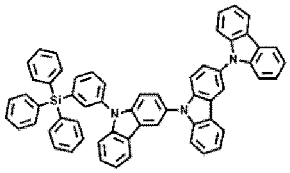
HTH37

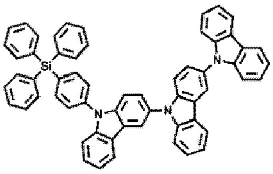
HTH38

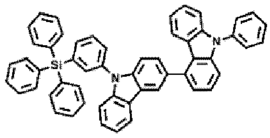
HTH39

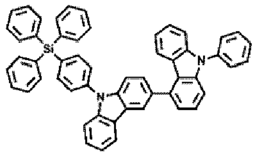
HTH40

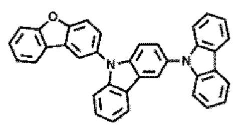
HTH41

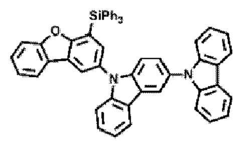
HTH42

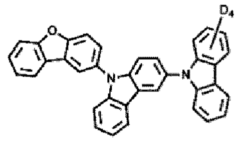
HTH43

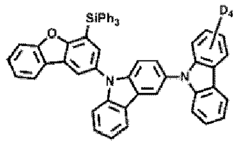
HTH44

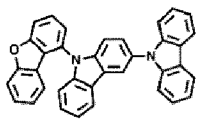
HTH45

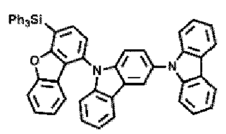
HTH46

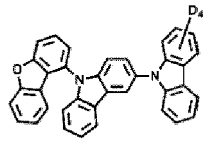
HTH47

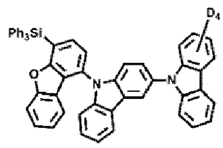
HTH48

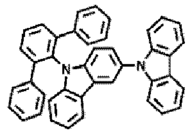
HTH49

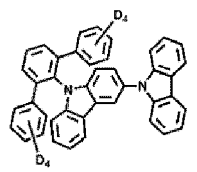
HTH50

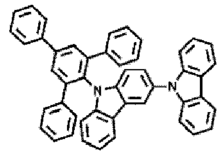
HTH51

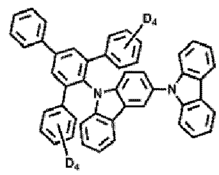
HTH52

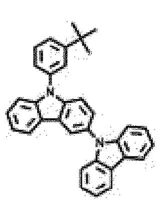
HTH53

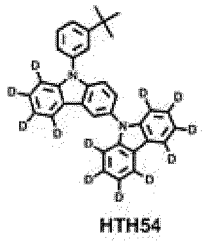
HTH54

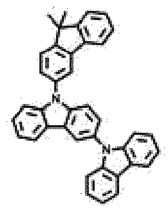
HTH55

**Phosphorescent dopant**

In one or more embodiments, the phosphorescent dopant may comprise at least one transition metal as a central metal.

The phosphorescent dopant may comprise a monodentate ligand, a bidentate ligand, a tridentate ligand, a tetradentate ligand, a pentadentate ligand, a hexadentate ligand, or any combination thereof.

In some embodiments, the phosphorescent dopant may be electrically neutral.

In one or more embodiments, the phosphorescent dopant may comprise the fourth compound represented by Formula 401A.

For example, in some embodiments, the phosphorescent dopant may comprise an organometallic compound represented by Formula 401:

**Formula 401** $M(L_{401})_{xc1}(L_{402})_{xc2}$

**Formula 402**

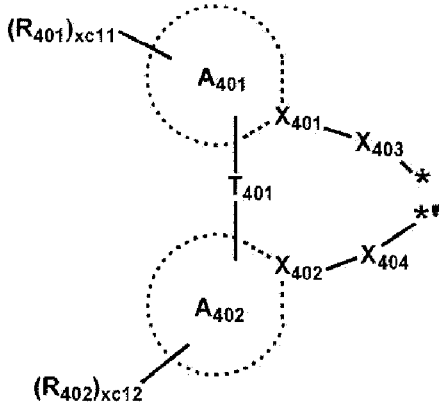

wherein, in Formulae 401 and 402,

M may be a transition metal (for example, iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
$L_{401}$ may be a ligand represented by Formula 402, and xc1 is 1, 2, or 3, wherein, when xc1 is 2 or more, two or more of $L_{401}$(s) may be identical to or different from each other,
$L_{402}$ may be an organic ligand, and xc2 may be 0, 1, 2, 3, or 4, wherein, when xc2 is 2 or more, two or more of $L_{402}$(s) may be identical to or different from each other,
$X_{401}$ and $X_{402}$ may each independently be N or C,
ring $A_{401}$ and ring $A_{402}$ may each independently be a $C_3$-$C_{60}$ carbocyclic group or a $C_1$-$C_{60}$ heterocyclic group,
$T_{401}$ may be a single bond, *-O-*', *-S-*', *-C(=O)-*', *-N($Q_{411}$)-*', *-C($Q_{411}$)($Q_{412}$)-*', *-C($Q_{411}$)=C($Q_{412}$)-*', *-C($Q_{411}$)=*', or *=C=*',
$X_{403}$ and $X_{404}$ may each independently be a chemical bond (for example, a covalent bond or a coordinate bond), O, S, N($Q_{413}$), B($Q_{413}$), P($Q_{413}$), C($Q_{413}$)($Q_{414}$), or Si($Q_{413}$)($Q_{414}$),
$Q_{411}$ to $Q_{414}$ may each independently be the same as defined herein with respect to Q1,
$R_{401}$ and $R_{402}$ may each independently be hydrogen, deuterium, -F, -Cl, -Br, -I, a hydroxyl group, a cyano group, a nitro group, a $C_1$-$C_{20}$ alkyl group unsubstituted or substituted with at least one $R_{10a}$, a $C_1$-$C_{20}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, -Si($Q_{401}$)($Q_{402}$)($Q_{403}$), -N($Q_{401}$)($Q_{402}$), -B($Q_{401}$)($Q_{402}$), -C(=O)($Q_{401}$), -S(=O)$_2$($Q_{401}$), or -P(=O)($Q_{401}$)($Q_{402}$),
$Q_{401}$ to $Q_{403}$ may each independently be the same as defined herein with respect to Q1,
xc11 and xc12 may each independently be an integer from 0 to 10, and
* and *' in Formula 402 each indicate a binding site to M in Formula 401.

In one or more embodiments, in Formula 402, i) $X_{401}$ may be nitrogen and $X_{402}$ may be carbon, or ii) each of $X_{401}$ and $X_{402}$ may be nitrogen.

In one or more embodiments, when xc1 in Formula 401 is 2 or more, two ring $A_{401}$(s) among two or more of $L_{401}$(s) may optionally be linked to each other via $T_{402}$, which is a linking group, and/or two ring $A_{402}$(s) among two or more of $L_{401}$(s) may optionally be linked to each other via $T_{403}$, which is a linking group (see Compounds PD1 to PD4 and PD7). $T_{402}$ and $T_{403}$ may each independently be the same as defined herein with respect to $T_{401}$.

In Formula 401, $L_{402}$ may be an organic ligand. For example, in one or more embodiments, $L_{402}$ may comprise a halogen, a diketone group (for example, an acetylacetonate group), a carboxylic acid group (for example, a picolinate group), -C(=O), an isonitrile group, a -CN group, a phosphorus group (for example, a phosphine group, a phosphite group, etc.), or any combination thereof.

In one or more embodiments, the phosphorescent dopant may comprise, for example, at least one selected from among Compounds PD1 to PD41, or any combination thereof:

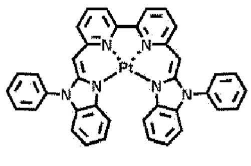
PD1

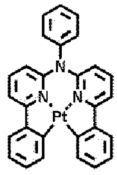
PD2

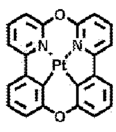
PD3

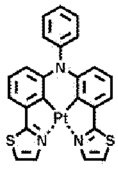
PD4

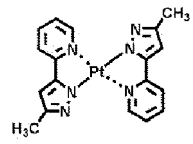
PD5

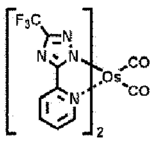
PD6

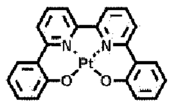
PD7

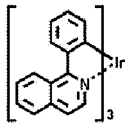
PD8

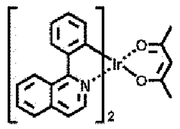
PD9

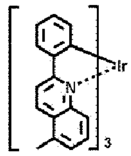
PD10

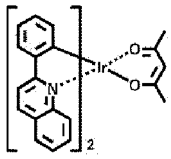
PD11

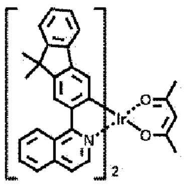
PD12

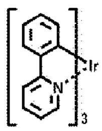
PD13

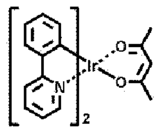
PD14

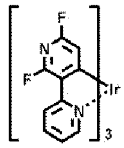
PD15

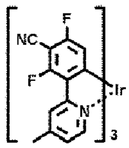
PD16

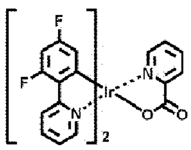
PD17

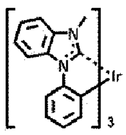
PD18

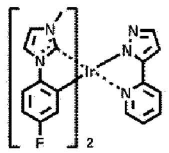
PD19

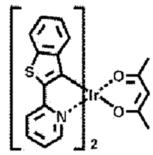
PD20

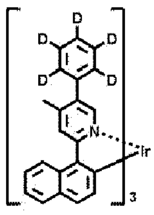
PD21

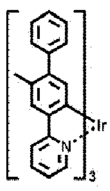
PD22

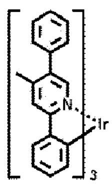
PD23

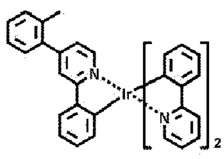
PD24

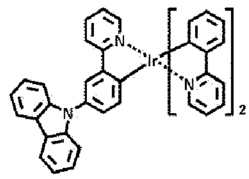
PD25

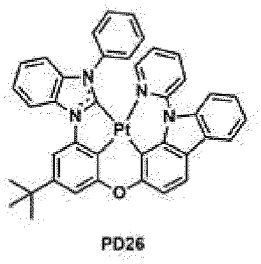

PD26

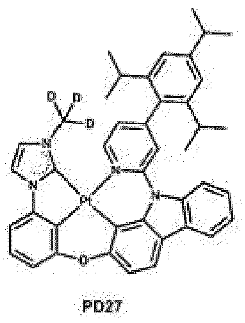

PD27

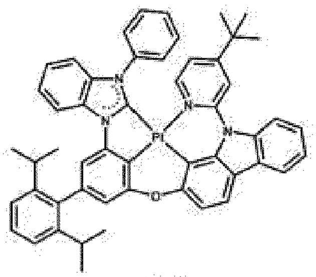

PD28

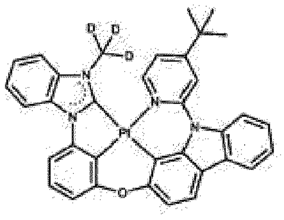

PD29

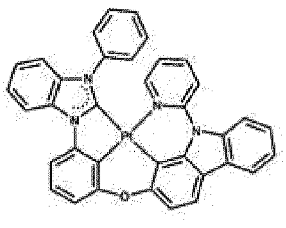

PD30

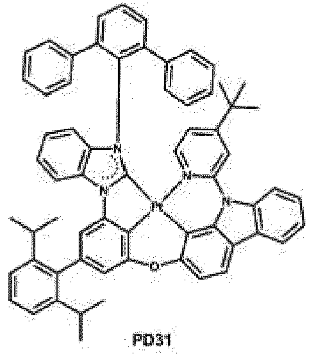

PD31

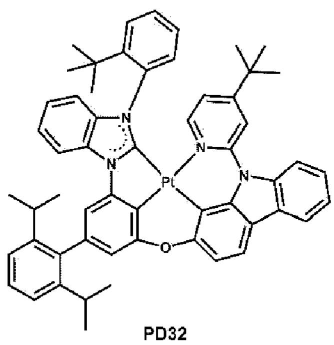

PD32

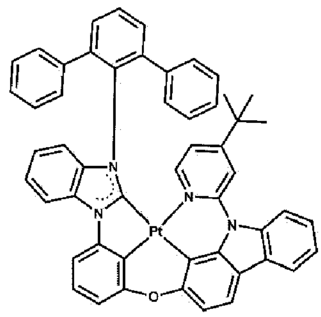

PD33

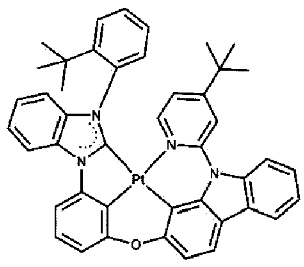

PD34

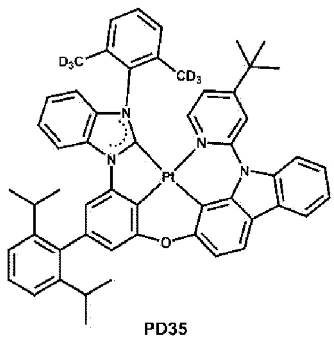

PD35

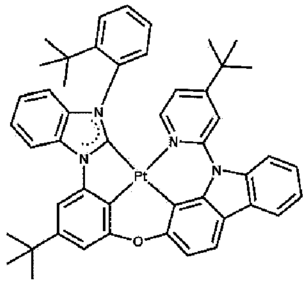

PD36

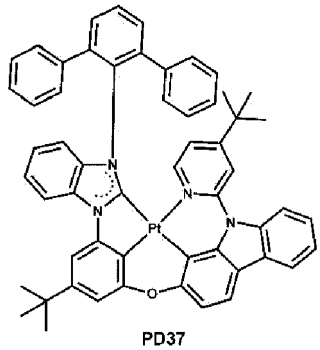

PD37

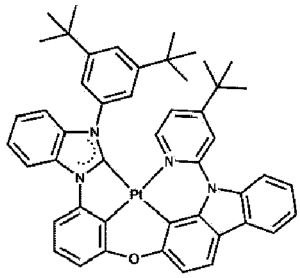

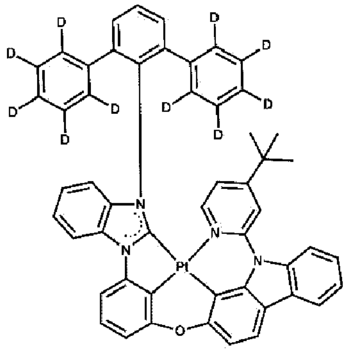

PD38 PD39

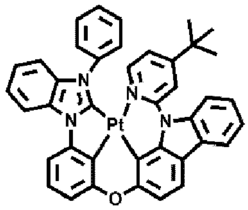

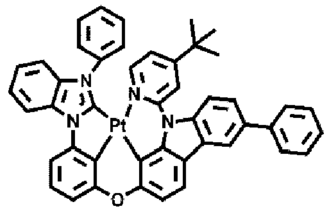

PD40 PD41

## Fluorescent dopant

In one or more embodiments, the fluorescent dopant may comprise an amine group-containing compound, a styryl group-containing compound, or any combination thereof.

For example, in some embodiments, the fluorescent dopant may comprise a compound represented by Formula 501:

### Formula 501

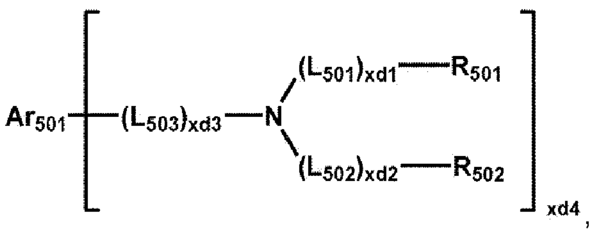

wherein, in Formula 501,

$Ar_{501}$, $L_{501}$ to $L_{503}$, $R_{501}$, and $R_{502}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
xd1 to xd3 may each independently be 0, 1, 2, or 3, and
xd4 may be 1, 2, 3, 4, 5, or 6.

In one or more embodiments, $Ar_{501}$ in Formula 501 may be a condensed cyclic group (for example, an anthracene group, a chrysene group, a pyrene group, etc.) in which three or more monocyclic groups are condensed together.

In one or more embodiments, xd4 in Formula 501 may be 2.

For example, in one or more embodiments, the fluorescent dopant may comprise: at least one selected from among Compounds FD1 to FD36; 4,4'-bis(2,2-diphenylvinyl)-1,1'-biphenyl (DPVBi); 4,4'-bis[4-(di-phenylamino)styryl]biphenyl (DPAVBi); or any combination thereof:

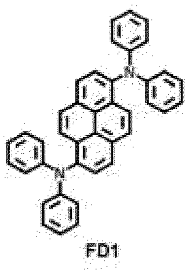
FD1

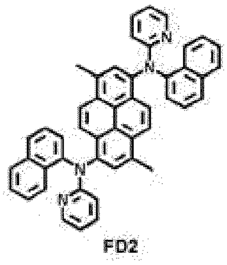
FD2

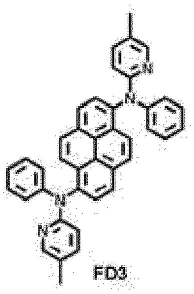
FD3

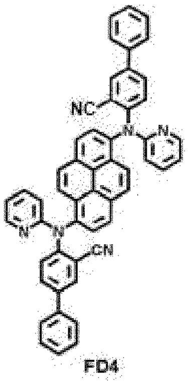
FD4

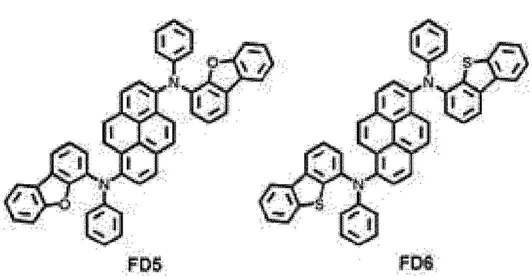
FD5

FD6

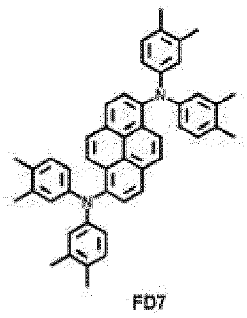
FD7

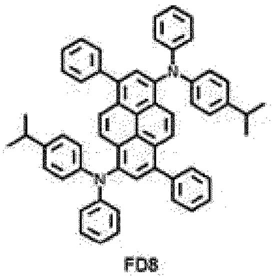
FD8

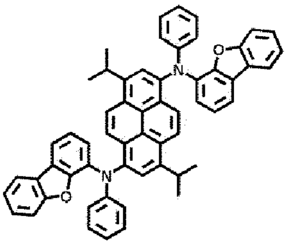
FD9

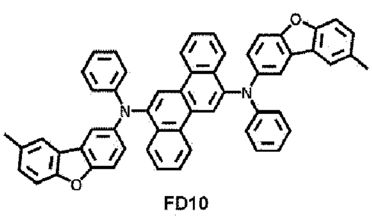
FD10

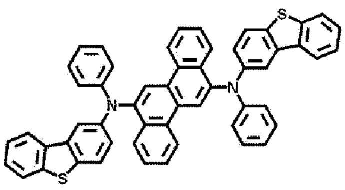
FD11

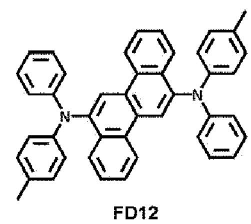
FD12

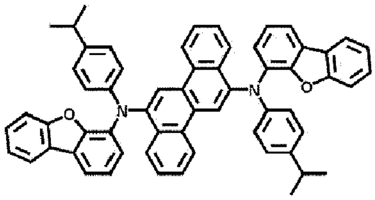
FD13

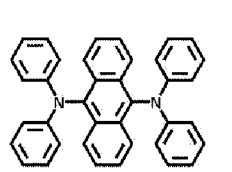
FD14

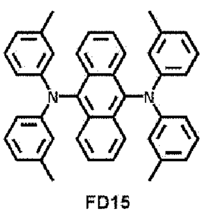
FD15

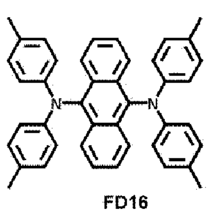
FD16

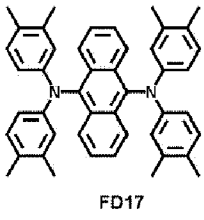
FD17

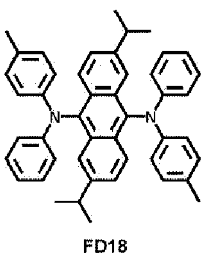
FD18

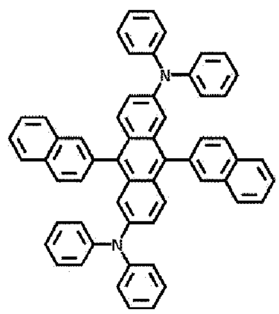

FD19

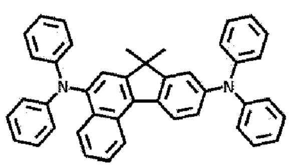

FD20

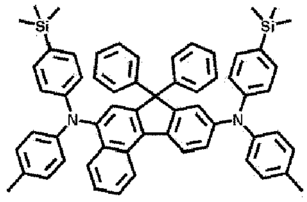

FD21

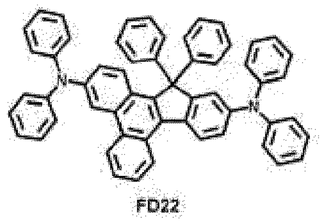

FD22

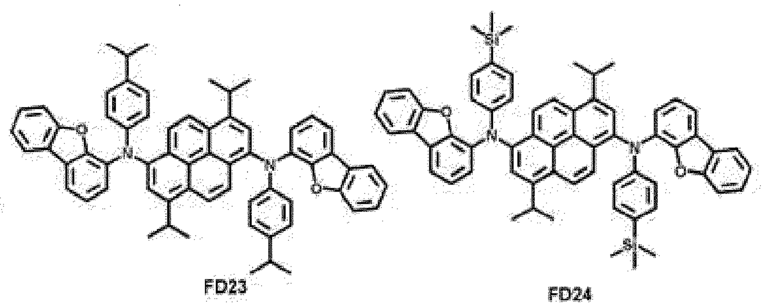

FD23

FD24

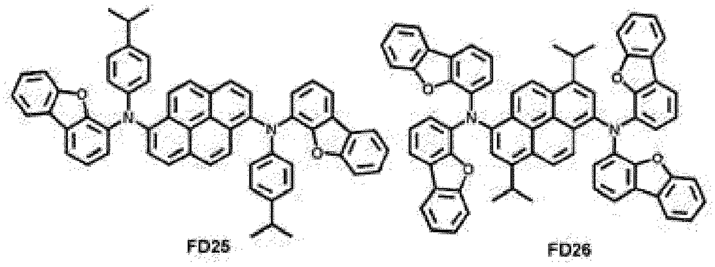

FD25

FD26

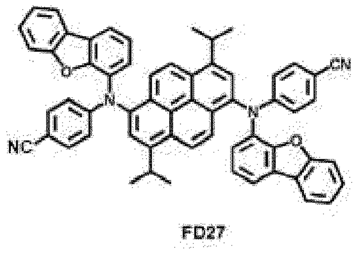

FD27

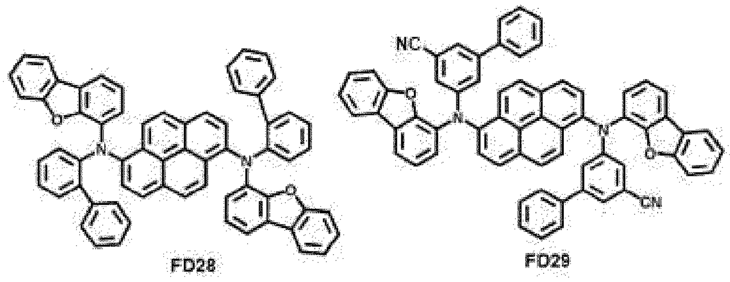

FD28

FD29

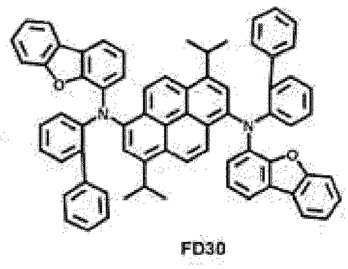

FD30

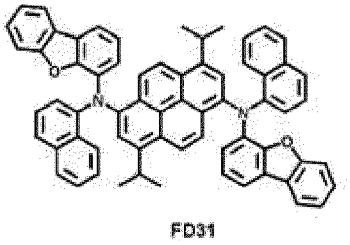

FD31

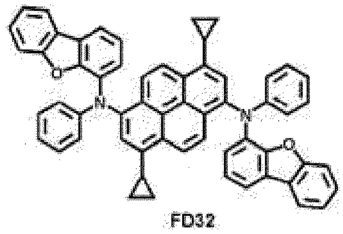

FD32

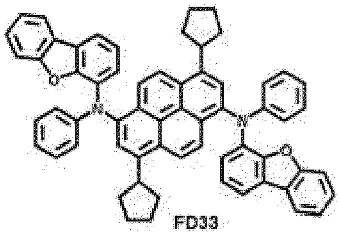

FD33

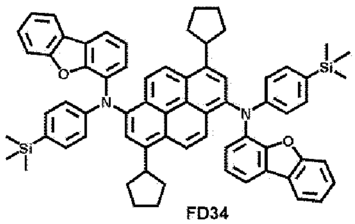

FD34

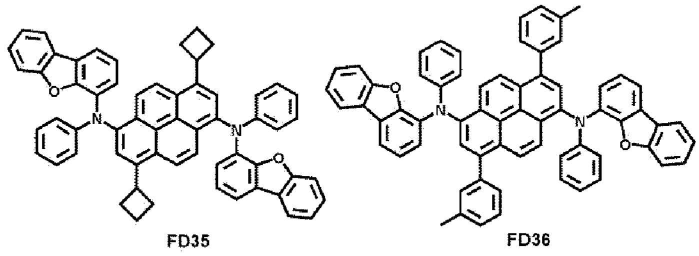

FD35 FD36

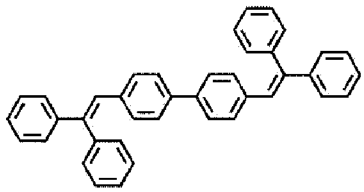

DPVBi

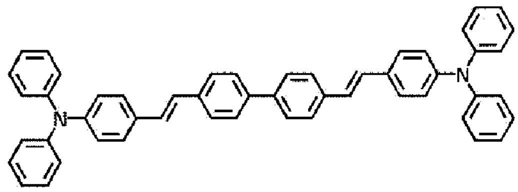

DPAVBi

## Delayed fluorescence material

In one or more embodiments, the emission layer may comprise a delayed fluorescence material.

In the present disclosure, the delayed fluorescence material may be selected from compounds capable of emitting delayed fluorescence based on a delayed fluorescence emission mechanism.

The delayed fluorescence material included in the emission layer may act as a host or a dopant depending on the type or kind of other materials included in the emission layer.

In one or more embodiments, the delayed fluorescence material may be the condensed cyclic compound satisfying Expression 1.

In one or more embodiments, a difference between a triplet energy level (eV) of the delayed fluorescence material and a singlet energy level (eV) of the delayed fluorescence material may be greater than or equal to 0 eV and less than or equal to 0.5 eV. When the difference between the triplet energy level (eV) of the delayed fluorescence material and the singlet energy level (eV) of the delayed fluorescence material is satisfied within the range above, up-conversion from the triplet state to the singlet state of the delayed fluorescence materials may effectively occur, and thus, the light-emitting device 10 may have improved luminescence efficiency.

For example, in one or more embodiments, the delayed fluorescence material may comprise: i) a material comprising at least one electron donor (for example, a $\pi$ electron-rich $C_3$-$C_{60}$ cyclic group and/or the like, such as a carbazole group) and at least one electron acceptor (for example, a sulfoxide group, a cyano group, a $\pi$ electron-deficient nitrogen-containing $C_1$-$C_{60}$ cyclic group, and/or the like), ii) a material comprising a $C_8$-$C_{60}$ polycyclic group comprising at least two cyclic groups condensed to each other while sharing boron (B), and/or iii) the like.

Non-limiting examples of the delayed fluorescence material may comprise at least one selected from Compounds DF1 to DF9:

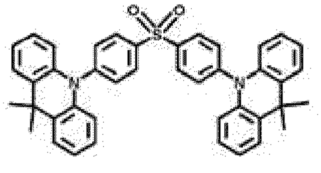

DF1(DMAC-DPS)

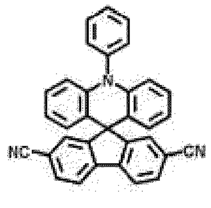

DF2(ACRFLCN)

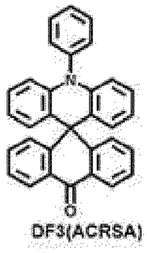

DF3(ACRSA)

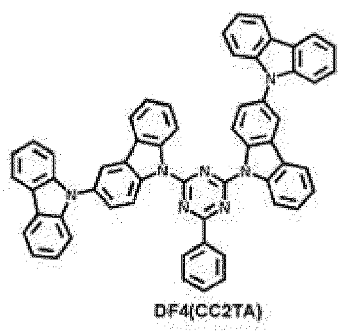

DF4(CC2TA)

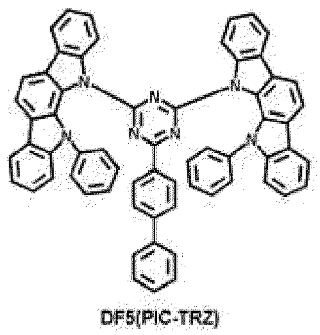

DF5(PIC-TRZ)

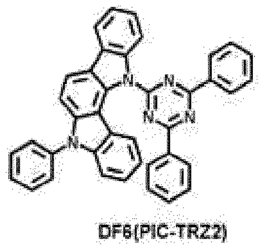

DF6(PIC-TRZ2)

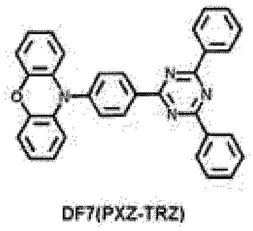

DF7(PXZ-TRZ)

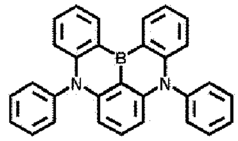

DF8(DABNA-1)

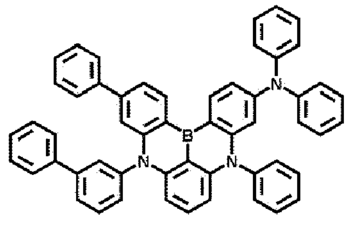

DF9(DABNA-2)

## Quantum dot

In one or more embodiments, the emission layer may comprise a quantum dot.

The term "quantum dot" as utilized herein refers to a crystal of a semiconductor compound, and may comprise any material capable of emitting light of one or more suitable emission wavelengths according to the size of the crystal.

A diameter of the quantum dot may be, for example, in a range of about 1 nm to about 10 nm.

The quantum dot may be synthesized by a wet chemical process, a metal organic chemical vapor deposition process, a molecular beam epitaxy process, or any process similar thereto.

The wet chemical process is a method comprising mixing a precursor material with an organic solvent and then growing quantum dot particle crystals. When the crystal grows, the organic solvent naturally acts as a dispersant coordinated on the surface of the quantum dot crystal and controls the growth of the crystal so that the growth of quantum dot particles can be controlled or selected through a process which costs lower, and is easier than vapor deposition methods, such as metal organic chemical vapor deposition (MOCVD) or molecular beam epitaxy (MBE).

The quantum dot may comprise: a Group II-VI semiconductor compound; a Group III-V semiconductor compound; a Group III-VI semiconductor compound; a Group I-III-VI semiconductor compound; a Group IV-VI semiconductor compound; a Group IV element or compound; or any combination thereof.

Non-limiting examples of the Group II-VI semiconductor compound may be: a binary compound, such as CdS, CdSe, CdTe, ZnS, ZnSe, ZnTe, ZnO, HgS, HgSe, HgTe, MgSe, MgS, and/or the like; a ternary compound, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and/or the like; a quaternary compound, such as CdZnSeS, CdZnSeTe, CdZnSTe, CdHgSeS, CdHgSeTe, CdHgSTe, HgZnSeS, HgZnSeTe, HgZnSTe, and/or the like; or any combination thereof.

Non-limiting examples of the Group III-V semiconductor compound may be: a binary compound, such as GaN, GaP, GaAs, GaSb, AlN, AlP, AlAs, AlSb, InN, InP, InAs, InSb, and/or the like; a ternary compound, such as GaNP, GaNAs, GaNSb, GaPAs, GaPSb, AlNP, AlNAs, AlNSb, AlPAs, AlPSb, InGaP, InNP, InAlP, InNAs, InNSb, InPAs, InPSb, and/or the like; a quaternary compound, such as GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and/or the like; or any combination thereof. In some embodiments, the Group III-V semiconductor compound may further comprise a Group II element. Non-limiting examples of the Group III-V semiconductor compound further comprising the Group II element may be InZnP, InGaZnP, InAlZnP, and/or the like.

Non-limiting examples of the Group III-VI semiconductor compound may be: a binary compound, such as GaS, GaSe, $Ga_2Se_3$, GaTe, InS, InSe, $In_2S_3$, $In_2Se_3$, InTe, and/or the like; a ternary compound, such as $InGaS_3$, $InGaSe_3$, and/or the like; or any combination thereof.

Non-limiting examples of the Group I-III-VI semiconductor compound may be: a ternary compound, such as

AgInS, $AgInS_2$, CuInS, $CuInS_2$, $CuGaO_2$, $AgGaO_2$, $AgAlO_2$, and/or the like; or any combination thereof.

Non-limiting examples of the Group IV-VI semiconductor compound may be: a binary compound, such as SnS, SnSe, SnTe, PbS, PbSe, PbTe, and/or the like; a ternary compound, such as SnSeS, SnSeTe, SnSTe, PbSeS, PbSeTe, PbSTe, SnPbS, SnPbSe, SnPbTe, and/or the like; a quaternary compound, such as SnPbSSe, SnPbSeTe, SnPbSTe, and/or the like; or any combination thereof.

Non-limiting examples of the Group IV element or compound may be: a single element compound, such as Si, Ge, and/or the like; a binary compound, such as SiC, SiGe, and/or the like; or any combination thereof.

Each element included in a multi-element compound, such as the binary compound, the ternary compound, and the quaternary compound, may be present at a substantially uniform concentration or non-substantially uniform concentration in a particle.

In one or more embodiments, the quantum dot may have a single structure in which the concentration of each element in the quantum dot is substantially uniform, or may have a core-shell dual structure. For example, a material included in the core and a material included in the shell may be different from each other.

The shell of the quantum dot may act as a protective layer that prevents chemical degeneration of the core to maintain semiconductor characteristics, and/or as a charging layer that imparts electrophoretic characteristics to the quantum dot. The shell may be a single layer or a multi-layer. The interface between the core and the shell may have a concentration gradient in which the concentration of an element existing in the shell decreases toward the center of the core.

Non-limiting examples of the shell of the quantum dot may be an oxide of metal, metalloid, or non-metal, a semiconductor compound, or a combination thereof. Non-limiting examples of the oxide of metal, metalloid, or non-metal suitable as a shell may be: a binary compound, such as $SiO_2$, $Al_2O_3$, $TiO_2$, ZnO, MnO, $Mn_2O_3$, $Mn_3O_4$, CuO, FeO, $Fe_2O_3$, $Fe_3O_4$, CoO, $Co_3O_4$, NiO, and/or the like; a ternary compound, such as $MgAl_2O_4$, $CoFe_2O_4$, $NiFe_2O_4$, $CoMn_2O_4$, and/or the like; or any combination thereof. Non-limiting examples of the semiconductor compound suitable as a shell may be: as described herein, a Group II-VI semiconductor compound; a Group III-V semiconductor compound; a Group III-VI semiconductor compound; a Group I-III-VI semiconductor compound; a Group IV-VI semiconductor compound; or any combination thereof. Non-limiting examples of the semiconductor compound suitable as a shell may be CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, or any combination thereof.

The quantum dot may have a full width at half maximum (FWHM) of the emission wavelength spectrum of less than or equal to about 45 nm, less than or equal to about 40 nm, or for example, less than or equal to about 30 nm. When the FWHM of the quantum dot is within these ranges, the quantum dot may have improved color purity and/or improved color reproducibility. In some embodiments, because light emitted through the quantum dot is emitted in all directions, the wide viewing angle may be improved.

In some embodiments, the quantum dot may be in the form/shape of substantially spherical, pyramidal, multi-arm, or cubic nanoparticles, nanotubes, nanowires, nanofibers, or nanoplate particles.

Because the energy band gap may be adjusted by controlling the size of the quantum dot, light having one or more suitable wavelength bands may be obtained from the quantum dot emission layer. Accordingly, by utilizing quantum dots of different sizes, a light-emitting device that emits light of one or more suitable wavelengths may be implemented. In one or more embodiments, the size of the quantum dots may be selected to emit red light, green light, and/or blue light. In some embodiments, the size of the quantum dots may be configured to emit white light by combination of light of one or more suitable colors.

### Electron transport region in interlayer 130

The electron transport region may have: i) a single-layer structure comprising (e.g., consisting of) a single layer comprising (e.g., consisting of) a single material, ii) a single-layer structure comprising (e.g., consisting of) a single layer comprising (e.g., consisting of) multiple different materials, or iii) a multi-layer structure comprising multiple layers comprising different materials.

The electron transport region may comprise a buffer layer, a hole blocking layer, an electron control layer, an electron transport layer, an electron injection layer, or any combination thereof.

For example, in some embodiments, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, wherein constituent layers of each structure are sequentially stacked from the emission layer in the stated order.

In one or more embodiments, the electron transport region (for example, the buffer layer, the hole blocking layer, the electron control layer, or the electron transport layer in the electron transport region) may comprise a metal-free compound comprising at least one $\pi$ electron-deficient nitrogen-containing $C_1$-$C_{60}$ cyclic group.

For example, in some embodiments, the electron transport region may comprise a compound represented by Formula 601:

**Formula 601** $[Ar_{601}]_{xe11}-[(1-_{601})_{xe1}-R_{601}]_{xe21}$,

wherein, in Formula 601,

$Ar_{601}$ and $L_{601}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
xe11 may be 1, 2, or 3,
xe1 may be 0, 1, 2, 3, 4, or 5,
$R_{601}$ may be a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, - $Si(Q_{601})(Q_{602})(Q_{603})$, $-C(=O)(Q_{601})$, $-S(=O)_2(Q_{601})$, or $-P(=O)(Q_{601})(Q_{602})$,
$Q_{601}$ to $Q_{603}$ may each independently be the same as defined herein with respect to Q1,
xe21 may be 1, 2, 3, 4, or 5, and
at least one selected from among $Ar_{601}$, $L_{601}$, and $R_{601}$ may each independently be a $\pi$ electron-deficient nitrogen-containing $C_1$-$C_{60}$ cyclic group unsubstituted or substituted with at least one $R_{10a}$.

In one or more embodiments, when xe11 in Formula 601 is 2 or more, two or more of $Ar_{601}$(s) may be linked to each other via a single bond.
In one or more embodiments, $Ar_{601}$ in Formula 601 may be a substituted or unsubstituted anthracene group.
In one or more embodiments, the electron transport region may comprise a compound represented by Formula 601-1:

**Formula 601-1**

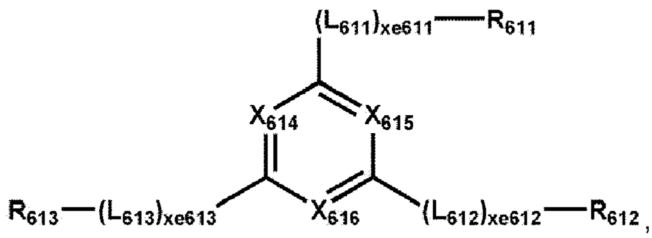

wherein, in Formula 601-1,

$X_{614}$ may be N or $C(R_{614})$, $X_{615}$ may be N or $C(R_{615})$, $X_{616}$ may be N or $C(R_{616})$, and at least one selected from among $X_{614}$ to $X_{616}$ may be N,
$L_{611}$ to $L_{613}$ may each independently be the same as defined herein with respect to $L_{601}$,
xe611 to xe613 may each independently be the same as defined herein with respect to xe1,
$R_{611}$ to $R_{613}$ may each independently be the same as defined herein with respect to $R_{601}$, and
$R_{614}$ to $R_{616}$ may each independently be hydrogen, deuterium, -F, -Cl, -Br, -I, a hydroxyl group, a cyano group, a nitro group, a $C_1$-$C_{20}$ alkyl group, a $C_1$-$C_{20}$ alkoxy group, a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$.

For example, xe1 and xe611 to xe613 in Formulae 601 and 601-1 may each independently be 0, 1, or 2.
In one or more embodiments, the electron transport region may comprise: at least one selected from among Compounds ET1 to ET45; 2,9-dimethyl-4,7-diphenyl-1,10-phenanthroline (BCP); 4,7-diphenyl-1,10-phenanthroline (Bphen); tris(8-hydroxyquinolinato)aluminum ($Alq_3$); bis(2-methyl-8-quinolinolato-N1,O8)-(1,1'-biphenyl-4-olato)aluminum (BAlq); 3-(4-biphenyl)-4-phenyl-5-tert-butylphenyl-1,2,4-triazole (TAZ); 4-(naphthalen-1-yl)-3,5-diphenyl-4H-1,2,4-triazole (NTAZ); or any combination thereof:

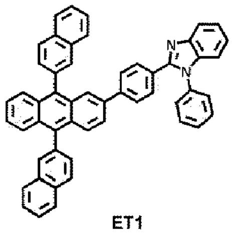
ET1
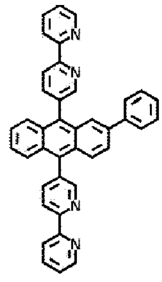
ET2
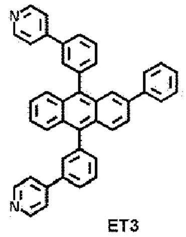
ET3
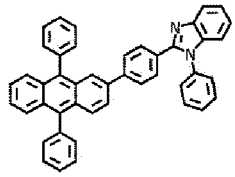
ET4

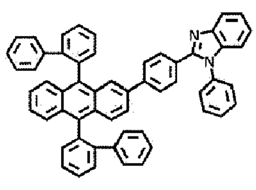
ET5
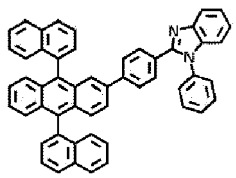
ET6
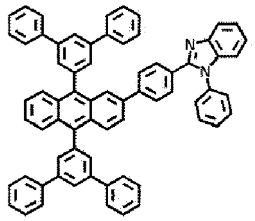
ET7
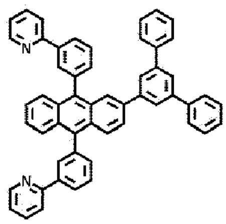
ET8

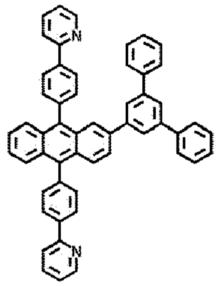
ET9
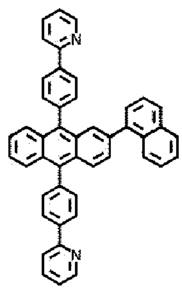
ET10
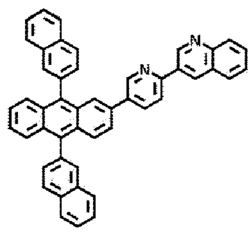
ET11
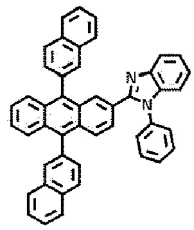
ET12

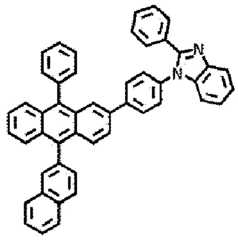
ET13
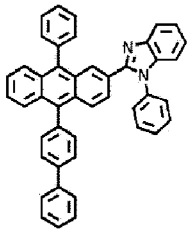
ET14
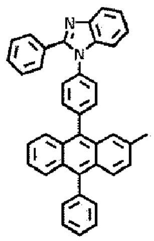
ET15
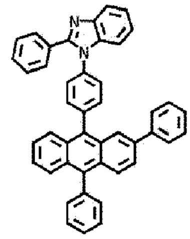
ET16

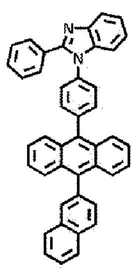
ET17
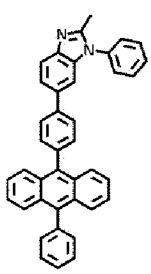
ET18
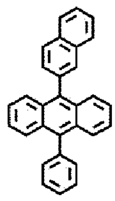
ET19
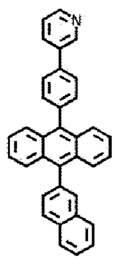
ET20
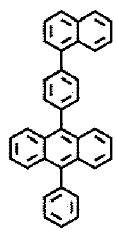
ET21
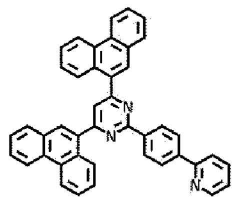
ET22

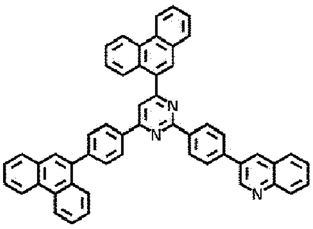

ET23

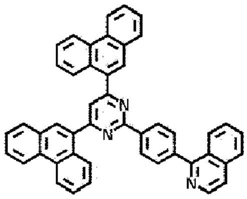

ET24

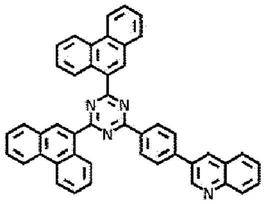

ET25

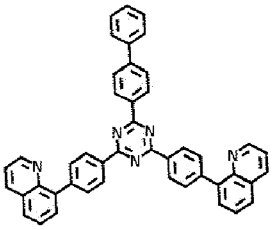

ET26

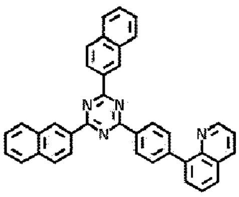

ET27

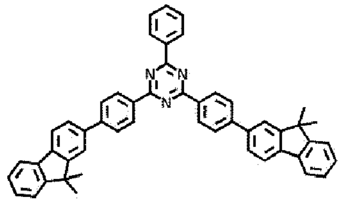

ET28

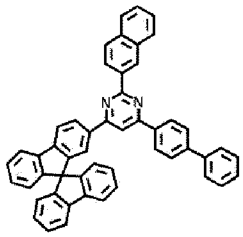

ET29

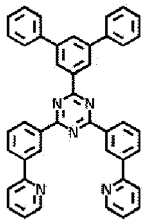

ET30

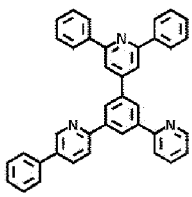

ET31

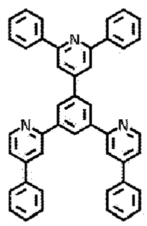

ET32

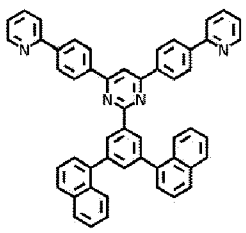

ET33

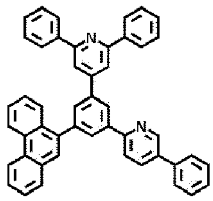

ET34

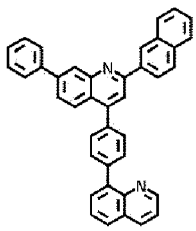

ET35

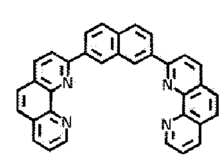

ET36

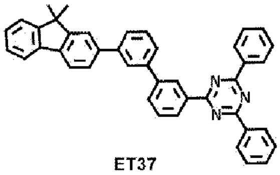

ET37

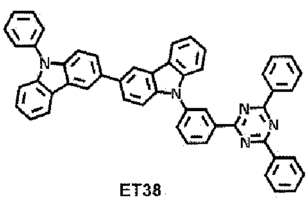

ET38

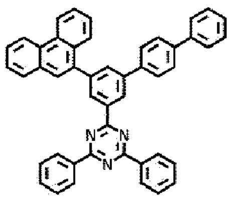

ET39

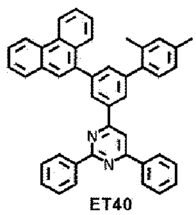

ET40

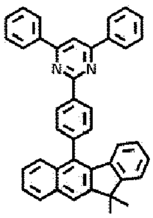

ET41

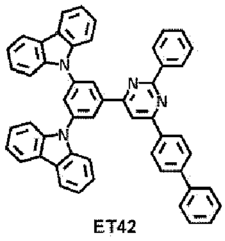

ET42

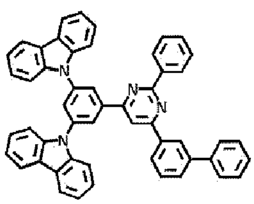

ET43

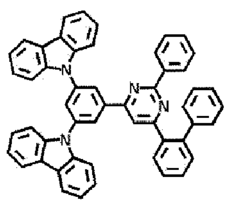

ET44

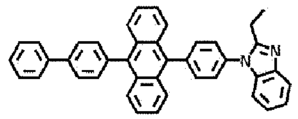

ET45

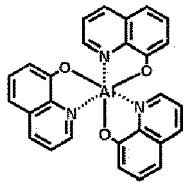

Alq3

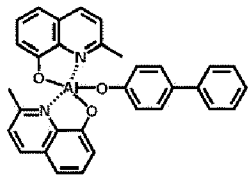

BAlq

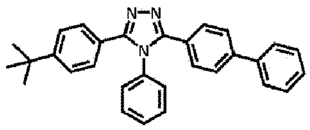

TAZ

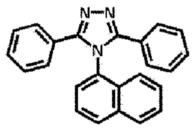

NTAZ .

A thickness of the electron transport region may be in a range of about 100 Å to about 5,000 Å, for example, about 160 Å to about 4,000 Å. When the electron transport region comprises a buffer layer, a hole blocking layer, an electron control layer, an electron transport layer, or any combination thereof, a thickness of the buffer layer, the hole blocking layer, or the electron control layer may be in a range of about 20 Å to about 1,000 Å, for example, about 30 Å to about 300 Å, and a thickness of the electron transport layer may be in a range of about 100 Å to about 1,000 Å, for example, about 150 Å to about 500 Å. When the thicknesses of the buffer layer, the hole blocking layer, the electron control layer, the electron transport layer, and/or the electron transport region are within these ranges, satisfactory electron transporting characteristics may be obtained without a substantial increase in driving voltage.

In one or more embodiments, the electron transport region (for example, the electron transport layer in the electron transport region) may further comprise, in addition to the materials described above, a metal-containing material.

The metal-containing material may comprise an alkali metal complex, an alkaline earth metal complex, or any combination thereof. A metal ion of the alkali metal complex may be a Li ion, a Na ion, a K ion, a Rb ion, or a Cs ion, and a metal ion of the alkaline earth metal complex may be a Be ion, a Mg ion, a Ca ion, a Sr ion, or a Ba ion. A ligand coordinated with the metal ion of the alkali metal complex or the alkaline earth-metal complex may comprise a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

For example, in some embodiments, the metal-containing material may comprise a Li complex. The Li complex may comprise, for example, Compound ET-D1 (LiQ) or ET-D2:

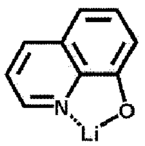

ET-D1

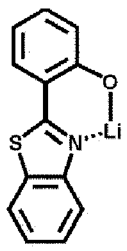

ET-D2 .

In one or more embodiments, the electron transport region may comprise an electron injection layer that facilitates the injection of electrons from the second electrode 150. The electron injection layer may directly contact the second electrode 150.

The electron injection layer may have: i) a single-layer structure comprising (e.g., consisting of) a single layer comprising (e.g., consisting of) a single material, ii) a single-layer structure comprising (e.g., consisting of) a single layer comprising (e.g., consisting of) multiple different materials, or iii) a multi-layer structure comprising multiple layers comprising different materials.

The electron injection layer may comprise an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof.

The alkali metal may comprise Li, Na, K, Rb, Cs, or any combination thereof. The alkaline earth metal may

comprise Mg, Ca, Sr, Ba, or any combination thereof. The rare earth metal may comprise Sc, Y, Ce, Tb, Yb, Gd, or any combination thereof.

The alkali metal-containing compound, the alkaline earth metal-containing compound, and the rare earth metal-containing compound may respectively be oxides, halides (for example, fluorides, chlorides, bromides, iodides, etc.), or tellurides of the alkali metal, the alkaline earth metal, and the rare earth metal, or any combination thereof.

The alkali metal-containing compound may comprise: an alkali metal oxide, such as $Li_2O$, $Cs_2O$, $K_2O$, and/or the like; alkali metal halides, such as LiF, NaF, CsF, KF, LiI, NaI, CsI, KI, and/or the like; or any combination thereof. The alkaline earth metal-containing compound may comprise an alkaline earth metal compound, such as BaO, SrO, CaO, $Ba_xSr_{1-x}O$ (wherein x is a real number satisfying $0<x<1$), $Ba_xCa_{1-x}O$ (wherein x is a real number satisfying $0<x<1$), and/or the like. The rare earth metal-containing compound may comprise $YbF_3$, $ScF_3$, $Sc_2O_3$, $Y_2O_3$, $Ce_2O_3$, $GdF_3$, $TbF_3$, $YbI_3$, $ScI_3$, $TbI_3$, or any combination thereof. In one or more embodiments, the rare earth metal-containing compound may comprise lanthanide metal telluride. Non-limiting examples of the lanthanide metal telluride may be LaTe, CeTe, PrTe, NdTe, PmTe, SmTe, EuTe, GdTe, TbTe, DyTe, HoTe, ErTe, TmTe, YbTe, LuTe, $La_2Te_3$, $Ce_2Te_3$, $Pr_2Te_3$, $Nd_2Te_3$, $Pm_2Te_3$, $Sm_2Te_3$, $Eu_2Te_3$, $Gd_2Te_3$, $Tb_2Te_3$, $Dy_2Te_3$, $Ho_2Te_3$, $Er_2Te_3$, $Tm_2Te_3$, $Yb_2Te_3$, $Lu_2Te_3$, and/or the like.

The alkali metal complex, the alkaline earth-metal complex, and the rare earth metal complex may comprise i) one of ions of the alkali metal, the alkaline earth metal, and the rare earth metal, respectively, and ii) a ligand bonded to the metal ion, for example, hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenyl benzimidazole, hydroxyphenylbenzothiazole, bipyridine, phenanthroline, cyclopentadiene, or any combination thereof.

In one or more embodiments, the electron injection layer may comprise (e.g., consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described above. In one or more embodiments, the electron injection layer may further comprise an organic material (for example, a compound represented by Formula 601).

In one or more embodiments, the electron injection layer may comprise (e.g., consist of) i) an alkali metal-containing compound (for example, alkali metal halide), or may comprise ii) a) an alkali metal-containing compound (for example, alkali metal halide); and b) an alkali metal, an alkaline earth metal, a rare earth metal, or any combination thereof. For example, in some embodiments, the electron injection layer may be a KI:Yb co-deposited layer, an RbI:Yb co-deposited layer, a LiF:Yb co-deposited layer, and/or the like.

When the electron injection layer further comprises an organic material, an alkali metal, an alkaline earth metal, a rare earth metal, an alkali metal-containing compound, an alkaline earth metal-containing compound, a rare earth metal-containing compound, an alkali metal complex, an alkaline earth-metal complex, a rare earth metal complex, or any combination thereof may be substantially uniformly or non-uniformly dispersed in a matrix comprising the organic material.

A thickness of the electron injection layer may be in a range of about 1 Å to about 100 Å, and, for example, about 3 Å to about 90 Å. When the thickness of the electron injection layer is within the ranges above, satisfactory electron injection characteristics may be obtained without a substantial increase in driving voltage.

## Second electrode 150

The second electrode 150 may be arranged on the interlayer 130 having a structure as described above. The second electrode 150 may be a cathode, which is an electron injection electrode, and as a material for forming the second electrode 150, a metal, an alloy, an electrically conductive compound, or any combination thereof, each having a low-work function, may be utilized.

The second electrode 150 may comprise lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The second electrode 150 may be a transmissive electrode, a semi-transmissive electrode, or a reflective electrode.

The second electrode 150 may have a single-layer structure or a multi-layer structure comprising multiple layers.

## Capping layer

A first capping layer may be arranged outside the first electrode 110, and/or a second capping layer may be arranged outside the second electrode 150. In one or more embodiments, the light-emitting device 10 may have a structure in which the first capping layer, the first electrode 110, the interlayer 130, and the second electrode 150 are sequentially stacked in the stated order, a structure in which the first electrode 110, the interlayer 130, the second electrode 150, and the second capping layer are sequentially stacked in the stated order, or a structure in which the first

capping layer, the first electrode 110, the interlayer 130, the second electrode 150, and the second capping layer are sequentially stacked in the stated order.

In some embodiments, light generated in the emission layer of the interlayer 130 of the light-emitting device 10 may be extracted toward the outside through the first electrode 110 which is a semi-transmissive electrode or a transmissive electrode, and the first capping layer. In some embodiments, light generated in the emission layer of the interlayer 130 of the light-emitting device 10 may be extracted toward the outside through the second electrode 150 which is a semi-transmissive electrode or a transmissive electrode, and the second capping layer.

The first capping layer and the second capping layer may increase external emission efficiency according to the principle of constructive interference. Accordingly, the light extraction efficiency of the light-emitting device 10 is increased, so that the luminescence efficiency of the light-emitting device 10 may be improved.

Each of the first capping layer and the second capping layer may comprise a material having a refractive index of greater than or equal to 1.6 (e.g., at 589 nm).

The first capping layer and the second capping layer may each independently be an organic capping layer comprising an organic material, an inorganic capping layer comprising an inorganic material, or an organic-inorganic composite capping layer comprising an organic material and an inorganic material.

At least one selected from among the first capping layer and the second capping layer may (e.g., the first capping layer and the second capping layer may each) independently comprise a carbocyclic compound, a heterocyclic compound, an amine group-containing compound, a porphine derivative, a phthalocyanine derivative, a naphthalocyanine derivative, an alkali metal complex, an alkaline earth metal complex, or any combination thereof. The carbocyclic compound, the heterocyclic compound, and the amine group-containing compound may optionally be substituted with a substituent comprising O, N, S, Se, Si, F, Cl, Br, I, or any combination thereof. In one or more embodiments, at least one selected from the first capping layer and the second capping layer may (e.g., the first capping layer and the second capping layer may each) independently comprise an amine group-containing compound.

In one or more embodiments, at least one selected from the first capping layer and the second capping layer may (e.g., the first capping layer and the second capping layer may each) independently comprise a compound represented by Formula 201, a compound represented by Formula 202, or any combination thereof.

In one or more embodiments, at least one selected from the first capping layer and the second capping layer may (e.g., the first capping layer and the second capping layer may each) independently comprise: at least one selected from among Compounds HT28 to HT33; at least one selected from among Compounds CP1 to CP6; β-NPB; or any combination thereof:

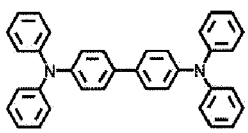
CP1

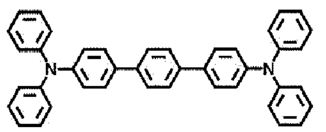
CP2

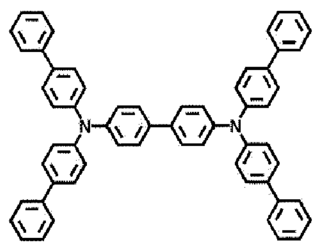
CP3

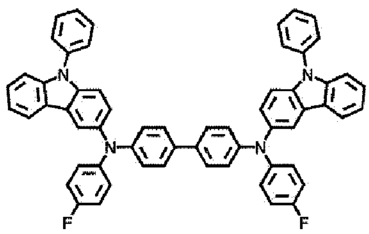
CP4

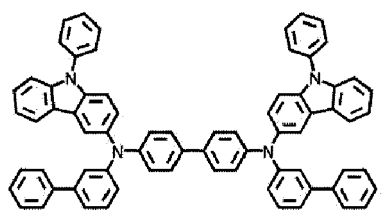
CP5

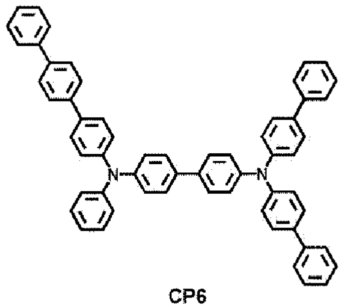

CP6

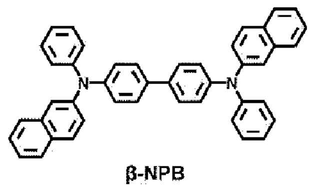

β-NPB .

**Film**

The condensed cyclic compound satisfying Expression 1 may be included in one or more suitable films. Accordingly, one or more aspects of embodiments of the present disclosure are directed toward a film comprising the condensed cyclic compound satisfying Expression 1. The film may be, for example, an optical member (or a light control element) (for example, a color filter, a color conversion member, a capping layer, a light extraction efficiency enhancement layer, a selective light absorbing layer, a polarizing layer, a quantum dotcontaining layer, etc.), a light blocking member (for example, a light reflective layer, a light absorbing layer, etc.), a protective member (for example, an insulating layer, a dielectric layer, etc.), and/or the like.

**Electronic apparatus**

The light-emitting device may be included in one or more suitable electronic apparatuses. For example, in some embodiments, the electronic apparatus comprising the light-emitting device may be a light-emitting apparatus, an authentication apparatus, and/or the like.

In one or more embodiments, the electronic apparatus (for example, a light-emitting apparatus) may further comprise, in addition to the light-emitting device, i) a color filter, ii) a color conversion layer, or iii) a color filter and a color conversion layer. The color filter and/or the color conversion layer may be arranged in at least one direction in which light emitted from the light-emitting device travels. For example, in some embodiments, the light emitted from the light-emitting device may be blue light or white light (e.g., combined white light). Details of the light-emitting device may be referred to the descriptions provided herein. In some embodiments, the color conversion layer may comprise a quantum dot. The quantum dot may be, for example, the quantum dot as described herein.

The electronic apparatus may comprise a first substrate. The first substrate may comprise a plurality of subpixel areas, the color filter may comprise a plurality of color filter areas respectively corresponding to the subpixel areas, and the color conversion layer may comprise a plurality of color conversion areas respectively corresponding to the subpixel areas.

A pixel-defining film may be arranged among the subpixel areas to define each of the subpixel areas.

The color filter may further comprise a plurality of color filter areas and light-shielding patterns arranged among the color filter areas, and the color conversion layer may further comprise a plurality of color conversion areas and light-shielding patterns arranged among the color conversion areas.

The plurality of color filter areas (or the plurality of color conversion areas) may comprise a first area to emit first color light, a second area to emit second color light, and/or a third area to emit third color light, wherein the first color light, the second color light, and/or the third color light may have different maximum emission wavelengths from one another. For example, in some embodiments, the first color light may be red light, the second color light may be green light, and the third color light may be blue light. For example, in one or more embodiments, the plurality of color filter areas (or the plurality of color conversion areas) may comprise quantum dots. In some embodiments, the first area may comprise a red quantum dot to emit red light, the second area may comprise a green quantum dot to emit green light, and the third area may not comprise (e.g., may exclude) a quantum dot. Details of the quantum dot may be referred to the descriptions provided herein. The first area, the second area, and/or the third area may each further comprise a scatter.

For example, in some embodiments, the light-emitting device may be to emit first light, the first area may be to absorb the first light to emit first-first color light, the second area may be to absorb the first light to emit second-first color light, and the third area may be to absorb the first light to emit third-first color light. In this regard, the first-first color light, the second-first color light, and the third-first color light may have different maximum emission wavelengths. In some embodiments, the first light may be blue light, the first-first color light may be red light, the second-first color light may be green light, and the third-first color light may be blue light.

In one or more embodiments, the electronic apparatus may further comprise a thin-film transistor, in addition

to the light-emitting device as described above. The thin-film transistor may comprise a source electrode, a drain electrode, and an activation layer, wherein one selected from the source electrode and the drain electrode may be electrically connected to the first electrode or the second electrode of the light-emitting device.

The thin-film transistor may further comprise a gate electrode, a gate insulating film, and/or the like.

The activation layer may comprise crystalline silicon, amorphous silicon, an organic semiconductor, an oxide semiconductor, and/or the like.

In one or more embodiments, the electronic apparatus may further comprise a sealing portion for sealing the light-emitting device. The sealing portion may be arranged between the color filter and/or the color conversion layer and the light-emitting device. The sealing portion allows light from the light-emitting device to be extracted to the outside, and concurrently (e.g., simultaneously) prevents ambient air and moisture from penetrating into the light-emitting device. The sealing portion may be a sealing substrate comprising a transparent glass substrate or a plastic substrate. The sealing portion may be a thin-film encapsulation layer comprising at least one layer of an organic layer and/or an inorganic layer. When the sealing portion is a thin-film encapsulation layer, the electronic apparatus may be flexible.

Various functional layers may be additionally arranged on the sealing portion, in addition to the color filter and/or the color conversion layer, according to the utilization of the electronic apparatus. The functional layers may comprise a touch screen layer, a polarizing layer, and/or the like. The touch screen layer may be a pressure-sensitive touch screen layer, a capacitive touch screen layer, or an infrared touch screen layer.

The authentication apparatus may further comprise, in addition to the light-emitting device as described above, a biometric information collector. The authentication apparatus may be, for example, a biometric authentication apparatus that authenticates an individual by utilizing biometric information of a living body (for example, fingertips, pupils, etc.).

The electronic apparatus may be applied to one or more of displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, or endoscope displays), fish finders, one or more suitable measuring instruments, meters (for example, meters for a vehicle, an aircraft, and a vessel), projectors, and/or the like.

**Description of FIGS. 2 and 3**

FIG. 2 is a cross-sectional view of a light-emitting apparatus according to one or more embodiments of the present disclosure.

The light-emitting apparatus of FIG. 2 may comprise a substrate 100, a thin-film transistor (TFT), a light-emitting device, and an encapsulation portion 300 that seals the light-emitting device.

The substrate 100 may be a flexible substrate, a glass substrate, or a metal substrate. A buffer layer 210 may be on the substrate 100. The buffer layer 210 may prevent or reduce penetration of impurities through the substrate 100 and may provide a flat surface on the substrate 100.

A TFT may be on the buffer layer 210. The TFT may comprise an activation layer 220, a gate electrode 240, a source electrode 260, and a drain electrode 270.

The activation layer 220 may comprise an inorganic semiconductor such as silicon or polysilicon, an organic semiconductor, or an oxide semiconductor, and may comprise a source region, a drain region, and a channel region.

A gate insulating film 230 for insulating the activation layer 220 from the gate electrode 240 may be on the activation layer 220, and the gate electrode 240 may be on the gate insulating film 230.

An interlayer insulating film 250 may be on the gate electrode 240. The interlayer insulating film 250 may be between the gate electrode 240 and the source electrode 260 and between the gate electrode 240 and the drain electrode 270, to insulate from one another.

The source electrode 260 and the drain electrode 270 may be on the interlayer insulating film 250. The interlayer insulating film 250 and the gate insulating film 230 may be formed to expose the source region and the drain region of the activation layer 220, and the source electrode 260 and the drain electrode 270 may be arranged in contact with the exposed portions of the source region and the drain region of the activation layer 220, respectively.

The TFT may be electrically connected to a light-emitting device to drive the light-emitting device, and may be covered and protected by a passivation layer 280. The passivation layer 280 may comprise an inorganic insulating film, an organic insulating film, or any combination thereof. A light-emitting device may be provided on the passivation layer 280. The light-emitting device may comprise a first electrode 110, an interlayer 130, and a second electrode 150.

The first electrode 110 may be on the passivation layer 280. The passivation layer 280 may be arranged to expose a portion of the drain electrode 270, not fully covering the drain electrode 270, and the first electrode 110 may be arranged to be connected to the exposed portion of the drain electrode 270.

A pixel defining layer 290 comprising an insulating material may be on the first electrode 110. The pixel defining layer 290 may expose a certain region of the first electrode 110, and the interlayer 130 may be formed in the exposed

region of the first electrode 110. The pixel defining layer 290 may be a polyimide-based organic film or a polyacrylic-based organic film. In some embodiments, at least some layers of the interlayer 130 may extend beyond the upper portion of the pixel defining layer 290 to be arranged in the form of a common layer.

The second electrode 150 may be on the interlayer 130, and a capping layer 170 may be additionally formed on the second electrode 150. The capping layer 170 may be formed to cover the second electrode 150.

The encapsulation portion 300 may be on the capping layer 170. The encapsulation portion 300 may be arranged on a light-emitting device to protect the light-emitting device from moisture and/or oxygen. The encapsulation portion 300 may comprise: an inorganic film comprising silicon nitride (SiNx), silicon oxide (SiOx), indium tin oxide, indium zinc oxide, or any combination thereof; an organic film comprising polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate, polyacrylic acid, etc.), an epoxy-based resin (for example, aliphatic glycidyl ether (AGE), etc.), or any combination thereof; or a combination of the inorganic film and the organic film.

FIG. 3 is a cross-sectional view of a light-emitting apparatus according to one or more embodiments of the present disclosure.

The light-emitting apparatus of FIG. 3 is substantially the same as the light-emitting apparatus of FIG. 2, except that a light-shielding pattern 500 and a functional region 400 are additionally arranged on the encapsulation portion 300. The functional region 400 may be i) a color filter area, ii) a color conversion area, or iii) a combination of the color filter area and the color conversion area. In one or more embodiments, the light-emitting device included in the light-emitting apparatus of FIG. 3 may be a tandem light-emitting device.

**Description of FIG. 4**

FIG. 4 is a schematic perspective view of electronic equipment 1 comprising a light-emitting device according to one or more embodiments of the present disclosure. The electronic equipment 1 may be, or comprise, an apparatus that displays a moving image or still image, portable electronic equipment, such as a mobile phone, a smart phone, a tablet personal computer (PC), a mobile communication terminal, an electronic notebook, an electronic book, a portable multimedia player (PMP), a navigation, or a ultra mobile PC (UMPC), as well as one or more suitable products, such as a television, a laptop, a monitor, a billboard, or an Internet of things (IOT). The electronic equipment 1 may be such a product above or a part thereof. In some embodiments, the electronic equipment 1 may be a wearable device, such as a smart watch, a watch phone, a glasses-type or kind display, or a head mounted display (HMD), or a part of the wearable device. However, embodiments of the present disclosure are not limited thereto. For example, in some embodiments, the electron equipment 1 may comprise a dashboard of a vehicle, a center fascia of a vehicle, a center information display arranged on a dashboard of a vehicle, a room mirror display replacing a side mirror of a vehicle, an entertainment display for the rear seat of a vehicle or a display arranged on the back of the front seat, or a head up display (HUD) installed in the front of a vehicle or projected on a front window glass, and/or a computer generated hologram augmented reality head up display (CGH AR HUD). FIG. 4 illustrates an embodiment in which the electronic equipment 1 is a smart phone for convenience of explanation.

The electronic equipment 1 may comprise a display area DA and a non-display area NDA outside the display area DA. A display apparatus of the electronic equipment 1 may implement an image through an array of a plurality of pixels that are two-dimensionally arranged in the display area DA.

The non-display area NDA is an area that does not display an image, and may entirely surround the display area DA. At the non-display area NDA, a driver for providing electrical signals or power to display devices arranged in the display area DA may be arranged. At the non-display area NDA, a pad, which is an area to which an electronic element or a printing circuit board may be electrically connected, may be arranged.

In the electronic equipment 1, a length in the x-axis direction and a length in the y-axis direction may be different from each other. In one embodiment, as shown in FIG. 4, the length in the x-axis direction may be shorter than the length in the y-axis direction. In one or more embodiments, the length in the x-axis direction may be the same as the length in the y-axis direction. In one or more embodiments, the length in the x-axis direction may be longer than the length in the y-axis direction.

**Description of FIGs.5 and 6A to 6C**

FIG. 5 is a schematic view of an exterior of a vehicle 1000 as electronic equipment comprising a light-emitting device according to one or more embodiments of the present disclosure. FIGs. 6A to 6C are each a schematic view of an interior of the vehicle 1000 according to one or more embodiments of the present disclosure.

Referring to FIGs. 5, 6A, 6B, and 6C, the vehicle 1000 may refer to one or more suitable apparatuses for moving an object to be transported, such as a human, an object, or an animal, from a departure point to a destination point. The vehicle 1000 may comprise a vehicle traveling on a road or a track, a vessel moving over the sea or a river, an airplane

flying in the sky utilizing the action of air, and/or the like.

In one or more embodiments, the vehicle 1000 may travel on a road or a track. The vehicle 1000 may move in a certain direction according to rotation of at least one wheel thereof. For example, the vehicle 1000 may comprise a three-wheeled or four-wheeled vehicle, a construction machine, a two-wheeled vehicle, a prime mover apparatus, a bicycle, or a train running on a track.

The vehicle 1000 may comprise a body having an interior and an exterior, and a chassis in which mechanical apparatuses necessary for driving are installed as other parts except for the body. The exterior of the body may comprise a front panel, a bonnet, a roof panel, a rear panel, a trunk, a pillar provided at a boundary between doors, and/or the like. The chassis of the vehicle 1000 may comprise a power generating apparatus, a power transmitting apparatus, a driving apparatus, a steering apparatus, a braking apparatus, a suspension apparatus, a transmission apparatus, a fuel apparatus, front and rear wheels, left and right wheels, and/or the like.

The vehicle 1000 may comprise a side window glass 1100, a front window glass 1200, a side mirror 1300, a cluster 1400, a center fascia 1500, a passenger seat dashboard 1600, and a display apparatus 2.

The side window glass 1100 and the front window glass 1200 may be partitioned by a pillar arranged between the side window glass 1100 and the front window glass 1200.

The side window glass 1100 may be installed on the side of the vehicle 1000. In some embodiments, the side window glass 1100 may be installed on a door of the vehicle 1000. A plurality of side window glasses 1100 may be provided and may face each other. In some embodiments, the side window glass 1100 may comprise a first side window glass 1110 and a second side window glass 1120. In some embodiments, the first side window glass 1110 may be arranged adjacent to the cluster 1400. The second side window glass 1120 may be arranged adjacent to the passenger seat dashboard 1600.

In some embodiments, the side window glasses 1100 may be spaced apart from each other in the x-direction or the -x-direction. For example, the first side window glass 1110 and the second side window glass 1120 may be spaced apart from each other in the x direction or the -x direction. In other words, an imaginary straight line L connecting the side window glasses 1100 may extend in the x-direction or the -x-direction. For example, the imaginary straight line L connecting the first side window glass 1110 and the second side window glass 1120 to each other may extend in the x direction or the -x direction.

The front window glass 1200 may be installed in the front of the vehicle 1000. The front window glass 1200 may be arranged between the side window glasses 1100 facing each other.

The side mirror 1300 may provide a rear view of the vehicle 1000. The side mirror 1300 may be installed on the exterior of the body. In some embodiments, a plurality of side mirrors 1300 may be provided. Any one of the plurality of side mirrors 1300 may be arranged outside the first side window glass 1110. The other one of the plurality of side mirrors 1300 may be arranged outside the second side window glass 1120.

The cluster 1400 may be arranged in front of the steering wheel. The cluster 1400 may comprise a tachometer, a speedometer, a coolant thermometer, a fuel gauge turn indicator, a high beam indicator, a warning light, a seat belt warning light, an odometer, a hodometer, an automatic shift selector indicator, a door open warning light, an engine oil warning light, and/or a low fuel warning light.

The center fascia 1500 may comprise a control panel on which a plurality of buttons for adjusting an audio apparatus, an air conditioning apparatus, and/or a heater of a seat are arranged. The center fascia 1500 may be arranged on one side of the cluster 1400.

The passenger seat dashboard 1600 may be spaced apart from the cluster 1400 with the center fascia 1500 arranged therebetween. In some embodiments, the cluster 1400 may be arranged to correspond to a driver seat, and the passenger seat dashboard 1600 may be arranged to correspond to a passenger seat. In some embodiments, the cluster 1400 may be adjacent to the first side window glass 1110, and the passenger seat dashboard 1600 may be adjacent to the second side window glass 1120.

In one or more embodiments, the display apparatus 2 may comprise a display panel 3, and the display panel 3 may display an image. The display apparatus 2 may be arranged inside the vehicle 1000. In some embodiments, the display apparatus 2 may be arranged between the side window glasses 1100 facing each other. The display apparatus 2 may be arranged on at least one selected from among the cluster 1400, the center fascia 1500, and the passenger seat dashboard 1600.

The display apparatus 2 may comprise an organic light-emitting display apparatus, an inorganic light-emitting display apparatus, a quantum dot display apparatus, and/or the like. Hereinafter, as the display apparatus 2 according to one or more embodiments of the present disclosure, an organic light-emitting display apparatus comprising the light-emitting device according to the present disclosure will be described as an example, but one or more suitable types (kinds) of display apparatuses as described above may be utilized in embodiments of the present disclosure.

Referring to FIG. 6A, the display apparatus 2 may be arranged on the center fascia 1500. In one embodiment, the display apparatus 2 may display navigation information. In one embodiment, the display apparatus 2 may display audio, video, and/or information regarding vehicle settings.

Referring to FIG. 6B, the display apparatus 2 may be arranged on the cluster 1400. When the display apparatus 2 is arranged on the cluster 1400, the cluster 1400 may display driving information and/or the like through the display apparatus 2. For example, in some embodiments, the cluster 1400 may be implemented digitally. The digital cluster 1400 may display vehicle information and driving information as images. For example, a needle and a gauge of a tachometer and one or more suitable warning light icons may be displayed by a digital signal.
Referring to FIG. 6C, the display apparatus 2 may be arranged on the passenger seat dashboard 1600. The display apparatus 2 may be embedded in the passenger seat dashboard 1600 or arranged on the passenger seat dashboard 1600. In some embodiments, the display apparatus 2 arranged on the passenger seat dashboard 1600 may display an image related to information displayed on the cluster 1400 and/or information displayed on the center fascia 1500. In one or more embodiments, the display apparatus 2 arranged on the passenger seat dashboard 1600 may display information different from information displayed on the cluster 1400 and/or information displayed on the center fascia 1500.

**Manufacturing method**

Respective layers included in the hole transport region, the emission layer, and respective layers included in the electron transport region may be formed in a certain region by utilizing one or more suitable methods selected from vacuum deposition, spin coating, casting, Langmuir-Blodgett (LB) deposition, ink-jet printing, laser-printing, laser-induced thermal imaging, and/or the like.
When respective layers included in the hole transport region, the emission layer, and respective layers included in the electron transport region are each formed by vacuum deposition, the deposition may be performed at a deposition temperature of about 100 °C to about 500 °C, a vacuum degree of about $10^{-8}$ torr to about $10^{-3}$ torr, and a deposition speed of about 0.01 Å/sec to about 100 Å/sec, depending on a material to be included in a layer to be formed and the structure of a layer to be formed.

**Definition of terms**

The term "$C_3$-$C_{60}$ carbocyclic group" as utilized herein refers to a cyclic group comprising (e.g., consisting of) carbon only as a ring-forming atom and having 3 to 60 carbon atoms, and the term "$C_1$-$C_{60}$ heterocyclic group" as utilized herein refers to a cyclic group that has 1 to 60 carbon atoms and further has, in addition to carbon, a heteroatom as a ring-forming atom. The $C_3$-$C_{60}$ carbocyclic group and the $C_1$-$C_{60}$ heterocyclic group may each be a monocyclic group comprising (e.g., consisting of) one ring or a polycyclic group in which two or more rings are condensed with each other. For example, the number of ring-forming atoms of the $C_1$-$C_{60}$ heterocyclic group may be from 3 to 61.
The term "cyclic group" as utilized herein may include both (e.g., simultaneously) the $C_3$-$C_{60}$ carbocyclic group and the $C_1$-$C_{60}$ heterocyclic group.
The term "$\pi$ electron-rich $C_3$-$C_{60}$ cyclic group" as utilized herein refers to a cyclic group that has 3 to 60 carbon atoms and does not include *-N=*' as a ring-forming moiety, and the term "$\pi$ electron-deficient nitrogen-containing $C_1$-$C_{60}$ cyclic group" as utilized herein refers to a heterocyclic group that has 1 to 60 carbon atoms and comprises *-N=*' as a ring-forming moiety.
For example,

the $C_3$-$C_{60}$ carbocyclic group may be i) a T1 group or ii) a condensed cyclic group in which at least two T1 groups are condensed with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the $C_1$-$C_{60}$ heterocyclic group may be i) a T2 group, ii) a condensed cyclic group in which at least two T2 groups are condensed with each other, or iii) a condensed cyclic group in which at least one T2 group and at least one T1 group are condensed with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a

pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),

the $\pi$ electron-rich $C_3$-$C_{60}$ cyclic group may be i) a T1 group, ii) a condensed cyclic group in which at least two T1 groups are condensed with each other, iii) a T3 group, iv) a condensed cyclic group in which at least two T3 groups are condensed with each other, or v) a condensed cyclic group in which at least one T3 group and at least one T1 group are condensed with each other (for example, the $C_3$-$C_{60}$ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, etc.),

the $\pi$ electron-deficient nitrogen-containing $C_1$-$C_{60}$ cyclic group may be i) a T4 group, ii) a condensed cyclic group in which at least two T4 groups are condensed with each other, iii) a condensed cyclic group in which at least one T4 group and at least one T1 group are condensed with each other, iv) a condensed cyclic group in which at least one T4 group and at least one T3 group are condensed with each other, or v) a condensed cyclic group in which at least one T4 group, at least one T1 group, and at least one T3 group are condensed with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),

the T1 group may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or bicyclo[2.2.1]heptane) group, a norbornene group, a bicyclo[1.1.1]pentane group, a bicyclo[2.1.1]hexane group, a bicyclo[2.2.2]octane group, or a benzene group,

the T2 group may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,

the T3 group may be a furan group, a thiophene group, a 1H-pyrrole group, a silole group, or a borole group, and

the T4 group may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "the cyclic group, the $C_3$-$C_{60}$ carbocyclic group, the $C_1$-$C_{60}$ heterocyclic group, the $\pi$ electron-rich $C_3$-$C_{60}$ cyclic group, or the $\pi$ electron-deficient nitrogen-containing $C_1$-$C_{60}$ cyclic group" as utilized herein refer to a group condensed to any cyclic group, a monovalent group, or a polyvalent group (for example, a divalent group, a trivalent group, a tetravalent group, etc.) according to the structure of a formula for which the corresponding term is utilized. For example, "a benzene group" may be a benzo group, a phenyl group, a phenylene group, and/or the like, which may be

easily understand by one of ordinary skill in the art according to the structure of a formula comprising the "benzene group."

Depending on context, in the present disclosure, a divalent group may refer or be a polyvalent group (e.g., trivalent, tetravalent, etc., and not just divalent) per, e.g., the structure of a formula in connection with which of the terms are utilized.

Non-limiting examples of the monovalent $C_3$-$C_{60}$ carbocyclic group and monovalent $C_1$-$C_{60}$ heterocyclic group may be a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed polycyclic group, and a monovalent non-aromatic condensed heteropolycyclic group, and non-limiting examples of the divalent $C_3$-$C_{60}$ carbocyclic group and the divalent $C_1$-$C_{60}$ heterocyclic group may be a $C_3$-$C_{10}$ cycloalkylene group, a $C_1$-$C_{10}$ heterocycloalkylene group, a $C_3$-$C_{10}$ cycloalkenylene group, a $C_1$-$C_{10}$ heterocycloalkenylene group, a $C_6$-$C_{60}$ arylene group, a $C_1$-$C_{60}$ heteroarylene group, a divalent non-aromatic condensed polycyclic group, and a substituted or unsubstituted divalent non-aromatic condensed heteropolycyclic group.

The term "$C_1$-$C_{60}$ alkyl group" as utilized herein refers to a linear or branched aliphatic hydrocarbon monovalent group that has 1 to 60 carbon atoms, and non-limiting examples thereof may be a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, and/or the like. The term "$C_1$-$C_{60}$ alkylene group" as utilized herein refers to a divalent group having the same structure as the $C_1$-$C_{60}$ alkyl group.

The term "$C_2$-$C_{60}$ alkyl group" as utilized herein refers to a linear or branched aliphatic hydrocarbon monovalent group that has 2 to 60 carbon atoms (the term "$C_2$-$C_{20}$ alkyl group" as used utilized herein refers to a linear or branched aliphatic hydrocarbon monovalent group that has 2 to 20 carbon atoms), and non-limiting examples thereof may be an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, and/or the like. The term "$C_2$-$C_{60}$ alkylene group" as utilized herein refers to a divalent group having the same structure as the $C_2$-$C_{60}$ alkyl group.

The term "$C_2$-$C_{60}$ alkenyl group" as utilized herein refers to a monovalent hydrocarbon group having at least one carbon-carbon double bond in the middle or at the terminus of the $C_2$-$C_{60}$ alkyl group (the term "$C_2$-$C_{20}$ alkenyl group" as used utilized herein refers to a monovalent hydrocarbon group having at least one carbon-carbon double bond in the middle or at the terminus of the $C_2$-$C_{20}$ alkyl group), and non-limiting examples thereof may be an ethenyl group, a propenyl group, a butenyl group, and/or the like. The term "$C_2$-$C_{60}$ alkenylene group" as utilized herein refers to a divalent group having the same structure as the $C_2$-$C_{60}$ alkenyl group.

The term "$C_2$-$C_{60}$ alkynyl group" as utilized herein refers to a monovalent hydrocarbon group having at least one carbon-carbon triple bond in the middle or at the terminus of the $C_2$-$C_{60}$ alkyl group (the term "$C_2$-$C_{20}$ alkynyl group" as used utilized herein refers to a monovalent hydrocarbon group having at least one carbon-carbon triple bond in the middle or at the terminus of the $C_2$-$C_{20}$ alkyl group), and non-limiting examples thereof may be an ethynyl group, a propynyl group, and/or the like. The term "$C_2$-$C_{60}$ alkynylene group" as utilized herein refers to a divalent group having the same structure as the $C_2$-$C_{60}$ alkynyl group.

The term "$C_1$-$C_{60}$ alkoxy group" as utilized herein refers to a monovalent group represented by $-OA_{101}$ (wherein $A_{101}$ is the $C_1$-$C_{60}$ alkyl group), and non-limiting examples thereof may be a methoxy group, an ethoxy group, an isopropyloxy group, and/or the like.

The term "$C_3$-$C_{10}$ cycloalkyl group" as utilized herein refers to a monovalent saturated hydrocarbon cyclic group having 3 to 10 carbon atoms, and non-limiting examples thereof may be a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, a bicyclo[2.2.2]octyl group, and/or the like. The term "$C_3$-$C_{10}$ cycloalkylene group" as utilized herein refers to a divalent group having the same structure as the $C_3$-$C_{10}$ cycloalkyl group.

The term "$C_1$-$C_{10}$ heterocycloalkyl group" as utilized herein refers to a monovalent cyclic group of 1 to 10 carbon atoms, further comprising, in addition to carbon atoms, at least one heteroatom, as ring-forming atoms, and non-limiting examples thereof may be a 1,2,3,4-oxatriazolidinyl group, a tetrahydrofuranyl group, a tetrahydrothiophenyl group, and/or the like. The term "$C_1$-$C_{10}$ heterocycloalkylene group" as utilized herein refers to a divalent group having the same structure as the $C_1$-$C_{10}$ heterocycloalkyl group.

The term "$C_3$-$C_{10}$ cycloalkenyl group" as utilized herein refers to a monovalent cyclic group that has 3 to 10

carbon atoms and at least one carbon-carbon double bond in the ring thereof and no aromaticity, and non-limiting examples thereof may be a cyclopentenyl group, a cyclohexenyl group, a cycloheptenyl group, and/or the like. The term "$C_3$-$C_{10}$ cycloalkenylene group" as utilized herein refers to a divalent group having the same structure as the $C_3$-$C_{10}$ cycloalkenyl group.

The term "$C_1$-$C_{10}$ heterocycloalkenyl group" as utilized herein refers to a monovalent cyclic group of 1 to 10 carbon atoms, further comprising, in addition to carbon atoms, at least one heteroatom, as ring-forming atoms, and having at least one carbon-carbon double bond in the cyclic structure thereof. Non-limiting examples of the $C_1$-$C_{10}$ heterocycloalkenyl group may be a 4,5-dihydro-1,2,3,4-oxatriazolyl group, a 2,3-dihydrofuranyl group, a 2,3-dihydrothiophenyl group, and/or the like. The term "$C_1$-$C_{10}$ heterocycloalkenylene group" as utilized herein refers to a divalent group having the same structure as the $C_1$-$C_{10}$ heterocycloalkenyl group.

The term "$C_6$-$C_{60}$ aryl group" as utilized herein refers to a monovalent group having a carbocyclic aromatic system of 6 to 60 carbon atoms, and the term "$C_6$-$C_{60}$ arylene group" as utilized herein refers to a divalent group having a carbocyclic aromatic system of 6 to 60 carbon atoms. Non-limiting examples of the $C_6$-$C_{60}$ aryl group may be a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, an ovalenyl group, and/or the like. When the $C_6$-$C_{60}$ aryl group and the $C_6$-$C_{60}$ arylene group each comprise two or more rings, the rings may be condensed with each other.

The term "$C_1$-$C_{60}$ heteroaryl group" as utilized herein refers to a monovalent group having a heterocyclic aromatic system of 1 to 60 carbon atoms, further comprising, in addition to carbon atoms, at least one heteroatom, as ring-forming atoms. The term "$C_1$-$C_{60}$ heteroarylene group" as utilized herein refers to a divalent group having a heterocyclic aromatic system of 1 to 60 carbon atoms, further comprising, in addition to carbon atoms, at least one heteroatom, as ring-forming atoms. Non-limiting examples of the $C_1$-$C_{60}$ heteroaryl group may be a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, a naphthyridinyl group, and/or the like. When the $C_1$-$C_{60}$ heteroaryl group and the $C_1$-$C_{60}$ heteroarylene group each comprise two or more rings, the rings may be condensed with each other.

The term "monovalent non-aromatic condensed polycyclic group" as utilized herein refers to a monovalent group (for example, having 8 to 60 carbon atoms) having two or more rings condensed to each other, only carbon atoms as ring-forming atoms, and no aromaticity in its entire molecular structure as a whole. Non-limiting examples of the monovalent non-aromatic condensed polycyclic group may be an indenyl group, a fluorenyl group, a spirobifluorenyl group, a benzofluorenyl group, an indenophenanthrenyl group, an indeno anthracenyl group, and/or the like. The term "divalent non-aromatic condensed polycyclic group" as utilized herein refers to a divalent group having the same structure as the monovalent non-aromatic condensed polycyclic group.

The term "monovalent non-aromatic condensed heteropolycyclic group" as utilized herein refers to a monovalent group (for example, having 1 to 60 carbon atoms) having two or more rings condensed to each other, further comprising, in addition to carbon atoms, at least one heteroatom, as ring-forming atoms, and having non-aromaticity in its entire molecular structure as a whole. Non-limiting examples of the monovalent non-aromatic condensed heteropolycyclic group may be a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indeno carbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, a benzothienodibenzothiophenyl group, and/or the like. The term "divalent non-aromatic condensed heteropolycyclic group" as utilized herein refers to a divalent group having the same structure as the monovalent non-aromatic condensed heteropolycyclic group.

The term "$C_6$-$C_{60}$ aryloxy group" as utilized herein refers to $-OA_{102}$ (wherein $A_{102}$ is the $C_6$-$C_{60}$ aryl group), and the term "$C_6$-$C_{60}$ arylthio group" as utilized herein refers to $-SA_{103}$ (wherein $A_{103}$ is the $C_6$-$C_{60}$ aryl group).

The term "$C_7$-$C_{60}$ arylalkyl group" as utilized herein refers to $-A_{104}A_{105}$ (wherein $A_{104}$ is a $C_1$-$C_{54}$ alkylene group, and $A_{105}$ is a $C_6$-$C_{59}$ aryl group), and the term "$C_2$-$C_{60}$ heteroarylalkyl group" as utilized herein refers to $-A_{106}A_{107}$

(wherein $A_{106}$ is a $C_1$-$C_{59}$ alkylene group, and $A_{107}$ is a $C_1$-$C_{59}$ heteroaryl group).

The term "$R_{10a}$" as utilized herein may be:

deuterium, -F, -Cl, -Br, -I, a hydroxyl group, a cyano group, or a nitro group;

a $C_1$-$C_{60}$ alkyl group, a $C_2$-$C_{60}$ alkenyl group, a $C_2$-$C_{60}$ alkynyl group, or a $C_1$-$C_{60}$ alkoxy group, each unsubstituted or substituted with deuterium, -F, -Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ arylalkyl group, a $C_2$-$C_{60}$ heteroarylalkyl group, -Si($Q_{11}$)($Q_{12}$)($Q_{13}$), -N($Q_{11}$)($Q_{12}$), -B($Q_{11}$)($Q_{12}$), -C(=O)($Q_{11}$), -S(=O)$_2$($Q_{11}$), -P(=O)($Q_{11}$)($Q_{12}$), or any combination thereof;

a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ arylalkyl group, or a $C_2$-$C_{60}$ heteroarylalkyl group, each unsubstituted or substituted with deuterium, -F, -Cl, -Br, -I, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ arylalkyl group, a $C_2$-$C_{60}$ heteroarylalkyl group, - Si($Q_{21}$)($Q_{22}$)($Q_{23}$), -N($Q_{21}$)($Q_{22}$), -B($Q_{21}$)($Q_{22}$), -C(=O)($Q_{21}$), -S(=O)$_2$($Q_{21}$), -P(=O)($Q_{21}$)($Q_{22}$), or any combination thereof; or

-Si($Q_{31}$)($Q_{32}$)($Q_{33}$), -N($Q_{31}$)($Q_{32}$), -B($Q_{31}$)($Q_{32}$), -C(=O)($Q_{31}$), -S(=O)$_2$($Q_{31}$), or - P(=O)($Q_{31}$)($Q_{32}$).

$Q_1$ to $Q_3$, $Q_{11}$ to $Q_{13}$, $Q_{21}$ to $Q_{23}$, and $Q_{31}$ to $Q_{33}$ utilized herein may each independently be: hydrogen; deuterium; -F; -Cl; -Br; -I; a hydroxyl group; a cyano group; a nitro group; a $C_1$-$C_{60}$ alkyl group; a $C_2$-$C_{60}$ alkenyl group; a $C_2$-$C_{60}$ alkynyl group; a $C_1$-$C_{60}$ alkoxy group; a $C_3$-$C_{60}$ carbocyclic group or a $C_1$-$C_{60}$ heterocyclic group, each unsubstituted or substituted with deuterium, -F, a cyano group, a $C_1$-$C_{60}$ alkyl group, a $C_1$-$C_{60}$ alkoxy group, a phenyl group, a biphenyl group, or any combination thereof; a $C_7$-$C_{60}$ arylalkyl group; or a $C_2$-$C_{60}$ heteroarylalkyl group.

The term "heteroatom" as utilized herein refers to any atom other than a carbon atom. Non-limiting examples of the heteroatom may be O, S, N, P, Si, B, Ge, Se, and any combination thereof.

The term "third-row transition metal" as utilized herein comprises hafnium (Hf), tantalum (Ta), tungsten (W), rhenium (Re), osmium (Os), iridium (Ir), platinum (Pt), gold (Au), and/or the like.

The term "Ph" as utilized herein refers to a phenyl group, the term "Me" as utilized herein refers to a methyl group, the term "Et" as utilized herein refers to an ethyl group, the term "tert-Bu" or "$Bu^t$" as utilized herein refers to a tert-butyl group, and the term "OMe" as utilized herein refers to a methoxy group.

The term "biphenyl group" as utilized herein refers to "a phenyl group substituted with a phenyl group." In other words, the "biphenyl group" is a substituted phenyl group having a $C_6$-$C_{60}$ aryl group as a substituent.

The term "terphenyl group" as utilized herein refers to "a phenyl group substituted with a biphenyl group." In other words, the "terphenyl group" is a substituted phenyl group having, as a substituent, a $C_6$-$C_{60}$ aryl group substituted with a $C_6$-$C_{60}$ aryl group.

In the present disclosure, the x-axis, y-axis, and z-axis are not limited to three axes in an orthogonal coordinate system, and may be interpreted in a broad sense comprising these axes. For example, the x-axis, y-axis, and z-axis may refer to those orthogonal to each other, or may refer to those in different directions that are not orthogonal to each other.

*, *', and *" as utilized herein, unless defined otherwise, each refer to a binding site to a neighboring atom in a corresponding formula or moiety.

Hereinafter, compounds according to one or more embodiments and light-emitting devices according to one or more embodiments will be described in more detail with reference to Synthesis Examples and Examples. The wording "B was utilized instead of A" utilized in describing Synthesis Examples refers to that an identical molar equivalent of B was utilized in place of A.

## Examples

### Synthesis Example 1. Synthesis of Compound 1

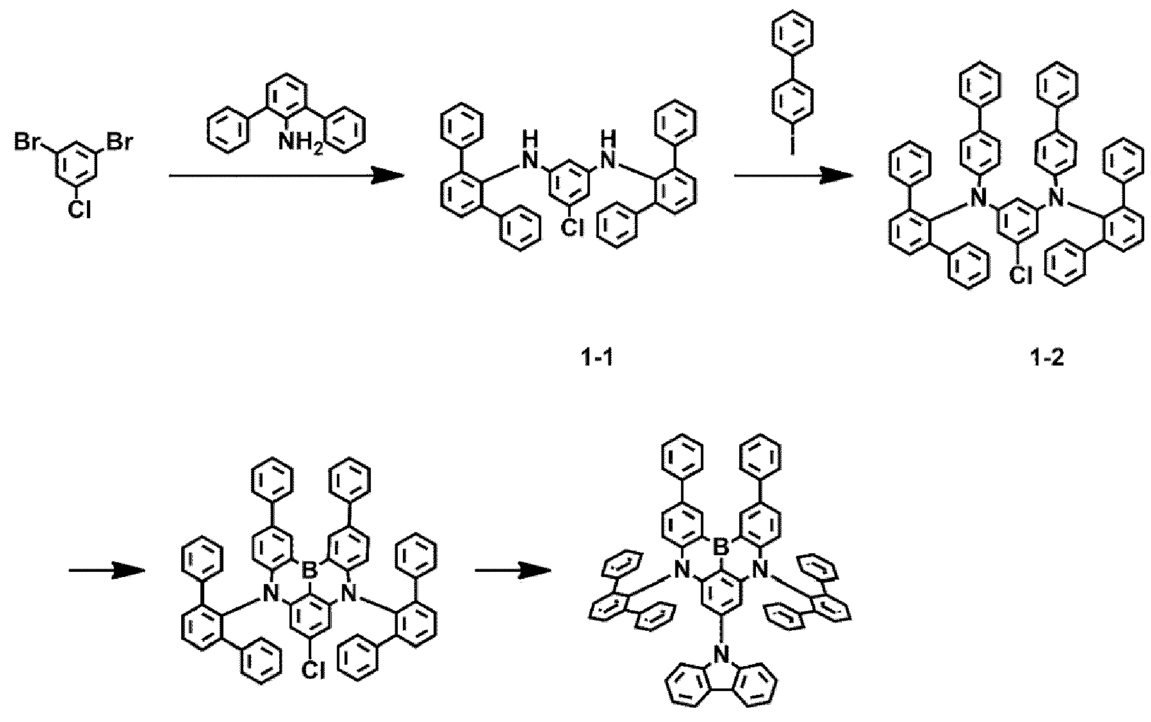

1-1 1-2

1-3 1

**Synthesis of Intermediate 1-1**

1,3-dibromo-5-chlorobenzene (1 eq), [1,1':3',1"-terphenyl]-2'-amine (2 eq), tris(dibenzylideneacetone)dipalladium(0) (0.05 eq), tri-tert-butylphosphine (0.1 eq), and sodium tert-butoxide (3 eq) were dissolved in toluene, and then stirred at 110 °C for 12 hours. After cooling, the mixture was washed three times with ethyl acetate and water, and an organic layer obtained by separation was dried utilizing $MgSO_4$ and then dried under reduced pressure. The resulting product was purified by column chromatography with methylene chloride (MC) and n-hexane as an eluent to obtain Intermediate 1-1. (Yield: 82 %)

**Synthesis of Intermediate 1-2**

Intermediate 1-1 (1 eq), 4-iodo-1,1'-biphenyl (2 eq), tris(dibenzylideneacetone)dipalladium(0) (0.25 eq), tri-tert-butylphosphine (0.5 eq), and sodium tert-butoxide (3 eq) were dissolved in o-xylene, and then stirred at 150 °C for 60 hours. After cooling, the mixture was washed three times with ethyl acetate and water, and an organic layer obtained by separation was dried utilizing $MgSO_4$ and then dried under reduced pressure. The resulting product was purified by column chromatography with MC and n-hexane as an eluent to obtain Intermediate 1-2. (Yield: 31 %)

**Synthesis of Intermediate 1-3**

After Intermediate 1-2 (1 eq) was dissolved in ortho-dichlorobenzene and then cooled down to 0 °C, $BBr_3$ (3 eq) was slowly injected thereinto under a nitrogen atmosphere. After completion of adding dropwise, the temperature was raised to 180 °C, followed by stirring for 24 hours. After cooling, triethylamine was slowly dropped into the flask containing the reactant to terminate the reaction, and then, ethyl alcohol was added to the reactant, followed by precipitation and filtration to thereby obtain a reaction product as a solid. The obtained solid was purified by column chromatography with MC and n-hexane as an eluent, and then, Intermediate 1-3 was obtained by recrystallization utilizing toluene and acetone. (Yield: 3 %)

**Synthesis of Compound 1**

Intermediate 1-3 (1 eq), carbazole (1.5 eq), tris(dibenzylideneacetone)dipalladium(0) (0.05 eq), tri-tert-butylphosphine (0.1 eq), and sodium tert-butoxide (3 eq) were dissolved in o-xylene, and then stirred at 150 °C for 36 hours. After cooling, the mixture was washed three times with ethyl acetate and water, and an organic layer obtained by

separation was dried utilizing $MgSO_4$ and then dried under reduced pressure. The resulting product was purified by column chromatography with MC and n-hexane as an eluent to obtain Compound 1. (Yield: 62 %)

**Synthesis Example 2. Synthesis of Compound 2**

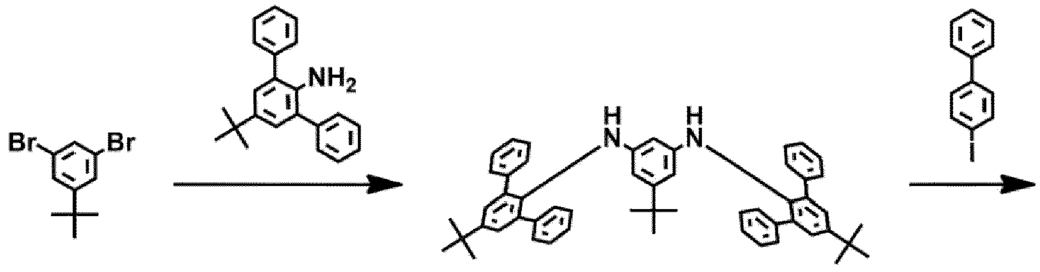

2-1

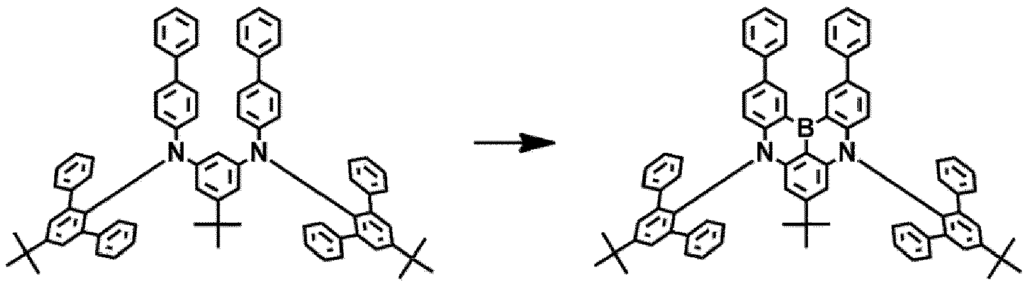

2-2 2

**Synthesis of Intermediate 2-1**

1,3-dibromo-5-(tert-butyl)benzene (1 eq), 5'-(tert-butyl)-[1,1':3',1"-terphenyl]-2'-amine (2 eq), tris(dibenzylideneacetone)dipalladium(0) (0.05 eq), tri-tert-butylphosphine (0.1 eq), and sodium tert-butoxide (3 eq) were dissolved in toluene, and then stirred at 110 °C for 12 hours. After cooling, the mixture was washed three times with ethyl acetate and water, and an organic layer obtained by separation was dried utilizing $MgSO_4$ and then dried under reduced pressure. The resulting product was purified by column chromatography with MC and n-hexane as an eluent to obtain Intermediate 2-1. (Yield: 71 %)

**Synthesis of Intermediate 2-2**

Intermediate 2-1 (1 eq), 4-iodo-1,1'-biphenyl (4 eq), tris(dibenzylideneacetone)dipalladium(0) (0.15 eq), tri-tert-butylphosphine (0.3 eq), and sodium tert-butoxide (4 eq) were dissolved in o-xylene, and then stirred at 150 °C for 48 hours. After cooling, the mixture was washed three times with ethyl acetate and water, and an organic layer obtained by separation was dried utilizing $MgSO_4$ and then dried under reduced pressure. The resulting product was purified by column chromatography with MC and n-hexane as an eluent to obtain Intermediate 2-2. (Yield: 33 %)

**Synthesis of Compound 2**

After Intermediate 2-2 (1 eq) was dissolved in ortho-dichlorobenzene and then cooled down to 0 °C, $BBr_3$ (5 eq) was slowly injected thereinto under a nitrogen atmosphere. After completion of adding dropwise, the temperature was raised to 180 °C, followed by stirring for 24 hours. After cooling, triethylamine was slowly dropped into the flask containing the reactant to terminate the reaction, and then, ethyl alcohol was added to the reactant, followed by precipitation and filtration to thereby obtain a reaction product as a solid. The obtained solid was purified by column chromatography with MC and n-hexane as an eluent, and then, Compound 2 was obtained by recrystallization utilizing toluene and acetone. (Yield: 4 %)

**Synthesis Example 3. Synthesis of Compound 3**

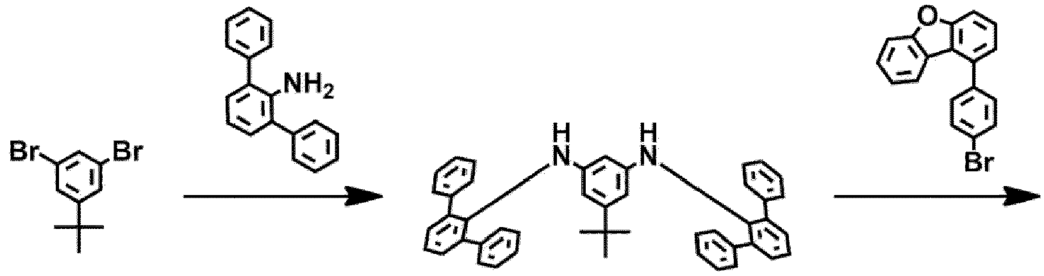

3-1

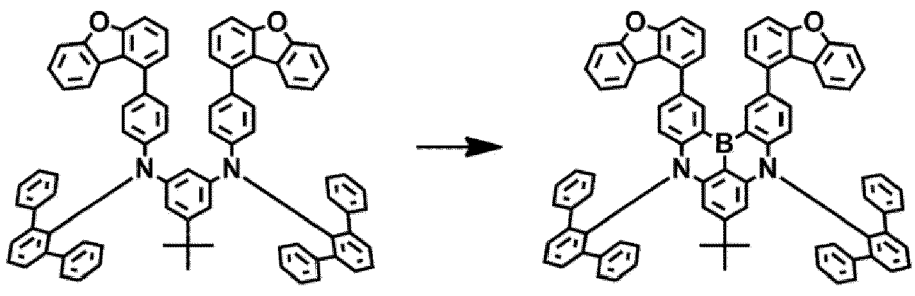

3-2 3

**Synthesis of Intermediate 3-1**

1,3-dibromo-5-(tert-butyl)benzene (1 eq), [1,1':3',1"-terphenyl]-2'-amine (2 eq), tris(dibenzylideneacetone)dipalladium(0) (0.05 eq), tri-tert-butylphosphine (0.1 eq), and sodium tert-butoxide (3 eq) were dissolved in toluene, and then stirred at 110 °C for 12 hours. After cooling, the mixture was washed three times with ethyl acetate and water, and an organic layer obtained by separation was dried utilizing $MgSO_4$ and then dried under reduced pressure. The resulting product was purified by column chromatography with MC and n-hexane as an eluent to obtain Intermediate 3-1. (Yield: 68 %)

**Synthesis of Intermediate 3-2**

Intermediate 3-1 (1 eq), 1-(4-bromophenyl)dibenzo[b,d]furan (4 eq), tris(dibenzylideneacetone)dipalladium(0) (0.15 eq), tri-tert-butylphosphine (0.3 eq), and sodium tert-butoxide (4 eq) were dissolved in o-xylene, and then stirred at 150 °C for 48 hours. After cooling, the mixture was washed three times with ethyl acetate and water, and an organic layer obtained by separation was dried utilizing $MgSO_4$ and then dried under reduced pressure. The resulting product was purified by column chromatography with MC and n-hexane as an eluent to obtain Intermediate 3-2. (Yield: 27 %)

**Synthesis of Compound 3**

After Intermediate 3-2 (1 eq) was dissolved in ortho-dichlorobenzene and then cooled down to 0 °C, $BBr_3$ (5

eq) was slowly injected thereinto under a nitrogen atmosphere. After completion of adding dropwise, the temperature was raised to 180 °C, followed by stirring for 24 hours. After cooling, triethylamine was slowly dropped into the flask containing the reactant to terminate the reaction, and then, ethyl alcohol was added to the reactant, followed by precipitation and filtration to thereby obtain a reaction product as a solid. The obtained solid was purified by column chromatography with MC and n-hexane as an eluent, and then, Compound 3 was obtained by recrystallization utilizing toluene and acetone. (Yield: 3 %)

**Synthesis Example 4. Synthesis of Compound 4**

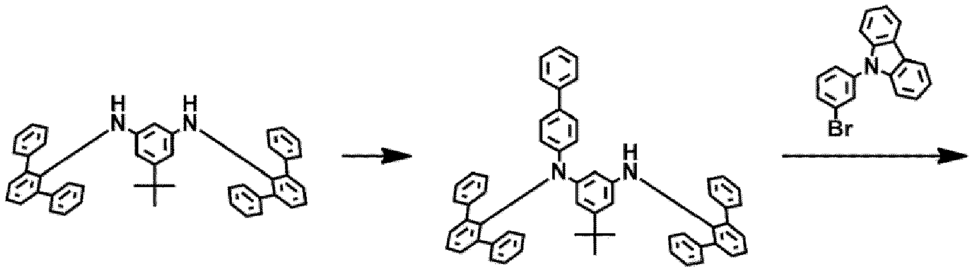

3-1 4-1

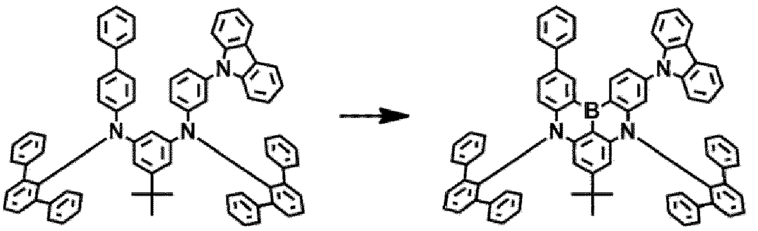

4-2 4

**Synthesis of Intermediate 4-1**

Intermediate 3-1 (1 eq), 4-iodo-1,1'-biphenyl (1 eq), tris(dibenzylideneacetone)dipalladium(0) (0.15 eq), tri-tert-butylphosphine (0.3 eq), and sodium tert-butoxide (4 eq) were dissolved in o-xylene, and then stirred at 150 °C for 48 hours. After cooling, the mixture was washed three times with ethyl acetate and water, and an organic layer obtained by separation was dried utilizing $MgSO_4$ and then dried under reduced pressure. The resulting product was purified by column chromatography with MC and n-hexane as an eluent to obtain Intermediate 4-1. (Yield: 30 %)

**Synthesis of Intermediate 4-2**

Intermediate 4-1 (1 eq), 9-(3-bromophenyl)-9H-carbazole (2 eq), tris(dibenzylideneacetone)dipalladium(0) (0.15 eq), tri-tert-butylphosphine (0.3 eq), and sodium tert-butoxide (4 eq) were dissolved in o-xylene, and then stirred at 150 °C for 48 hours. After cooling, the mixture was washed three times with ethyl acetate and water, and an organic layer obtained by separation was dried utilizing $MgSO_4$ and then dried under reduced pressure. The resulting product was purified by column chromatography with MC and n-hexane as an eluent to obtain Intermediate 4-2. (Yield: 44 %)

**Synthesis of Compound 4**

After Intermediate 4-2 (1 eq) was dissolved in ortho-dichlorobenzene and then cooled down to 0 °C, $BBr_3$ (5 eq) was slowly injected thereinto under a nitrogen atmosphere. After completion of adding dropwise, the temperature was raised to 180 °C, followed by stirring for 24 hours. After cooling, triethylamine was slowly dropped into the flask containing the reactant to terminate the reaction, and then, ethyl alcohol was added to the reactant, followed by precipitation and filtration to thereby obtain a reaction product as a solid. The obtained solid was purified by column chromatography with MC and n-hexane as an eluent, and then, Compound 4 was obtained by recrystallization utilizing toluene and acetone. (Yield: 3 %)

## Synthesis Example 5. Synthesis of Compound 5

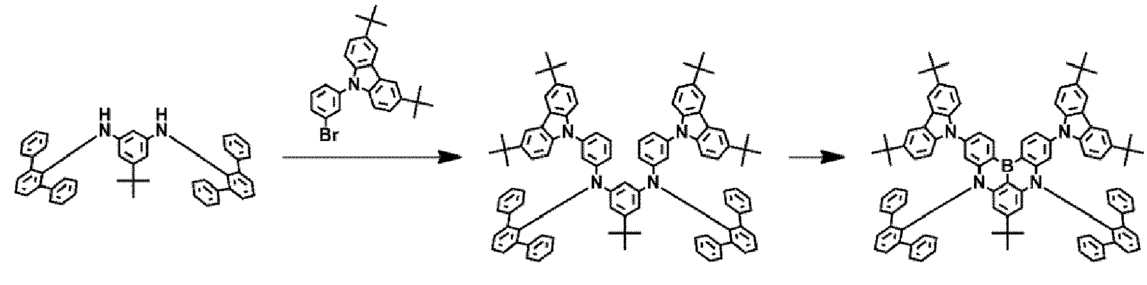

3-1 5-1 5

### Synthesis of Intermediate 5-1

Intermediate 3-1 (1 eq), 9-(3-bromophenyl)-3,6-di-tert-butyl-9H-carbazole (4 eq), tris(dibenzylideneacetone)dipalladium(0) (0.15 eq), tri-tert-butylphosphine (0.3 eq), and sodium tert-butoxide (4 eq) were dissolved in o-xylene, and then stirred at 150 °C for 48 hours. After cooling, the mixture was washed three times with ethyl acetate and water, and an organic layer obtained by separation was dried utilizing $MgSO_4$ and then dried under reduced pressure. The resulting product was purified by column chromatography with MC and n-hexane as an eluent to obtain Intermediate 5-1. (Yield: 43 %)

### Synthesis of Compound 5

After Intermediate 5-1 (1 eq) was dissolved in ortho-dichlorobenzene and then cooled down to 0 °C, $BBr_3$ (5 eq) was slowly injected thereinto under a nitrogen atmosphere. After completion of adding dropwise, the temperature was raised to 180 °C, followed by stirring for 24 hours. After cooling, triethylamine was slowly dropped into the flask containing the reactant to terminate the reaction, and then, ethyl alcohol was added to the reactant, followed by precipitation and filtration to thereby obtain a reaction product as a solid. The obtained solid was purified by column chromatography with MC and n-hexane as an eluent, and then, Compound 5 was obtained by recrystallization utilizing toluene and acetone. (Yield: 6 %)

## Synthesis Example 6. Synthesis of Compound 6

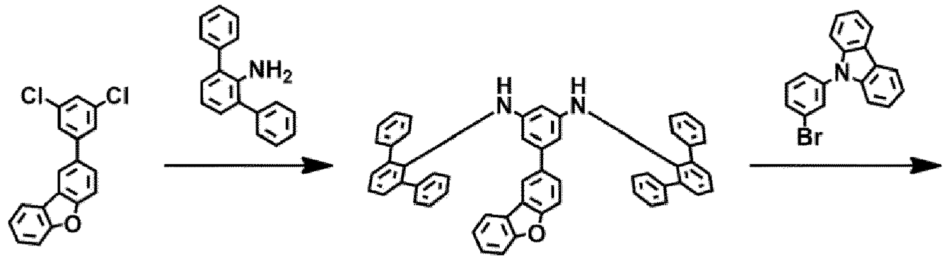

6-1

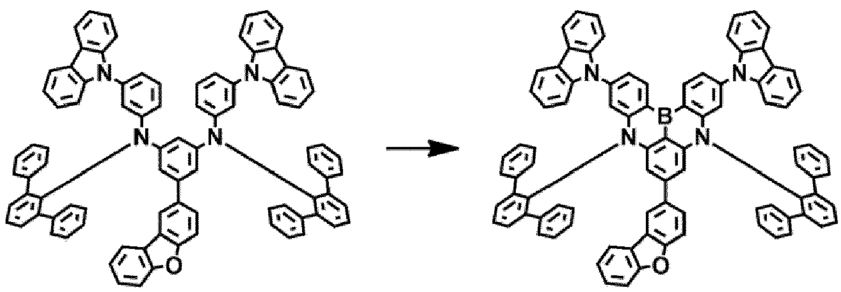

6-2 6

**Synthesis of Intermediate 6-1**

2-(3,5-dichlorophenyl)dibenzo[b,d]furan (1 eq), [1,1':3',1"-terphenyl]-2'-amine (2 eq), tris(dibenzylideneacetone)dipalladium(0) (0.05 eq), tri-tert-butylphosphine (0.1 eq), and sodium tert-butoxide (3 eq) were dissolved in o-xylene, and then stirred at 140 °C for 12 hours. After cooling, the mixture was washed three times with ethyl acetate and water, and an organic layer obtained by separation was dried utilizing $MgSO_4$ and then dried under reduced pressure. The resulting product was purified by column chromatography with MC and n-hexane as an eluent to obtain Intermediate 6-1. (Yield: 80 %)

**Synthesis of Intermediate 6-2**

Intermediate 6-1 (1 eq), 9-(3-bromophenyl)-9H-carbazole (4 eq), tris(dibenzylideneacetone)dipalladium(0) (0.15 eq), tri-tert-butylphosphine (0.3 eq), and sodium tert-butoxide (4 eq) were dissolved in o-xylene, and then stirred at 150 °C for 48 hours. After cooling, the mixture was washed three times with ethyl acetate and water, and an organic layer obtained by separation was dried utilizing $MgSO_4$ and then dried under reduced pressure. The resulting product was purified by column chromatography with MC and n-hexane as an eluent to obtain Intermediate 6-2. (Yield: 37 %)

**Synthesis of Compound 6**

After Intermediate 6-2 (1 eq) was dissolved in ortho-dichlorobenzene and then cooled down to 0 °C, $BBr_3$ (5 eq) was slowly injected thereinto under a nitrogen atmosphere. After completion of adding dropwise, the temperature was raised to 180 °C, followed by stirring for 24 hours. After cooling, triethylamine was slowly dropped into the flask containing the reactant to terminate the reaction, and then, ethyl alcohol was added to the reactant, followed by precipitation and filtration to thereby obtain a reaction product as a solid. The obtained solid was purified by column chromatography with MC and n-hexane as an eluent, and then, Compound 6 was obtained by recrystallization utilizing toluene and acetone. (Yield: 5 %)

**Synthesis Example 7. Synthesis of Compound 7**

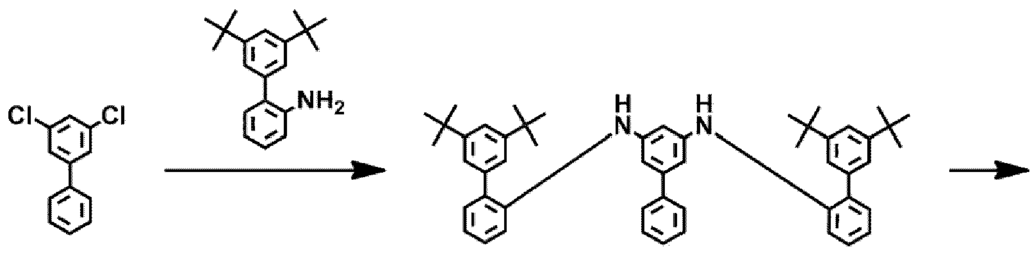

7-1

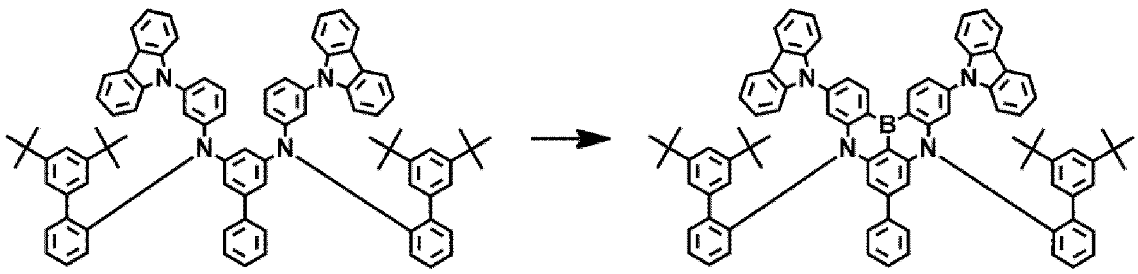

7-2 7

**Synthesis of Intermediate 7-1**

3,5-dichloro-1,1'-biphenyl (1 eq), 3',5'-di-tert-butyl-[1,1'-biphenyl]-2-amine (2.2 eq), tris(dibenzylideneacetone)dipalladium(0) (0.05 eq), tri-tert-butylphosphine (0.1 eq), and sodium tert-butoxide (3 eq) were dissolved in toluene, and then stirred at 100 °C for 12 hours. After cooling, the mixture was washed three times with ethyl acetate and water, and an organic layer obtained by separation was dried utilizing $MgSO_4$ and then dried under reduced pressure. The resulting product was purified by column chromatography with MC and n-hexane as an eluent to obtain Intermediate 7-1. (Yield: 84 %)

**Synthesis of Intermediate 7-2**

Intermediate 7-1 (1 eq), 9-(3-bromophenyl)-9H-carbazole (2.2 eq), tris(dibenzylideneacetone)dipalladium(0) (0.05 eq), tri-tert-butylphosphine (0.1 eq), and sodium tert-butoxide (3 eq) were dissolved in toluene, and then stirred at 110 °C for 24 hours. After cooling, the mixture was washed three times with ethyl acetate and water, and an organic layer obtained by separation was dried utilizing $MgSO_4$ and then dried under reduced pressure. The resulting product was purified by column chromatography with MC and n-hexane as an eluent to obtain Intermediate 7-2. (Yield: 64 %)

**Synthesis of Compound 7**

After Intermediate 7-2 (1 eq) was dissolved in ortho-dichlorobenzene and then cooled down to 0 °C, $BBr_3$ (5 eq) was slowly injected thereinto under a nitrogen atmosphere. After completion of adding dropwise, the temperature was raised to 180 °C, followed by stirring for 24 hours. After cooling, triethylamine was slowly dropped into the flask containing the reactant to terminate the reaction, and then, ethyl alcohol was added to the reactant, followed by precipitation and filtration to thereby obtain a reaction product as a solid. The obtained solid was purified by column chromatography with MC and n-hexane as an eluent, and then, Compound 7 was obtained by recrystallization utilizing toluene and acetone. (Yield: 6 %)

**Synthesis Example 8. Synthesis of Compound 8**

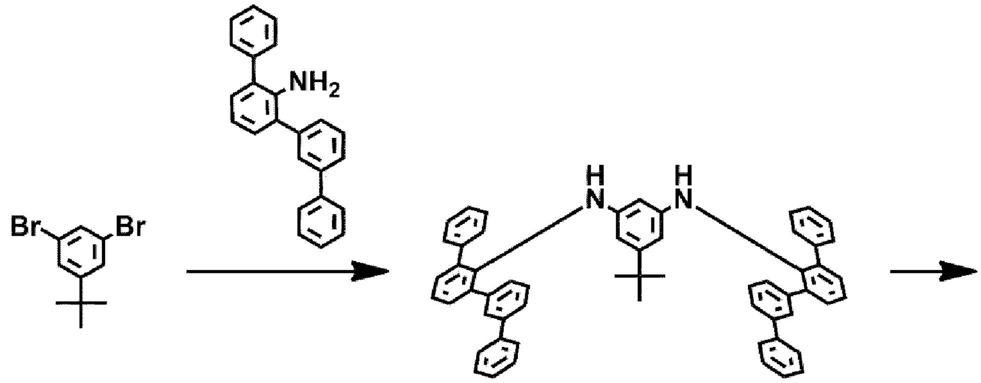

8-1

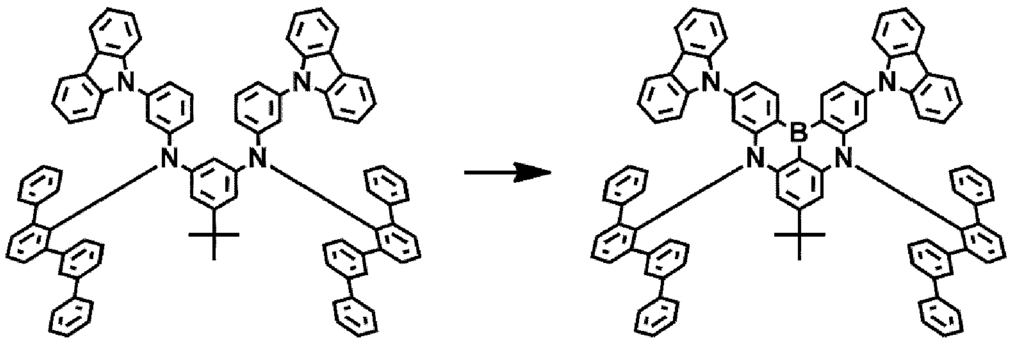

8-2 8

**Synthesis of Intermediate 8-1**

1,3-dibromo-5-(tert-butyl)benzene (1 eq), [1,1':3',1":3",1‴-quaterphenyl]-2'-amine (2 eq), tris(dibenzylideneacetone)dipalladium(0) (0.1 eq), tri-tert-butylphosphine (0.2 eq), and sodium tert-butoxide (3 eq) were dissolved in toluene, and then stirred at 110 °C for 24 hours. After cooling, the mixture was washed three times with ethyl acetate and water, and an organic layer obtained by separation was dried utilizing $MgSO_4$ and then dried under reduced pressure. The resulting product was purified by column chromatography with MC and n-hexane as an eluent to obtain Intermediate 8-1. (Yield: 69 %)

**Synthesis of Intermediate 8-2**

Intermediate 8-1 (1 eq), 9-(3-bromophenyl)-9H-carbazole (4 eq), tris(dibenzylideneacetone)dipalladium(0) (0.15 eq), tri-tert-butylphosphine (0.3 eq), and sodium tert-butoxide (4 eq) were dissolved in o-xylene, and then stirred at 150 °C for 48 hours. After cooling, the mixture was washed three times with ethyl acetate and water, and an organic layer obtained by separation was dried utilizing $MgSO_4$ and then dried under reduced pressure. The resulting product was purified by column chromatography with MC and n-hexane as an eluent to obtain Intermediate 8-2. (Yield: 35 %)

**Synthesis of Compound 8**

After Intermediate 8-2 (1 eq) was dissolved in ortho-dichlorobenzene and then cooled down to 0 °C, $BBr_3$ (5

eq) was slowly injected thereinto under a nitrogen atmosphere. After completion of adding dropwise, the temperature was raised to 180 °C, followed by stirring for 24 hours. After cooling, triethylamine was slowly dropped into the flask containing the reactant to terminate the reaction, and then, ethyl alcohol was added to the reactant, followed by precipitation and filtration to thereby obtain a reaction product as a solid. The obtained solid was purified by column chromatography with MC and n-hexane as an eluent, and then, Compound 8 was obtained by recrystallization utilizing toluene and acetone. (Yield: 4 %)

**Synthesis Example 9. Synthesis of Compound 9**

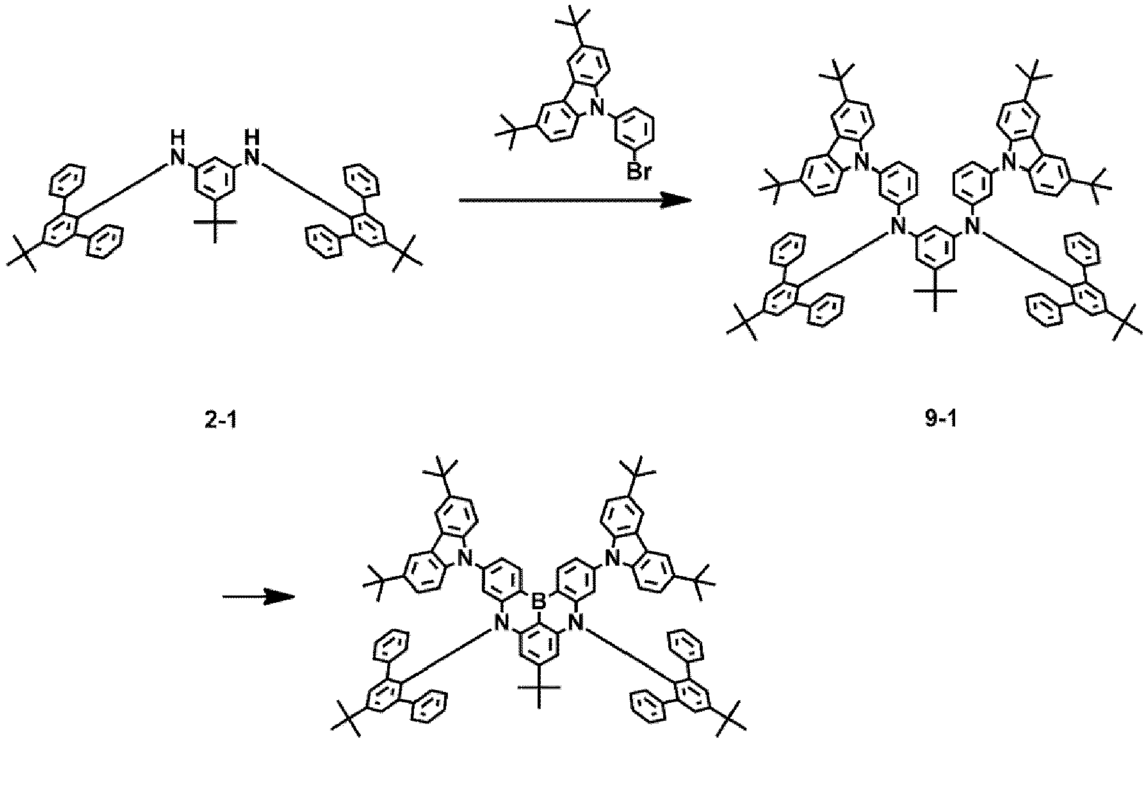

2-1

9-1

9

**Synthesis of Intermediate 9-1**

Intermediate 2-1 (1 eq), 9-(3-bromophenyl)-3,6-di-tert-butyl-9H-carbazole (1 eq), tris(dibenzylideneacetone)dipalladium(0) (0.15 eq), tri-tert-butylphosphine (0.3 eq), and sodium tert-butoxide (4 eq) were dissolved in toluene, and then stirred at 150 °C for 48 hours. After cooling, the mixture was washed three times with ethyl acetate and water, and an organic layer obtained by separation was dried utilizing $MgSO_4$ and then dried under reduced pressure. The resulting product was purified by column chromatography with MC and n-hexane as an eluent to obtain Intermediate 9-1. (Yield: 31 %)

**Synthesis of Compound 9**

After Intermediate 9-1 (1 eq) was dissolved in ortho-dichlorobenzene and then cooled down to 0 °C, $BBr_3$ (5 eq) was slowly injected thereinto under a nitrogen atmosphere. After completion of adding dropwise, the temperature was raised to 180 °C, followed by stirring for 24 hours. After cooling, triethylamine was slowly dropped into the flask containing the reactant to terminate the reaction, and then, ethyl alcohol was added to the reactant, followed by precipitation and filtration to thereby obtain a reaction product as a solid. The obtained solid was purified by column chromatography with MC and n-hexane as an eluent, and then, Compound 9 was obtained by recrystallization utilizing toluene and acetone. (Yield: 4 %)

**Synthesis Example 10. Synthesis of Compound** 10

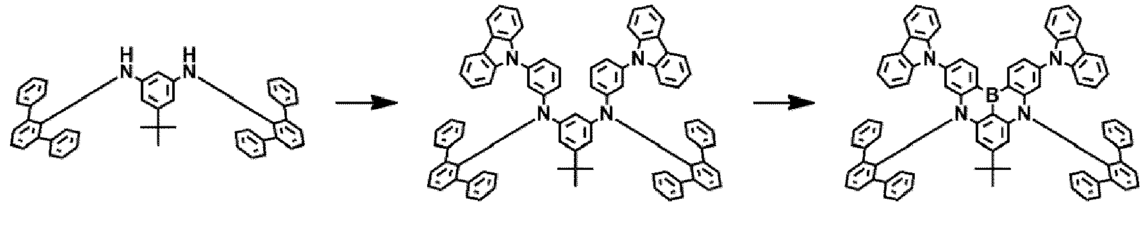

3-1 10-1 10

**Synthesis of Intermediate 10-1**

Intermediate 3-1 (1 eq), 9-(3-bromophenyl)-9H-carbazole (4 eq), tris(dibenzylideneacetone)dipalladium(0) (0.15 eq), tri-tert-butylphosphine (0.3 eq), and sodium tert-butoxide (4 eq) were dissolved in o-xylene, and then stirred at 150 °C for 48 hours. After cooling, the mixture was washed three times with ethyl acetate and water, and an organic layer obtained by separation was dried utilizing $MgSO_4$ and then dried under reduced pressure. The resulting product was purified by column chromatography with MC and n-hexane as an eluent to obtain Intermediate 10-1. (Yield: 32 %)

**Synthesis of Compound 10**

After Intermediate 10-1 (1 eq) was dissolved in ortho-dichlorobenzene and then cooled down to 0 °C, $BBr_3$ (5 eq) was slowly injected thereinto under a nitrogen atmosphere. After completion of adding dropwise, the temperature was raised to 180 °C, followed by stirring for 24 hours. After cooling, triethylamine was slowly dropped into the flask containing the reactant to terminate the reaction, and then, ethyl alcohol was added to the reactant, followed by precipitation and filtration to thereby obtain a reaction product as a solid. The obtained solid was purified by column chromatography with MC and n-hexane as an eluent, and then, Compound 10 was obtained by recrystallization utilizing toluene and acetone. (Yield: 5 %)

**Synthesis Example 11. Synthesis of Compound 11**

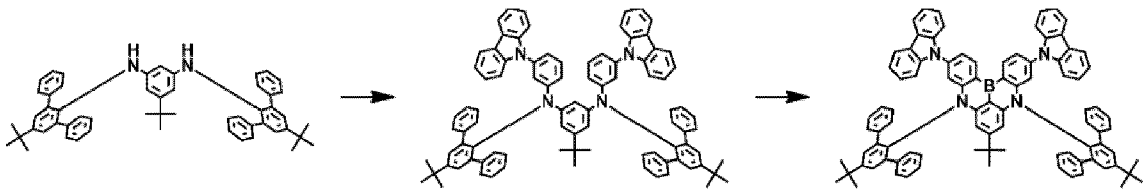

2-1 11-1 11

**Synthesis of Intermediate 11-1**

Intermediate 2-1 (1 eq), 9-(3-bromophenyl)-9H-carbazole (4 eq), tris(dibenzylideneacetone)dipalladium(0) (0.15 eq), tri-tert-butylphosphine (0.3 eq), and sodium tert-butoxide (4 eq) were dissolved in o-xylene, and then stirred at 150 °C for 48 hours. After cooling, the mixture was washed three times with ethyl acetate and water, and an organic layer obtained by separation was dried utilizing $MgSO_4$ and then dried under reduced pressure. The resulting product was purified by column chromatography with MC and n-hexane as an eluent to obtain Intermediate 11-1. (Yield: 27 %)

**Synthesis of Compound 11**

After Intermediate 11-1 (1 eq) was dissolved in ortho-dichlorobenzene and then cooled down to 0 °C, $BBr_3$ (5 eq) was slowly injected thereinto under a nitrogen atmosphere. After completion of adding dropwise, the temperature was raised to 180 °C, followed by stirring for 24 hours. After cooling, triethylamine was slowly dropped into the flask containing the reactant to terminate the reaction, and then, ethyl alcohol was added to the reactant, followed by precipitation and filtration to thereby obtain a reaction product as a solid. The obtained solid was purified by column chromatography with MC and n-hexane as an eluent, and then, Compound 11 was obtained by recrystallization utilizing toluene and acetone. (Yield: 7 %)

**Synthesis Example 12. Synthesis of Compound 12**

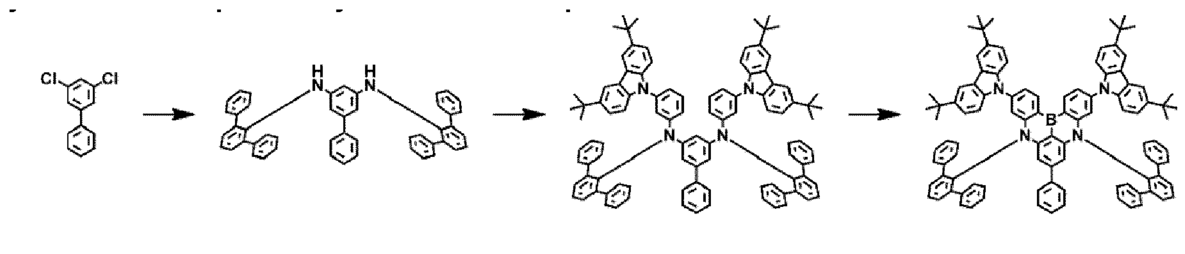

12-1 12-2 12

**Synthesis of Intermediate 12-1**

3,5-dichloro-1,1'-biphenyl (1 eq), [1,1':3',1"-terphenyl]-2'-amine (2 eq), tris(dibenzylideneacetone)dipalladium(0) (0.05 eq), tri-tert-butylphosphine (0.1 eq), and sodium tert-butoxide (3 eq) were dissolved in o-xylene, and then stirred at 140 °C for 12 hours. After cooling, the mixture was washed three times with ethyl acetate and water, and an organic layer obtained by separation was dried utilizing $MgSO_4$ and then dried under reduced pressure. The resulting product was purified by column chromatography with MC and n-hexane as an eluent to obtain Intermediate 12-1. (Yield: 62 %)

**Synthesis of Intermediate 12-2**

Intermediate 12-1 (1 eq), 9-(3-bromophenyl)-3,6-di-tert-butyl-9H-carbazole (4 eq), tris(dibenzylideneacetone)dipalladium(0) (0.15 eq), tri-tert-butylphosphine (0.3 eq), and sodium tert-butoxide (4 eq) were dissolved in o-xylene, and then stirred at 150 °C for 48 hours. After cooling, the mixture was washed three times with ethyl acetate and water, and an organic layer obtained by separation was dried utilizing $MgSO_4$ and then dried under reduced pressure. The resulting product was purified by column chromatography with MC and n-hexane as an eluent to obtain Intermediate 12-2. (Yield: 41 %)

**Synthesis of Compound 12**

After Intermediate 12-2 (1 eq) was dissolved in ortho-dichlorobenzene and then cooled down to 0 °C, $BBr_3$ (5 eq) was slowly injected thereinto under a nitrogen atmosphere. After completion of adding dropwise, the temperature was raised to 180 °C, followed by stirring for 24 hours. After cooling, triethylamine was slowly dropped into the flask containing the reactant to terminate the reaction, and then, ethyl alcohol was added to the reactant, followed by precipitation and filtration to thereby obtain a reaction product as a solid. The obtained solid was purified by column chromatography with MC and n-hexane as an eluent, and then, Compound 12 was obtained by recrystallization utilizing toluene and acetone. (Yield: 4 %)

**Synthesis Example 13. Synthesis of Compound 13**

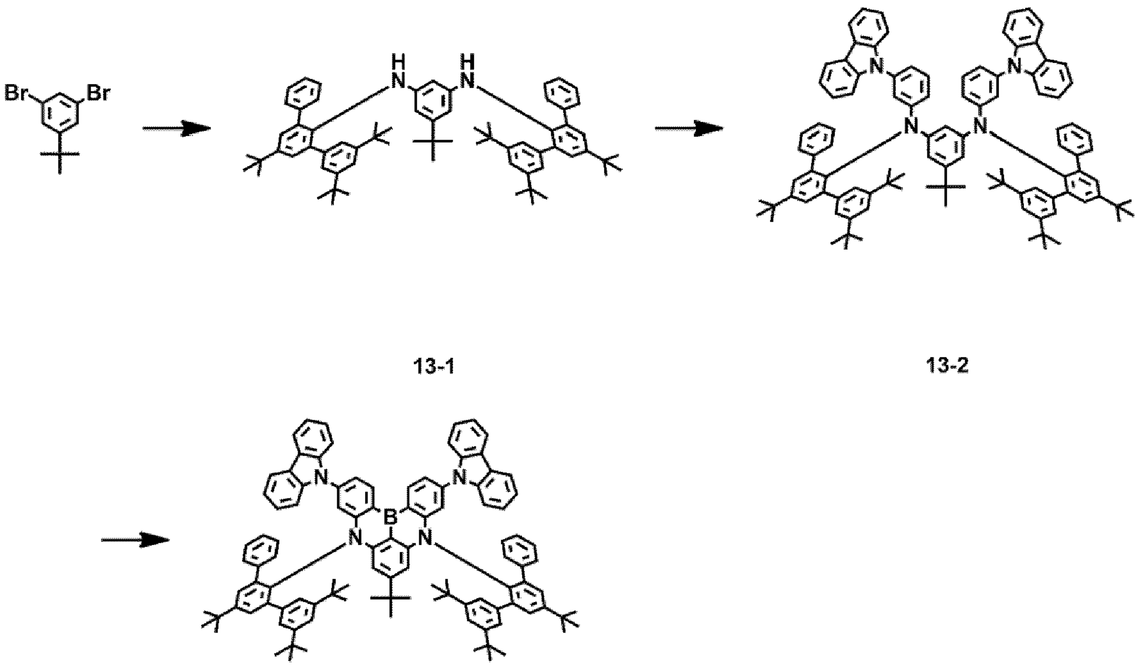

13-1 13-2

13

**Synthesis of Intermediate 13-1**

1,3-dibromo-5-(tert-butyl)benzene (1 eq), 3,5,5'-tri-tert-butyl-[1,1':3',1"-terphenyl]-2'-amine (2 eq), tris(dibenzylideneacetone)dipalladium(0) (0.15 eq), tri-tert-butylphosphine (0.3 eq), and sodium tert-butoxide (3 eq) were dissolved in o-xylene, and then stirred at 140 °C for 12 hours. After cooling, the mixture was washed three times with ethyl acetate and water, and an organic layer obtained by separation was dried utilizing $MgSO_4$ and then dried under reduced pressure. The resulting product was purified by column chromatography with MC and n-hexane as an eluent to obtain Intermediate 13-1. (Yield: 53 %)

**Synthesis of Intermediate 13-2**

Intermediate 13-1 (1 eq), 9-(3-bromophenyl)-9H-carbazole (4 eq), tris(dibenzylideneacetone)dipalladium(0) (0.15 eq), tri-tert-butylphosphine (0.3 eq), and sodium tert-butoxide (4 eq) were dissolved in o-xylene, and then stirred at 150 °C for 48 hours. After cooling, the mixture was washed three times with ethyl acetate and water, and an organic layer obtained by separation was dried utilizing $MgSO_4$ and then dried under reduced pressure. The resulting product was purified by column chromatography with MC and n-hexane as an eluent to obtain Intermediate 13-2. (Yield: 35 %)

**Synthesis of Compound 13**

After Intermediate 13-2 (1 eq) was dissolved in ortho-dichlorobenzene and then cooled down to 0 °C, $BBr_3$ (5 eq) was slowly injected thereinto under a nitrogen atmosphere. After completion of adding dropwise, the temperature was raised to 180 °C, followed by stirring for 24 hours. After cooling, triethylamine was slowly dropped into the flask containing the reactant to terminate the reaction, and then, ethyl alcohol was added to the reactant, followed by precipitation and filtration to thereby obtain a reaction product as a solid. The obtained solid was purified by column chromatography with MC and n-hexane as an eluent, and then, Compound 13 was obtained by recrystallization utilizing toluene and acetone. (Yield: 2 %)

**Synthesis Example 14. Synthesis of Compound 14**

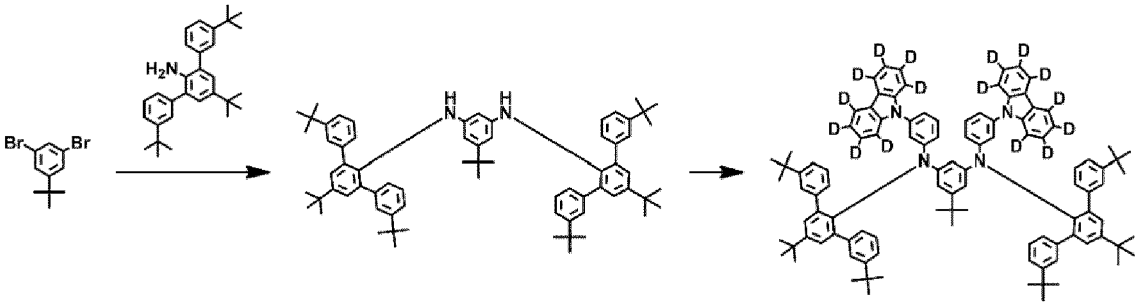

14-1 14-2

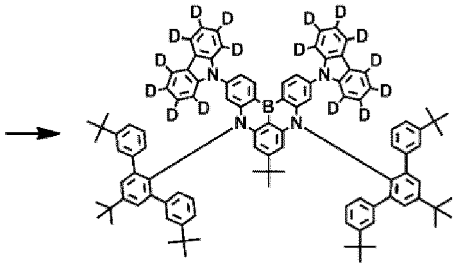

14

**Synthesis of Intermediate 14-1**

1,3-dibromo-5-(tert-butyl)benzene (1 eq), 3,3",5'-tri-tert-butyl-[1,1':3',1"-terphenyl]-2'-amine (2 eq), tris(dibenzylideneacetone)dipalladium(0) (0.15 eq), tri-tert-butylphosphine (0.3 eq), and sodium tert-butoxide (5 eq) were dissolved in o-xylene, and then stirred at 140 °C for 12 hours. After cooling, the mixture was washed three times with ethyl acetate and water, and an organic layer obtained by separation was dried utilizing $MgSO_4$ and then dried under reduced pressure. The resulting product was purified by column chromatography with MC and n-hexane as an eluent to obtain Intermediate 14-1. (Yield: 48 %)

**Synthesis of Intermediate 14-2**

Intermediate 14-1 (1 eq), 9-(3-bromophenyl)-9H-carbazole-D8 (4 eq), tris(dibenzylideneacetone)dipalladium(0) (0.15 eq), tri-tert-butylphosphine (0.3 eq), and sodium tert-butoxide (4 eq) were dissolved in o-xylene, and then stirred at 150 °C for 48 hours. After cooling, the mixture was washed three times with ethyl acetate and water, and an organic layer obtained by separation was dried utilizing $MgSO_4$ and then dried under reduced pressure. The resulting product was purified by column chromatography with MC and n-hexane as an eluent to obtain Intermediate 14-2. (Yield: 27 %)

**Synthesis of Compound 14**

After Intermediate 14-2 (1 eq) was dissolved in ortho-dichlorobenzene and then cooled down to 0 °C, $BBr_3$ (5 eq) was slowly injected thereinto under a nitrogen atmosphere. After completion of adding dropwise, the temperature was raised to 180 °C, followed by stirring for 24 hours. After cooling, triethylamine was slowly dropped into the flask containing the reactant to terminate the reaction, and then, ethyl alcohol was added to the reactant, followed by precipitation and filtration to thereby obtain a reaction product as a solid. The obtained solid was purified by column chromatography with MC and n-hexane as an eluent, and then, Compound 14 was obtained by recrystallization utilizing toluene and acetone. (Yield: 2 %)

**Synthesis Example 15. Synthesis of Compound 15**

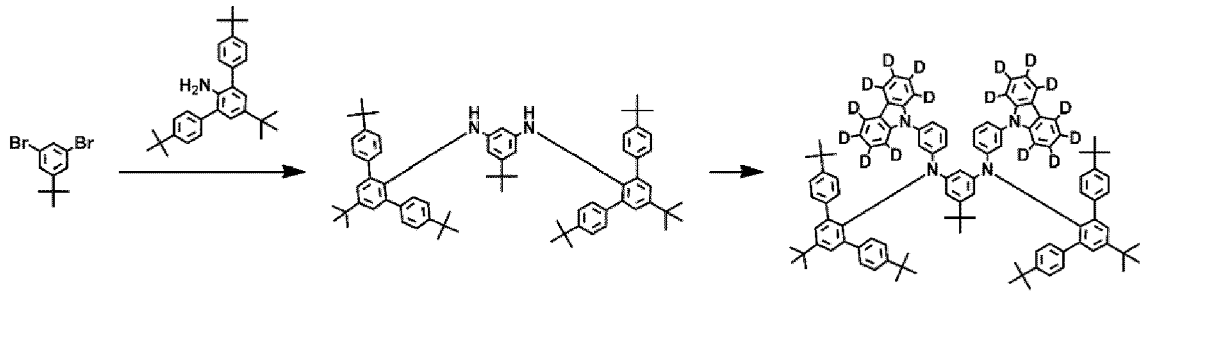

15-1 15-2

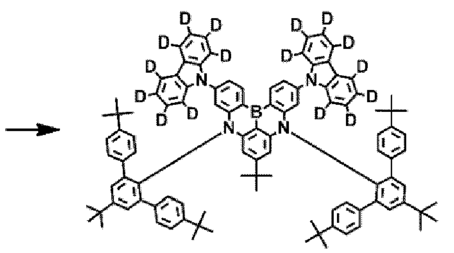

15

**Synthesis of Intermemediate 15-1**

1,3-dibromo-5-(tert-butyl)benzene (1 eq), 4,4",5'-tri-tert-butyl-[1,1':3',1"-terphenyl]-2'-amine (2 eq), tris(dibenzylideneacetone)dipalladium(0) (0.15 eq), tri-tert-butylphosphine (0.3 eq), and sodium tert-butoxide (5 eq) were dissolved in o-xylene, and then stirred at 140 °C for 12 hours. After cooling, the mixture was washed three times with ethyl acetate and water, and an organic layer obtained by separation was dried utilizing $MgSO_4$ and then dried under reduced pressure. The resulting product was purified by column chromatography with MC and n-hexane as an eluent to obtain Intermediate 15-1. (Yield: 42 %)

**Synthesis of Intermediate 15-2**

Intermediate 15-1 (1 eq), 9-(3-bromophenyl)-9H-carbazole-D8 (4 eq), tris(dibenzylideneacetone)dipalladium(0) (0.15 eq), tri-tert-butylphosphine (0.3 eq), and sodium tert-butoxide (4 eq) were dissolved in o-xylene, and then stirred at 150 °C for 48 hours. After cooling, the mixture was washed three times with ethyl acetate and water, and an organic layer obtained by separation was dried utilizing $MgSO_4$ and then dried under reduced pressure. The resulting product was purified by column chromatography with MC and n-hexane as an eluent to obtain Intermediate 15-2. (Yield: 31 %)

**Synthesis of Compound 15**

After Intermediate 15-2 (1 eq) was dissolved in ortho-dichlorobenzene and then cooled down to 0 °C, $BBr_3$ (5 eq) was slowly injected thereinto under a nitrogen atmosphere. After completion of adding dropwise, the temperature was raised to 180 °C, followed by stirring for 24 hours. After cooling, triethylamine was slowly dropped into the flask containing the reactant to terminate the reaction, and then, ethyl alcohol was added to the reactant, followed by precipitation and filtration to thereby obtain a reaction product as a solid. The obtained solid was purified by column chromatography with MC and n-hexane as an eluent, and then, Compound 15 was obtained by recrystallization utilizing toluene and acetone. (Yield: 2 %)

$^1H$ Nuclear Magnetic Resonance spectroscopy (NMR) and Mass spectroscopy-Fast atom bombardment (MS/FAB) of the compounds synthesized according to Synthesis Examples are shown in Table 1. Synthesis methods for other compounds than the compounds shown in Table 1 may be easily recognized by those skilled in the technical field by referring to the synthesis paths and source material materials described above.

Table 1

| Comp ound | $^1$H NMR (δ) | MS/FAB | |
|---|---|---|---|
| | | Calc | Found |
| 1 | 9.12-9.09 (2H, d), 8.36 (2H, s), 7.86-7.83 (4H, d), 7.75-7.69 (6H, d), 7.62-7.58 (2H, d), 7.55-7.48 (8H, m), 7.41-7.37 (2H, m), 7.23-7.19 (2H, s), 7.11-7.08 (22H, d), 6.93 (2H, s) | 1042.105 | 1042.102 |
| 2 | 8.98-8.92 (2H, s), 7.81-7.62 (12H, m) 7.6-7.57 (4H, s) 7.18-7.13 (2H, m), 7.05-6.90 (20H, m), 6.25 (2H, s) | 1045.234 | 1045.228 |
| | 1.41 (18H, s), 1.04 (9H, s) | | |
| 3 | 9.22-9.18 (2H, s), 7.95-7.95 (2H, d), 7.65-7.49 (16H, m) 7.41-7.38 (2H, m), 7.32-7.26 (2H, m), 7.18 (2H, d), 7.09-6.96 (20H, m), 6.26 (2H, s), 1.09 (9H, s) | 1113.180 | 1113.175 |
| 4 | 8.96-8.93 (1H, s), 8.86-8.82 (1H, d), 8.21-8.17 (2H, d),7.81-7.62 (6H, m), 7.6-7.57 (6H, s), 7.49-7.43 (4H, m), 7.31-7.26 (2H, m), 7.18-7.13 (3H, m), 7.05-6.90 (20H, m), 6.25 (2H, s), 1.04 (9H, s) | 1022.115 | 1022.108 |
| 5 | 8.86-8.82 (2H, d), 8.21-8.15 (4H, d), 7.64-7.61 (6H, m)7.48-7.41 (8H, m), 7.18-7.13 (4H, m), 7.05-6.90 (20H, m), 6.27 (2H s), 1.43 (36H, s), 1.06 (9H, s) | 1335.644 | 1335.641 |
| 6 | 8.86-8.83 (2H, d), 8.2-8.15 (4H, d), 7.84-7.81 (2H, m)7.6-7.57 (6H, m), 7.48-7.41 (12H, m), 7.31-7.26 (1H, m), 7.27-7.22 (4H, m), 7.18-7.13 (4H, m), 7.06-6.90 (20H, m), 6.69 (2H, s) | 1221.283 | 1221.275 |
| 7 | 8.67-8.59 (2H, d), 8.2-8.15 (4H, d), 7.6-7.57 (8H, m)7.48-7.41 (9H, m), 7.27-7.22 (4H, m), 7.12-7.08 (4H, m) 7.02-6.95 (10H, m), 6.75 (2H, s), 1.16 (36H, s) | 1203.438 | 1203.433 |
| 8 | 8.87-8.83 (2H, d), 8.21-8.15 (4H, d), 7.61-7.57 (6H, m)7.49-7.41 (8H, m), 7.26-7.22 (4H, m), 7.17-7.13 (4H, m) 7.11-6.96 (28H, m), 6.24 (2H, s), 1.08 (9H, s) | 1263.408 | 1263.401 |
| 9 | 8.88-8.84 (2H, d), 8.21-8.15 (4H, d), 7.60-7.57 (4H, s)7.48-7.41 (8H, m), 7.18-7.13 (4H, m), 7.05-6.90 (20H, m), 6.24 (2H s), 1.44 (36H, s), 1.40 (18H, s), 1.07 (9H, s) | 1447.860 | 1447.854 |
| 10 | 8.86-8.83 (2H, d), 8.2-8.15 (4H, d), 7.6-7.57 (6H, m)7.48-7.41 (8H, m), 7.27-7.22 (4H, m), 7.18-7.13 (4H, m) 7.06-6.90 (20H, m), 6.26 (2H, s), 1.09 (9H, s) | 1111.212 | 1111.208 |
| 11 | 8.88-8.84 (2H, d), 8.2-8.15 (4H, d), 7.6-7.57 (4H, s) 7.48-7.41 (8H, m), 7.27-7.22 (4H, m), 7.18-7.13 (4H, m) 7.05-6.90 (20H, m), 6.25 (2H, s) 1.39 (18H, s) 1.08 (9H, s) | 1223.428 | 1223.415 |
| 12 | 8.86-8.82 (2H, d), 8.21-8.15 (4H, d), 7.64-7.61 (6H, m)7.51-7.41 (13H, m), 7.18-7.13 (4H, m), 7.05-6.90 (20H, m), 6.77 (2H, s), 1.46 (36H, s) | 1355.634 | 1355.631 |
| 13 | 8.61-8.58 (2H, d), 8.2-8.15 (4H, d), 7.6-7.57 (4H, s)7.48-7.41 (8H, m), 7.27-7.22 (4H, m), 7.12-7.08 (4H, m) 7.02-6.95 (16H, m), 6.35 (2H, s) 1.39 (18H, s), 1.16(36H, s) 1.02 (9H, s) | 1447.860 | 1447.851 |
| 14 | 8.62-8.58 (2H, d), 7.6-7.57 (4H, s), 7.12-7.07 (4H, m)7.07-6.98 (16H, m), 6.33 (2H, s) 1.41 (18H, s), 1.20(36H, s) 1.03 (9H, s) | 1463.958 | 1463.936 |
| 15 | 8.61-8.58 (2H, d), 7.6-7.57 (4H, s), 7.12-7.08 (4H, m)7.02-6.95 (16H, m), 6.35 (2H, s) 1.39 (18H, s), 1.16(36H, s) 1.02 (9H, s) | 1463.958 | 1463.929 |

**Evaluation Example 1: Evaluation of energy of compounds**

Table 2 and FIG. 9 show the surface area, the volume, and the ratio between the surface area and the volume of Compounds 1 to 15 according to embodiments and Comparative Example Compounds DABNA-1, DABNA-2, t-DABNA, and CzB and Compounds a to i, calculated according to Connolly Surface analysis.

Table 2

| Compound | Surface area (SA) [Å$^2$] | Volume (V) [Å$^3$] | SA:V [Å$^{-1}$] |
|---|---|---|---|
| 1 | 906.98 | 1063.32 | 0.8530 |
| 2 | 986.34 | 1119.71 | 0.8809 |
| 3 | 921.49 | 1148.45 | 0.8024 |
| 4 | 915.25 | 1053.11 | 0.8691 |
| 5 | 1234.06 | 1435.4 | 0.8597 |
| 6 | 1054.11 | 1212.92 | 0.8691 |
| 7 | 1371.07 | 1571.34 | 0.8725 |
| 8 | 1059.43 | 1321.59 | 0.8016 |
| 9 | 1369.29 | 1576.8 | 0.8684 |
| 10 | 973.29 | 1141.15 | 0.8529 |
| 11 | 1104.27 | 1283.27 | 0.8605 |
| 12 | 1265.11 | 1425.31 | 0.8876 |
| 13 | 1285.92 | 1620.45 | 0.7936 |
| 14 | 1310.14 | 1600.55 | 0.8186 |
| 15 | 1295.66 | 1618.07 | 0.8007 |
| DABNA-1 | 403.53 | 409.87 | 0.9845 |
| DABNA-2 | 718.55 | 731.48 | 0.9823 |
| t-DABNA | 661 | 704.63 | 0.9381 |
| CzB | 630.58 | 674.14 | 0.9354 |
| a | 566.32 | 578.49 | 0.9790 |
| b | 1072.89 | 1102.01 | 0.9736 |
| c | 844.06 | 870.23 | 0.9699 |
| d | 852.45 | 898.86 | 0.9484 |
| e | 994.73 | 1044.95 | 0.9519 |
| f | 741.75 | 825.65 | 0.8984 |
| g | 852.15 | 947.74 | 0.8991 |
| h | 773.79 | 858.61 | 0.9012 |
| i | 872.02 | 968.7 | 0.9002 |

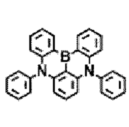
DABNA-1

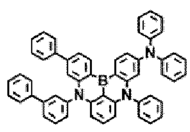
DABNA-2

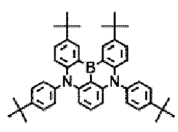
t-DABNA

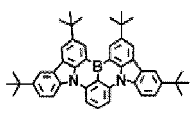
CzB

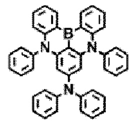
a

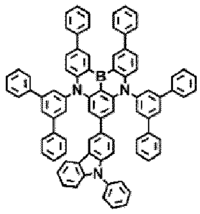
b

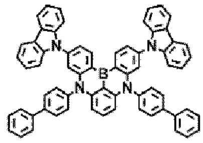
c

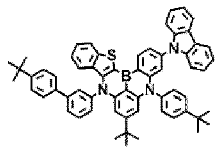
d

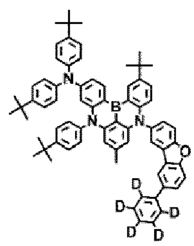
e

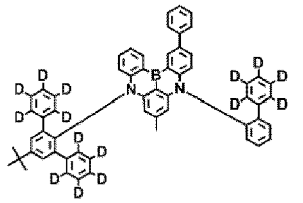
f

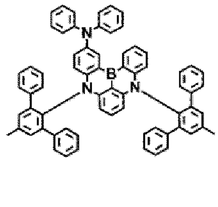
g

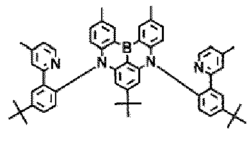
h

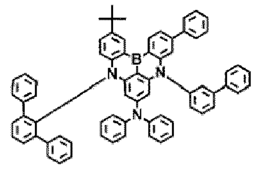
i

From Table 2, it was confirmed that Compounds 1 to 15 had a surface area to volume ratio of less than or equal to 0.8900 $Å^{-1}$, unlike Comparative Example Compounds DABNA-1, DABNA-2, t-DABNA, and CzB and Compounds a to i.

Example 1

As an anode, a glass substrate (product of Corning Inc.) with a 15 $\Omega/cm^2$ (1,200 Å) ITO electrode formed thereon was cut to a size of 50 mm x 50 mm x 0.7 mm, sonicated in isopropyl alcohol and pure water each for 5 minutes, and then cleaned by irradiation of ultraviolet rays and exposure of ozone thereto for 30 minutes. Then, the resultant glass substrate was mounted on a vacuum deposition apparatus.

NPB was deposited on the anode to form a hole injection layer having a thickness of 300 Å, HT3 was deposited on the hole injection layer to form a hole transport layer having a thickness of 200 Å, and CzSi was deposited on the hole transport layer to form an emission auxiliary layer having a thickness of 100 Å.

HTH31 and ETH66 (weight ratio of 5:5) as a host, PD40 as a phosphorescent sensitizer, and Compound 1 as a luminescent material were co-deposited at a weight ratio of 85:14:1 (host phosphorescent sensitizer:luminescent material) on the emission auxiliary layer to form an emission layer having a thickness of 350 Å, and then, HBL-1 was vacuum-deposited thereon to form a hole blocking layer having a thickness of 50 Å.

After a mixed layer of CNNPTRZ:LiQ (weight ratio of 4:6) was deposited on the hole blocking layer to form an electron transport layer having a thickness of 310 Å, Yb was deposited on the electron transport layer to form an electron injection layer having a thickness of 15 Å, and Mg was vacuum-deposited thereon to form an electrode (cathode) having a thickness of 800 Å, thereby completing the manufacture of an organic electroluminescent device.

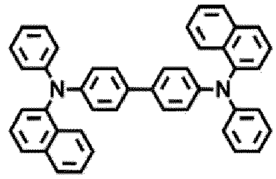
NPB

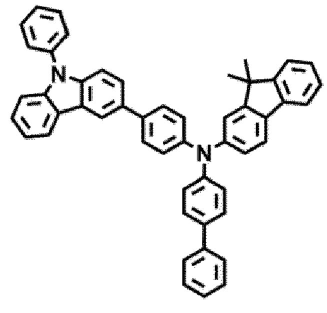
HT3

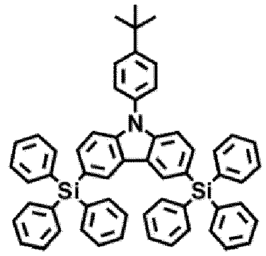
CzSi

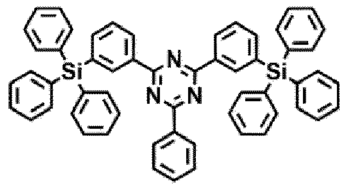

HBL-1

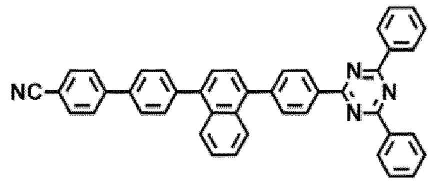

CNNPTRZ

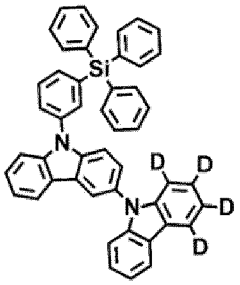

HTH31

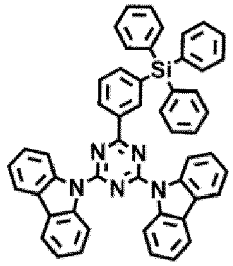

ETH66

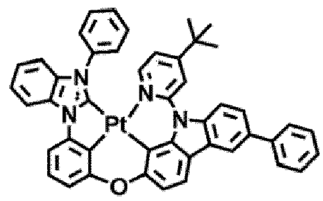

PD40

**Examples 2 to 15 and Comparative Examples 1 to 13**

Light-emitting devices were manufactured in substantially the same manner as in Example 1, except that the compounds shown in Table 3 were respectively utilized as luminescent materials in forming the emission layers.

**Evaluation Example 1**

To evaluate the characteristics of each of the light-emitting devices manufactured according to Examples 1 to 15 and Comparative Examples 1 to 13, the driving voltage and efficiency (cd/A) thereof at the current density of 10 mA/cm$^2$ were measured, and the lifespan thereof was measured as the time taken for the luminance to be deteriorated to 95 % of the initial value when the light-emitting devices were each continuously driven at the current density of 10 mA/cm$^2$. A lifespan ratio (T95) of each of the light-emitting devices manufactured according to Examples 1 to 15 and Comparative Examples 1 to 13 was further calculated relative to the lifespan (T95) of the light-emitting device manufactured according to Comparative Example 3. The results are shown in Table 3.

Table 3

| | Exciplex host (HT:ET = 5:5) | Phosphorescent sensitizer | Luminescent material |
|---|---|---|---|
| Example 1 | HTH31/ETH66 | PD40 | 1 |
| Example 2 | HTH31/ETH66 | PD40 | 2 |
| Example 3 | HTH31/ETH66 | PD40 | 3 |
| Example 4 | HTH31/ETH66 | PD40 | 4 |
| Example 5 | HTH31/ETH66 | PD40 | 5 |
| Example 6 | HTH31/ETH66 | PD40 | 6 |
| Example 7 | HTH31/ETH66 | PD40 | 7 |
| Example 8 | HTH31/ETH66 | PD40 | 8 |
| Example 9 | HTH31/ETH66 | PD40 | 9 |
| Example 10 | HTH31/ETH66 | PD40 | 10 |
| Example 11 | HTH31/ETH66 | PD40 | 11 |

(continued)

| | Exciplex host (HT:ET = 5:5) | Phosphorescent sensitizer | Luminescent material | |
|---|---|---|---|---|
| Example 12 | HTH31/ETH66 | PD40 | 12 | |
| Example 13 | HTH31/ETH66 | PD40 | 13 | |
| Example 14 | HTH31/ETH66 | PD40 | 14 | |
| Example 15 | HTH31/ETH66 | PD40 | 15 | |
| Comparative Example 1 | HTH31/ETH66 | PD40 | DABNA-1 | |
| Comparative Example 2 | HTH31/ETH66 | PD40 | DABNA-2 | |
| Comparative Example 3 | HTH31/ETH66 | PD40 | t-DABNA | |
| Comparative Example 4 | HTH31/ETH66 | PD40 | CzB | |
| Comparative Example 5 | HTH31/ETH66 | PD40 | a | |
| Comparative Example 6 | HTH31/ETH66 | PD40 | b | |
| Comparative Example 7 | HTH31/ETH66 | PD40 | c | |
| Comparative Example 8 | HTH31/ETH66 | PD40 | d | |
| Comparative Example 9 | HTH31/ETH66 | PD40 | e | |
| Comparative Example 10 | HTH31/ETH66 | PD40 | f | |
| Comparative Example 11 | HTH31/ETH66 | PD40 | a | |
| Comparative Example 12 | HTH31/ETH66 | PD40 | h | |
| Comparative Example 13 | HTH31/ETH66 | PD40 | i | |
| | Driving voltage (V) | Efficiency (cd/A) | Emission wavelength (nm) | Lifespan ratio (T95) |
| Example 1 | 4.4 | 25.9 | 460 | 6.2 |
| Example 2 | 4.5 | 26.4 | 463 | 6.7 |
| Example 3 | 4.4 | 26.6 | 461 | 6.5 |
| Example 4 | 4.4 | 26.9 | 461 | 6.9 |
| Example 5 | 4.3 | 27.8 | 460 | 7.4 |
| Example 6 | 4.4 | 26.2 | 461 | 7.2 |
| Example 7 | 4.6 | 27.1 | 462 | 6.6 |
| Example 8 | 4.5 | 27.3 | 461 | 7.8 |
| Example 9 | 4.4 | 26.9 | 460 | 7.7 |

(continued)

| | Driving voltage (V) | Efficiency (cd/A) | Emission wavelength (nm) | Lifespan ratio (T95) |
|---|---|---|---|---|
| Example 10 | 4.4 | 27.5 | 461 | 7.2 |
| Example 11 | 4.3 | 27.4 | 461 | 7.8 |
| Example 12 | 4.6 | 26.4 | 463 | 6.8 |
| Example 13 | 4.5 | 27.5 | 462 | 7.4 |
| Example 14 | 4.6 | 27.6 | 461 | 7.7 |
| Example 15 | 4.5 | 27.8 | 460 | 7.4 |
| Comparative Example 1 | 5.5 | 13.6 | 462 | 0.4 |
| Comparative Example 2 | 5.3 | 17.8 | 465 | 1.2 |
| Comparative Example 3 | 5.4 | 14.5 | 466 | 1 |
| Comparative Example 4 | 5.8 | 11.4 | 487 | 0.2 |
| Comparative Example 5 | 5.8 | 16.6 | 461 | 1.4 |
| Comparative Example 6 | 5.5 | 19.4 | 468 | 3.7 |
| Comparative Example 7 | 5.3 | 20.3 | 462 | 4.0 |
| Comparative Example 8 | 5.4 | 21.1 | 462 | 1.6 |
| Comparative Example 9 | 5.7 | 17.6 | 463 | 2.3 |
| Comparative Example 10 | 5.4 | 17.7 | 460 | 3.1 |
| Comparative Example 11 | 5.3 | 14.3 | 466 | 3.3 |
| Comparative Example 12 | 5.8 | 12.7 | 463 | 1.6 |
| Comparative Example 13 | 5.2 | 17.7 | 459 | 3.1 |

From Table 3, it was confirmed that the light-emitting devices of Examples 1 to 15 each had lower driving voltage, higher luminescence efficiency, and longer lifespan than the light-emitting devices of Comparative Examples 1 to 13.

According to the one or more embodiments, as the condensed cyclic compound of the present disclosure satisfies the embodied relational expression between surface area and volume, bulky substituents of the condensed cyclic compound may have a molecular shape around (e.g., surrounding) the multi-resonance core of the condensed cyclic compound, and the substituents having such an around (e.g., surrounding) shape may provide steric protection to the empty p orbital (e.g., vacant p orbital) of boron in the multi-resonance core. As a result, boron atoms, which may be chemically vulnerable, may be protected, and the molecule may have a round molecular shape as a whole, so that interaction with a surrounding matrix (such as a host, a sensitizer, or another boron emitter molecule) may be suppressed or reduced. Because emission transition occurs in the multi-resonance core, multi-resonance molecules require core protection to suppress or reduce DET. In the case of general boron-based, DABNA-based molecules, due to the plate-like structure of the multi-resonance core, emission side effects caused by intermolecular interactions, such as aggregation, excimers, and exciplexes, may appear, and exciton quenching such as DET, TTA, and TPQ may easily occur, in an organic light-emitting device, thus negatively affecting the efficiency and lifespan of the organic light-emitting device. In the case of molecules satisfying the relational expression of the present disclosure, intramolecularly, the p orbital (e.g., vacant p orbital) of boron may be protected, and extramolecularly, intermolecular interaction may be reduced by increasing the intermolecular distance.

Further, because such substituents with high steric hindrance have a bent structure, orbitals of the multi-resonance core may not be distributed, and the electron density may be confined within the multi-resonance core of the molecule, so that the multi-resonance may be further promoted due to the high electron density in the core.

Therefore, the structural and chemical stability of the compound of the present disclosure may be increased, and the energy transfer efficiency may be increased, and thus, a light-emitting device and an electronic apparatus that comprise the compound of the present disclosure may have high efficiency and long lifespan.

In the present disclosure, although the terms "first," "second," "third," "fourth," etc., may be utilized herein to describe one or more elements, components, regions, and/or layers, these elements, components, regions, and/or layers should not be limited by these terms. These terms are only utilized to distinguish one component from another component.

As utilized herein, the singular forms "a," "an," "one," and "the" are intended to comprise the plural forms as well, unless the context clearly indicates otherwise. Further, the use of "may" when describing embodiments of the present disclosure refers to "one or more embodiments of the present disclosure".

In the present disclosure, when particles are spherical, "diameter" indicates a particle diameter or an average particle diameter, and when the particles are non-spherical, the "diameter" indicates a major axis length or an average major axis length. The diameter (or size) of the particles may be measured utilizing a scanning electron microscope or a particle size analyzer. As the particle size analyzer, for example, HORIBA, LA-950 laser particle size analyzer, may be utilized. When the size of the particles is measured utilizing a particle size analyzer, the average particle diameter (or size) is referred to as D50. D50 refers to the average diameter (or size) of particles whose cumulative volume corresponds to 50 vol% in the particle size distribution (e.g., cumulative distribution), and refers to the value of the particle size corresponding to 50% from the smallest particle when the total number of particles is 100% in the distribution curve accumulated in the order of the smallest particle size to the largest particle size.

As utilized herein, the terms "substantially," "about," or similar terms are used as terms of approximation and not as terms of degree, and are intended to account for the inherent deviations in measured or calculated values that would be recognized by those of ordinary skill in the art. "About" as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within $\pm$ 30%, 20%, 10%, 5% of the stated value.

Any numerical range recited herein is intended to comprise all sub-ranges of the same numerical precision subsumed within the recited range. For example, a range of "1.0 to 10.0" is intended to comprise all subranges between (and comprising) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to comprise all lower numerical limitations subsumed therein and any minimum numerical limitation recited in this specification is intended to comprise all higher numerical limitations subsumed therein. Accordingly, Applicant reserves the right to amend this specification, comprising the claims, to expressly recite any sub-range subsumed within the ranges expressly recited herein.

The light-emitting device, the display device, the display apparatus, the electronic apparatus, the electronic equipment, or any other relevant devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

It should be understood that embodiments described herein should be considered in a descriptive sense only

and not for purposes of limitation. Descriptions of features or aspects within each embodiment should typically be considered as available for other similar features or aspects in other embodiments. While one or more embodiments have been described with reference to the drawings, it will be understood by those of ordinary skill in the art that one or more suitable changes in form and details may be made therein without departing from the spirit and scope as defined by the following claims and equivalents thereof.

## Claims

**1.** A light-emitting device comprising:

a first electrode;
a second electrode facing the first electrode;
an interlayer between the first electrode and the second electrode and comprising an emission layer; and
a condensed cyclic compound satisfying Expression 1:

Expression 1

$$SA_1/V_1 \leq 0.89\ Å^{-1}$$

wherein, in Expression 1,
$SA_1$ indicates a surface area of the condensed cyclic compound, and $V_1$ indicates a volume of the condensed cyclic compound.

**2.** The light-emitting device of claim 1, wherein the first electrode is an anode,

the second electrode is a cathode,
the interlayer comprises the condensed cyclic compound,
the interlayer further comprises a hole transport region arranged between the first electrode and the emission layer and an electron transport region arranged between the emission layer and the second electrode,
the hole transport region comprises a hole injection layer, a hole transport layer, an emission auxiliary layer, an electron blocking layer, or any combination thereof, and
the electron transport region comprises a hole blocking layer, an electron transport layer, an electron injection layer, or any combination thereof.

**3.** The light-emitting device of claim 1 or claim 2, wherein the emission layer comprises the condensed cyclic compound.

**4.** The light-emitting device of claim 3, wherein the emission layer further comprises a host, and an amount of the condensed cyclic compound is in a range of about 0.01 parts by weight to about 49.99 parts by weight based on 100 parts by weight of the emission layer; and/or
wherein the emission layer is to emit blue light or blue-green light.

**5.** An electronic apparatus comprising the light-emitting device of any one of claims 1 to 4.

**6.** The electronic apparatus of claim 5, further comprising:

(i) a thin-film transistor, wherein the thin-film transistor comprises a source electrode and a drain electrode, and the first electrode of the light-emitting device is electrically connected to the source electrode or the drain electrode of the thin-film transistor; AND/OR
(ii) further comprising a color filter, a color conversion layer, a touch screen layer, a polarizing layer, or any combination thereof.

**7.** An electronic equipment comprising the light-emitting device of any one of claims 1 to 4, wherein the electronic equipment is at least one of a flat panel display, a curved display, a computer monitor, a medical monitor, a television, an advertisement board, an indoor or outdoor lighting and/or signaling light, a head-up display, a fully or partially transparent display, a flexible display, a rollable display, a foldable display, a stretchable display, a laser printer, a telephone, a mobile phone, a tablet, a phablet, a personal digital assistant (PDA), a wearable device, a laptop

computer, a digital camera, a camcorder, a viewfinder, a microdisplay, a 3D display, a virtual or augmented reality display, a vehicle, a video wall comprising multiple displays tiled together, a theater or stadium screen, a phototherapy device, or a sign.

**8.** A condensed cyclic compound, the condensed cyclic compound satisfying Expression 1:

Expression 1

$$SA_1/V_1 \leq 0.89 \text{ Å}^{-1}$$

wherein, in Expression 1,
$SA_1$ indicates a surface area of the condensed cyclic compound, and $V_1$ indicates a volume of the condensed cyclic compound.

**9.** The condensed cyclic compound of claim 8, wherein:

(i) the condensed cyclic compound is a boron-containing compound; AND/OR.
(ii) wherein the condensed cyclic compound satisfies Expression 2:

Expression 2

$$\Delta E_{ST} = E(S_1) - E(T_1) < 0.2 \text{ eV},$$

and
wherein, in Expression 2,

$E(S_1)$ indicates a singlet energy level (eV) of the condensed cyclic compound, and
$E(T_1)$ indicates a triplet energy level (eV) of the condensed cyclic compound.

**10.** The condensed cyclic compound of claim 8 or claim 9, wherein the surface area and the volume of the condensed cyclic compound are each measured by Connolly surface analysis; OR
wherein the surface area and the volume of the condensed cyclic compound are each measured by Connolly surface analysis and wherein the Connolly surface analysis is performed under conditions of a grid interval of about 0.15 Å, a Van Der Waals scale factor of about 1.0 Å, and a solvent radius (probe) of about 1.4 Å.

**11.** The condensed cyclic compound of any one of claims 8 to 10, wherein the condensed cyclic compound satisfies Expression 3:

Expression 3

$$SA_1/V_1 < SA_D/V_D * 0.90,$$

wherein, in Expression 3,

$SA_1$ indicates the surface area of the condensed cyclic compound, and $V_1$ indicates the volume of the condensed cyclic compound, and
$SA_D$ indicates a surface area of DABNA-1, and $V_D$ indicates a volume of DABNA-1, and
wherein DABNA-1 is a compound represented by

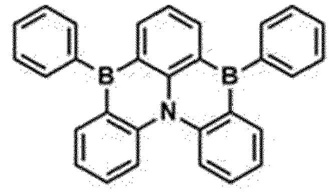

.

12. The condensed cyclic compound of any one of claims 8 to 11, wherein the condensed cyclic compound is represented by Formula 1:

Formula 1

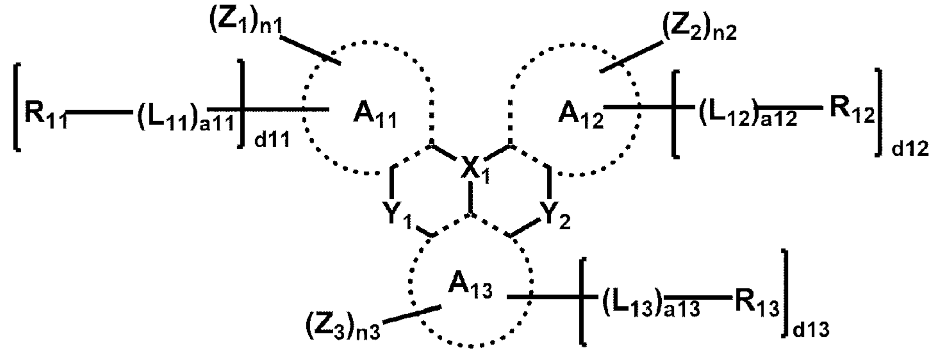

,

and
wherein, in Formula 1,

$A_{11}$ to $A_{13}$ are each independently a $C_3$-$C_{30}$ carbocyclic group or a $C_2$-$C_{30}$ heterocyclic group,
$X_1$ is B, P(=O), or P(=S),
$Y_1$ is O, S, Se, or N($E_1$),
$Y_2$ is O, S, Se, or N($E_2$),
$E_1$ is *-$(L_{14})_{a14}$-$R_{14}$,
$E_2$ is *-$(L_{15})_{a15}$-$R_{15}$,
$L_{11}$ to $L_{15}$ are each independently a single bond, a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,
a11 to a15 are each independently an integer from 1 to 5,
$R_{11}$ to $R_{15}$ are each independently hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_1$-$C_{60}$ alkylthio group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, -C($Q_1$)($Q_2$)($Q_3$), - Si($Q_1$)($Q_2$)($Q_3$), -N($Q_1$)($Q_2$), -B($Q_1$)($Q_2$), -C(=O)($Q_1$), -S(=O)$_2$($Q_1$), or-P(=O)($Q_1$)($Q_2$),
$Z_1$ to $Z_3$ are each independently deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_1$-$C_{60}$ alkylthio group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, a $C_6$-$C_{60}$ aryloxy group unsubstituted or substituted with at least one $R_{10a}$, a $C_6$-$C_{60}$ arylthio group unsubstituted or substituted with at least one $R_{10a}$, -C($Q_1$)($Q_2$)($Q_3$), -Si($Q_1$)($Q_2$)($Q_3$), -N($Q_1$)($Q_2$), -B($Q_1$)($Q_2$), - C(=O)($Q_1$), -S(=O)$_2$($Q_1$), or -P(=O)($Q_1$)($Q_2$),
d11 to d13 are each independently an integer from 0 to 20,
n1 to n3 are each independently an integer from 0 to 3,

two or more neighboring groups of $R_{11}$ in the number of d11, $R_{12}$ in the number of d12, $R_{13}$ in the number of d13, $R_{14}$, $R_{15}$, and $Z_1$ to $Z_3$ are optionally bonded to each other to form a $C_5$-$C_{60}$ carbocyclic group unsubstituted or substituted with at least one $R_{10a}$ or a $C_2$-$C_{60}$ heterocyclic group unsubstituted or substituted with at least one $R_{10a}$,
* indicates a binding site to a neighboring atom,
$R_{10a}$ is:

deuterium, -F, -Cl, -Br, -I, a hydroxyl group, a cyano group, or a nitro group;
a $C_1$-$C_{60}$ alkyl group, a $C_2$-$C_{60}$ alkenyl group, a $C_2$-$C_{60}$ alkynyl group, or a $C_1$-$C_{60}$ alkoxy group, each unsubstituted or substituted with deuterium, -F, -Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ arylalkyl group, a $C_2$-$C_{60}$ heteroarylalkyl group, $-Si(Q_{11})(Q_{12})(Q_{13})$, $-N(Q_{11})(Q_{12})$, $-B(Q_{11})(Q_{12})$, $-C(=O)(Q_{11})$, $-S(=O)_2(Q_{11})$, $-P(=O)(Q_{11})(Q_{12})$, or any combination thereof;
a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ arylalkyl group, or a $C_2$-$C_{60}$ heteroarylalkyl group, each unsubstituted or substituted with deuterium, -F, -Cl, -Br, -I, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ arylalkyl group, a $C_2$-$C_{60}$ heteroarylalkyl group, $-Si(Q_{21})(Q_{22})(Q_{23})$, $-N(Q_{21})(Q_{22})$, $-B(Q_{21})(Q_{22})$, $-C(=O)(Q_{21})$, $-S(=O)_2(Q_{21})$, $-P(=O)(Q_{21})(Q_{22})$, or any combination thereof; or
$-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, or $-P(=O)(Q_{31})(Q_{32})$, and
Q1 to Q3, Q11 to Q13, Q21 to Q23, and Q31 to Q33 are each independently: hydrogen; deuterium; -F; -Cl; -Br; -I; a hydroxyl group; a cyano group; a nitro group; a $C_1$-$C_{60}$ alkyl group; a $C_2$-$C_{60}$ alkenyl group; a $C_2$-$C_{60}$ alkynyl group; a $C_1$-$C_{60}$ alkoxy group; a $C_3$-$C_{60}$ carbocyclic group or a $C_1$-$C_{60}$ heterocyclic group, each unsubstituted or substituted with deuterium, -F, a cyano group, a $C_1$-$C_{60}$ alkyl group, a $C_1$-$C_{60}$ alkoxy group, a phenyl group, a biphenyl group, or any combination thereof; a $C_7$-$C_{60}$ arylalkyl group; or a $C_2$-$C_{60}$ heteroarylalkyl group.

**13.** The condensed cyclic compound of claim 12, wherein the condensed cyclic compound represented by Formula 1 satisfies at least one selected from among Conditions 1 to 5:

**Condition 1**
$Y_1$ is $N(E_1)$, and $E_1$ is a group represented by Formula 2;
**Condition 2**
$Y_2$ is $N(E_2)$, and $E_2$ is a group represented by Formula 2;
**Condition 3**
n1 is an integer of 1 or more;
**Condition 4**
n2 is an integer of 1 or more; and
**Condition 5**
n3 is an integer of 1 or more:

Formula 2

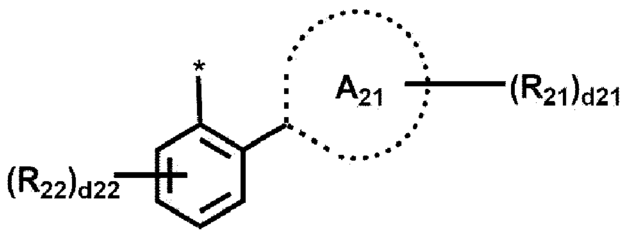

,

and
wherein, in Formula 2,

$A_{21}$ is a $C_3$-$C_{30}$ carbocyclic group or a $C_2$-$C_{30}$ heterocyclic group,
$R_{21}$ and $R_{22}$ are each the same as defined with respect to $R_{11}$ in Formula 1,

d21 is an integer from 0 to 20,
d22 is an integer from 0 to 4, and
* indicates a binding site to a neighboring atom.

**14.** The condensed cyclic compound of claim 13, wherein the group represented by Formula 2 is a group represented by Formula 2-1:

Formula 2-1

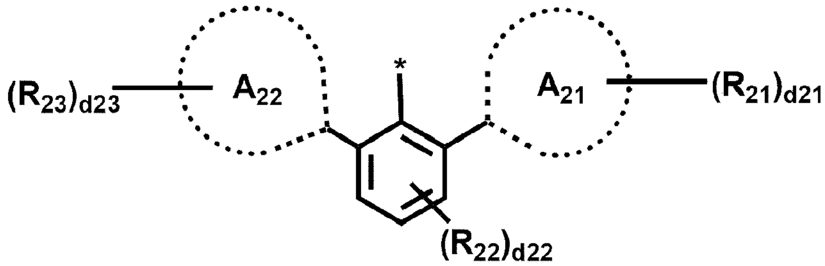

,

and
wherein, in Formula 2-1,

$A_{21}$ and $A_{22}$ are each independently a $C_3$-$C_{30}$ carbocyclic group or a $C_2$-$C_{30}$ heterocyclic group,
$R_{21}$, $R_{22}$, and d21 are each the same as defined in Formula 2,
$R_{23}$ is the same as defined with respect to $R_{11}$ in Formula 1,
d23 is an integer from 0 to 20,
d22 is an integer from 0 to 3, and
* indicates a binding site to a neighboring atom.

**15.** The condensed cyclic compound of any one of claims 12 to 14, wherein, in Formula 1, $Z_1$ and $Z_2$ are each independently a group represented by Formula 4:

Formula 4

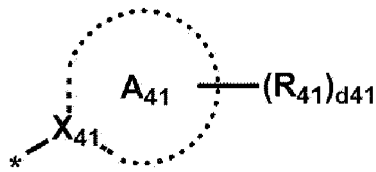

,

and
wherein, in Formula 4,

$X_{41}$ is C or N,
$A_{41}$ is a $C_3$-$C_{30}$ carbocyclic group or a $C_2$-$C_{30}$ heterocyclic group,
$R_{41}$ is the same as defined with respect to $R_{11}$ in Formula 1,
d41 is an integer from 0 to 20, and
* indicates a binding site to a neighboring atom.

FIG. 1

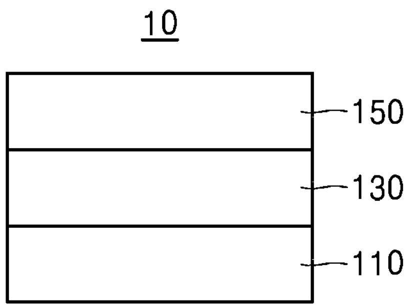

FIG. 2

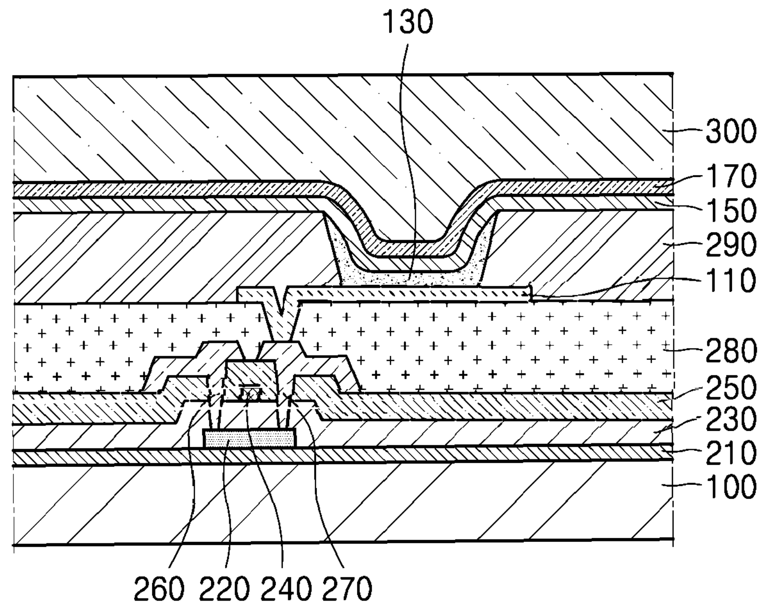
130
300
170
150
290
110
280
250
230
210
100
260
220
240
270

FIG. 3

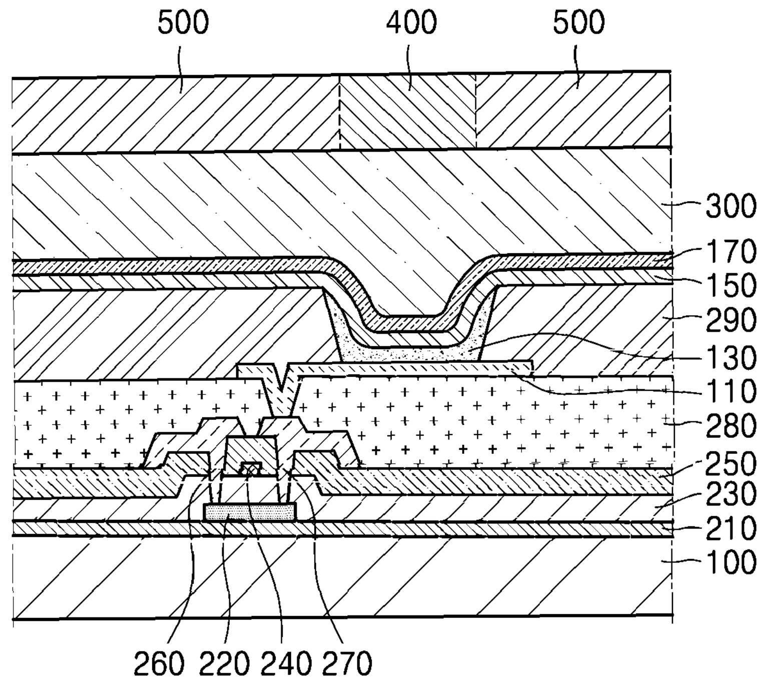
500
400
500
300
170
150
290
130
110
280
250
230
210
100
260
220
240
270

FIG. 4

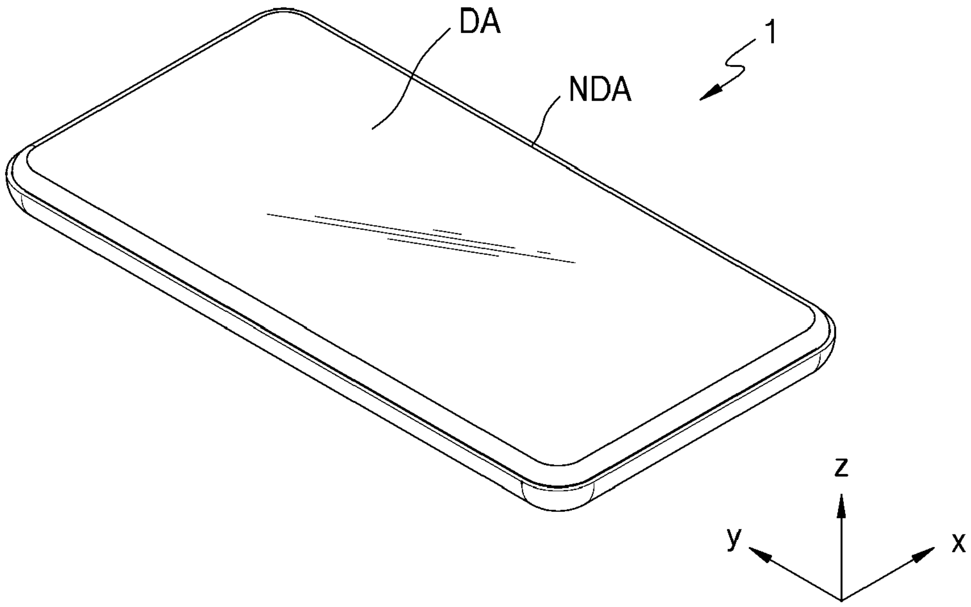


FIG. 5

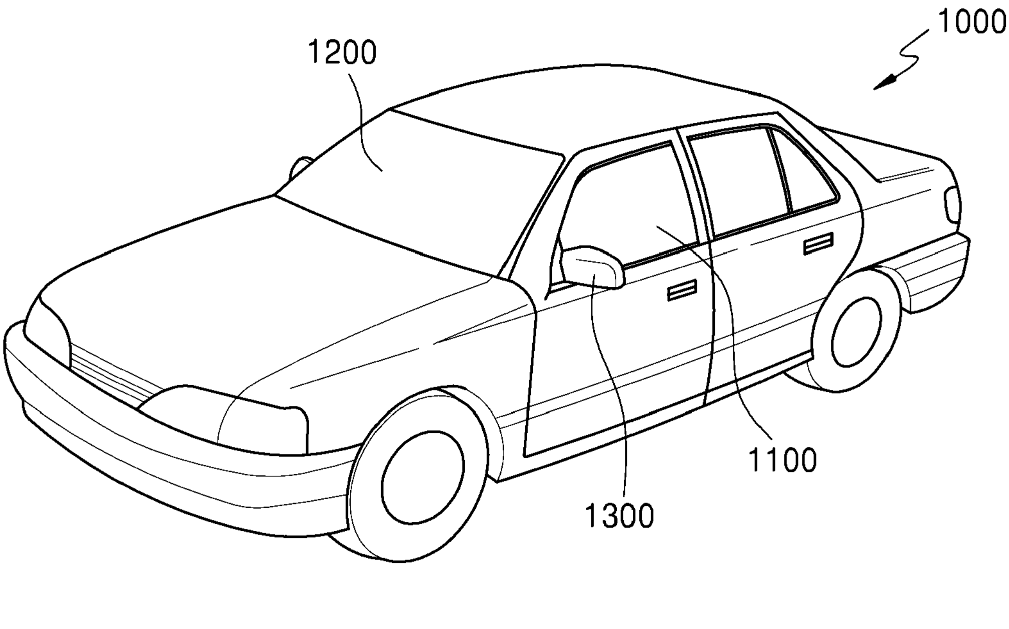

FIG. 6A

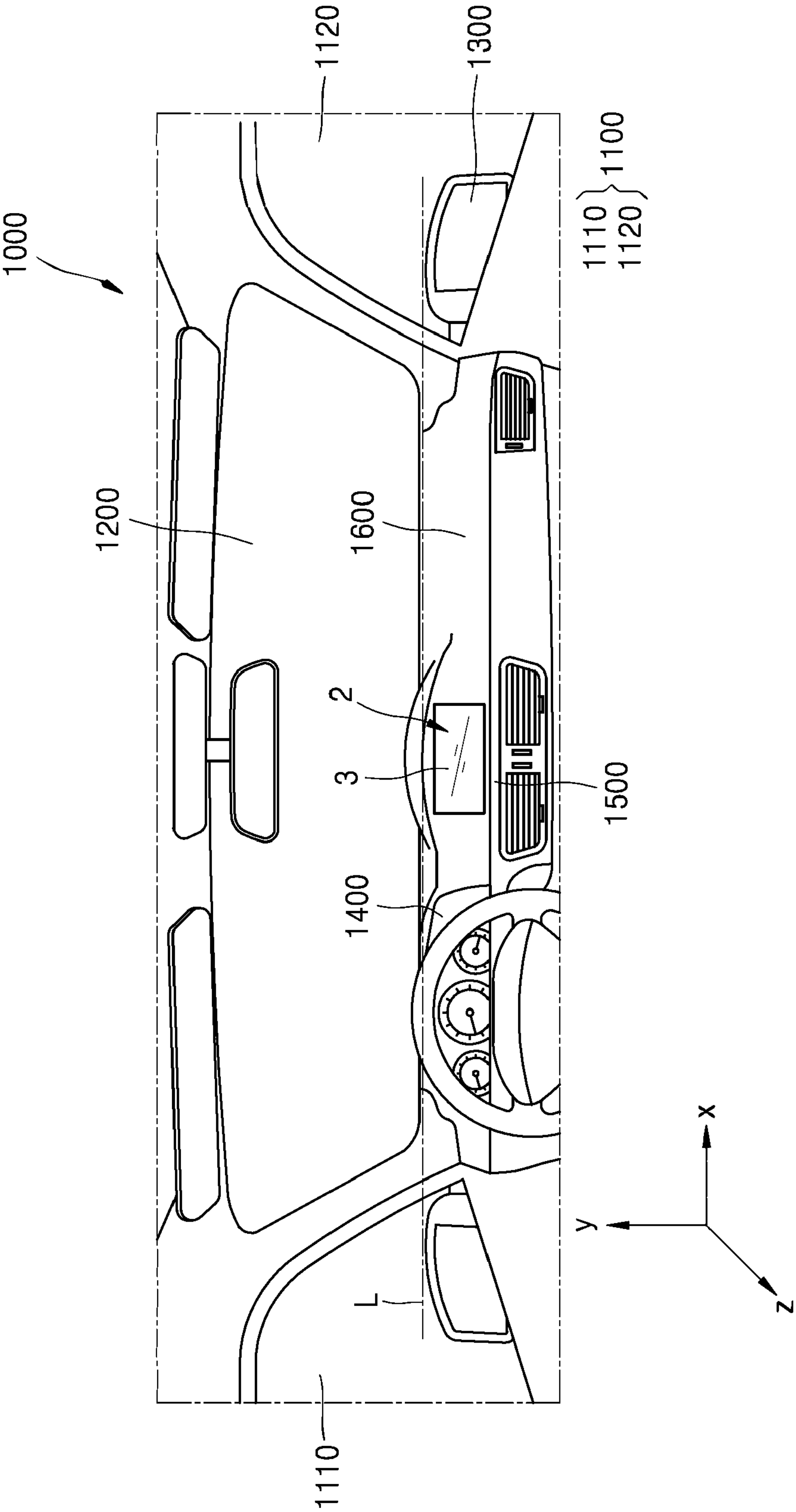
1000
1120
1300
1110
1120
1100
1200
1600
2
3
1500
1400
L
1110
x
y
z

FIG. 6B

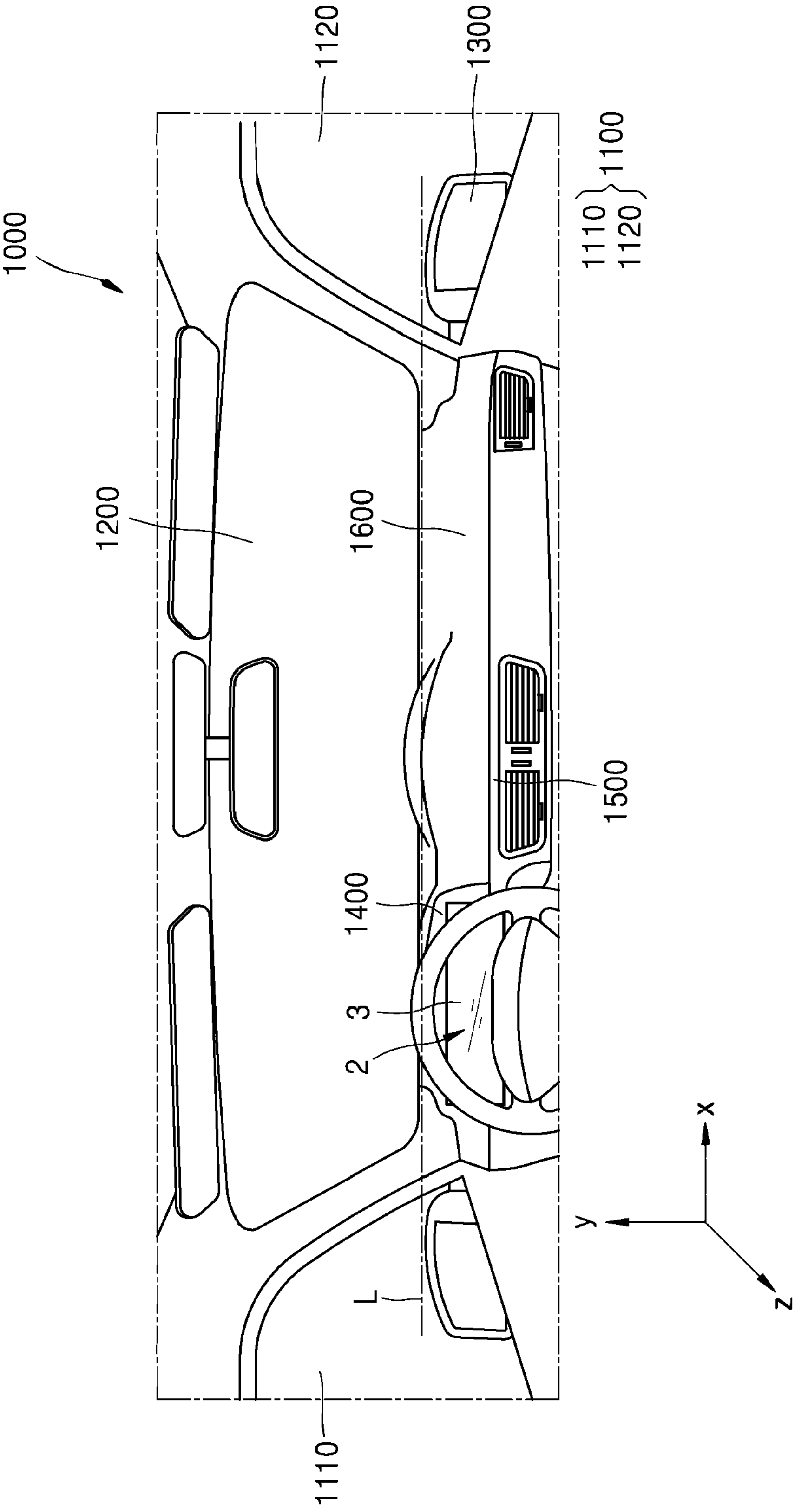
1000
1120
1300
1110
1120
1100
1200
1600
1500
1400
3
2
L
1110
x
y
z

FIG. 6C

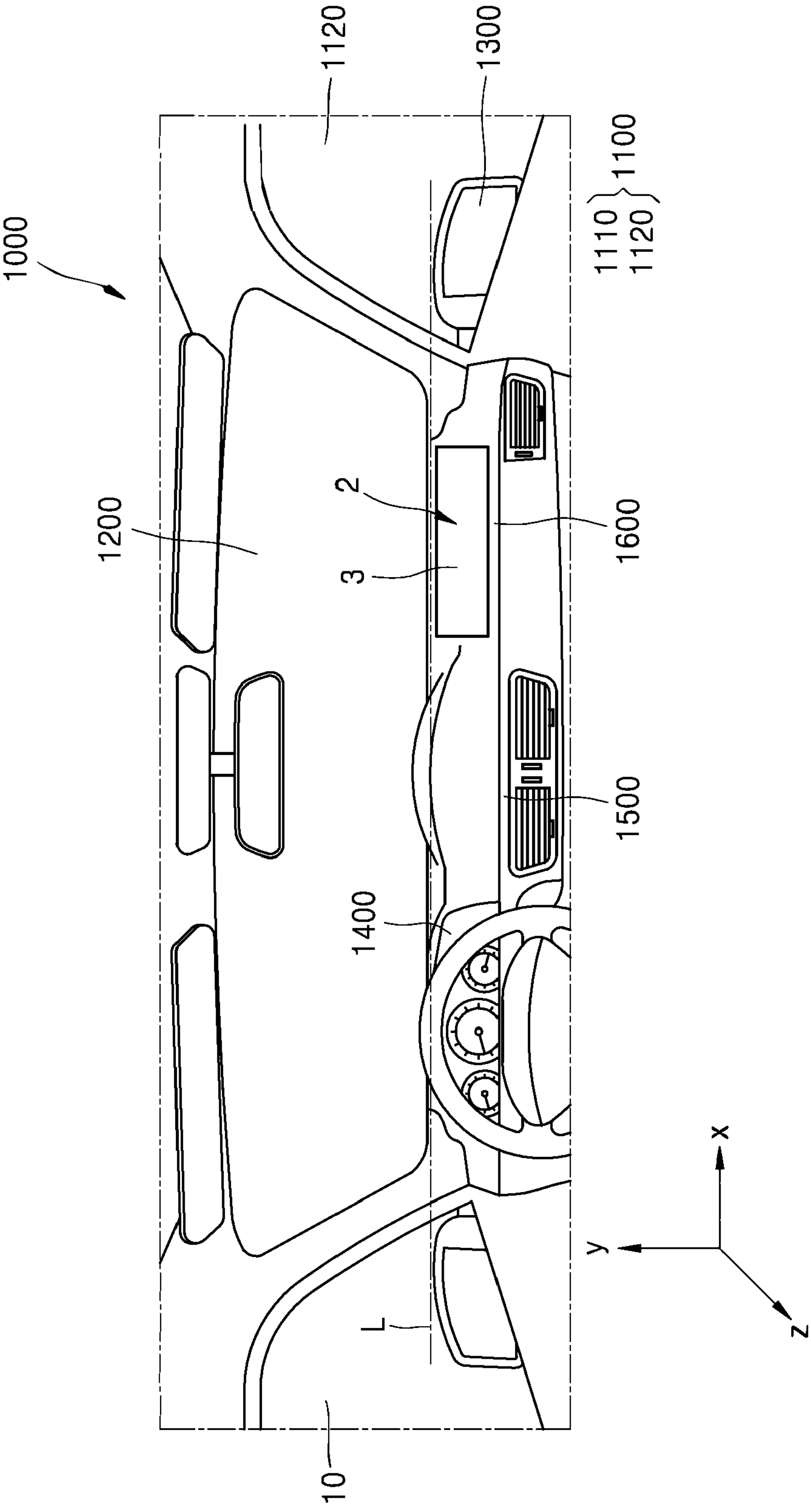
1000
1120
1300
1110
1120
1100
1200
2
3
1600
1500
1400
L
1110
x
y
z

FIG. 7

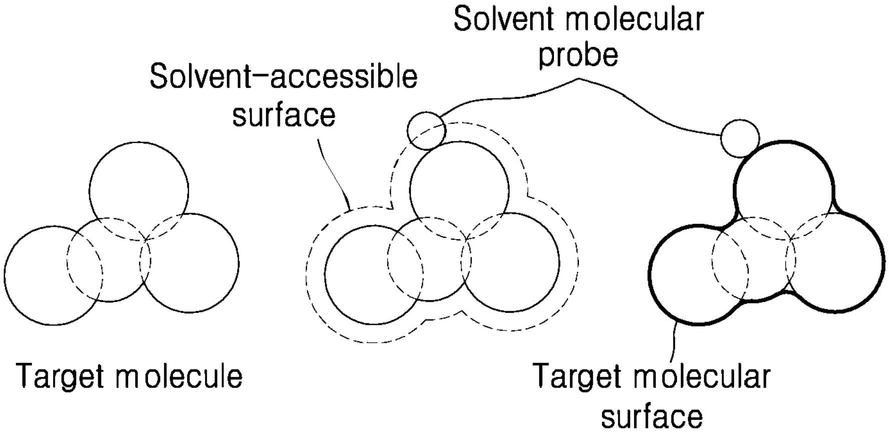
Solvent molecular
probe
Solvent-accessible
surface
Target molecule
Target molecular
surface

FIG. 8A

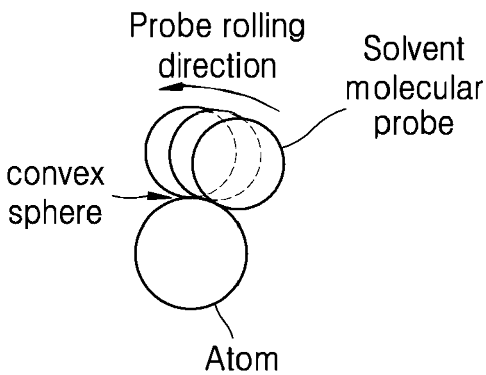
Probe rolling
direction
Solvent
molecular
probe
convex
sphere
Atom

FIG. 8B

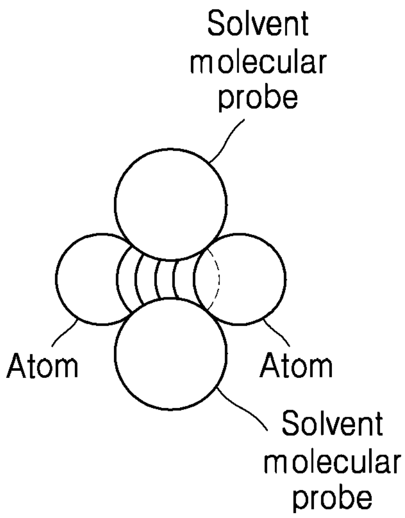
Solvent
molecular
probe
Atom
Atom
Solvent
molecular
probe

FIG. 8C

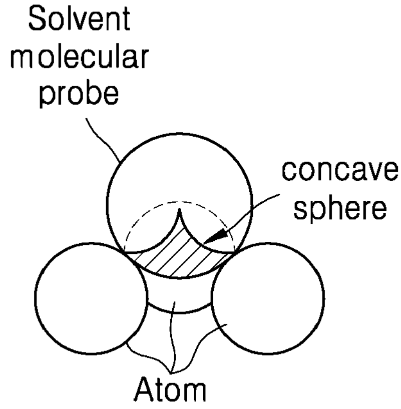
Solvent
molecular
probe
concave
sphere
Atom

# FIG. 9

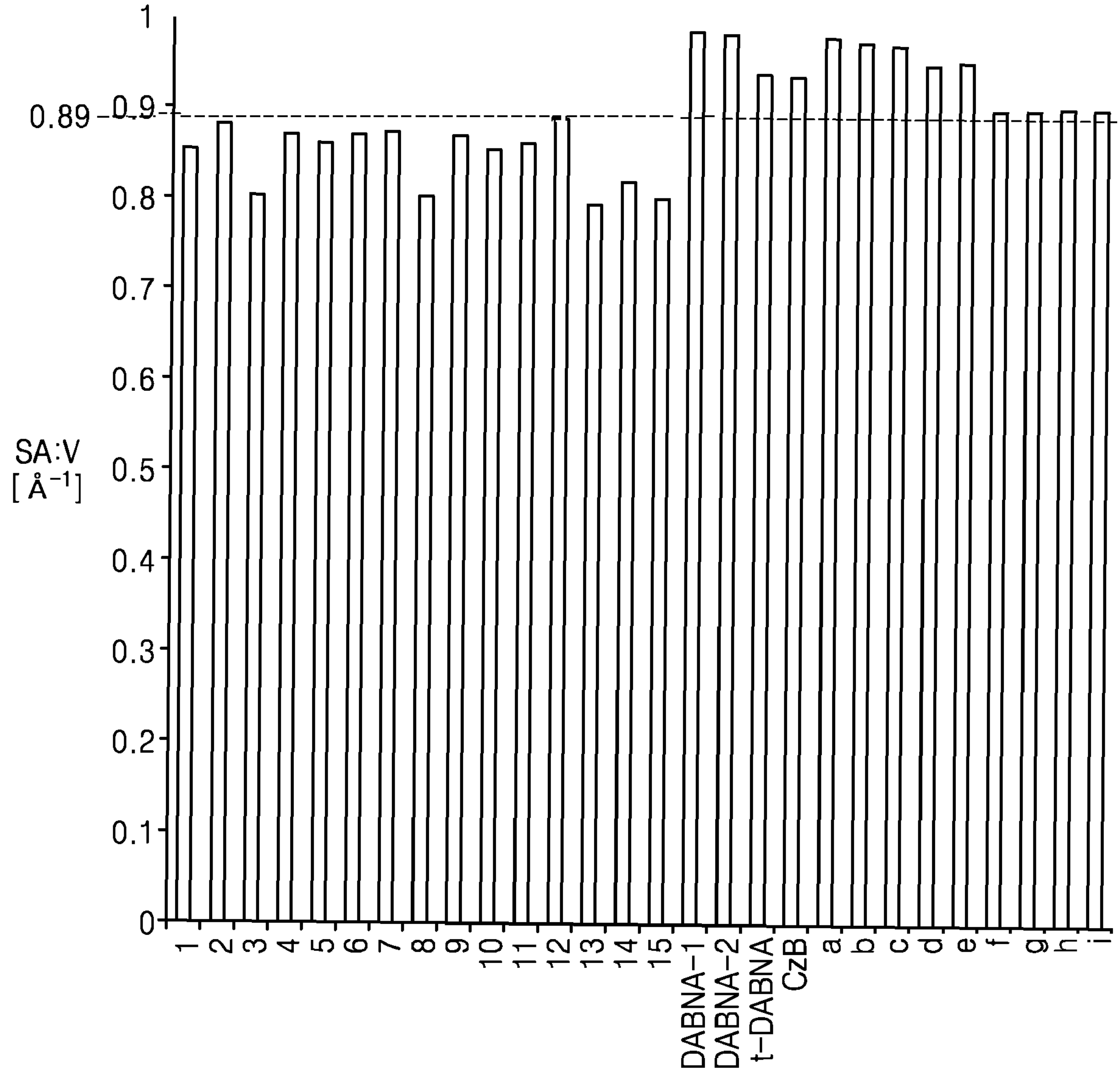
SA:V
[Å⁻¹]
1
0.89
0.9
0.8
0.7
0.6
0.5
0.4
0.3
0.2
0.1
0
1
2
3
4
5
6
7
8
9
10
11
12
13
14
15
DABNA-1
DABNA-2
t-DABNA
CzB
a
b
c
d
e
f
g
h
i

Europäisches Patentamt
European Patent Office
Office européen des brevets

# EUROPEAN SEARCH REPORT

Application Number
EP 23 21 0701

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KR 2022 0069866 A (SAMSUNG ELECTRONICS CO LTD [KR]) 27 May 2022 (2022-05-27) * paragraphs [0156] - [0160], [1120]; claims 14-17 * ----- | 1-15 | INV. H10K85/60 ADD. H10K101/00 H10K101/20 |
| X,P | EP 4 186 959 A1 (SAMSUNG DISPLAY CO LTD [KR]) 31 May 2023 (2023-05-31) * claims 5-7; example 13 * ----- | 1-15 | |
| X,P | EP 4 152 912 A1 (SAMSUNG DISPLAY CO LTD [KR]) 22 March 2023 (2023-03-22) * examples 4-3, 4-5; compounds 4, 6, 53, 84 * ----- | 1-15 | |
| | | | TECHNICAL FIELDS SEARCHED (IPC) |
| | | | H10K |

The present search report has been drawn up for all claims

1

| Place of search | Date of completion of the search | Examiner |
|---|---|---|
| The Hague | 26 April 2024 | Welter, Steve |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 23 21 0701

This annex lists the patent family members relating to the patent documents cited in the above-mentioned European search report. The members are as contained in the European Patent Office EDP file on The European Patent Office is in no way liable for these particulars which are merely given for the purpose of information.

26-04-2024

| Patent document cited in search report | Publication date | Patent family member(s) | Publication date |
|---|---|---|---|
| KR 20220069866 A | 27-05-2022 | KR 20220069866 A | 27-05-2022 |
| | | KR 20220069867 A | 27-05-2022 |
| EP 4186959 A1 | 31-05-2023 | CN 116209335 A | 02-06-2023 |
| | | EP 4186959 A1 | 31-05-2023 |
| | | KR 20230081933 A | 08-06-2023 |
| | | KR 20230081987 A | 08-06-2023 |
| | | US 2023172053 A1 | 01-06-2023 |
| EP 4152912 A1 | 22-03-2023 | CN 115835754 A | 21-03-2023 |
| | | EP 4152912 A1 | 22-03-2023 |
| | | EP 4322730 A2 | 14-02-2024 |
| | | KR 102472899 B1 | 02-12-2022 |
| | | KR 20230041587 A | 24-03-2023 |
| | | US 2023126371 A1 | 27-04-2023 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020220191075


### Non-patent literature cited in the description


- **MICHAEL L. CONNOLLY.** *J. Appl. Cryst.,* 1983, vol. 16, 548-558
- **CHUNMIAO MA.** *2020 5th International Symposium on Biomedical Science, Biotechnology and Healthcare,* 2020, 120-125